(19) Europäisches Patentamt
European Patent Office
Office européen des brevets

(11) **EP 1 260 090 B1**

(12) **EUROPEAN PATENT SPECIFICATION**

(45) Date of publication and mention of the grant of the patent:
**09.10.2013 Bulletin 2013/41**

(21) Application number: **01913201.8**

(22) Date of filing: **28.02.2001**

(51) Int Cl.:
***G01D 4/00*** *(2006.01)* ***H04Q 9/00*** *(2006.01)*

(86) International application number:
**PCT/US2001/006573**

(87) International publication number:
**WO 2001/065823 (07.09.2001 Gazette 2001/36)**

(54) **SYSTEM AND METHOD FOR ON-LINE MONITORING AND BILLING OF POWER CONSUMPTION**

SYSTEM UND VERFAHREN ZUR ONLINE-ÜBERWACHUNG UND GEBÜHRENBERECHNUNG FÜR DEN ENERGIEVERBRAUCH

SYSTEME ET PROCEDE DE SURVEILLANCE ET DE FACTURATION EN LIGNE DE LA CONSOMMATION D'ENERGIE

(84) Designated Contracting States:
**AT BE CH CY DE DK ES FI FR GB GR IE IT LI LU MC NL PT SE TR**

(30) Priority: **29.02.2000 US 185832 P**

(43) Date of publication of application:
**27.11.2002 Bulletin 2002/48**

(73) Proprietor: **Quadlogic Controls Corporation**
**New York, NY 10018 (US)**

(72) Inventors:
- **SWARZTRAUBER, Sayre, A.**
  **New York, NY 10010 (US)**
- **SHAFRIR, Doron**
  **Suffren, NY 10901 (US)**
- **LO, Stanley, C.**
  **Fresh Meadows, NY 11366 (US)**
- **NEWSOME, Michael**
  **Newport, VA 24128 (US)**
- **JACOBSON, Eric**
  **Bayside, NY 11364 (US)**

(74) Representative: **Naismith, Robert Stewart et al**
**Marks & Clerk LLP**
**Aurora**
**120 Bothwell Street**
**Glasgow**
**G2 7JS (GB)**

(56) References cited:

| | |
|---|---|
| **WO-A-99/46746** | **WO-A-99/57697** |
| **GB-A- 2 306 852** | **GB-A- 2 310 779** |
| **US-A- 3 922 492** | **US-A- 3 973 240** |
| **US-A- 4 004 097** | **US-A- 4 240 030** |
| **US-A- 4 727 315** | **US-A- 4 908 769** |
| **US-A- 5 182 744** | **US-A- 5 586 112** |
| **US-A- 5 764 739** | **US-A- 5 838 660** |
| **US-A- 5 897 607** | **US-A- 5 986 574** |
| **US-A- 6 049 791** | **US-A- 6 115 676** |
| **ZA-A- 9 106 610** | |

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 1 260 090 B1

## Description

FIELD OF THE INVENTION

The present invention relates to metering of and billing for electric power consumption, and has particular application to solid state electricity meters and powerline communication with such meters.

BACKGROUND

Submetering is the resale of electricity or allocation of costs within a multi-tenant property. Master metered apartments are units of a multi-tenant residential building without individual electric meters; the cost of electricity is included in the rent. Because tenants of such units typically consume up to 30% more electricity than tenants who pay for energy consumed, there is a demand for submetering of such units.

Systems and methods for submetering are known. One such system is disclosed in U.S. Patent No. 4, 783, 748, issued November 8, 1988, to Swarztrauber et al. In that system, as disclosed in the patent and as developed through 1999, the submeter (known as a Transmeter®) measures electricity by connecting to the power wires to measure voltage and through current transformers to measure current. The initial Transmeters®, manufactured from 1982 through 1991, processed the voltage and current in digital form to derive the real energy. In a development effort that spanned the period from 1988 through 1992, additional parameters were added. The Transmeters® manufactured from 1992 through 1999 calculate from the measured voltage and current additional parameters such as reactive and apparent energy, power factor, total harmonic distortion peak demand, time- of- use, voltage and current. They also stored the information in CMOS ram backed up by battery to maintain an audit trail of key energy information either every day or every 15 minutes. This type of memory storage can suffer data loss through power and battery failure, data corruption due to "fast transients"- a type of interference commonly found on power lines.

The Transmeter® systems manufactured and sold through 1999 collect and deliver information from Transmeters® located in multi-tenant properties. The individual Transmeters® inject signals onto the power distribution lines (a technique known as power line communication, or "PLC") in the multi-tenant property to a more centrally located device, the Transponder. The Transponder is typically installed at the point of entry of electricity to that property. If the property has more than one electrical service, one Transponder is installed per service. The Transponders are interconnected via an RS-485 network. One of the Transponders connects by modem to a dedicated standard telephone line.

The billing computer is configured to dial any property on command of the operator. The data is processed by standard spreadsheet or database programs to generate bills in either paper or machine-readable format for use by the property management companies.

However, such systems have a number of deficiencies. One deficiency is cost: units that are too costly will not be utilized in areas where the profit margins are too small or there is a relatively high probability of theft. Another deficiency shared by many systems is that the meters communicate with a central billing office via telephone lines, thus requiring additional installation of wires in the building, or at least requiring that telephone lines be located near the power lines.

US Patent No. 5,986,574 issued November 16, 1999 to Colton relates to a communication system which transmits data between a plurality of locations. The communication system is suitable for use by a utility provider to monitor a plurality of metering devices from a remote location.

WO 99/46746 relates to remote access to electronic meters using a TCP/IP protocol suite wherein an electronic meter incorporates a TCP/IP protocol suite and an HTTP server to provide two-way access to a meter incorporated into a gateway serving multiple meters connected through a power line or wireless two-way network.

WO 99/57697 relates to a wireless area network communications module for utility meters. A communications module permits remote meter reading of a utility meter via a wireless modem that communicates using data packet networks along a communication system such as ARDIS.

US Patent No. 5,764,739 issued June 9, 1998 to Patton et al. relates to a method and apparatus for providing information, such as power consumption, to a subscriber over an electronic network in response to commands provided by a subscriber.

GB 2,306,852 relates to an apparatus and system which can be adapted to allow the selected functions of metering the use of consumers of utilities and particularly electricity, gas and water and the transfer of other data which allows the performance of, for example, an electricity substation to be monitored by the electricity power supplier.

Other prior art documents that have been considered are US-A-5897607 and CA-A-2279802.

However, none of US Patent No. 5, 986, 574, WO 99/46746, WO 99/57697, US Patent No. 5, 764, 739, GB 2, 306, 852, US Patent No. 5, 897, 607 and CA 2, 279, 802 disclose interval metering.

The submetering market has several requirements that often fail to be met by existing submetering systems. Such requirements include:

(1) stringent metering standards found outside the United States such as those of Industry Canada and the International Electrotechnical Commission (a European standards organization with applicability to most of the world outside of North America). Not only must a submeter meet electrical standards, it must comply with strict mechanical standards as well.

(2) Communication with the submeter is required outside of densely populated urban areas, where electrical distribution transformers are not necessarily located near phone lines.

(3) There is an emerging need of electric utilities to provide on-line metering databases over the Internet. This need also includes providing this information to generation companies or Energy Service Companies (ESCOs) often located very distant from the customer. Such entities require delivery of information not available with standard electro-mechanical meters.

(4) Low-cost, high-volume manufacture.

SUMMARY

Various aspects of the present invention are defined in the independent claims. Some preferred features are defined in the dependent claims. In one aspect, the present invention comprises a system for monitoring energy usage on a power line. Preferably, this system comprises (a) an electronic microprocessor-controlled digital electricity metering device connected to the power line and comprising a non-volatile non-battery-powered data-storage device, wherein the metering device is operable to perform interval metering for each of a plurality of intervals, and receive a data request and transmit data in response to the request over the power line; and (b) a data collector (preferably, a transponder) connected to the metering device via the power line capable of (i) receiving data from and transmitting data to the metering device over the power line, (ii) storing data received from the metering device over the power line, and (iii) receiving data from and transmitting data to a remotely located computer (preferably, a billing computer), wherein the data acquired by said interval metering is stored in a manner that enables recovery of measurements for individual intervals of said plurality of intervals.

BRIEF DESCRIPTION OF THE DRAWINGS

**FIG. 1** is an overall installation diagram for a preferred embodiment of the present invention.
**FIG. 2** is an installation diagram for a slave transponder.
**FIG. 3** is a substation installation diagram of a master transponder.
**FIG. 4** is an aerial transformer and coupling diagram.
**FIG. 5** is a phase-to-phase inductive pad mount coupler diagram,
**FIG. 6** is a signal transformer assembly diagram.
**FIG. 7** is a concentrator/signal unit diagram
**FIG. 8** is a master and slave transponder power adapter diagram.
**FIGS. 9A-B** and **10** provide a Display Board schematic diagram.
**FIG. 11A** provides a 10 series preferred embodiment power board schematic diagram.
**FIG. 11B** provides a **KYZ** schematic diagram.
**FIG. 11C** is a 20 series preferred embodiment power board schematic diagram.
**FIGS. 12A-C, 13**, **14**, and **15A** provide a Transponder schematic diagram.
**FIGS. 15B-C** provide a Mini Closet Interface schematic diagram.
**FIG.16** is an Optical Adaptor schematic diagram.
**FIGS. 17A-B** is a Modem Board schematic diagram.
**FIG.17C** shows a schematic of the pulse expansion circuit.
**FIG. 18** depicts a configuration of a preferred submeter system.
**FIG.19** shows how electrical parameters are accumulated in preferred software.
**FIG. 20** depicts overall meter hardware of a preferred embodiment.
**FIG. 21** depicts preferred PLC receive circuitry for an ASIC.
**FIG. 22** is a diagram of a preferred two-pole lowpass filter used in an ASIC.
**FIG. 23** depicts a preferred embodiment of the present invention used to address electricity theft.
**FIG. 24** depicts a system configuration for preferred embodiment of a virtual meter.
**FIG. 25** depicts two preferred configurations for power interruption using GFI.

DETAILED DESCRIPTION OF PREFERRED EMBODIMENTS

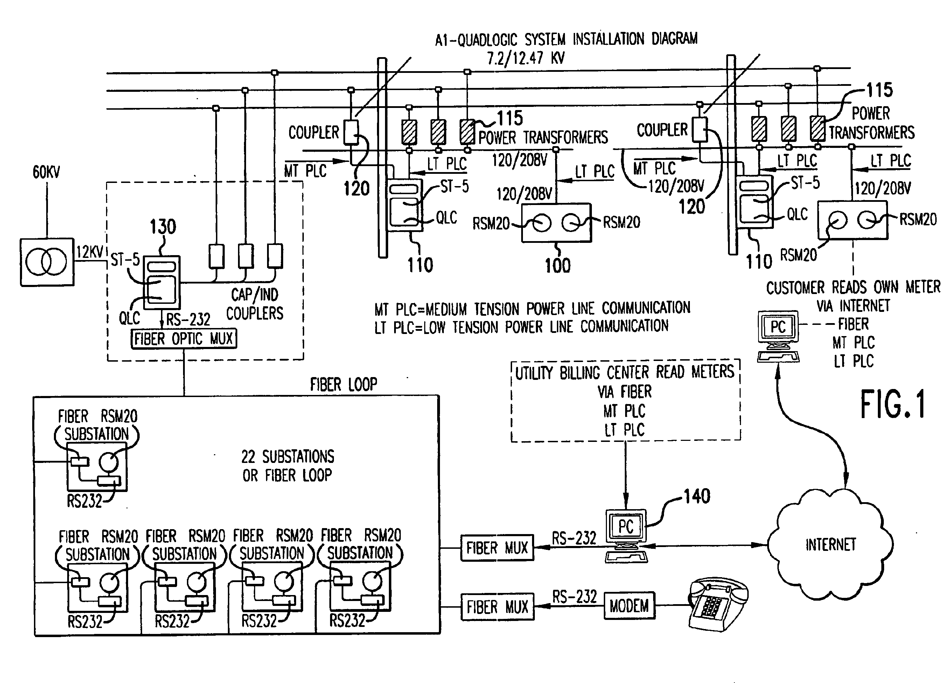

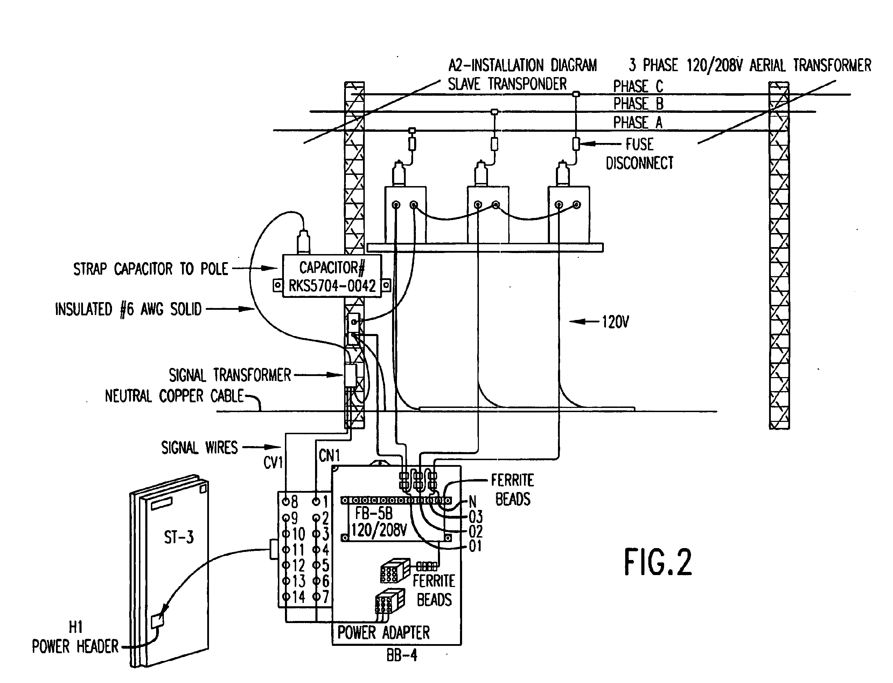

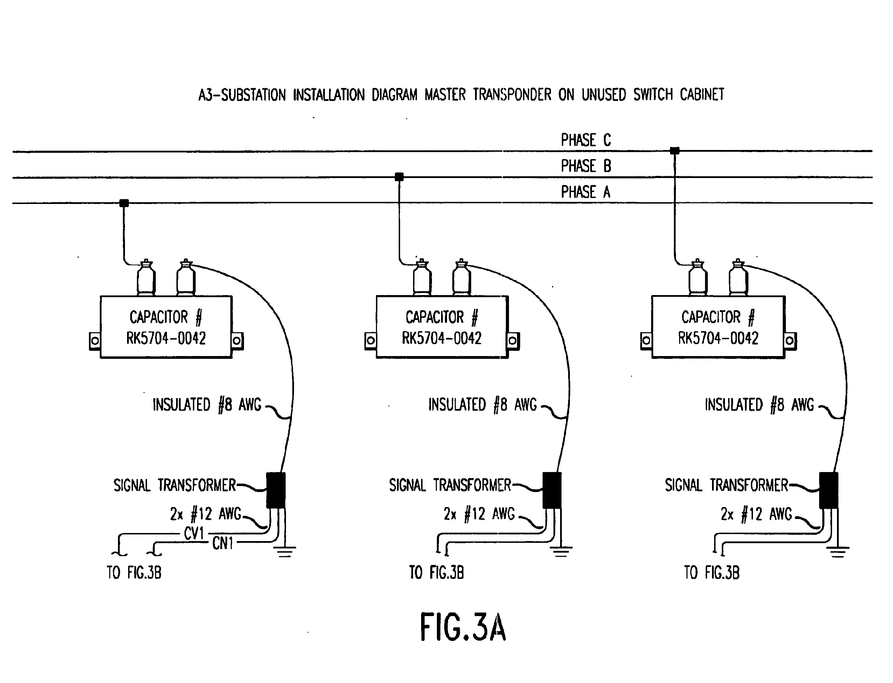

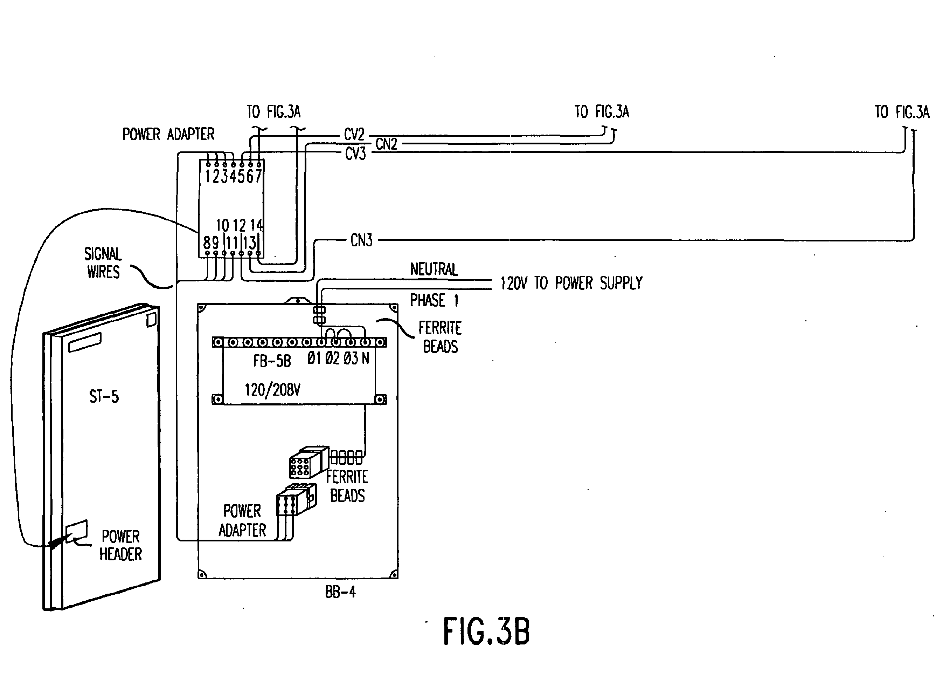

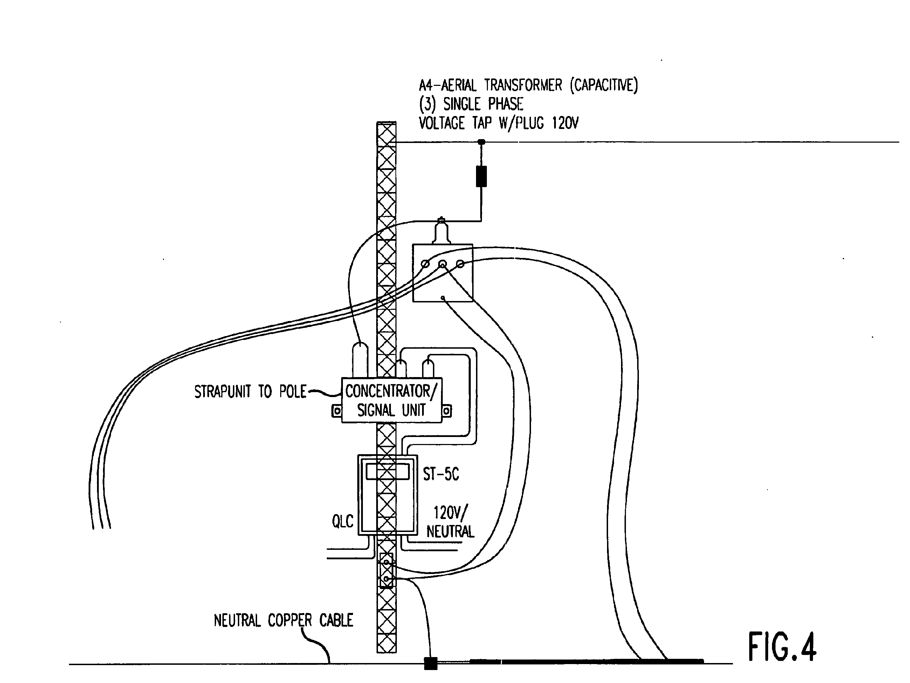

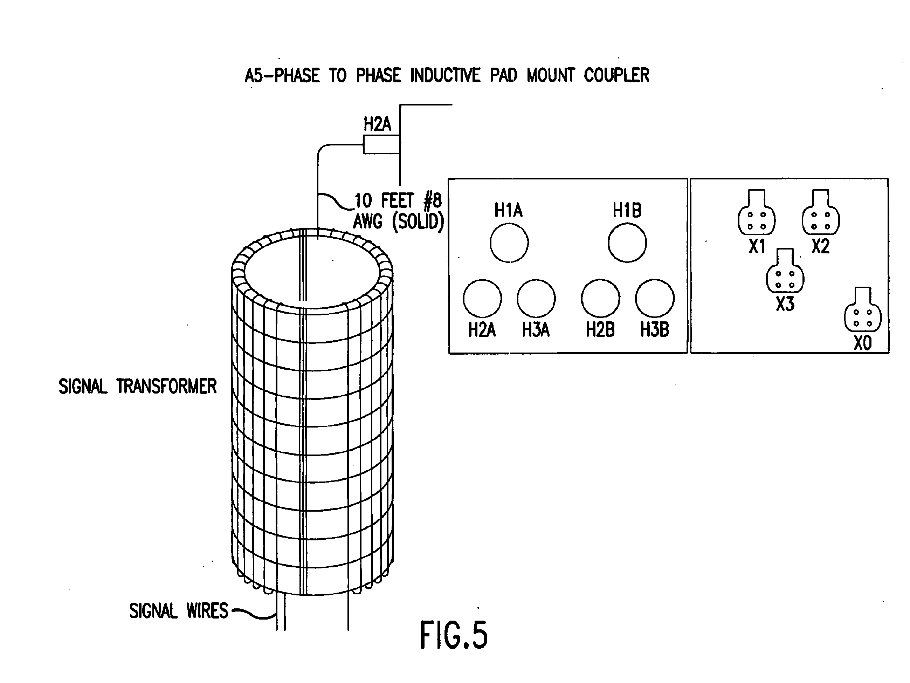

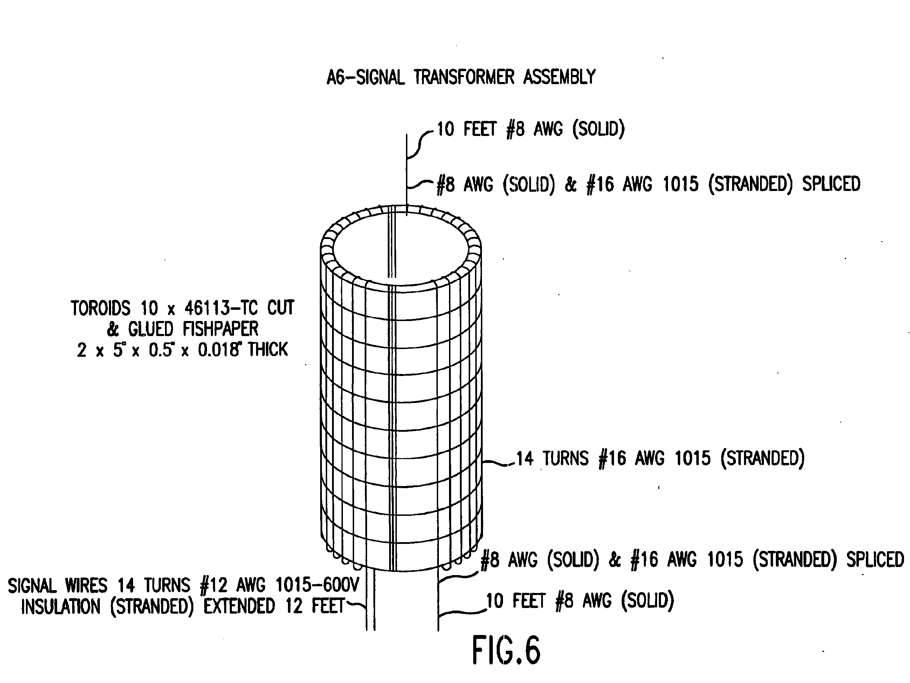

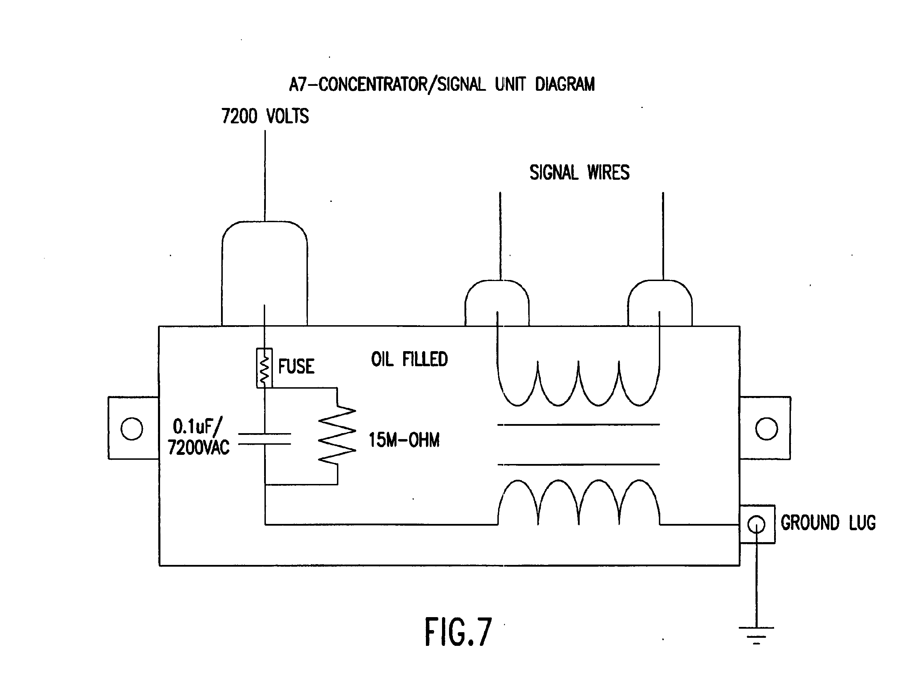

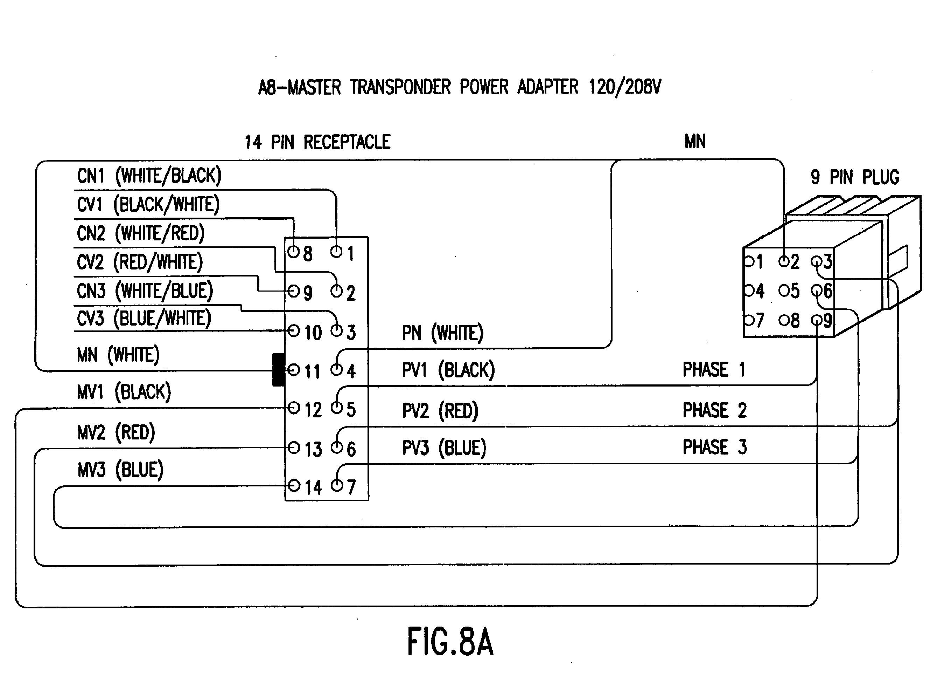

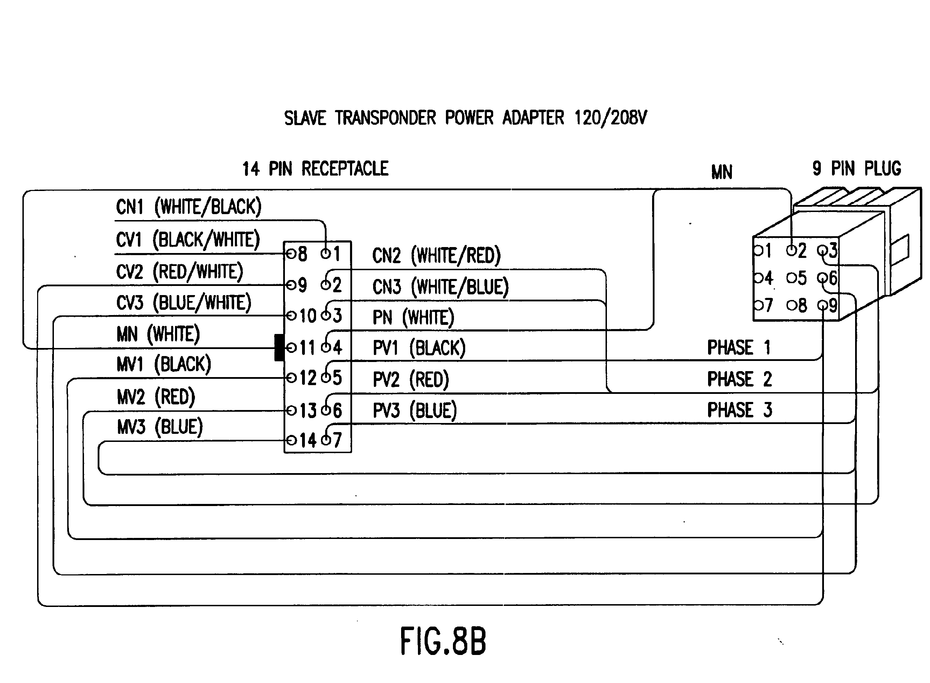

A full system drawing for a preferred embodiment of the present invention can be found in **FIGS. 1- 8**. The system preferably reads meters using four communications media: low voltage (120 volt) power lines, medium voltage distribution lines (12, 500 volt), a municipal fiber optic communications ring, and the Internet. **FIG. 1** is an overall installation diagram for a preferred embodiment of the present invention. **FIG. 2** is an installation diagram for a slave (low- level) transponder. **FIG. 3** is a substation installation diagram of a master (high- level) transponder. **FIG. 4** is an aerial transformer and coupling diagram. **FIG**. **5** is a phase- to- phase inductive pad mount coupler diagram. **FIG**. **6** is a signal transformer assembly diagram. **FIG. 7** is a concentrator/ signal unit diagram. **FIG. 8** is a master and slave transponder power adapter diagram.

The system and method of a preferred embodiment of the present invention comprises the following components (see **FIG. 1):**

(1) Transmeters **100**. These are the meters which monitor electricity, gas and water at the customer site.

(2) Low-level Transponders **110**. Utility distribution systems have distribution transformers **115** to bring medium voltage distribution voltages (4xV through 33kv) down to the low voltages (120-600 volt) connected to the customers. Low-level Transponders communicate with the Transmeters and with high-level Transponders **130** located at substations. Transponders of either type are referred to herein as "data collectors" or simply as "transponders." The context of usage will convey to those skilled in the art whether the transponder being discussed is a high- or low-level transponder, and whether the distinction is relevant. Referring to the embodiment illustrated in **FIG. 1**, high-level Transponder **130** requests data from a low-level Transponder **110**, which then requests the same data from a Transmeter **100** connected to the same distribution transformer. A low-level Transponder **110** preferably communicates on the medium distribution voltage using a coupler **120**, which can be either: (A) an inductive coupler: a device that replaces the cable feeding the distribution transformer with medium distribution voltage (the inductive coupler has two signal wires that connect to the low-level Transponder), or (B) a capacitive coupler: a circuit that includes a capacitor and a signal transformer. Two signal wires connect to the Transponder.

A low-level Transponder **110** may have an optional meter with 24 channels. These channels can be used to measure energy delivered on up to 24 phases of individual feeders leaving the distribution transformer. This data may be used to identify losses by comparing aggregate readings of all Transmeters **100** connected by phase and by feeder to the known reading at the low-level Transponder. These losses may be caused by theft of service. Identification of theft of service is a feature of a preferred embodiment of the present invention.

**High-level Transponders**

A high-level Transponder ("Transponder 5") **130** communicates with Low-level Transponders **110**, requesting specified data from specified Transmeters. The data request is made first, and then high-level Transponder **130** polls the low-level Transponder at a later time to see whether the data is ready. The high-level Transponder may request data from several low-level Transponders in sequence and poll them later. Because higher data rates are possible on the medium voltage than the low voltage, the system may thus obtain greater reading efficiency. The Transponders connect to one of several network media to communicate with the billing computer: (A) fiber optic network; (B) hard wire RS-485 network; (C) TCP/IP LAN; or (D) telephone lines.

**Billing Computer**

A Billing Computer **140** connects one or many communications networks to read data from many Transponders. The Billing computer is programmed to respond to requests from the utility or requests made over the Internet, and to deliver the required information in a form that is portable to whatever billing software the utility uses, typically MV-90.

Billing Computers may be interconnected over the Internet to form a WAN. The user accessing the site does not need to know which Billing Computer is requesting the information, nor the route to the high-level Transponder or low-level Transponder en route to the source of the information, the Transmeter.

**Internet Interface**

In a preferred embodiment, an Internet interface at the Billing Center allows the utility or its customer to access an Oracle database.

**Preferred Embodiments** - Common Features

Preferred embodiments of the submeter comprise a combination of a Display Board, a Power Board and a case to complete the product.

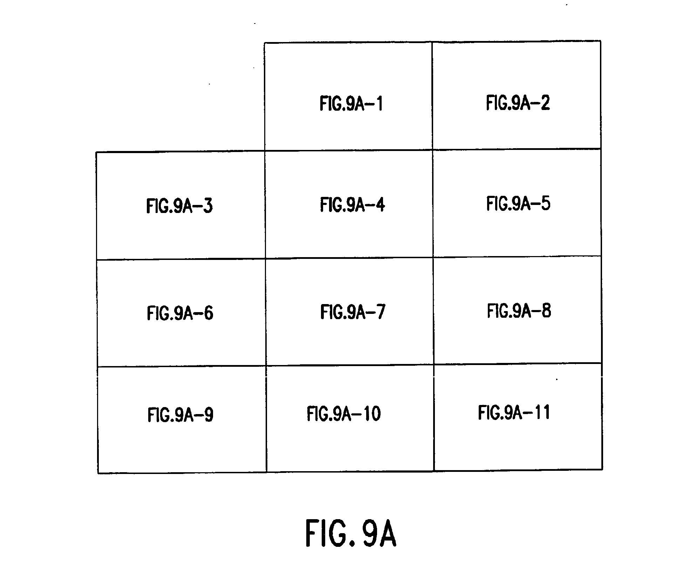

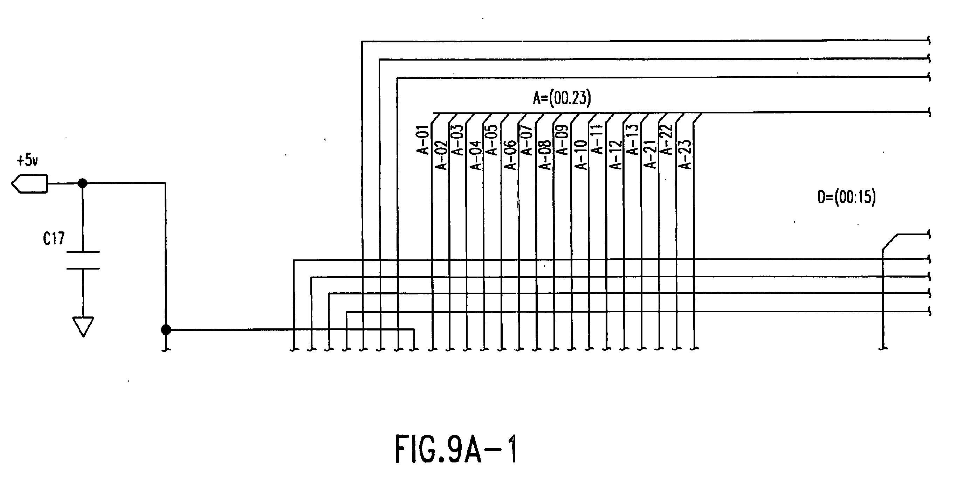

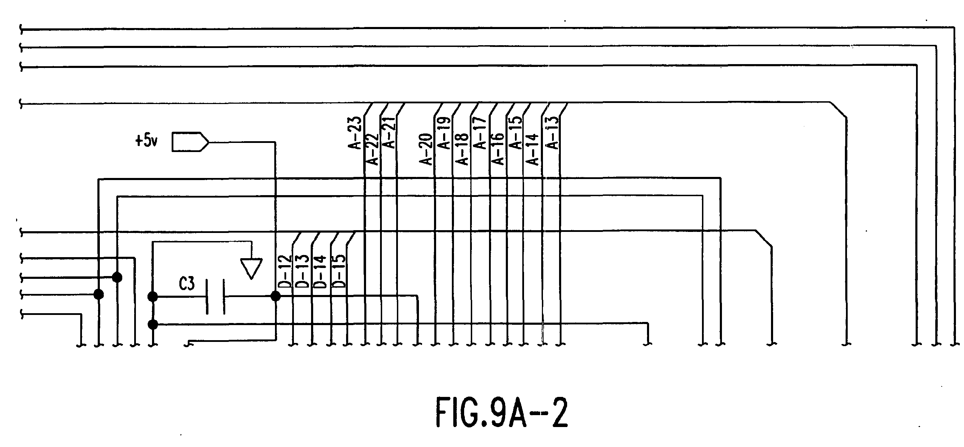

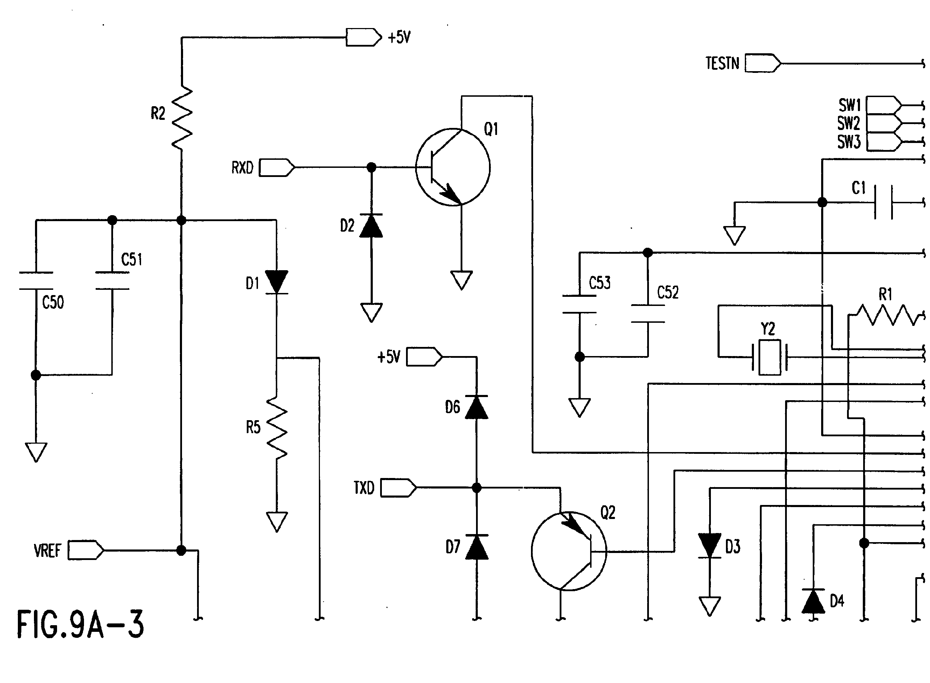

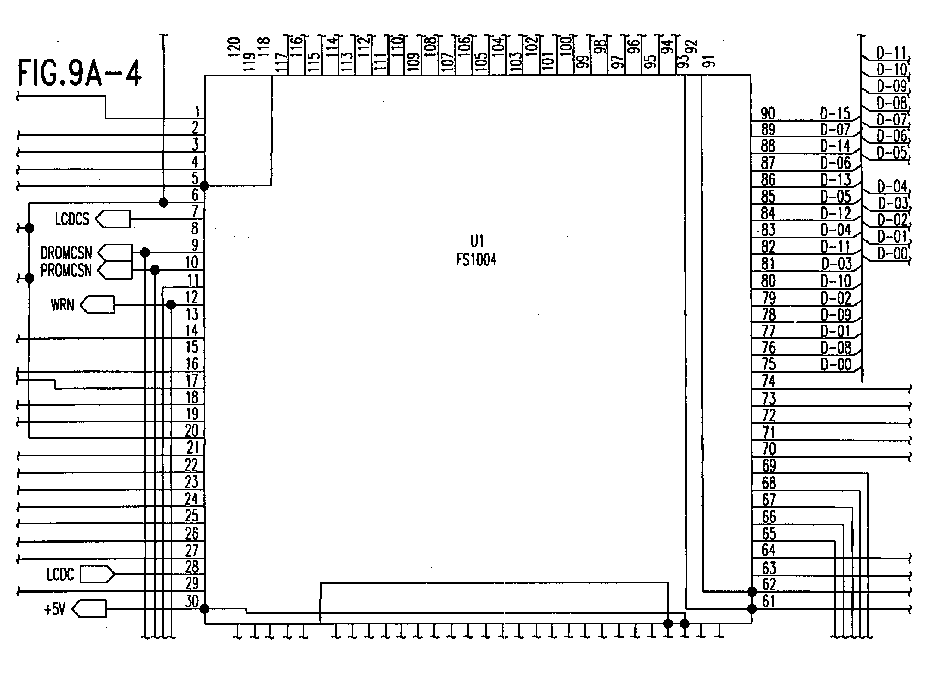

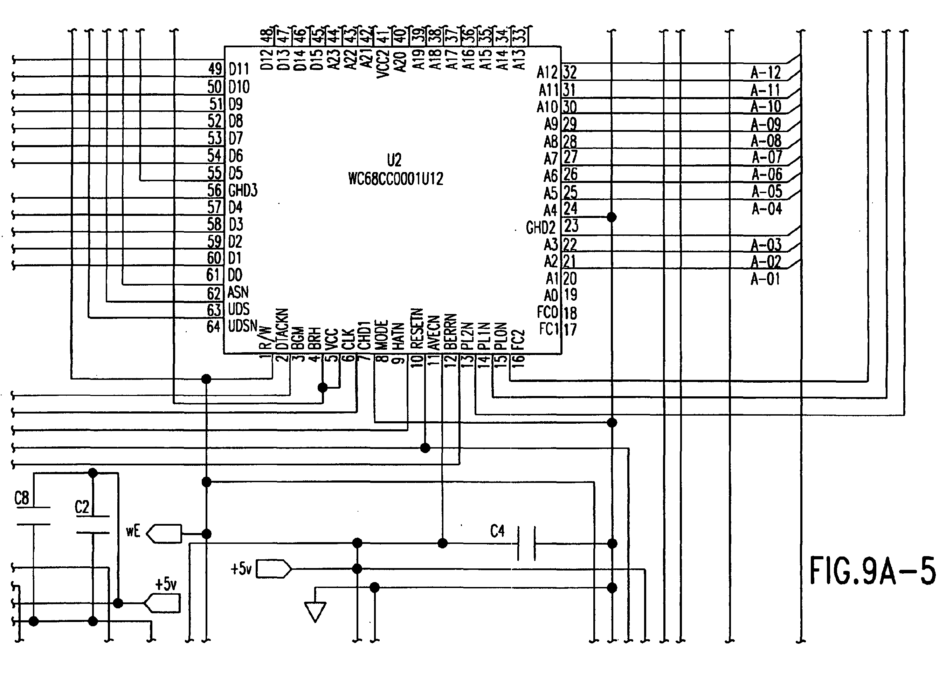

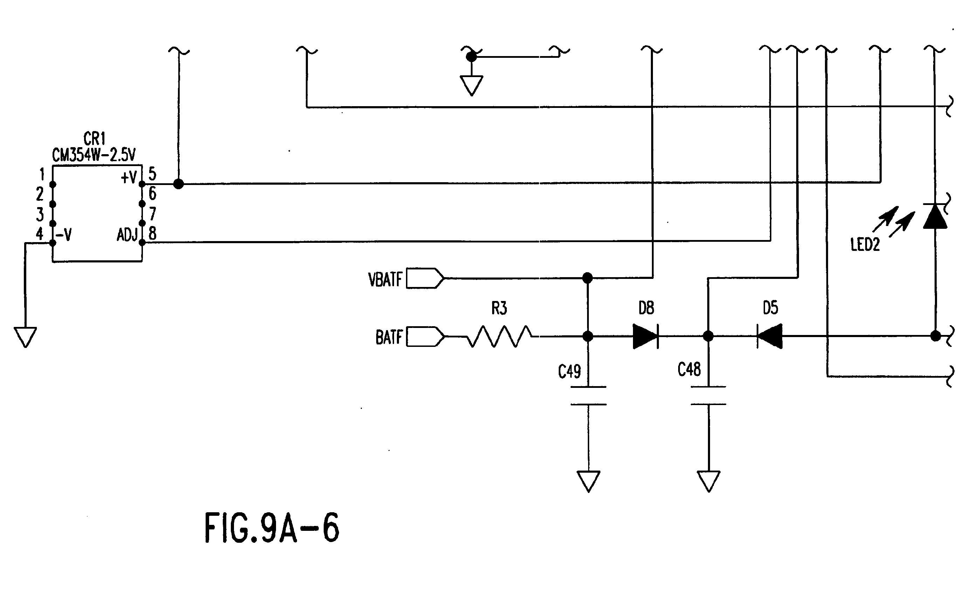

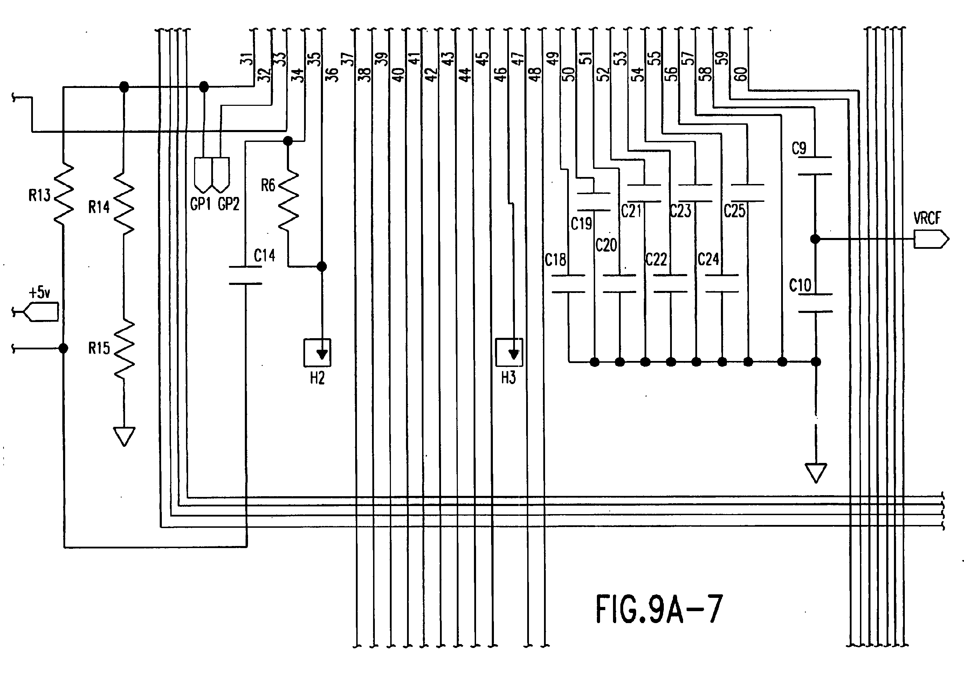

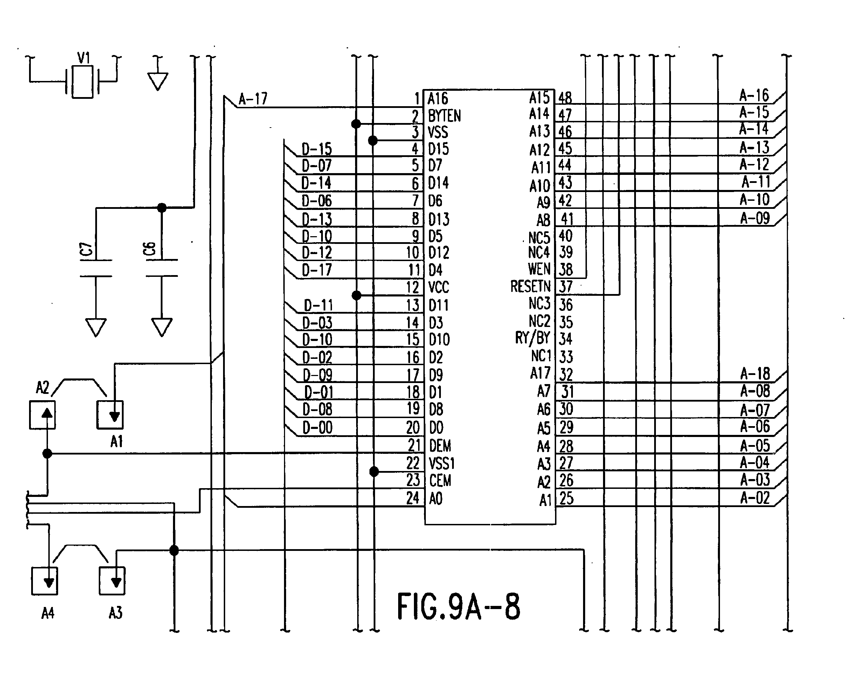

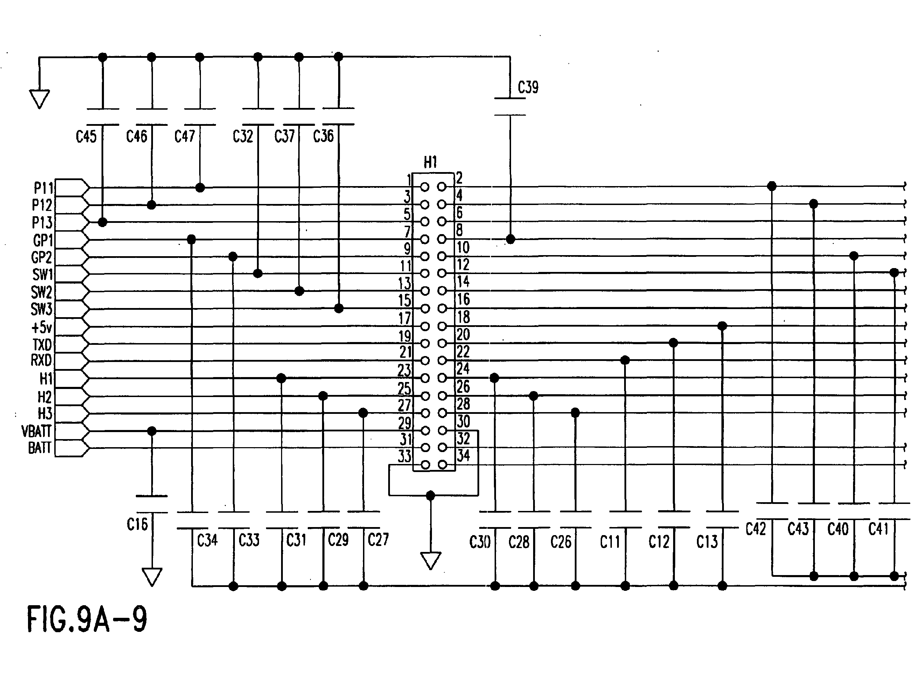

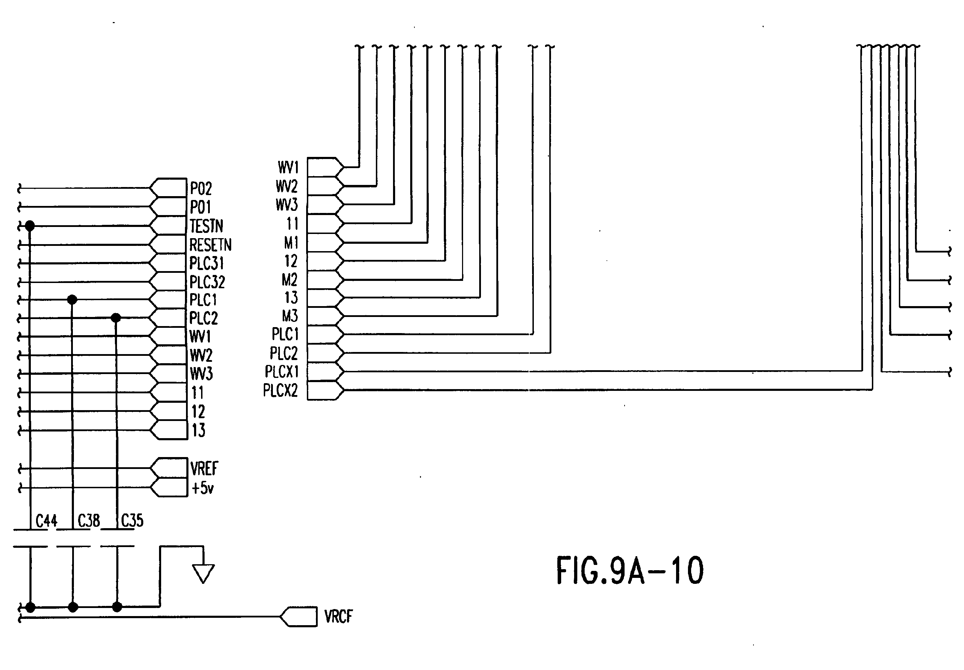

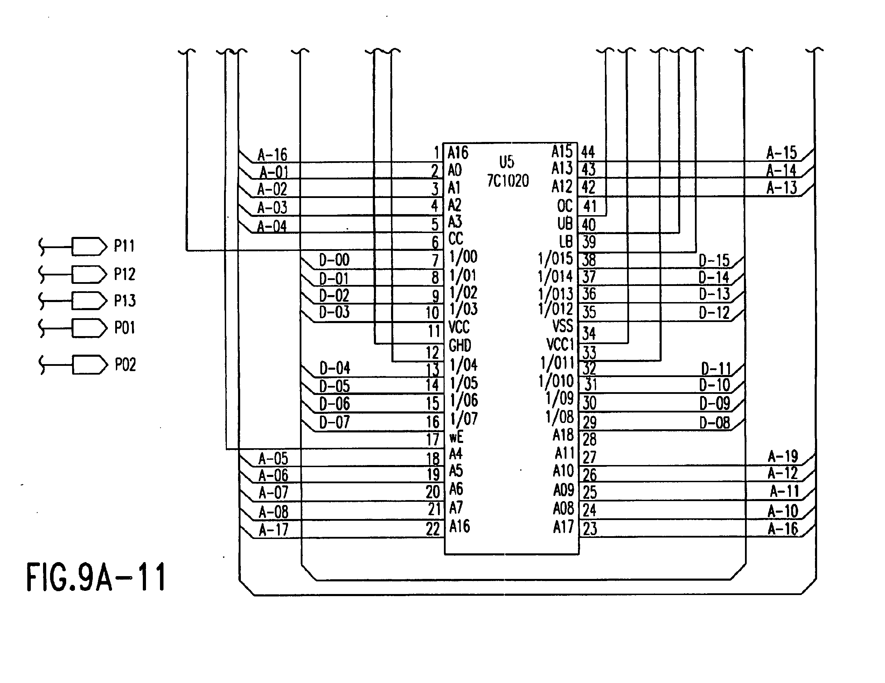

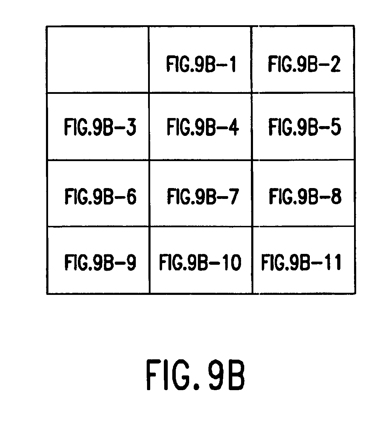

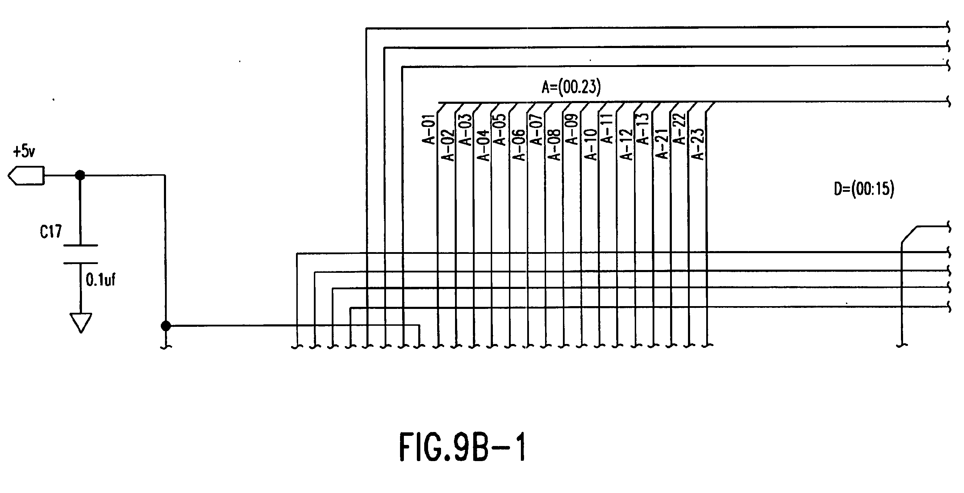

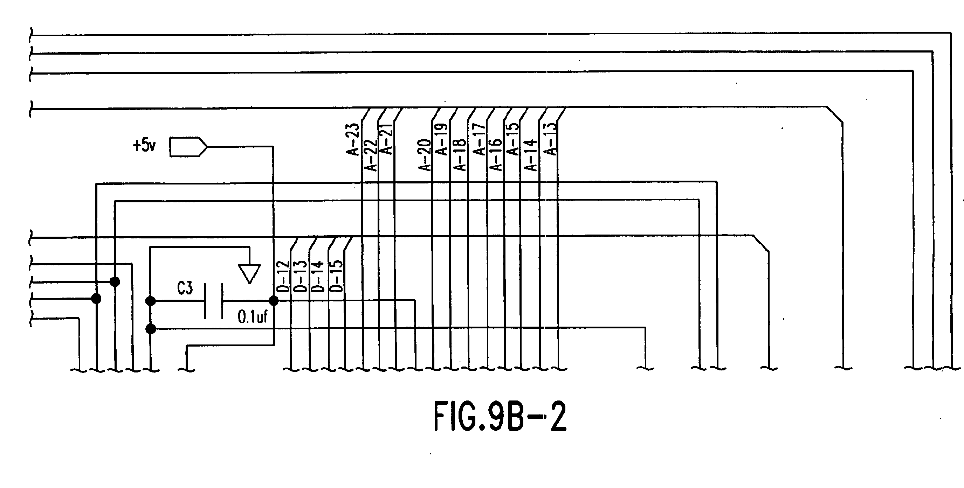

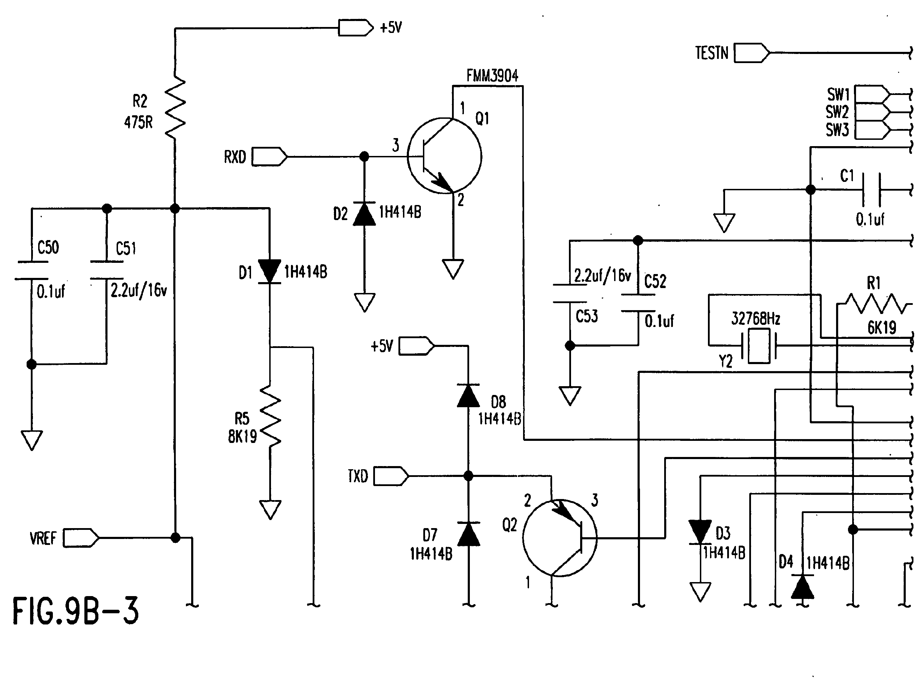

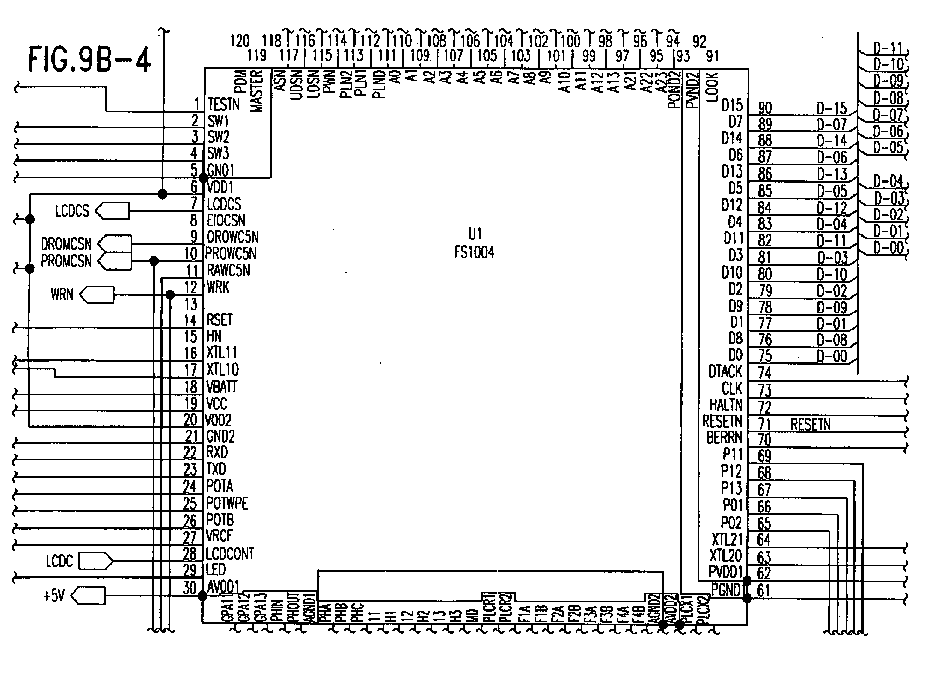

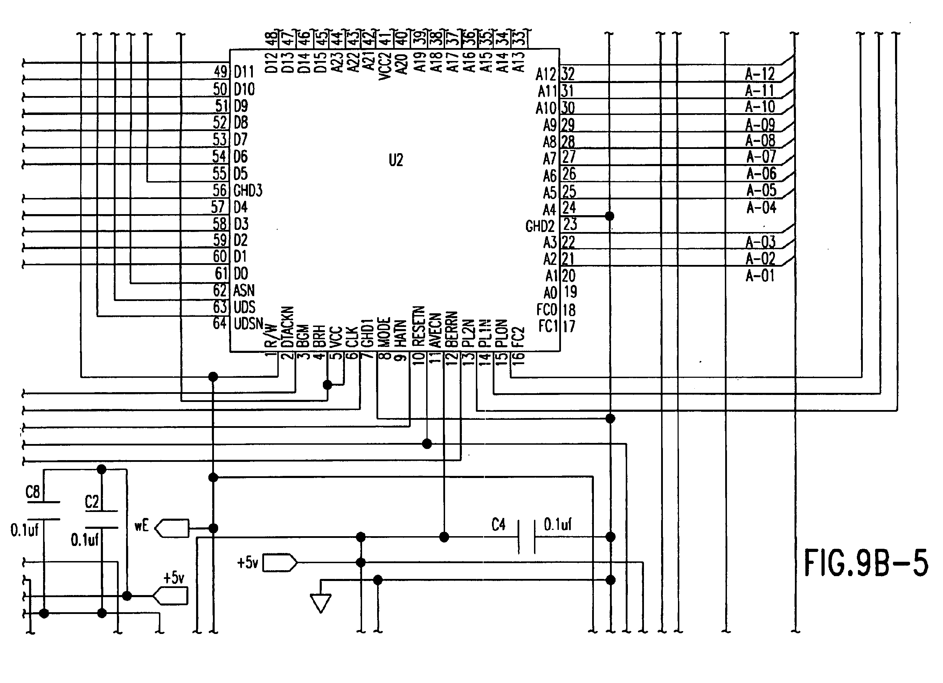

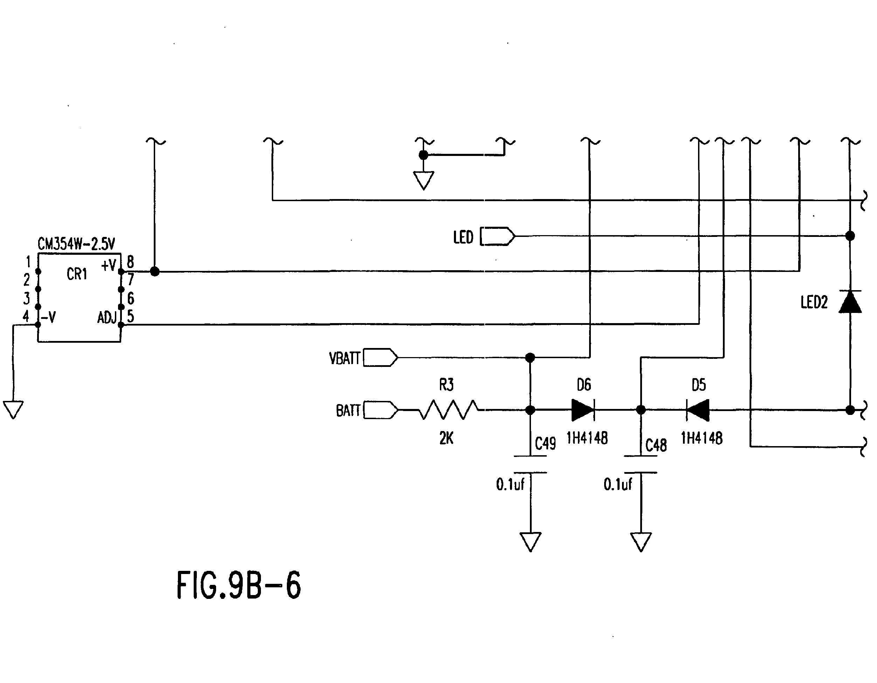

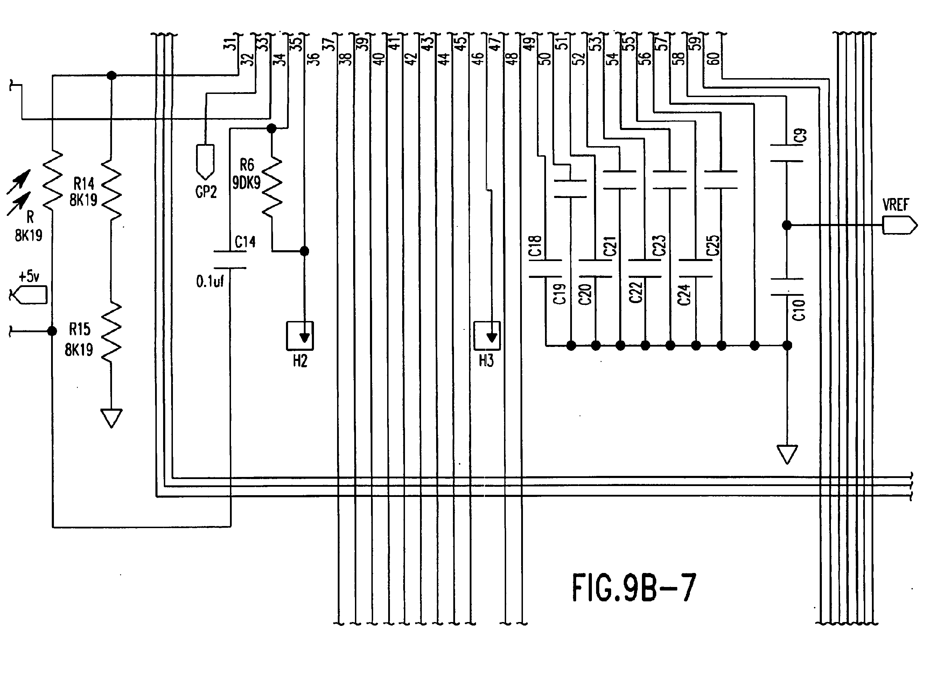

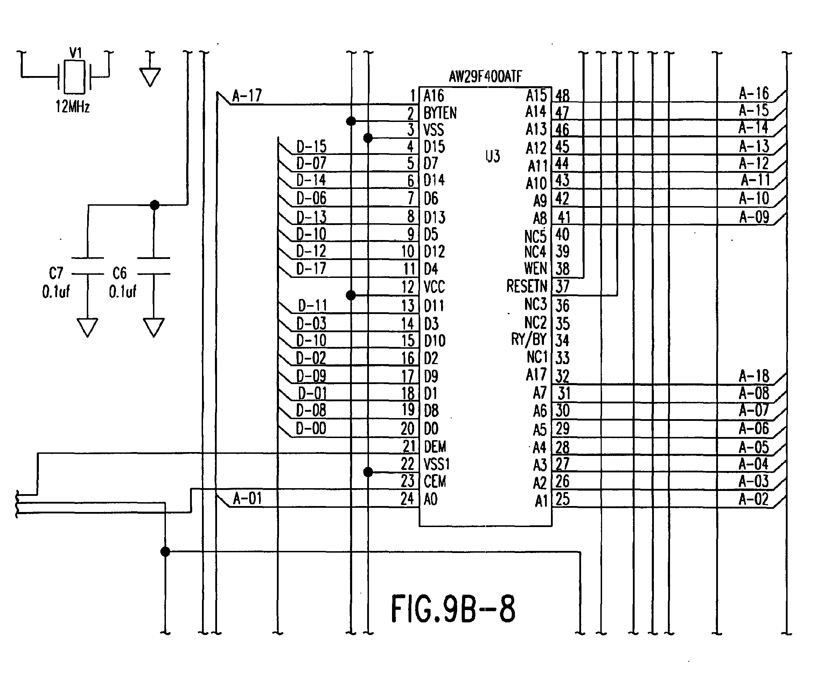

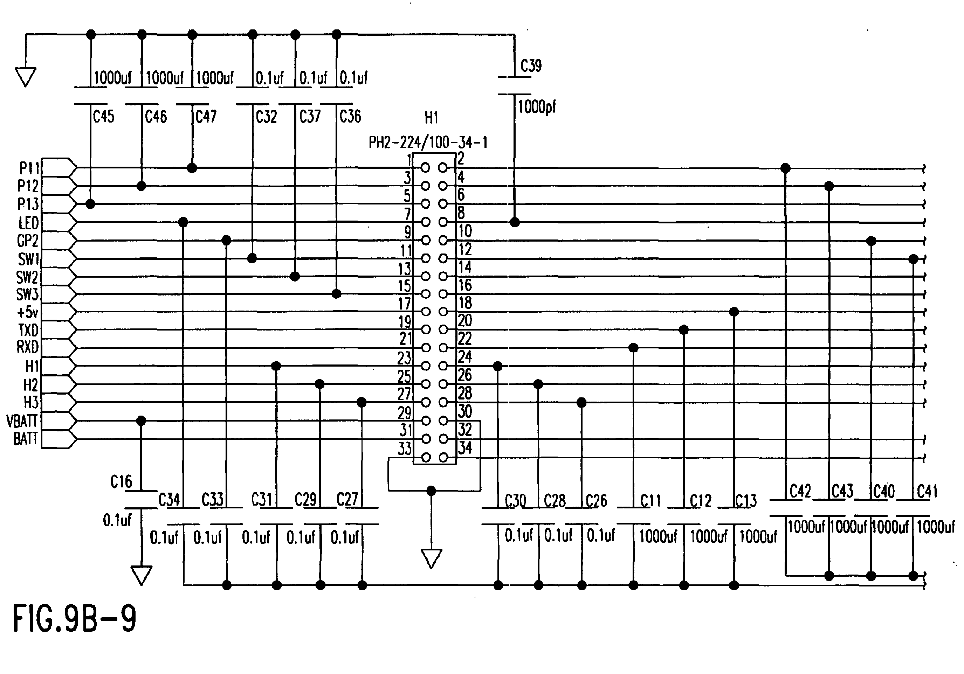

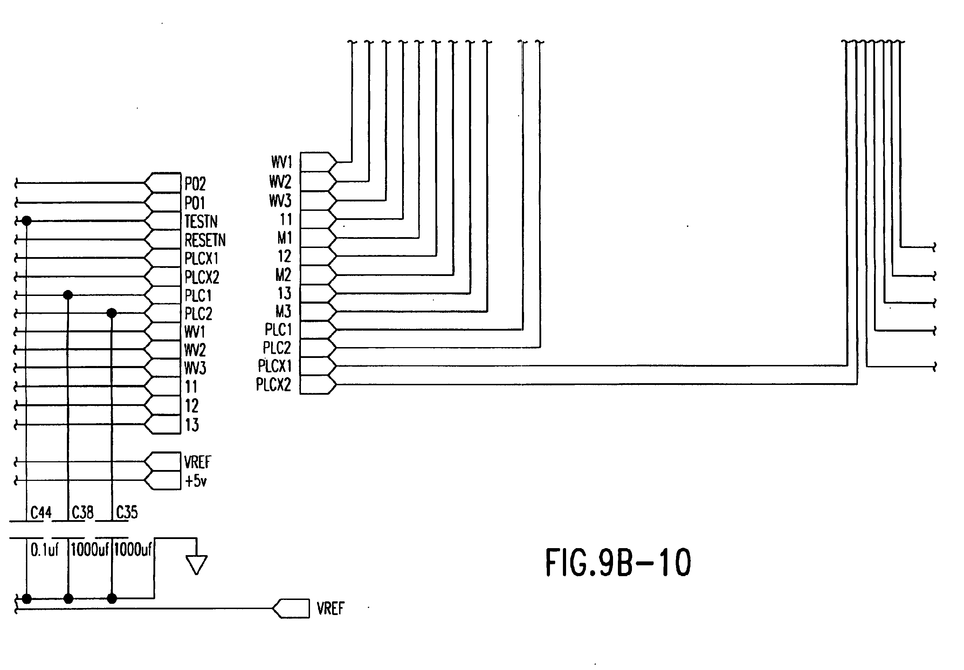

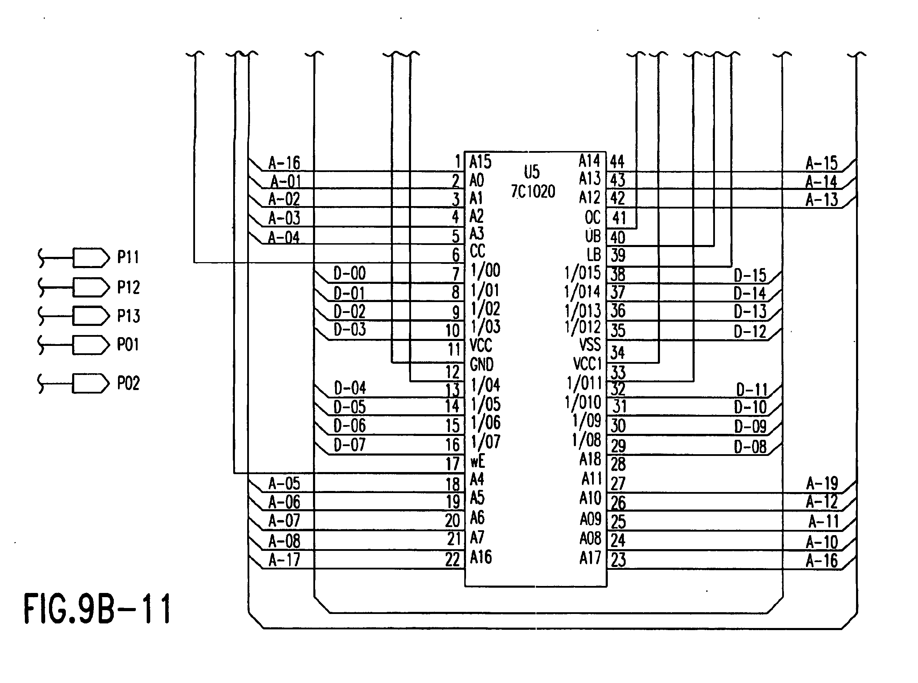

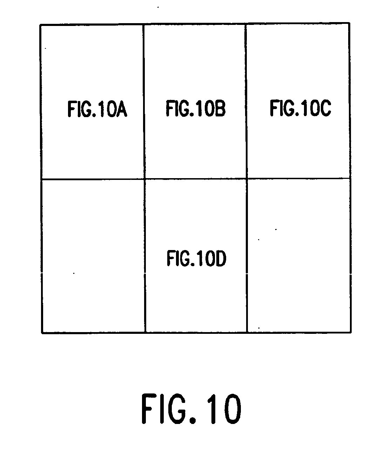

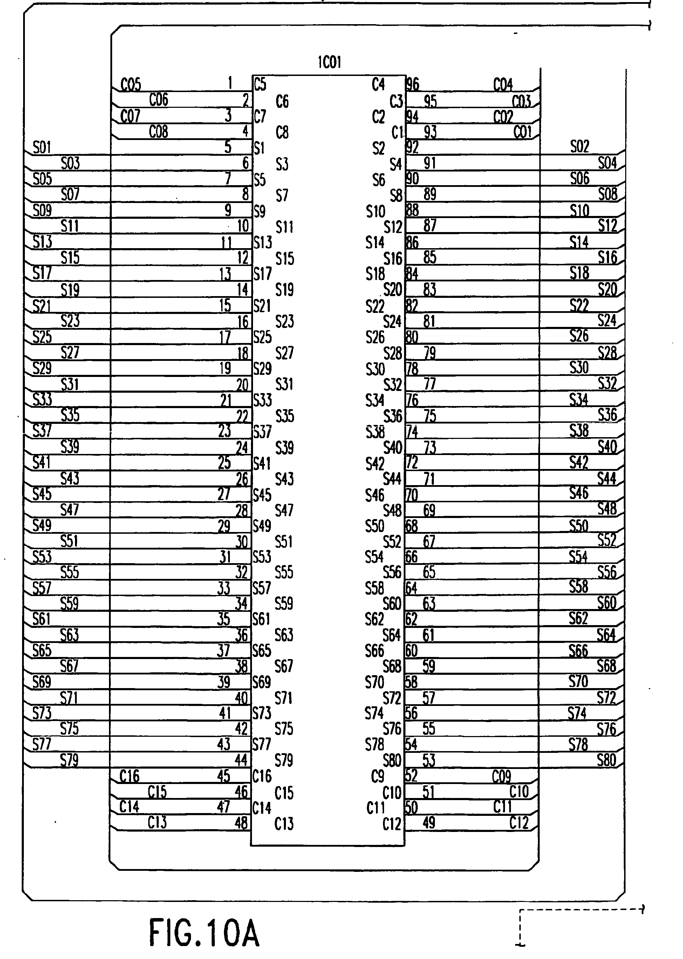

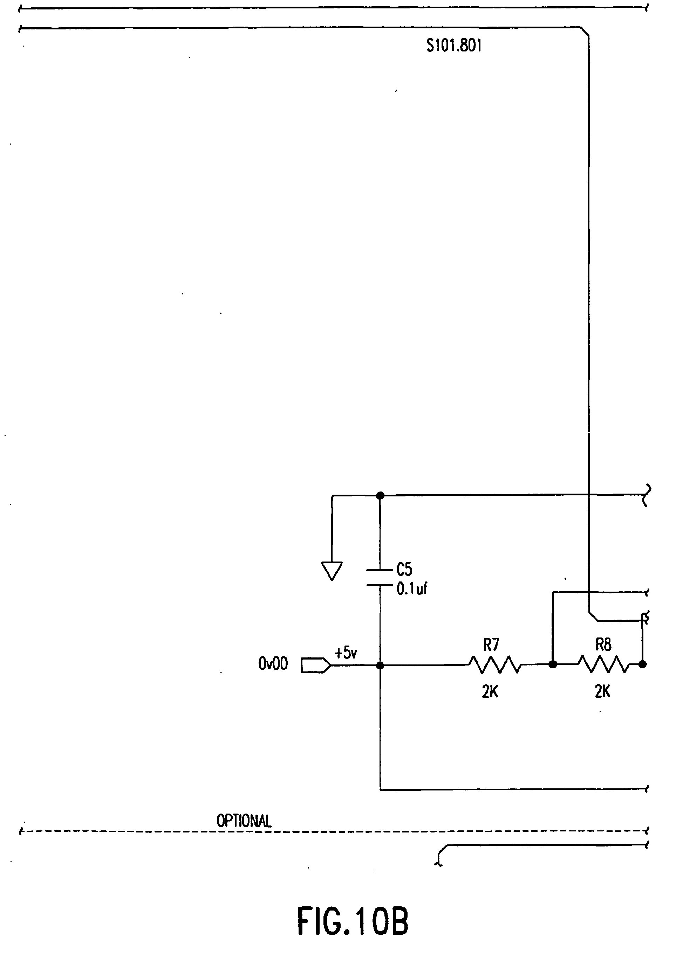

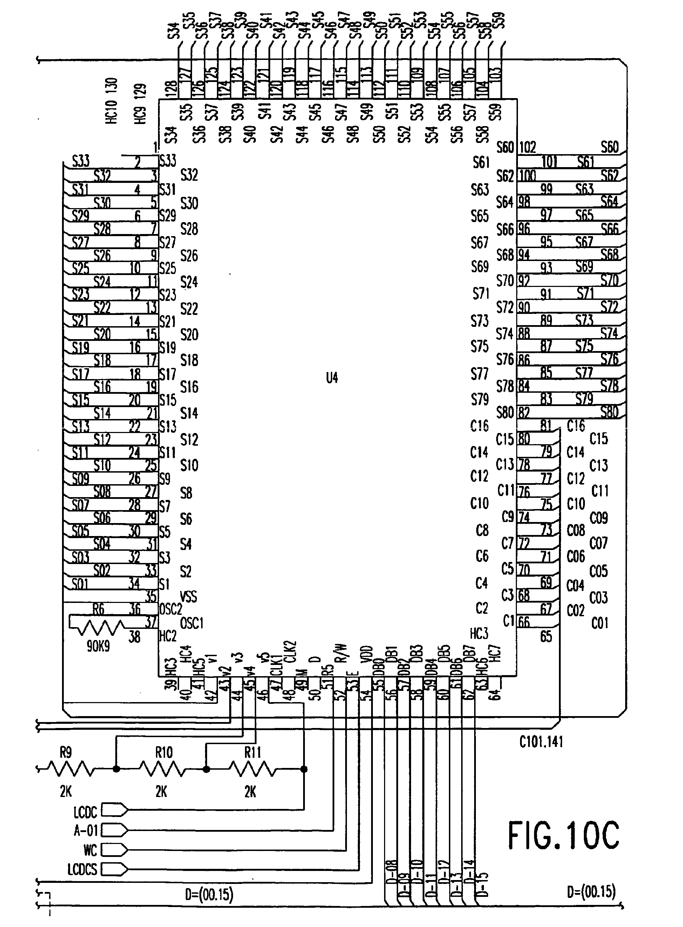

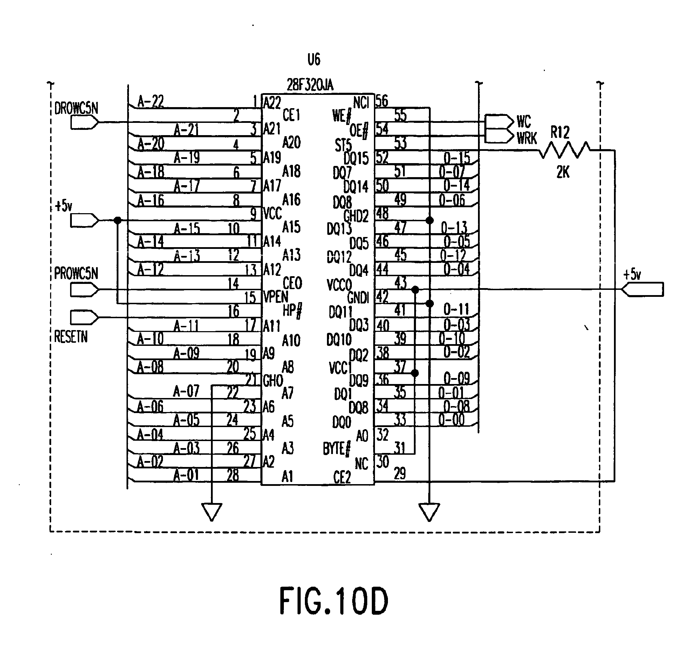

The Display Board is common to all embodiments. The Display Board schematic diagram can be found in **FIGS. 9A-B** and **10**. The Display Board has an application-specific integrated circuit ("ASIC") **U1,** a Motorola 68000 microprocessor **U2**, an LCD driver **U4** and display **LCD1,** a RAM memory (**U3** and **U6**), flash memory **U5** and a voltage reference **CR1.** The Display Board is preferably fabricated on a 5" to 2" 10 layer board with special care paid to ground planes. This affords improved protection against "fast transients," a type of interference found on power lines which often causes corruption of memory.

The Power Boards vary depending on the shape and connection requirements of the submeter. The power boards preferably contain power supply components, a battery for the real time clock, current and voltage interfaces, as well as optical, RS-232/485, modem, gas and water meter and other interfaces.

Flash memory **U5** maintains an audit trail of all critical metering (electric, gas and water) and events (power outages, tamper attempts, etc.). This audit trail forms a second line of defense against "fast transient" induced memory loss. The critical data is preferably stored at least every 15 minutes. The flash memory is most useful for storing firmware or archiving data. It does not function like a RAM. Unlike RAM memories, it is not susceptible to corruption due to "fast transients." With the preferred archiving method, maximum data loss can be controlled by selecting a frequent archiving period, minimizing the commercial importance of a memory loss. The flash memory audit trail of energy usage has independent commercial value to ESCOs, generating companies, and electric utilities under deregulation: energy can be sold at varying prices during the day, even on a 15 or 5 minute basis. The electric meter monitors each phase of the incoming power: electricity measuring volts; amps; real, reactive, and apparent energy and power; power factor; total harmonic distortion; and frequency.

The algorithms in the 68000 microprocessor control the ASIC (described in detail below) and are disclosed by the S-record file 28130104.S and improved version 38230102.S in the attached Appendix.

The submeter also counts contact closure transitions emitted from water and gas meters. Preferred submeters have a liquid crystal display, an optical port, and an (optional) RS-232/485 port.

Preferred submeters feature a power-line modem to communicate over the low voltage (120 volt, 220 volt, 480 volt or 600 volt) lines to a Transponder or Low-level Transponder.

In a first preferred embodiment (the "10 series"), the system comprises a small apartment-style submeter that mounts next to a breaker panel within a wall and uses current transformers mounted on the apartment feeders to sense current.

In a second preferred embodiment (the "20 series"), the system comprises: (1) a plug-in replacement for socket-style round ANSI meters; (2) gas and water contact closure accumulators, which continue accumulating by battery even if the electric power is removed; and (3) full complex plane (amplitude and angle) calibration of internal 10, 100, or 200 amp current elements to achieve a high level of calibration.

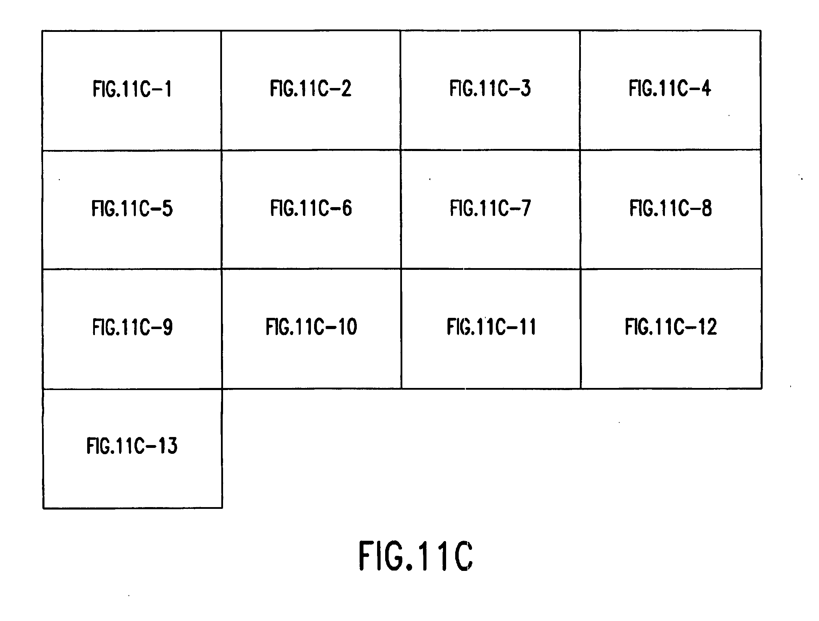

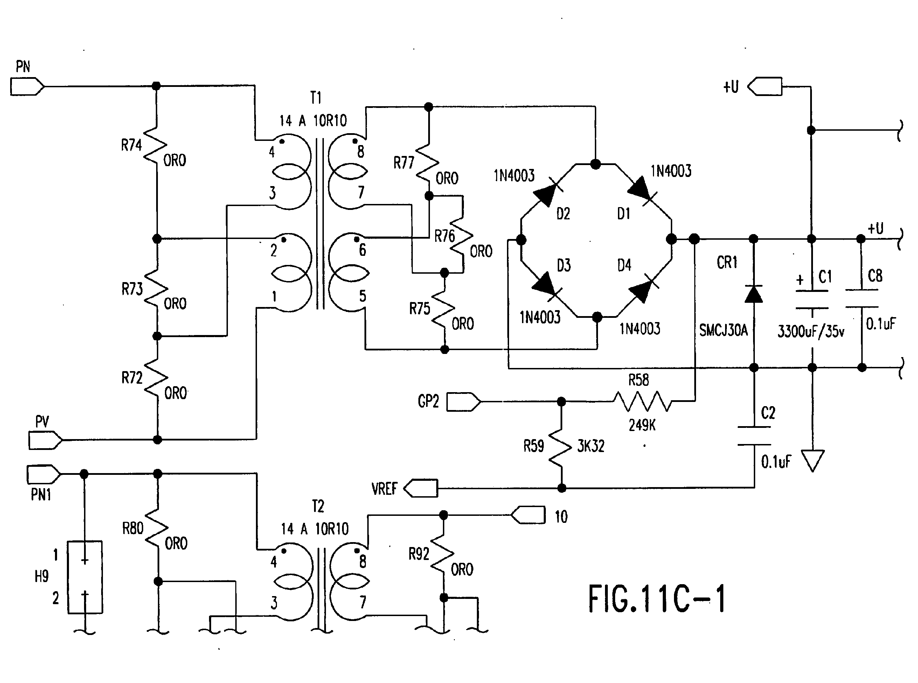

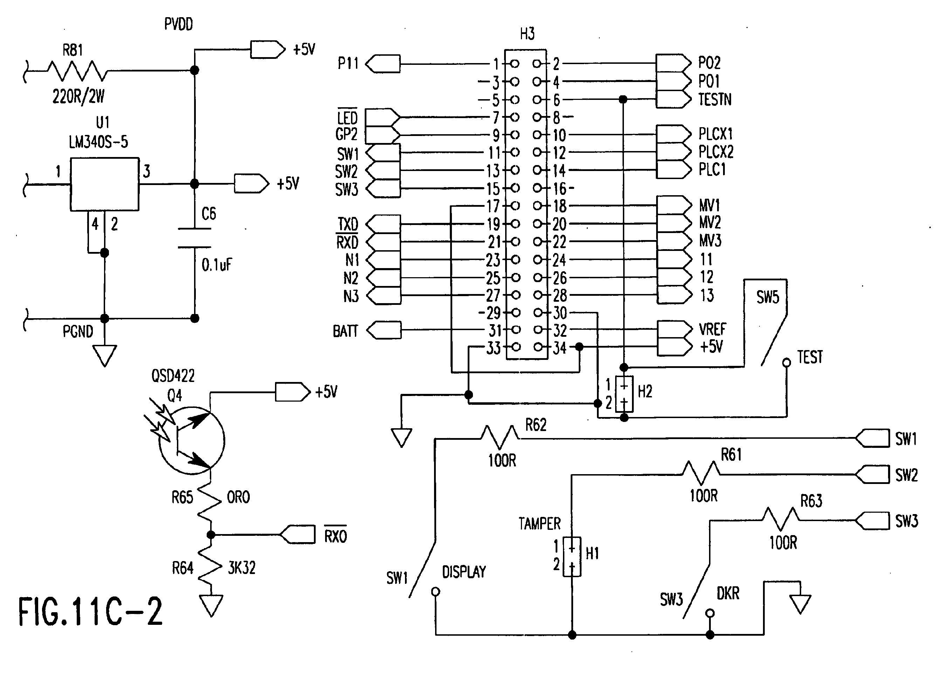

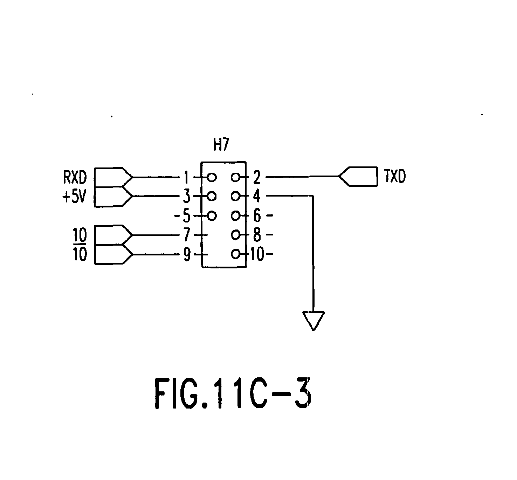

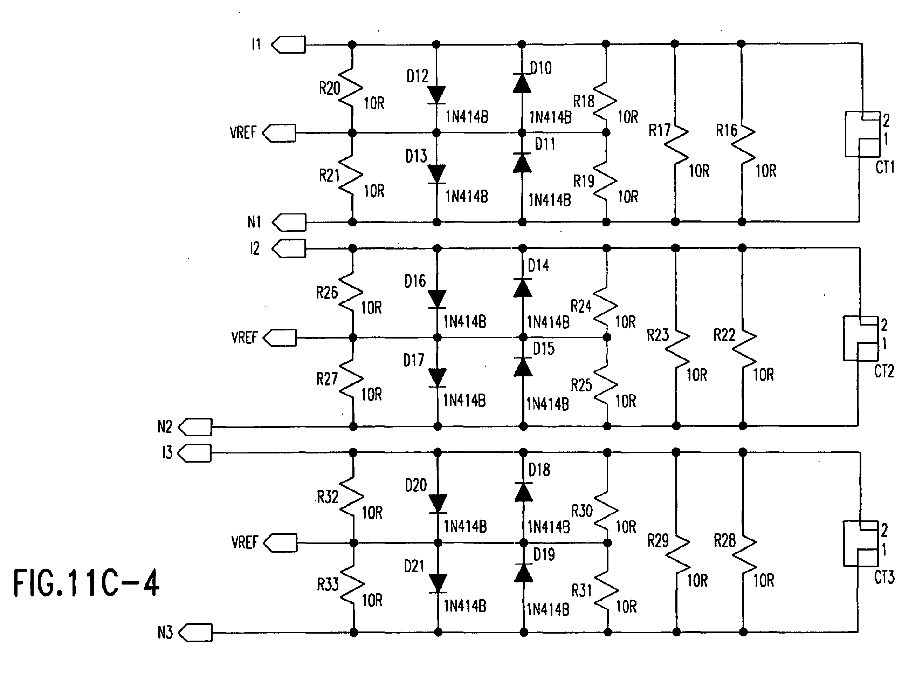

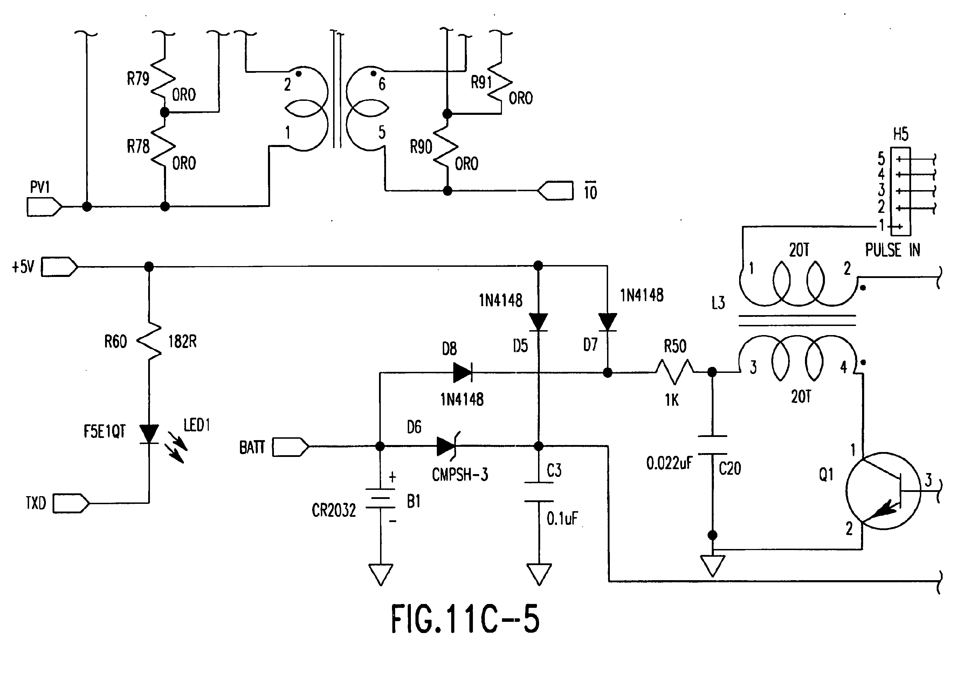

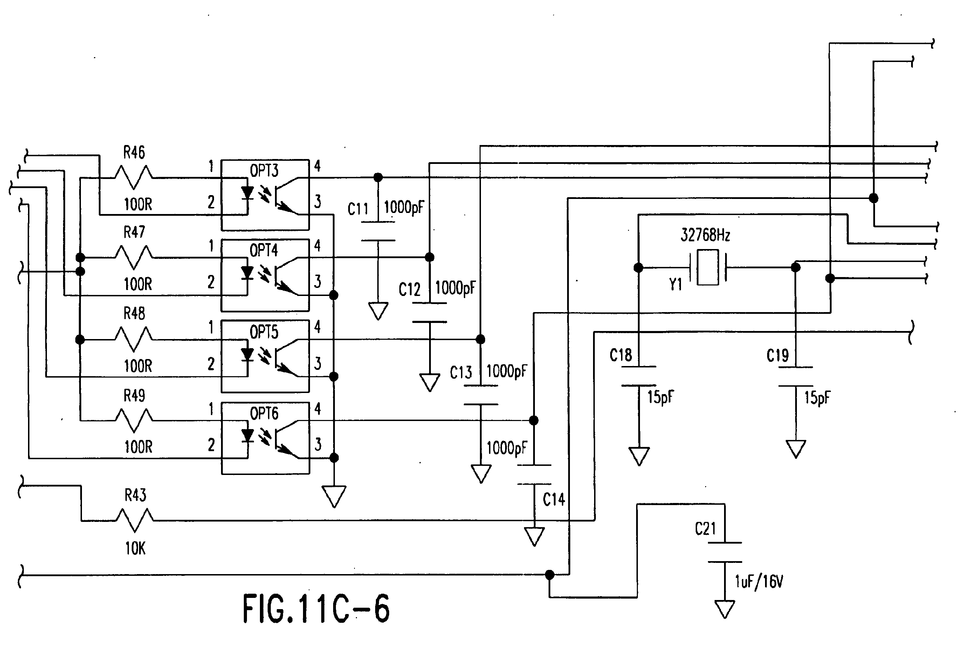

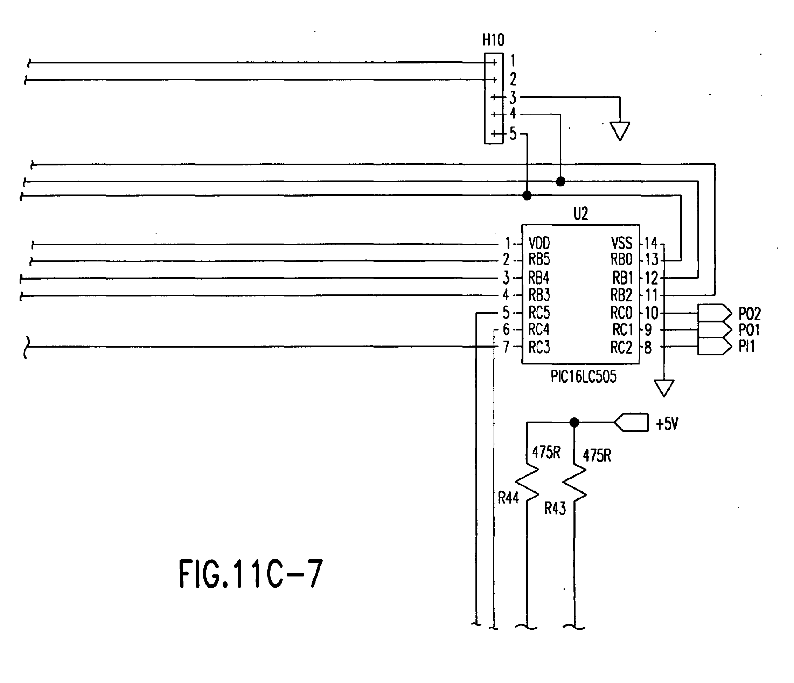

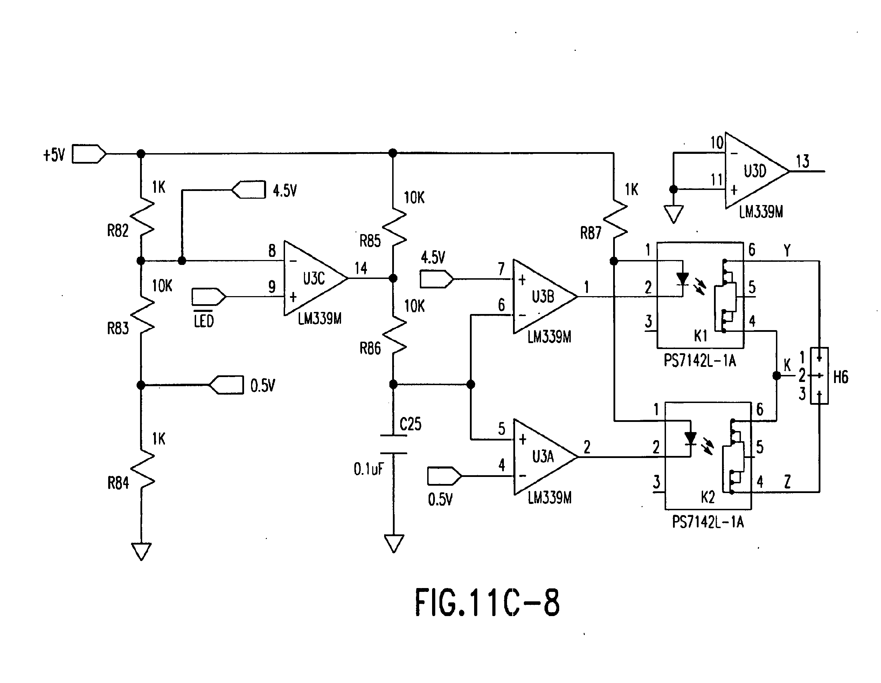

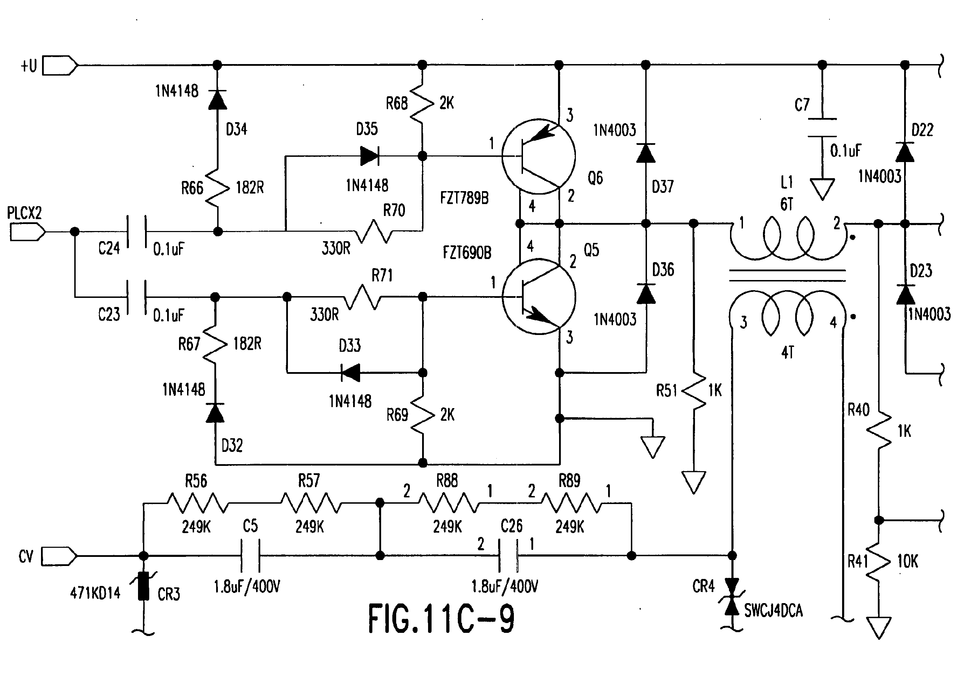

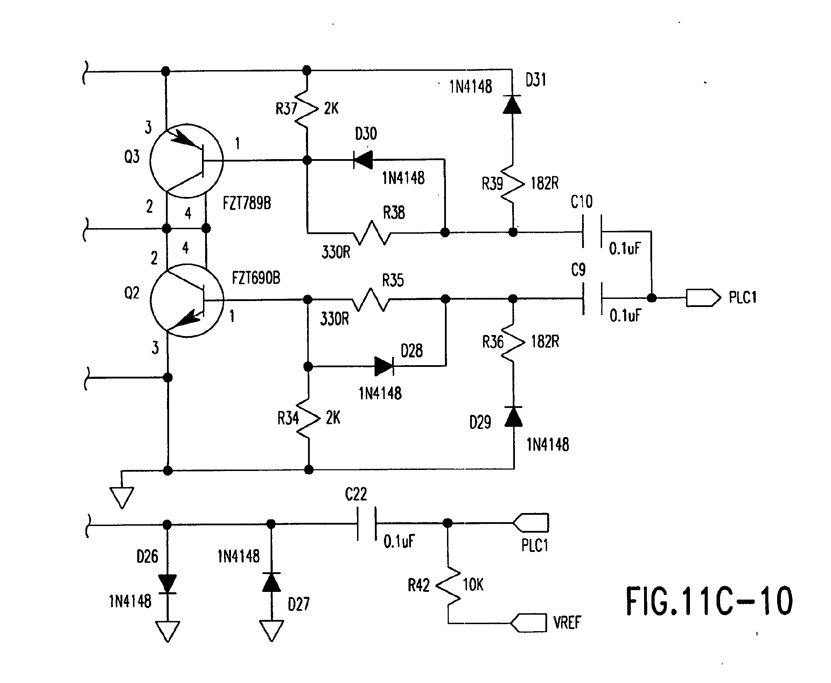

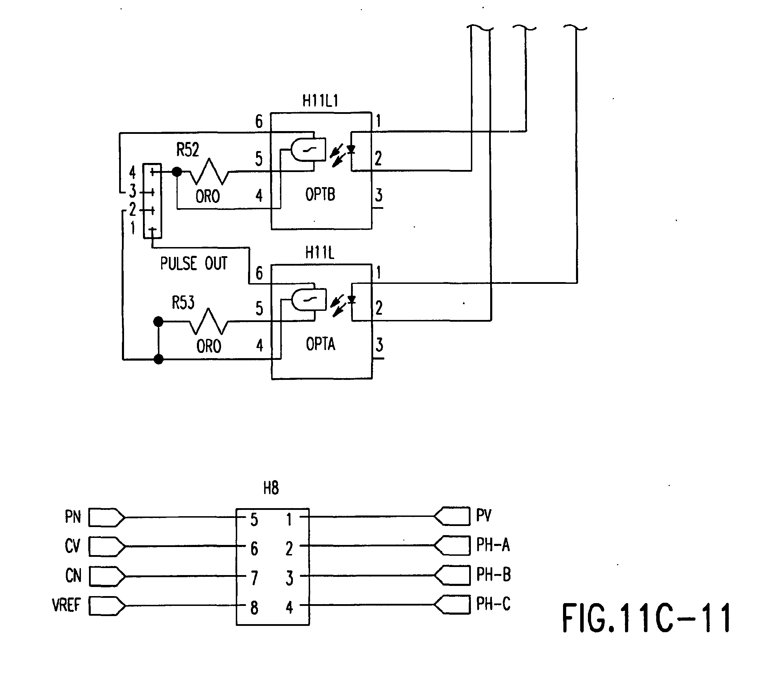

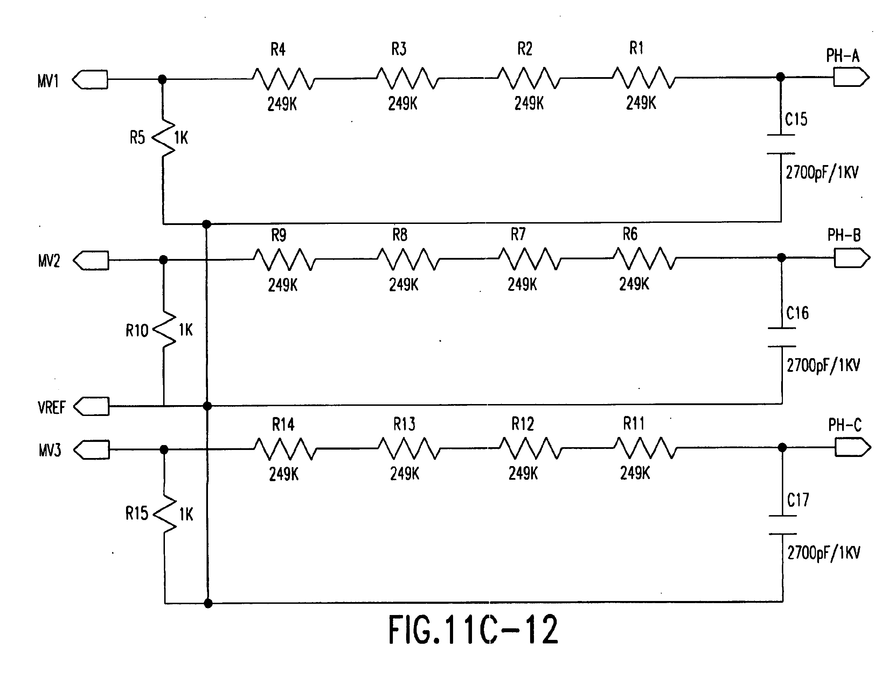

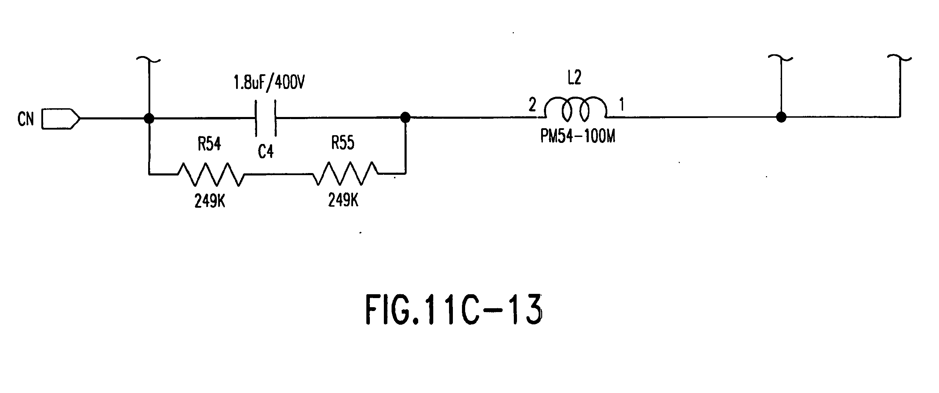

A 20 series schematic diagram can be found in **FIG. 11C: CT1, CT2,** and **CT3** (in the upper right corner of the diagram) are inputs from the current transformer. They connect to resistor networks that convert the current source into a voltage level that is compatible with the ASIC (described below). **PH-A, PH-B**, and **PH-C** (in the bottom-central part of the diagram) are measurement voltage levels that enter a different resistor network and divide the voltage to a level that is readable by the ASIC. **H3** (at the upper-central part of the diagram) is a header connection to the display board. **H8** (near **PH-A**) is a header that connects high voltage phases. **PLCX1, PLCX2,** and **PLC1** (near **H3**) are control signals that perform power line communication **(PLC). U2** (in the right-central part of the diagram - near **H7**) is a microprocessor that is connected to a contact closure counting circuit. Contact closures are isolated by **L3** and **OPT1** through **OPT6**. **Q4** and **LED1** are the optical receiver and transmitter, respectively. The ferrite beads **FB** are intended to decouple high frequency noise. **SW1, SW2**, and **SW3** are user access control switches. **T1** is the transformer for the main power supply transformer for this unit. The input is 120/220 selectable by **SW4**. Power voltage is rectified and regulated. **T2** provides an isolated power supply for an optional Modem Board attachment.

A third preferred embodiment (the "50 series") comprises an IEC bottom connect meter in which 100 amps at 200 volts 50 Hz pass through the meter to the customer and full complex plane (amplitude and angle) calibration of internal 10, 100, or 200 amp current elements to achieve high levels of calibration.

A fourth preferred embodiment (the "MC series") comprises a 24 channel meter that can be configured to 24 single phase loads, 12 apartment style loads, or 8 three phase commercial loads and provides economical per point cost.

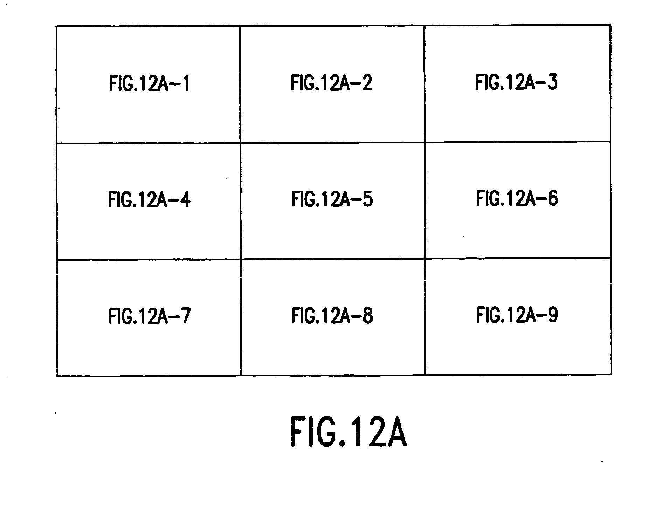

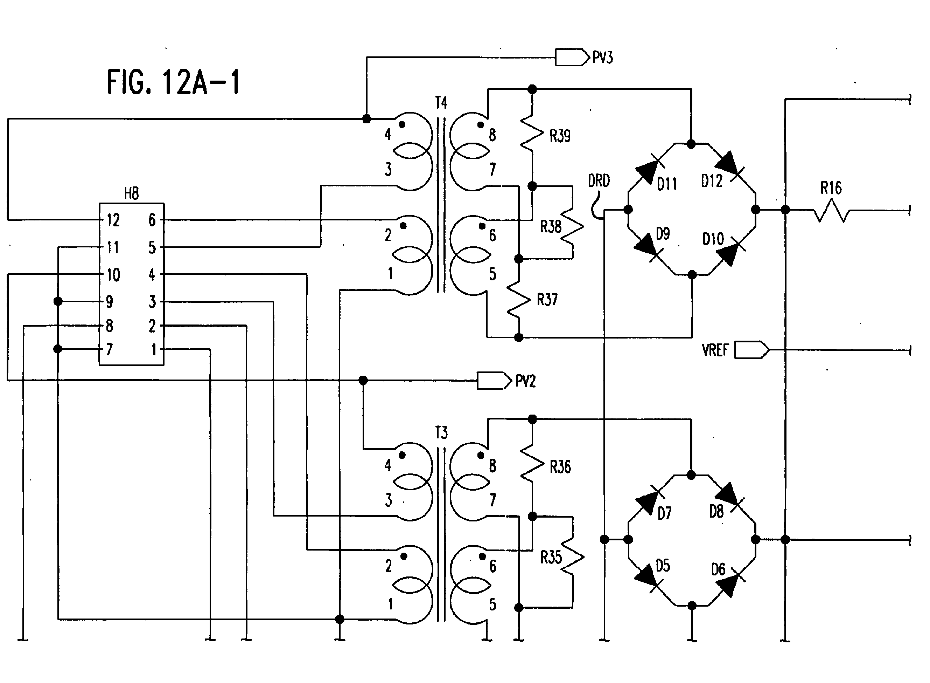

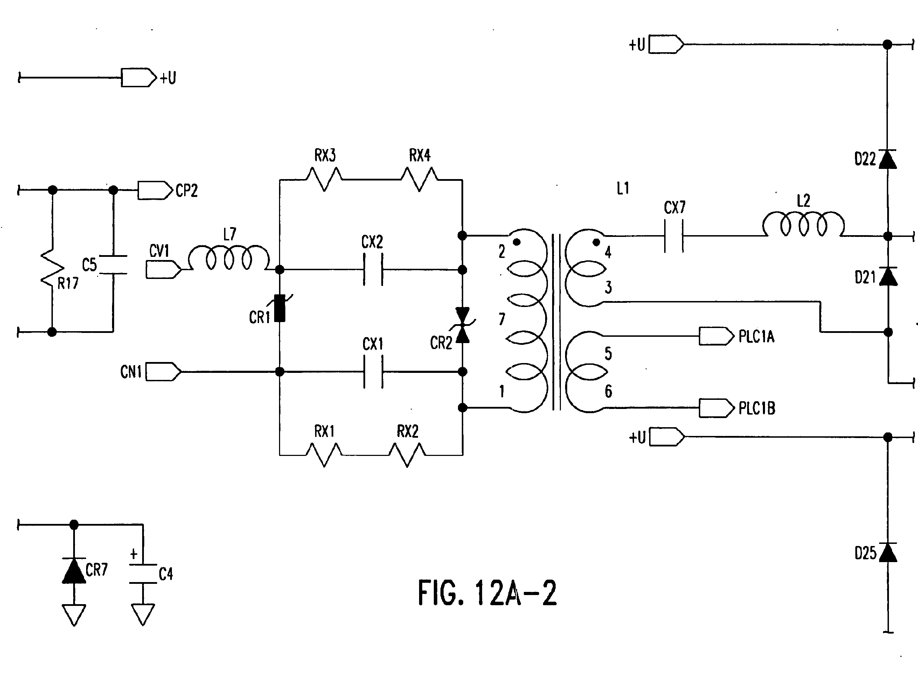

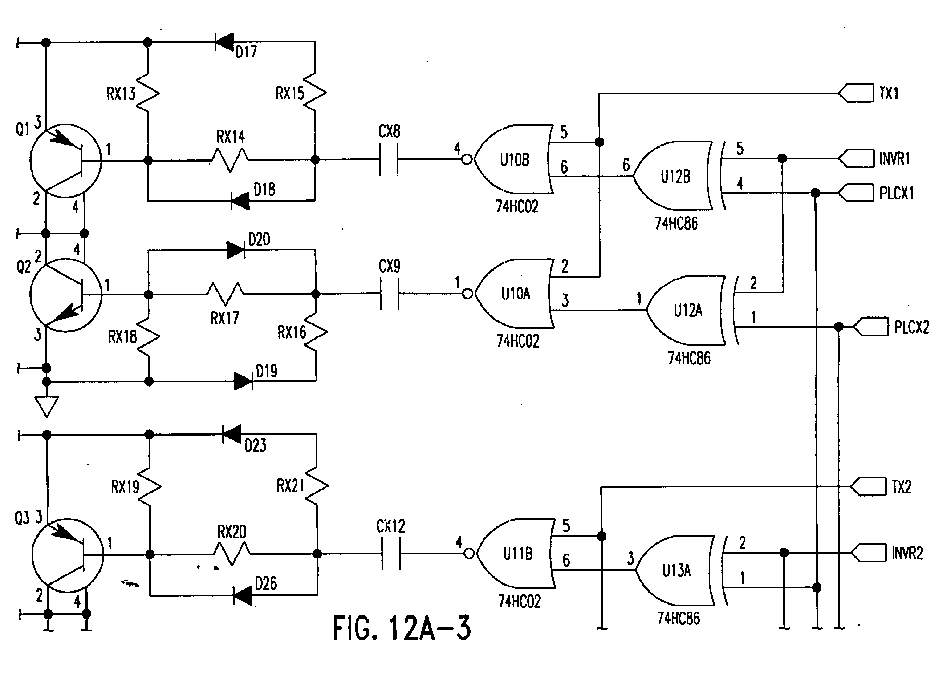

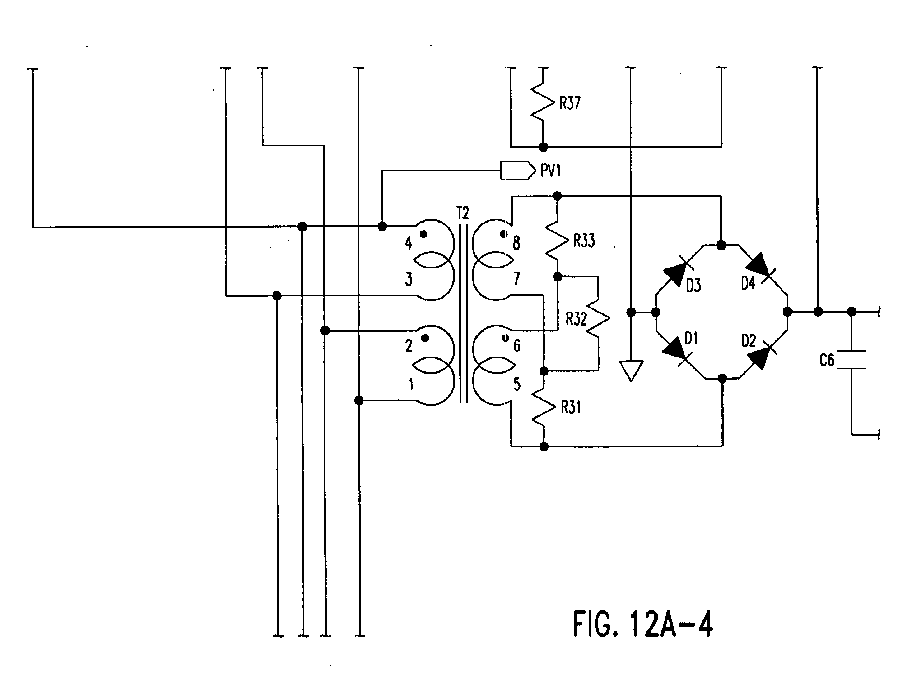

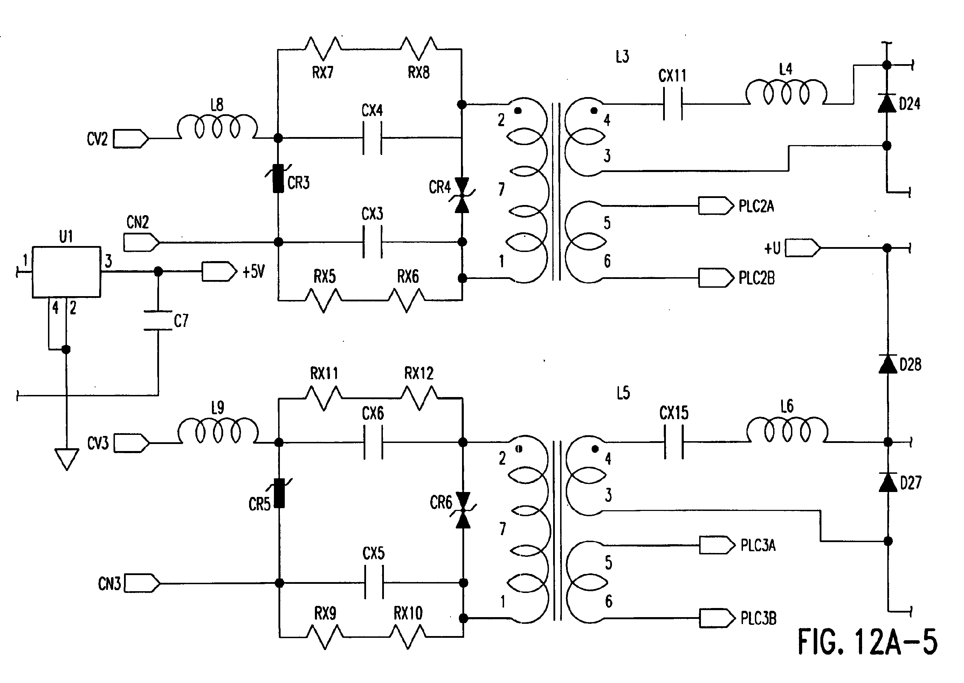

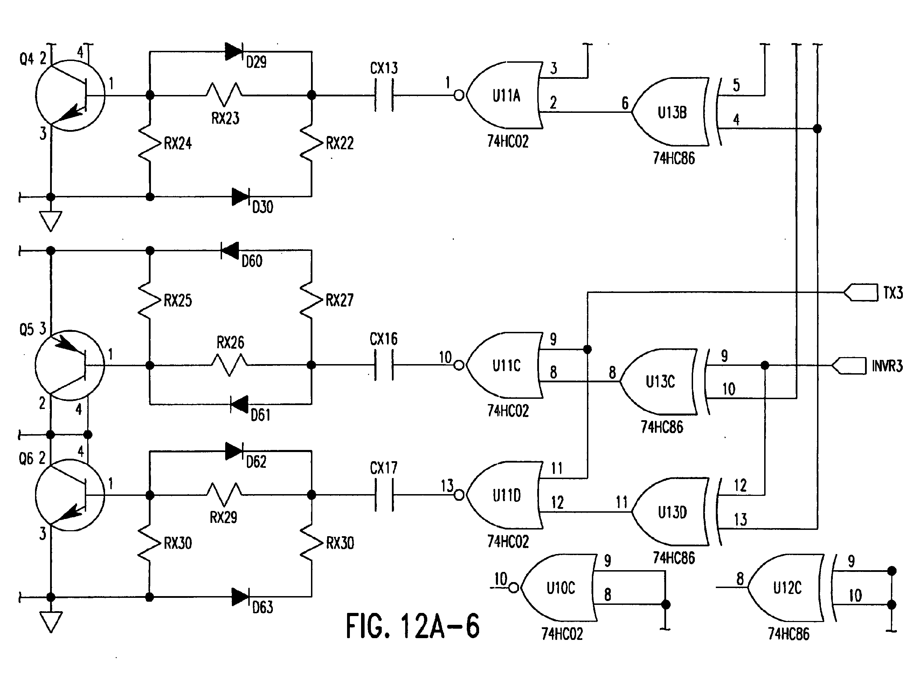

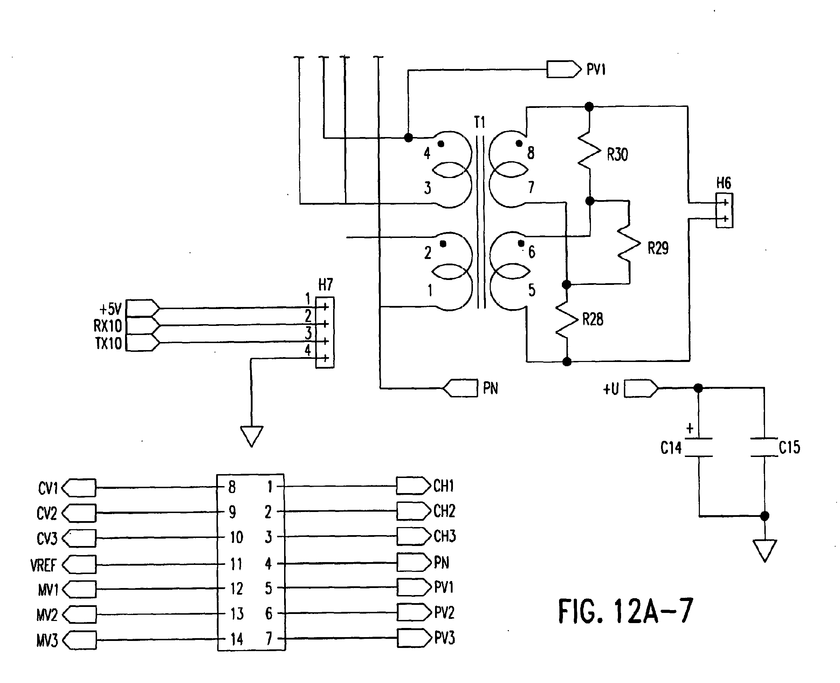

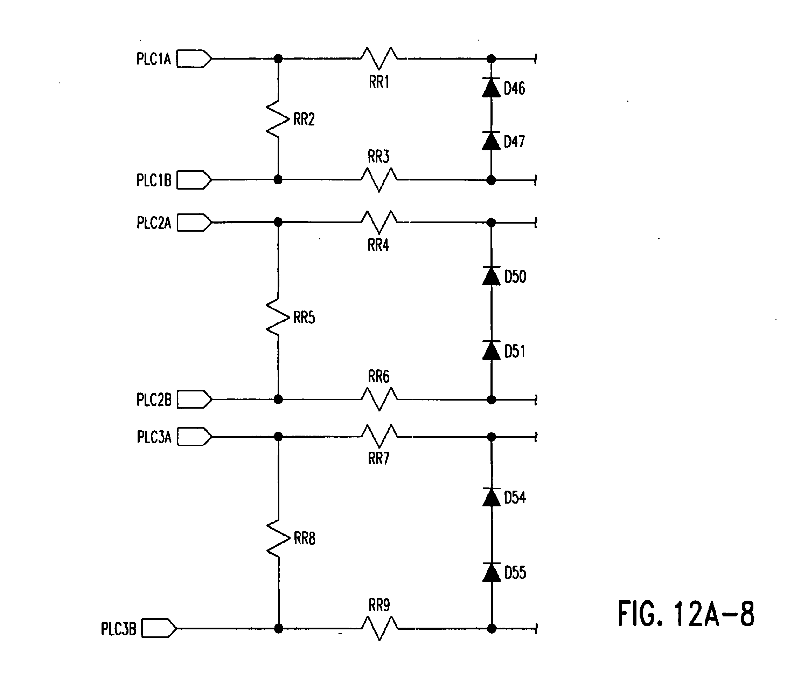

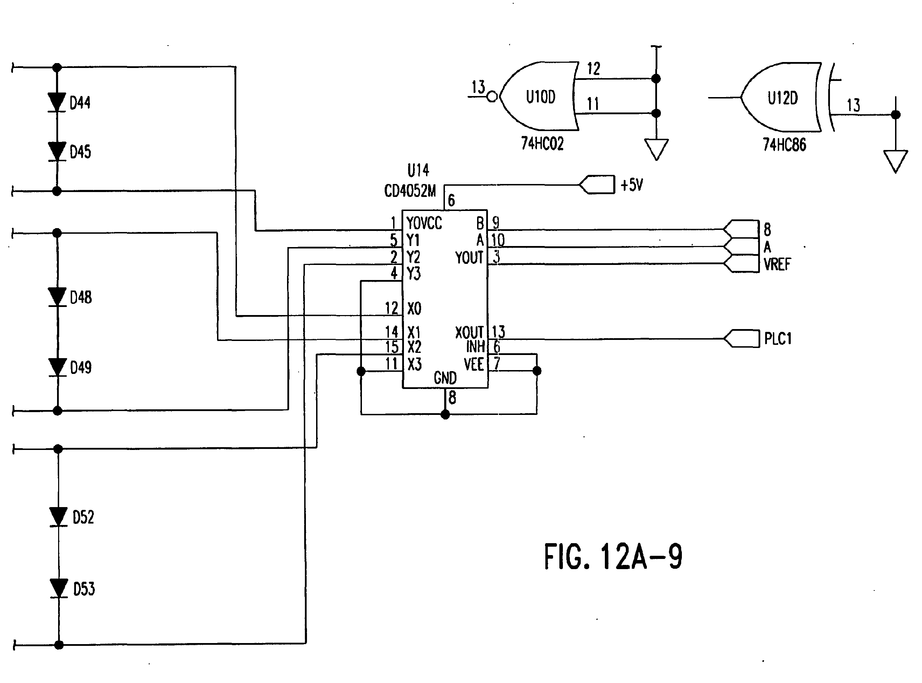

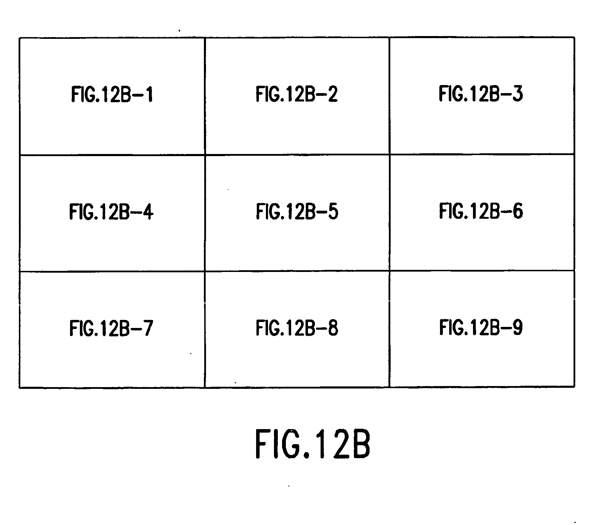

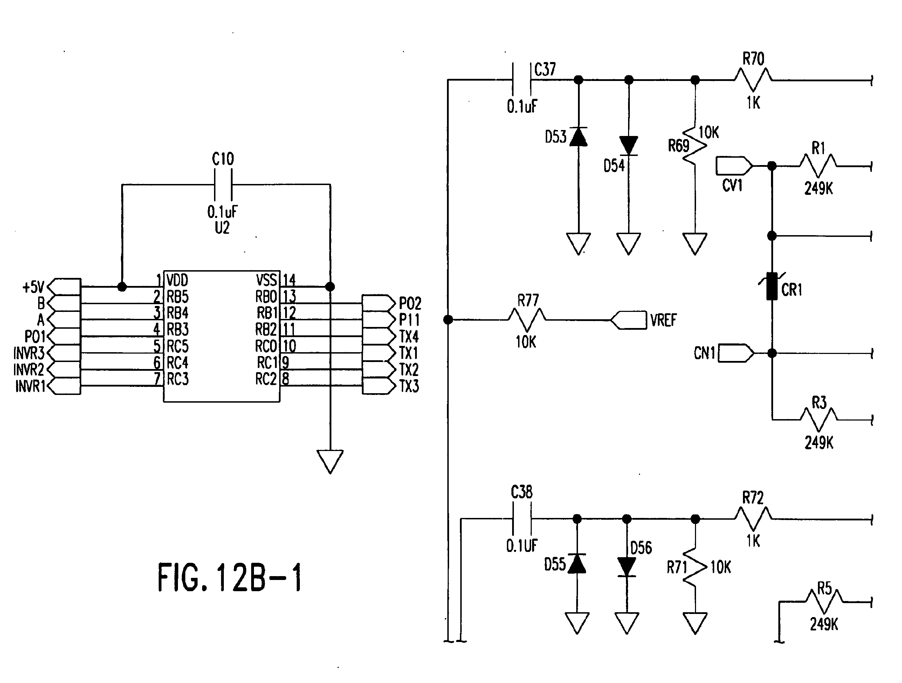

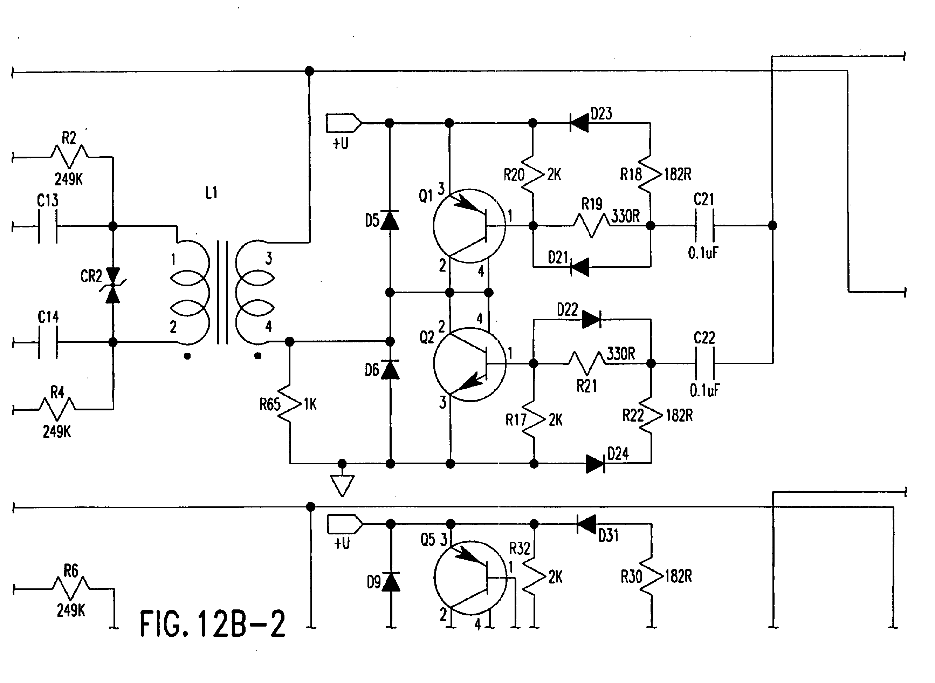

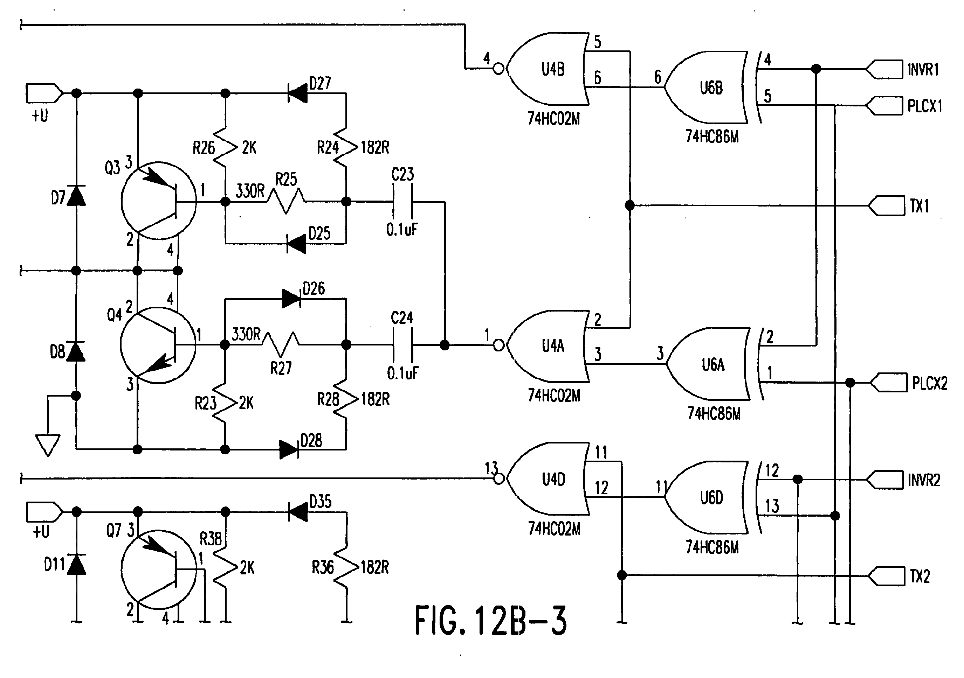

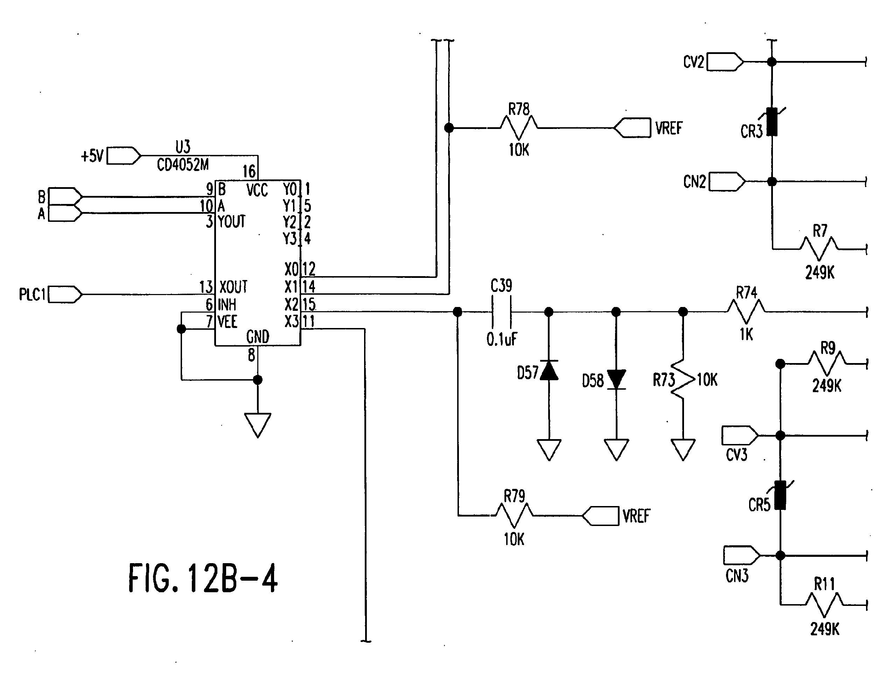

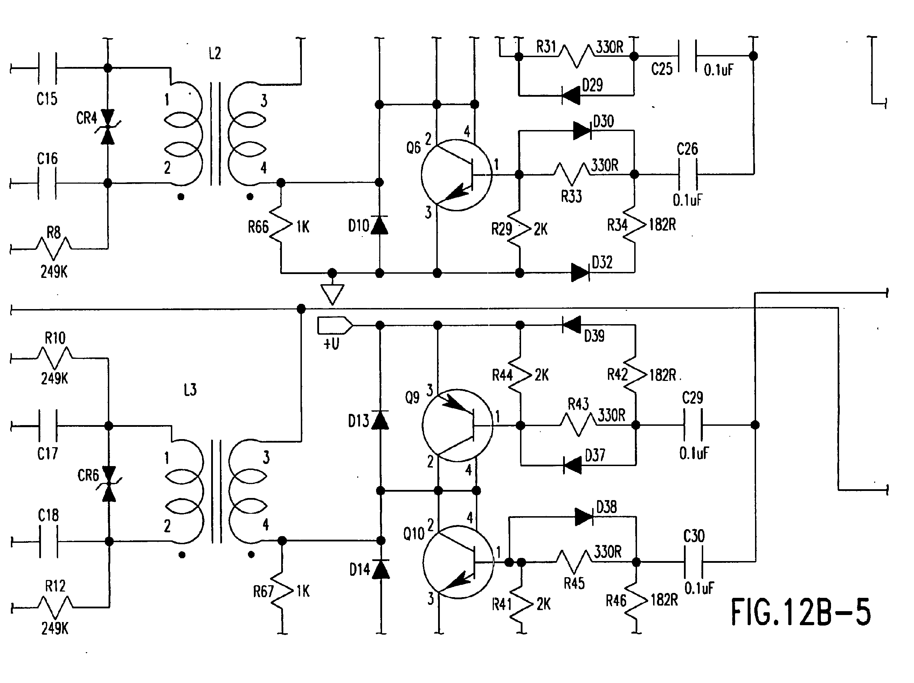

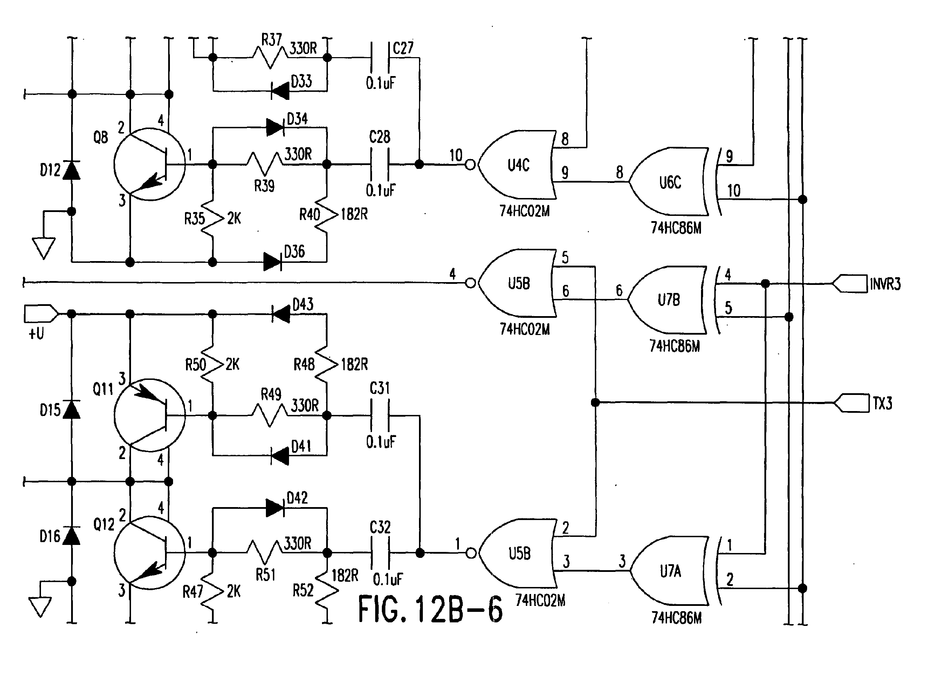

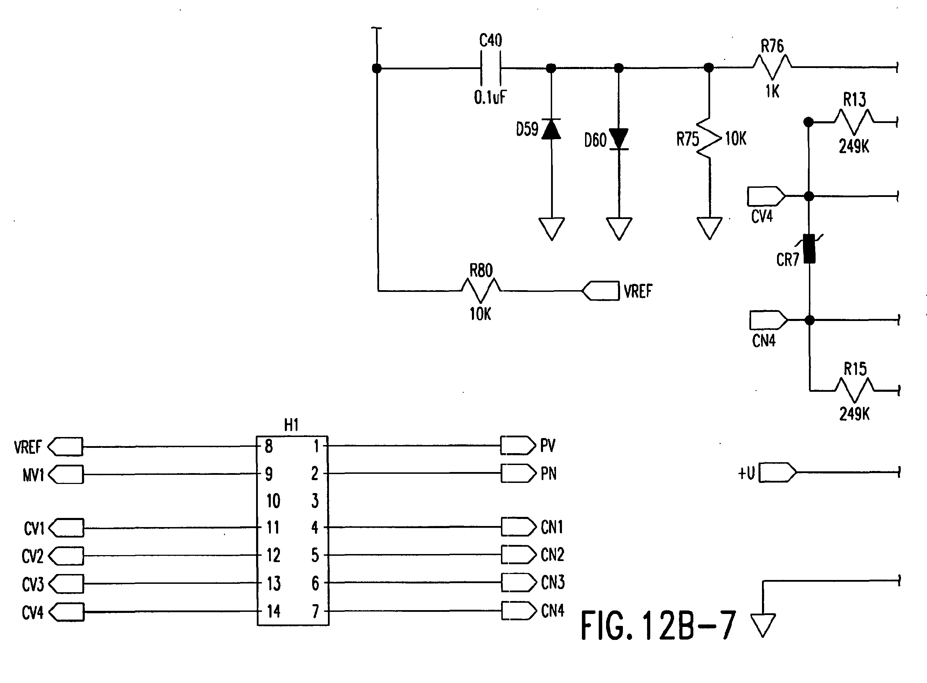

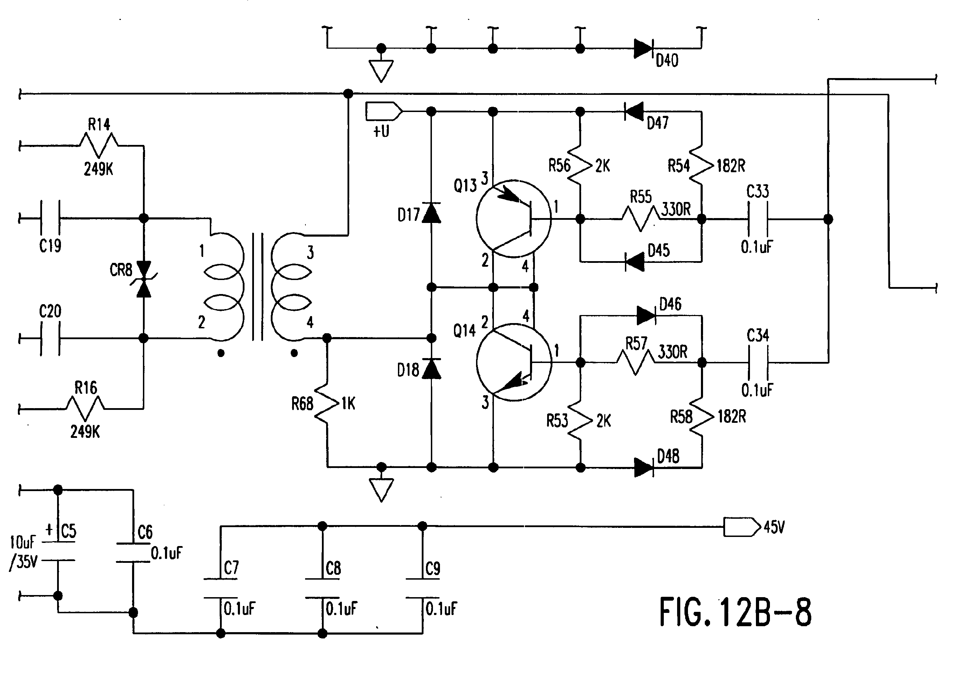

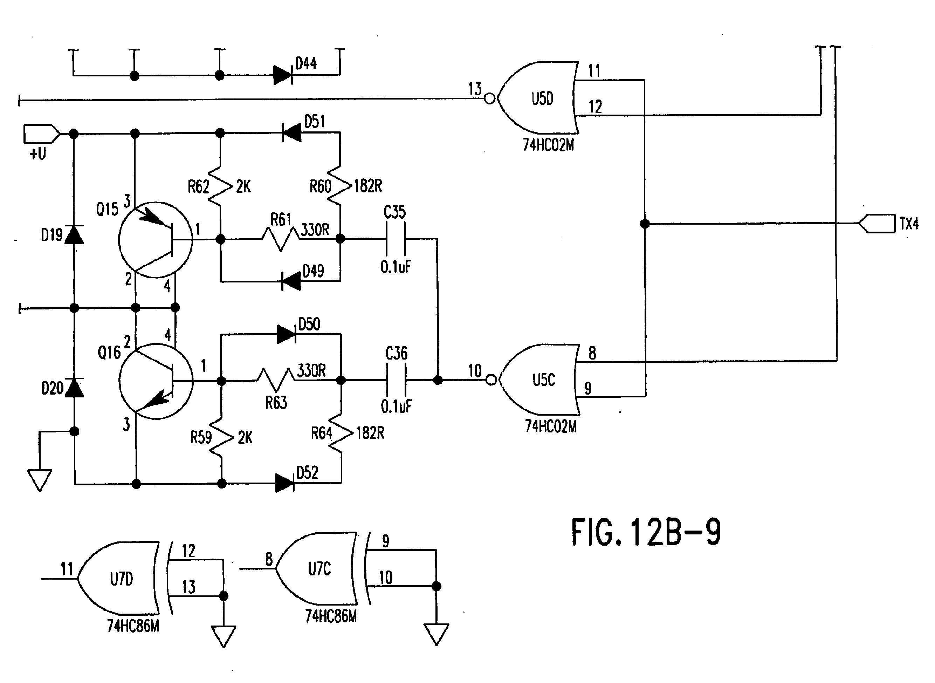

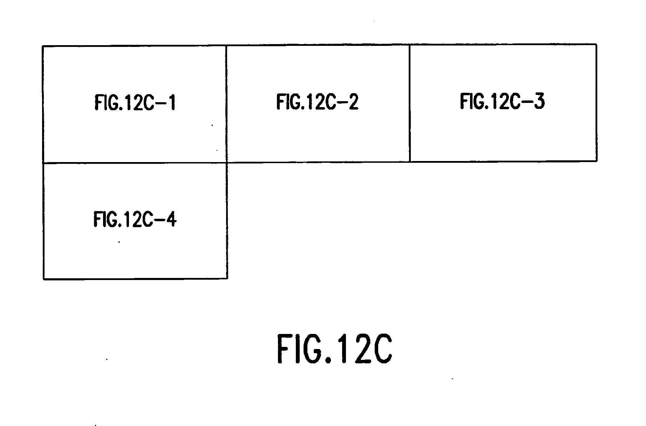

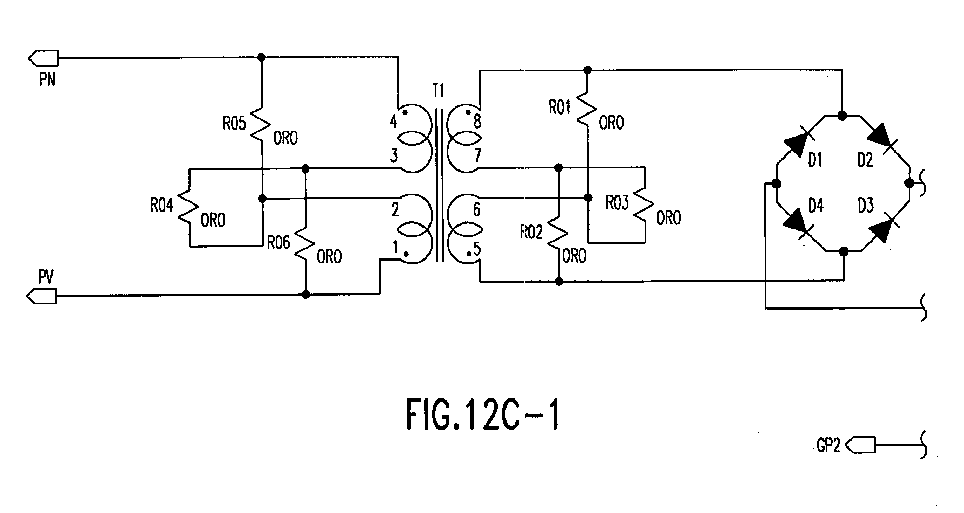

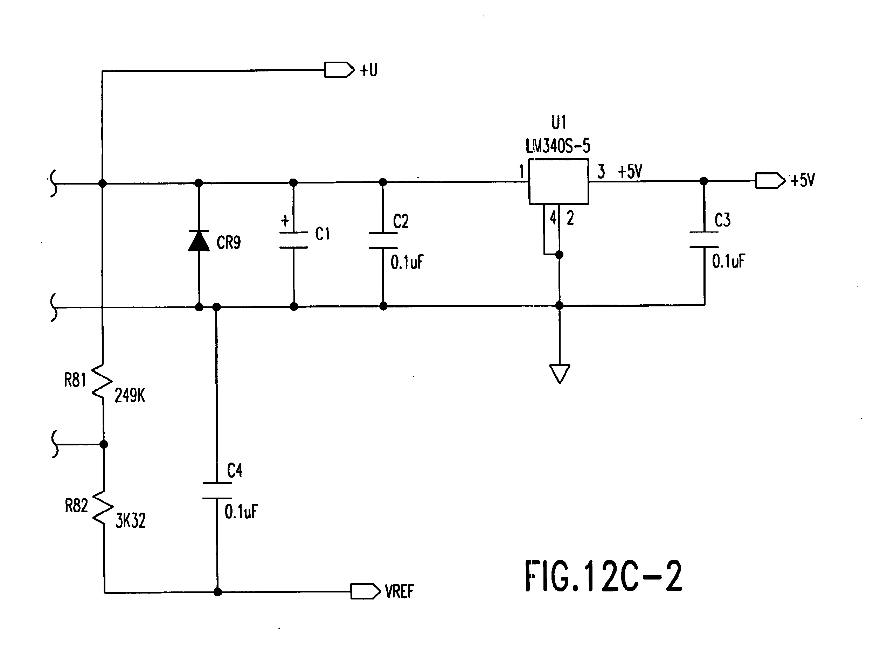

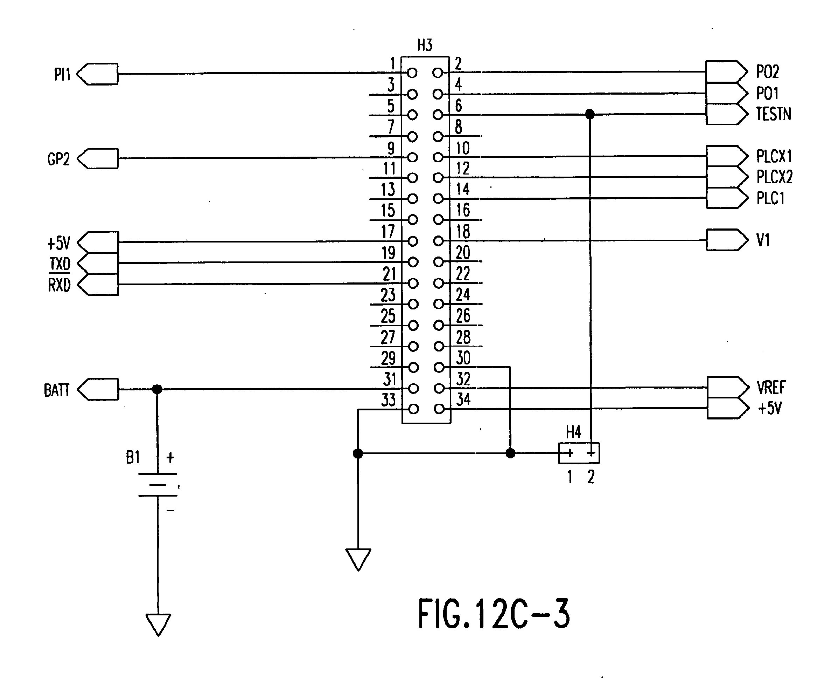

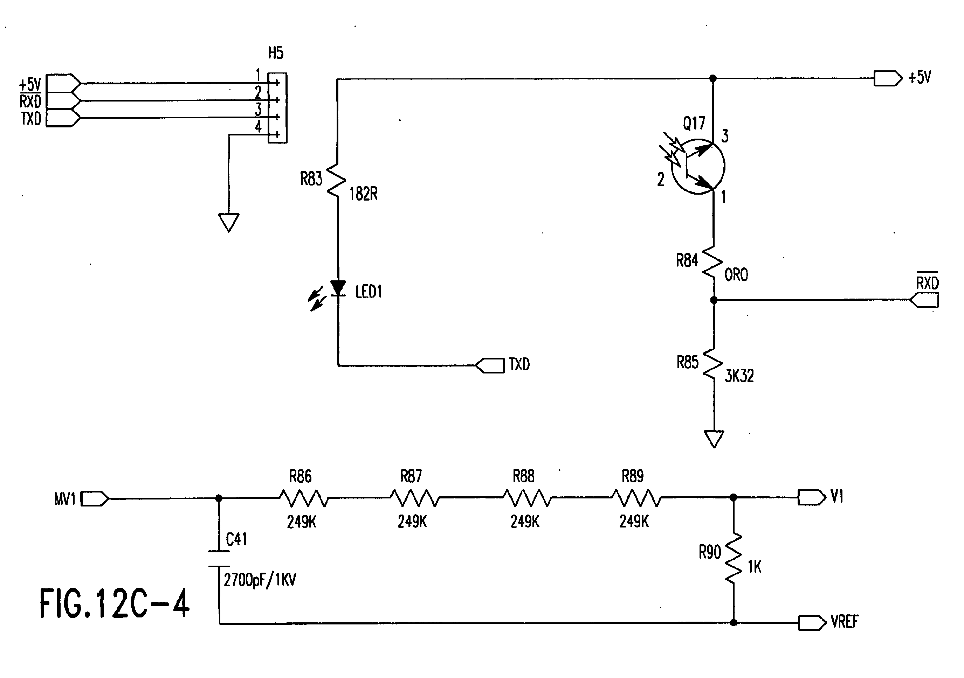

The Transmeter MC series schematic diagram is of the PCB type TMX-5 and can be found in **FIGS. 12A-C, 13, 14,** and **15A**. Note that the Low-level Transponder and the Transponder 5 also have PCB type TMX-5. Component placement determines whether the board is an MC series, Low-level Transponder, or Transponder 5. The circuits in **FIGS. 12A-C, 13**, **14,** and **15A** are discussed below.

Low- level Transponder: (1) receives instructions from Transponder to read a meter within its communication scope- typically one distribution transformer; and (2) can also be a meter to act as a check against loss due to theft. The Low- level Transponder schematic diagram is of PCB type TMX- 5 and can be found in **FIGS. 12A- C, 13, 14,** and **15A**.

Transponder: (1) reads Transmeters directly or via Low-level Transponders; and (2) communicates with fiber, phone or TCP/IP LAN. The Transponder schematic diagram is of PCB type TMX-5 and can be found in **FIGS. 12A-C, 13,14,** and **15A**.

**TMX-5**

The following are circuits in **FIGS. 12A-C, 13, 14,** and **15A**.

**H8** (see **FIG. 12A**) is a switch or adapter that selects between 120/220 VAC power supply voltage. Each phase is independently rectified and the rectified voltages are tied together. This requires only one of the power phases to be active for the system to receive power.

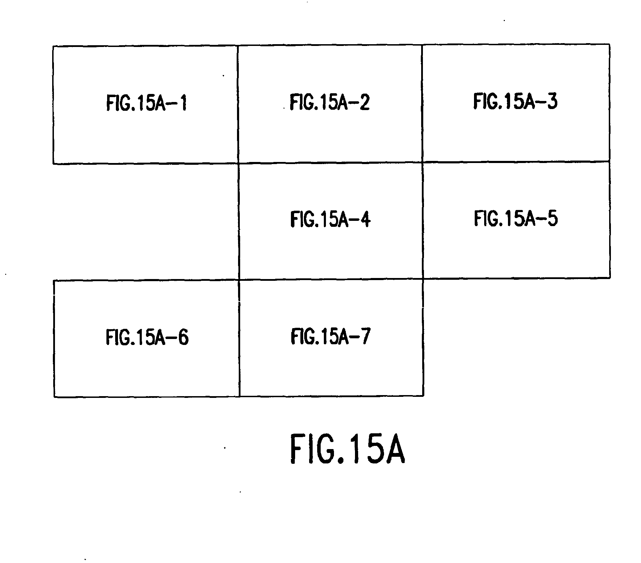

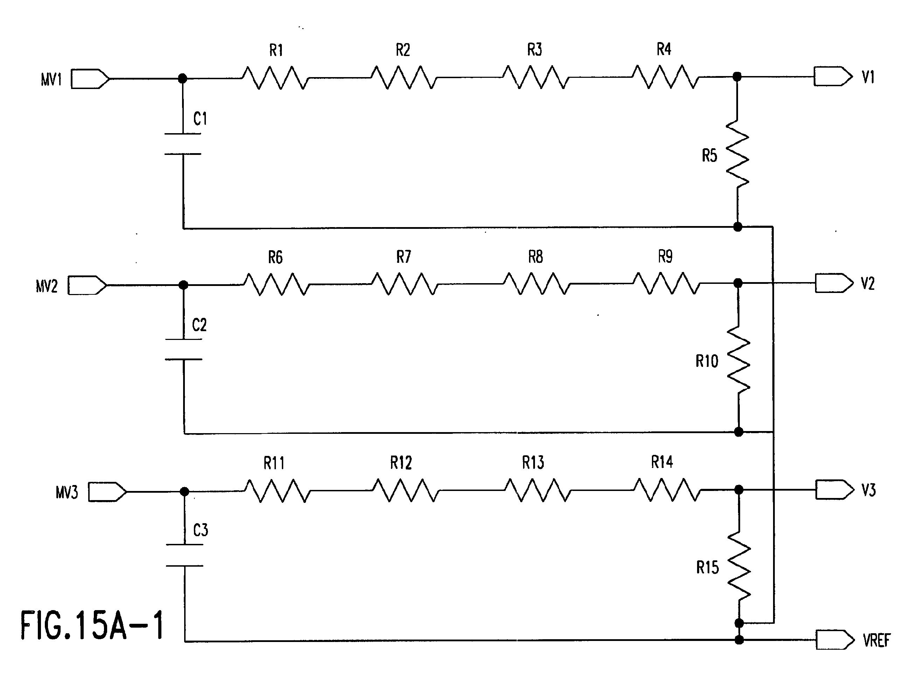

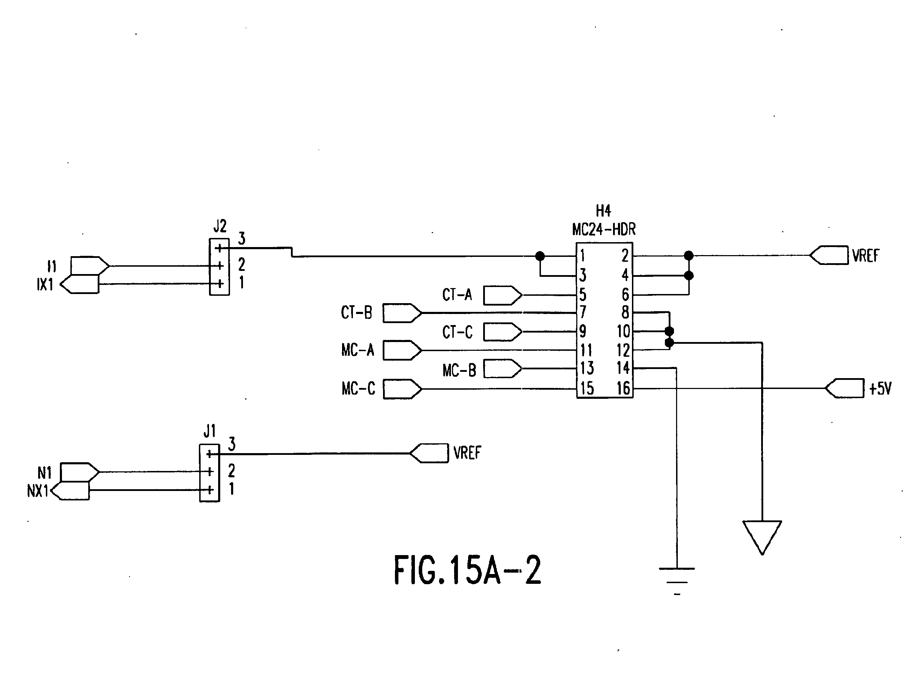

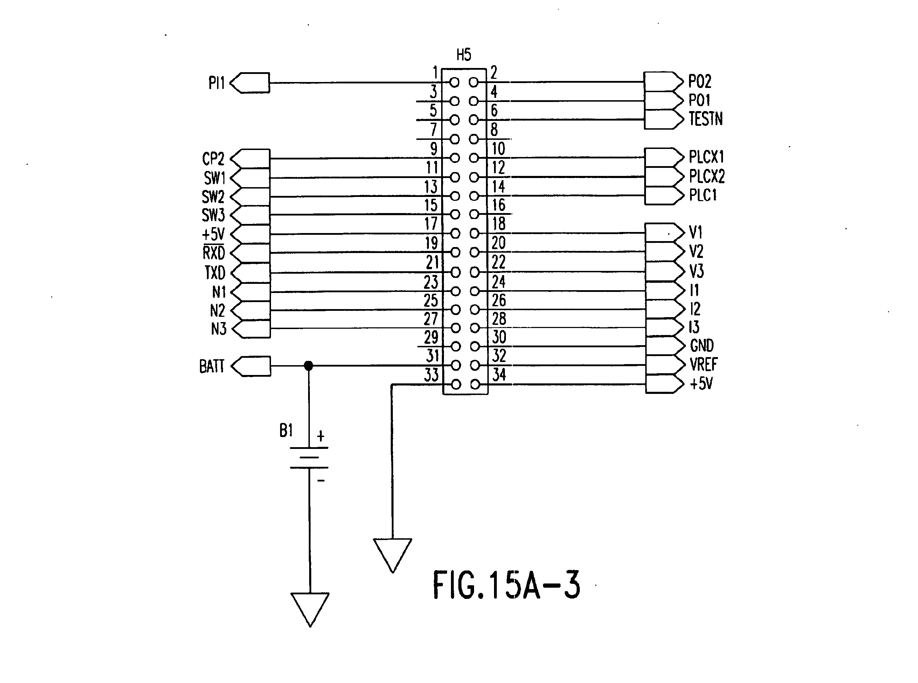

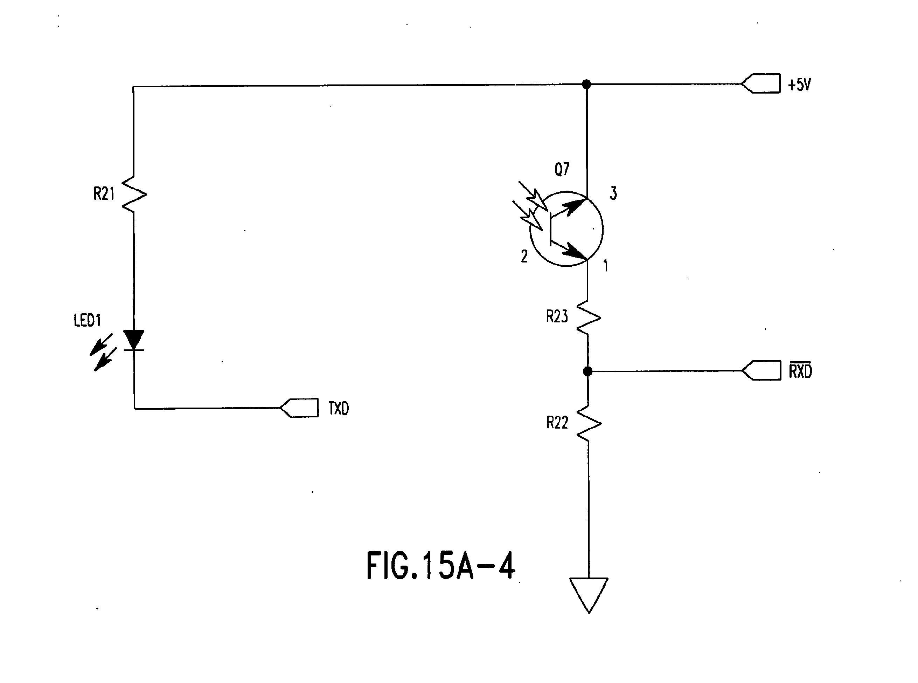

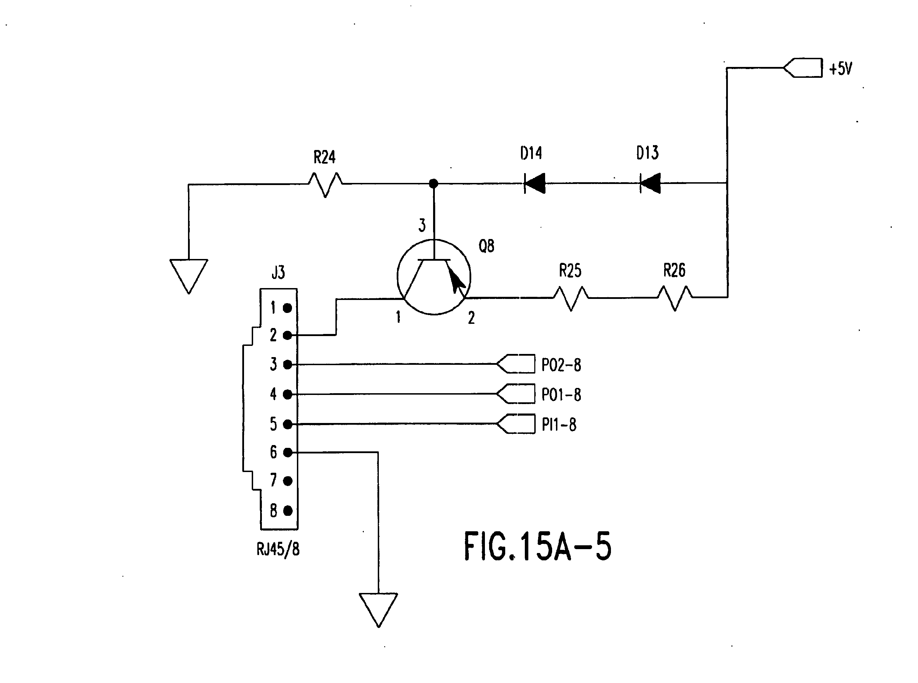

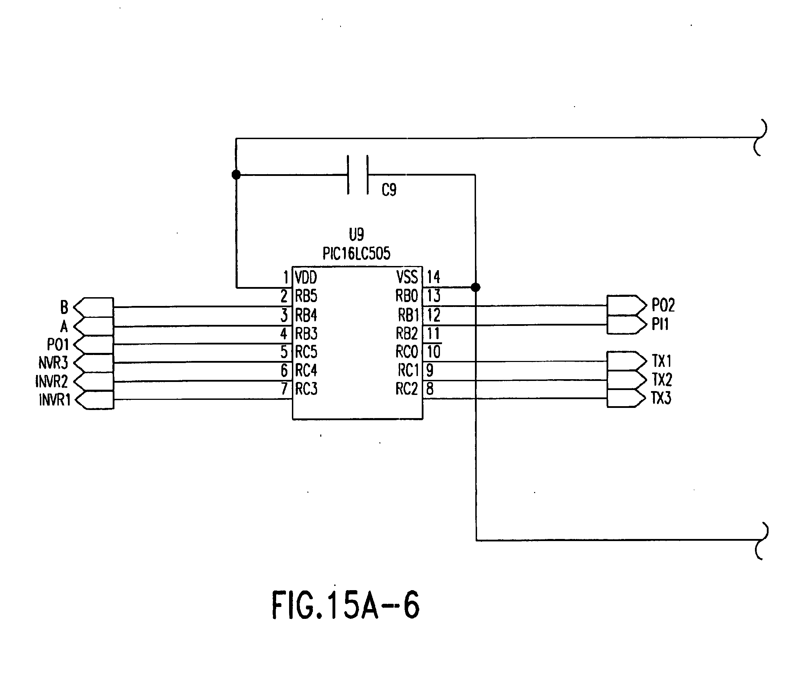

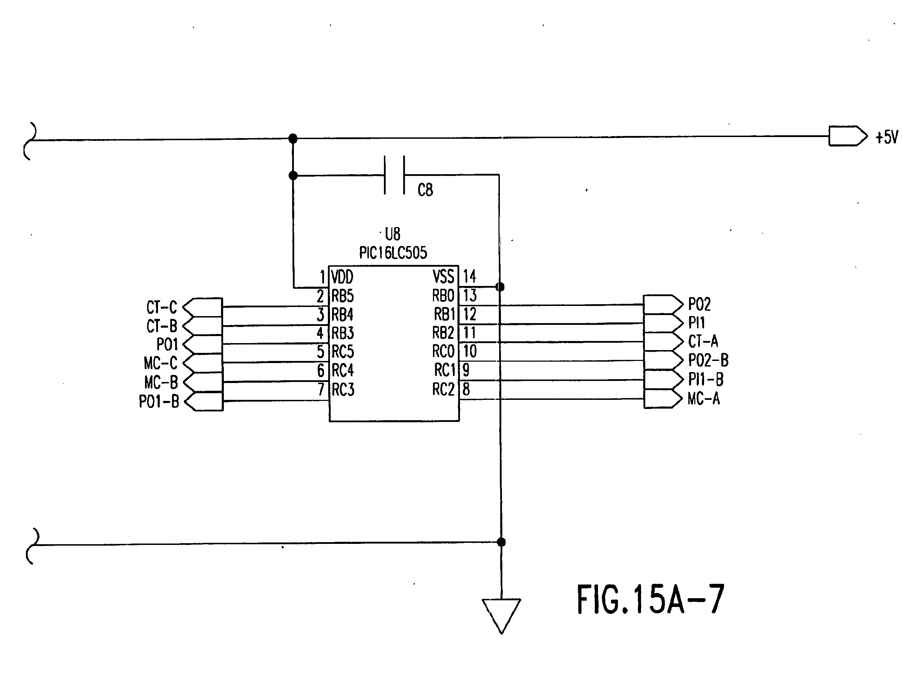

The transponder preferably has the ability to communicate on three power phases. There are three sets of PLC transmit and receive circuits (see **FIG. 12A).** A slave microprocessor **U9** (see **FIG. 15A,** lower left) controls the transmit circuits by controlling the following: the PLC phase gating IC **U11** (see **FIG. 12A),** level inverter IC **U13** (see **FIG. 12A**), and analog inputs **U14** (see **FIG. 12A). J3** is the connector for serial communication to an external contact closure counter. Its power supply is current limited. The algorithms contained in the slave microprocessor are described by the HEX formatted file, PLCGATE.HEX in the attached Appendix.

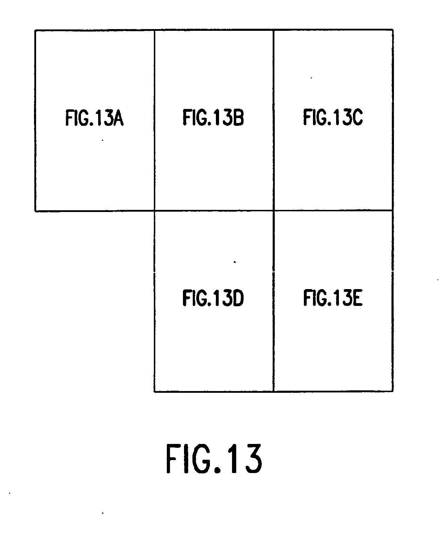

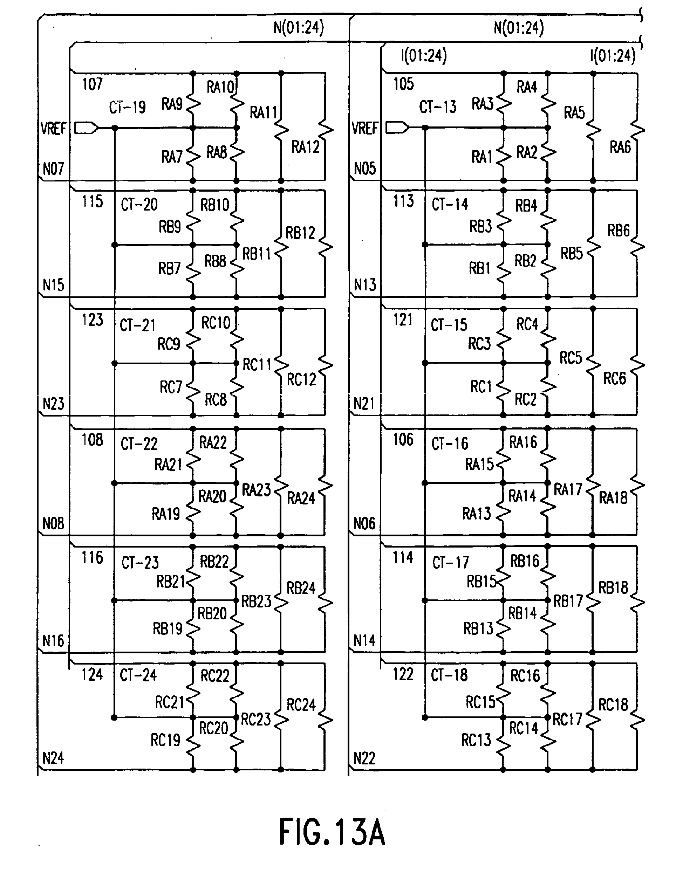

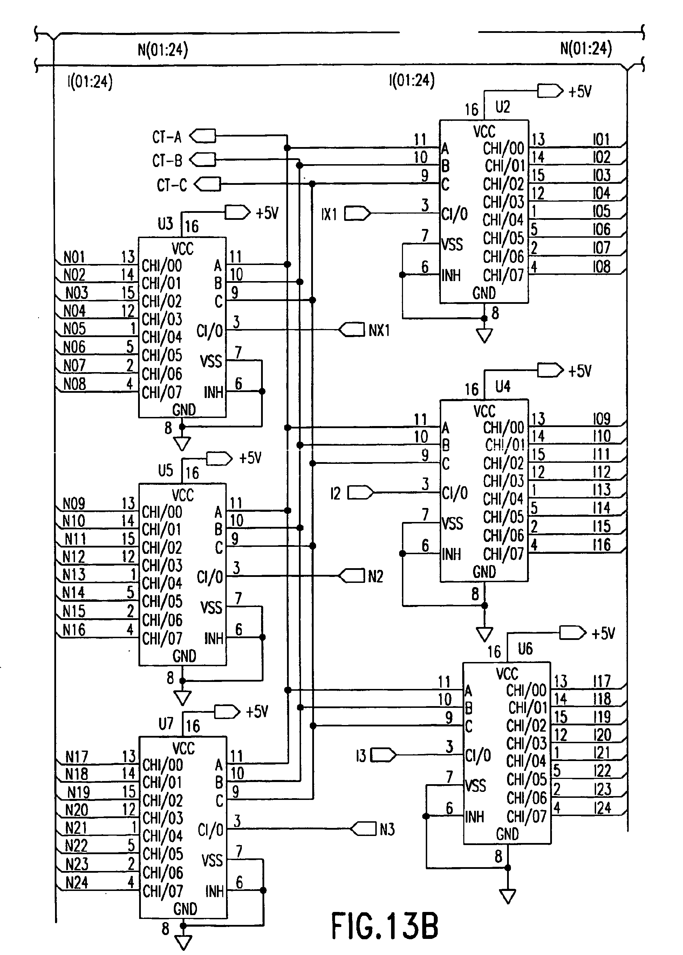

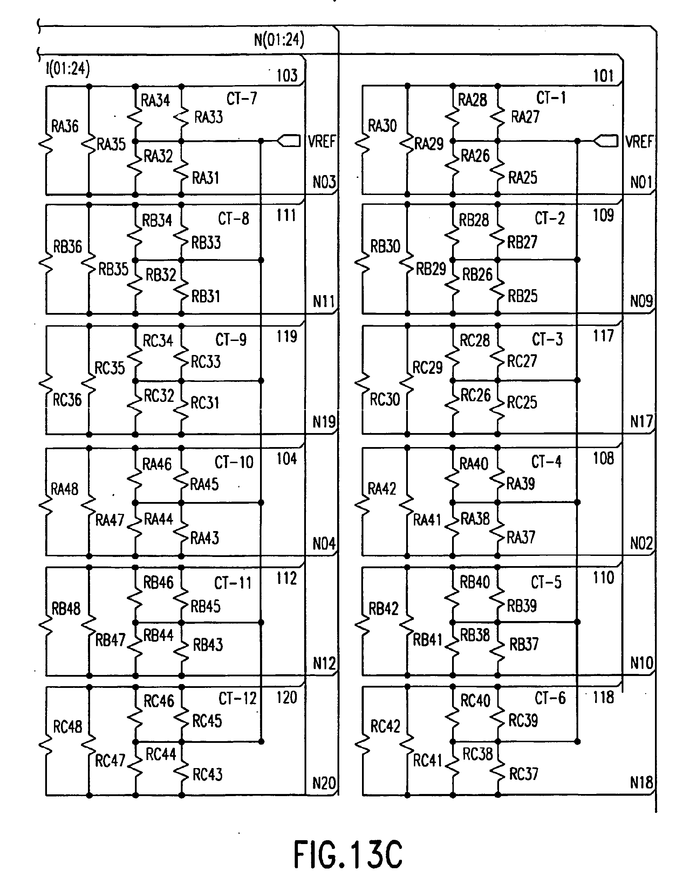

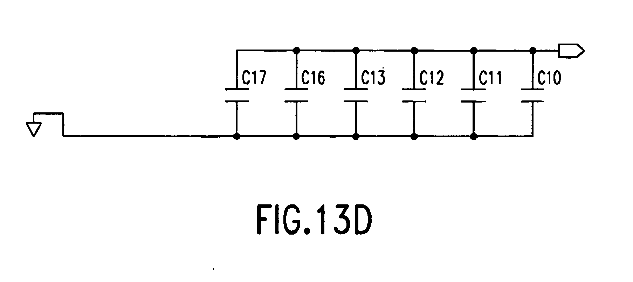

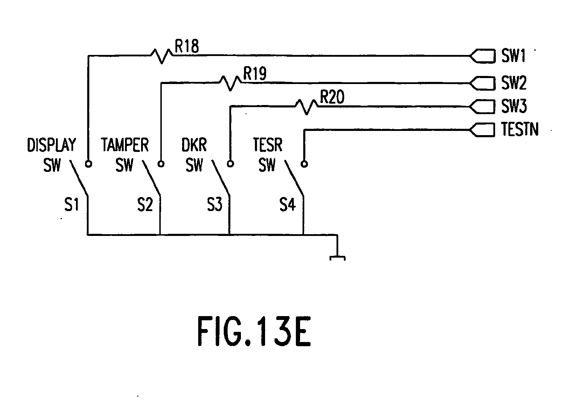

There are 24 meter inputs **(I0/N0** through **I23/N23,** shown in **FIG. 13),** each connecting to its own current-to-voltage resistor network. Metering is gated three phases at a time by analog multiplexers **U2** - **U8** (see **FIG**. **13**) into the ASIC by means of a slave microprocessor **U8** (see **FIG. 15A)**. Its master, the 68000, communicates with the slave to synchronize phase and timing. The algorithms contained in the slave microprocessor are described by the HEX formatted file, PHZGATE.HEX, in the attached Appendix.

**SW1, SW2,** and **SW3** (see **FIG. 13)** are user access control switches.

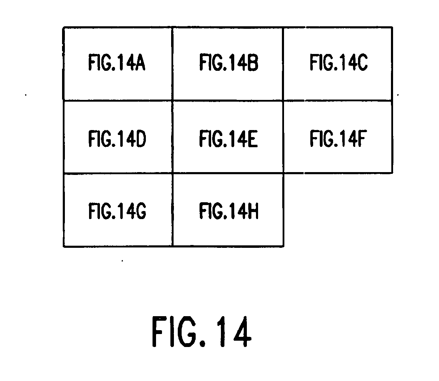

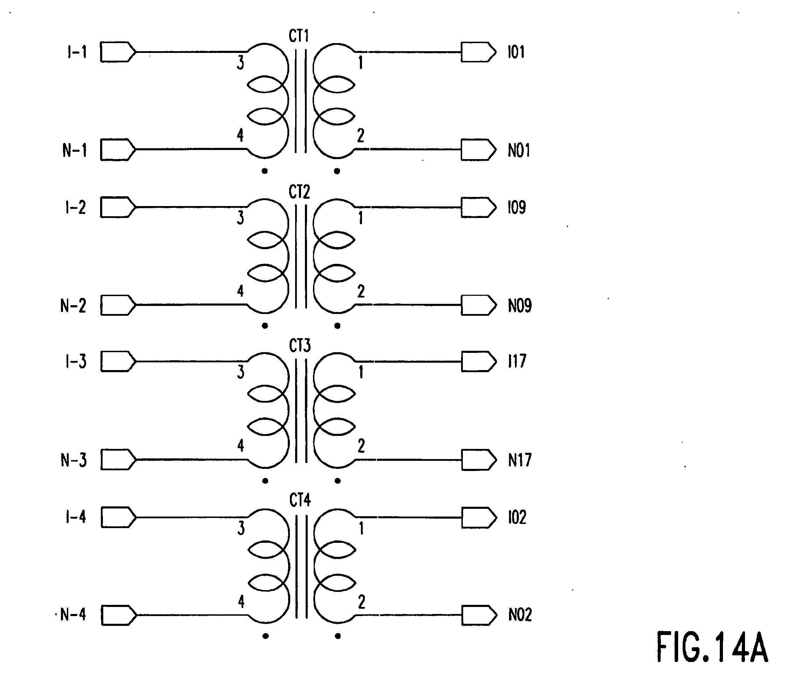

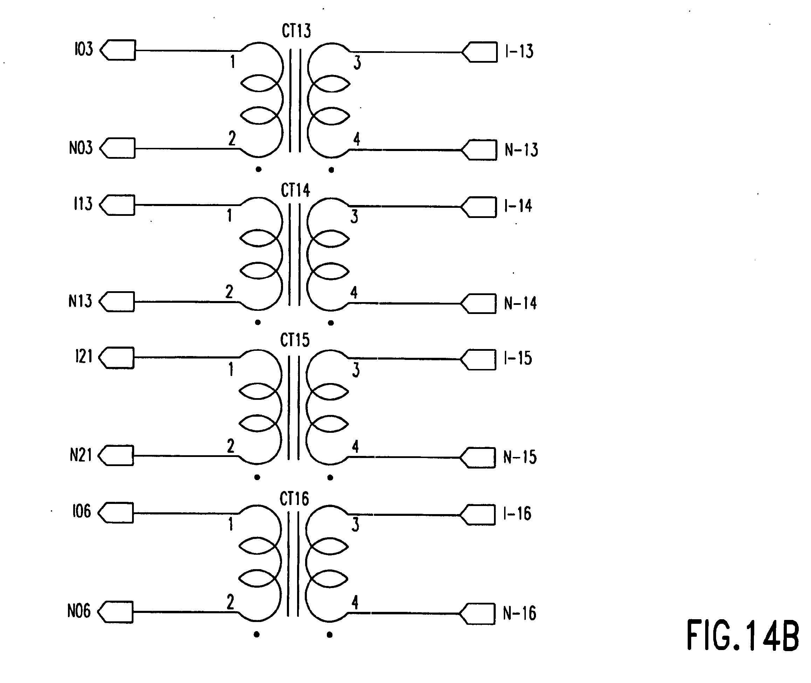

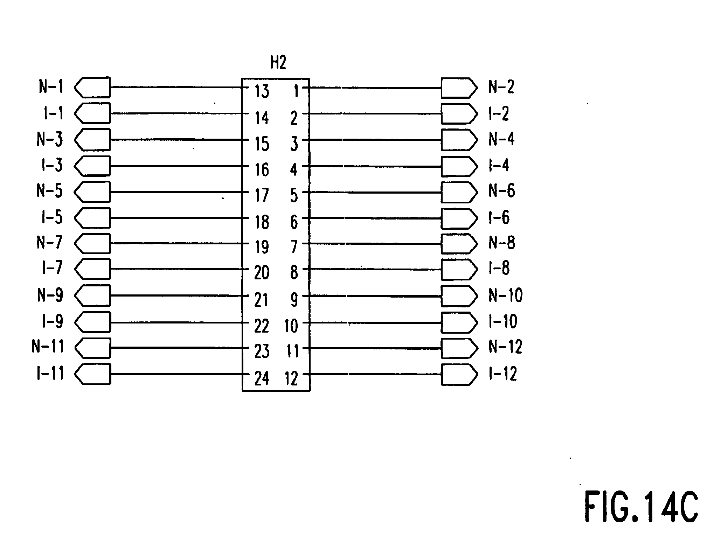

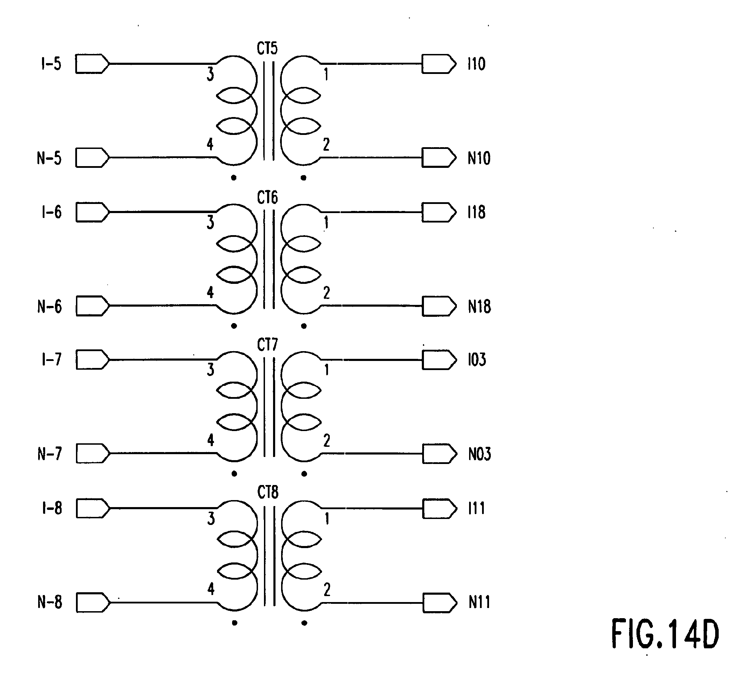

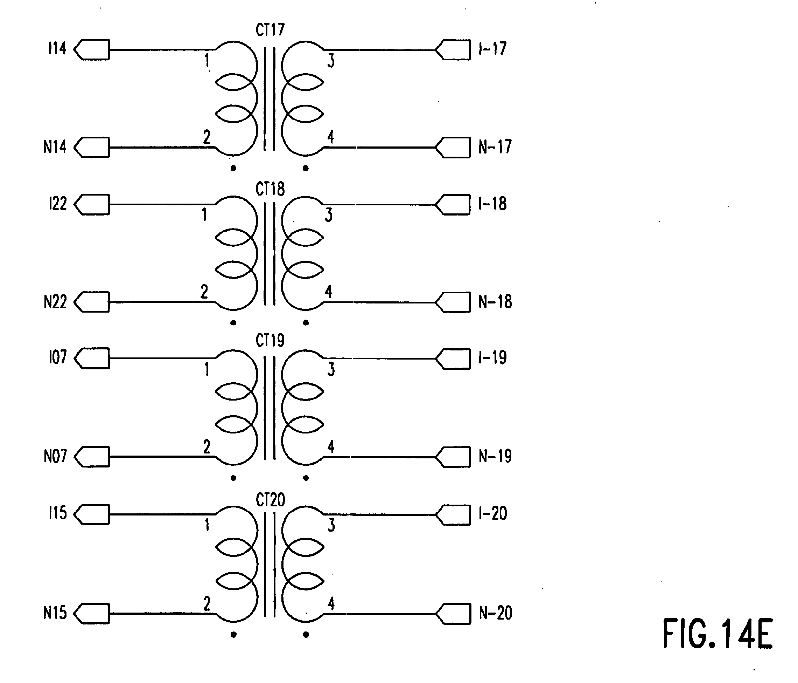

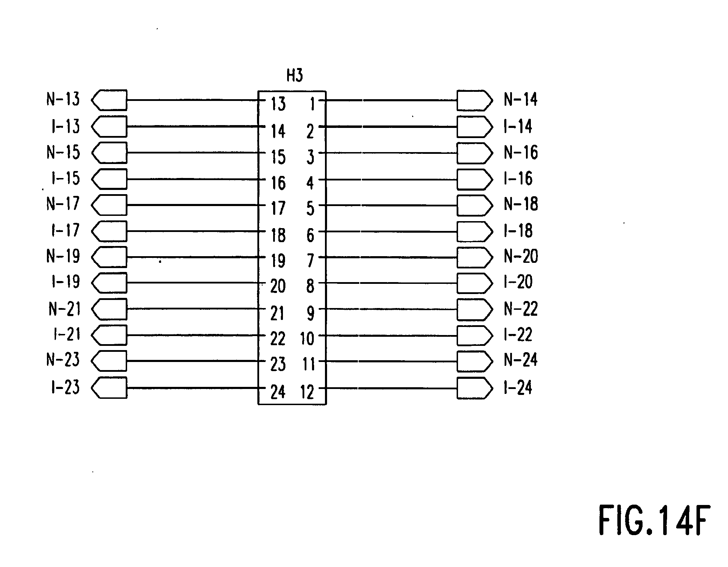

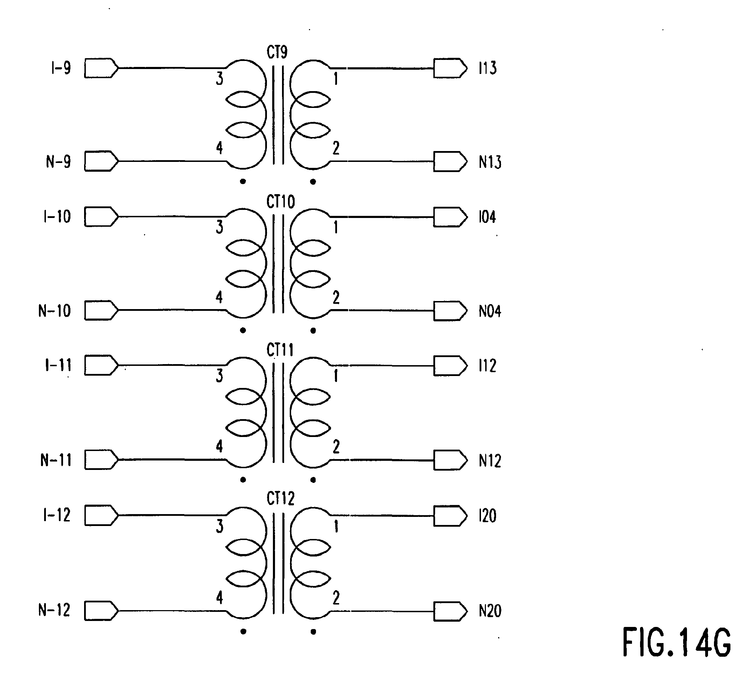

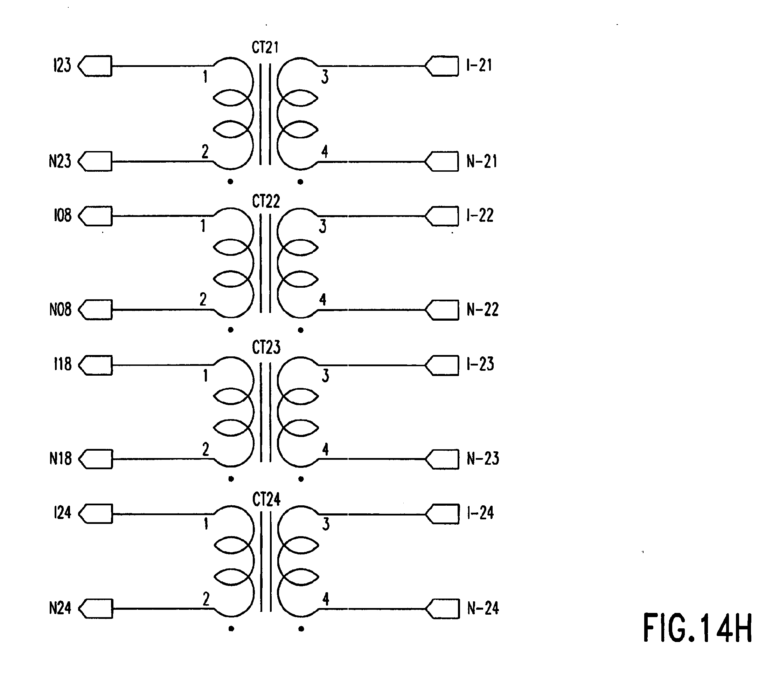

**H2** and **H3** (see **FIG. 14)** are headers that connect to the current transformers **CT1 - CT24** (see **FIG. 14**) to current inputs.

**MV- 1, MV- 2,** and **MV- 3** (see **FIG. 15A)** are measurement voltage levels that enter a different resistor network and divide the voltage to a level that is readable by the ASIC.

**H4**, **J1,** and **J2** (see **FIG. 15A**) are expansion headers that allow reading of more current channels.

**H5** (see **FIG. 15A**) is a header connection to the display board.

**J3** (see **FIG. 15A)** is a header that optionally connects with external pulse counters. The circuit involving **Q8** provides a current-limited +5V supply.

**Q7** and **LED1** (see **FIG. 15A**) are an optical receiver and transmitter, respectively.

**"Big Helper" Automated Reading and Billing Software**

This software runs on the Billing Computer and preferably comprises the following functionality:

(1) Read all Transponders to obtain required metering data from all Transmeters.
(2) Compare metering data with specified limits or historical data to identify suspicious readings or equipment failures at the earliest possible time.
(3) Compare Low-level Transponder energy readings with those of the corresponding Transmeters® to identify theft.
(4) Automatically select the best route to each Transponder, whether it be fiber, telephone, RS-485 or via the Internet to a satellite billing center running the Big Helper Software. This allows one billing center to use the Internet to connect to other centers in distant places without the use of long distance telephone service.
(5) Store data to an MV-90, Oracle® (or other equivalent) database for generation of bills.
(6) Seamlessly interconnect over the Internet to form a WAN of billing computers, each associated with a different set of Transponders.

**Alternate Embodiments**

Gas and Water Meter Interfaces

In the 20 series embodiment (see **FIG. 11C**), the gas and water meter interfaces continue to accumulate contact closures in the absence of electric power applied to the electricity meter. This is important for an electric company that wishes to sell meter reading services to water and gas utilities, yet guarantee data integrity even when electric power is out for an extended period of time.

A contact-closure counting microprocessor is powered by a diode OR of the +5V supply and on-board battery, enabling contact-closure counting in the absence of power. The pulse microprocessor accumulates counts in its internal registers and sends the data to the main processor via serial transfer. To sense the state of the contact closure, the microprocessor energizes the primary of a pulse transformer. The contact closure points are in series with the secondary of the pulse transformer. If the contact is closed, the diode in an optical isolator is forward biased. This energizes its photo detector, which is a sample-and-hold capacitor. The microprocessor reads the level on the capacitor as low. If the contact is not closed, the optical isolator is idle. The capacitor recharges and is read high. The algorithms contained in the pulse microprocessor are described by the HEX formatted file, PULSE.HEX, in the attached Appendix.

**Opto Adaptor**

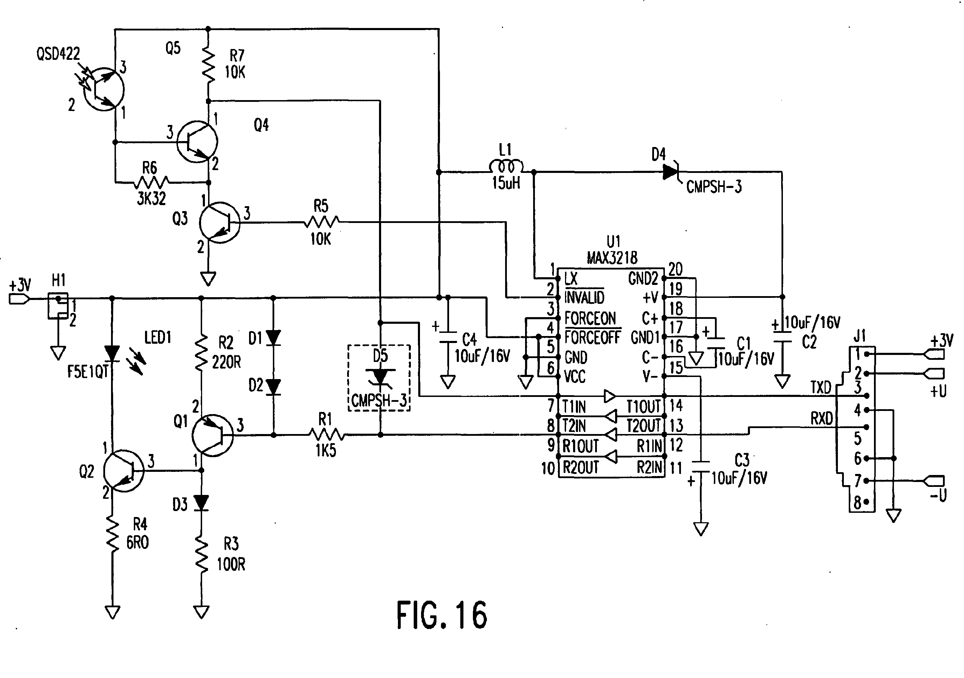

The Opto Adaptor (Optical Adaptor) converts RS232 into an optical signal that can be read by each meter. This board enables any meter to communicate with any computer through its serial port. An Opto Adaptor schematic diagram can be found in **FIG. 16**. **U1** converts RS232 to TTL levels. **Q1** and **Q2** are gain transistors to drive the optical transmit **LED1**. **Q5** is the optical receiver. **Q3** provides gain and **Q4** inhibits the receiver.

**Modem Board**

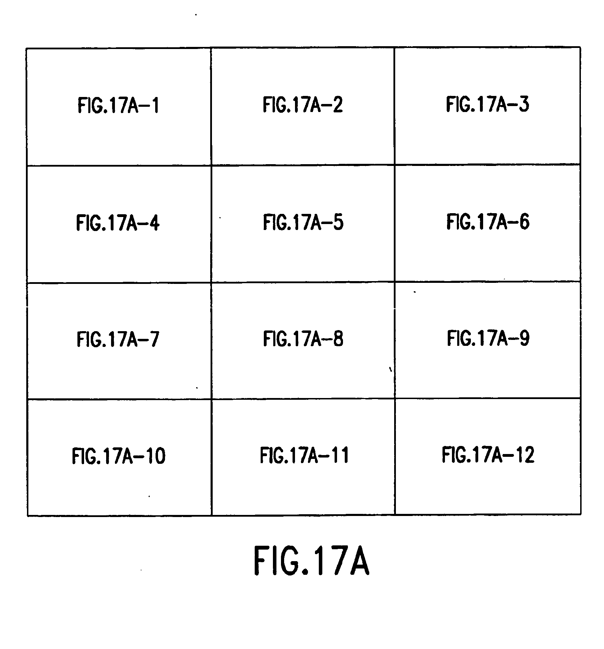

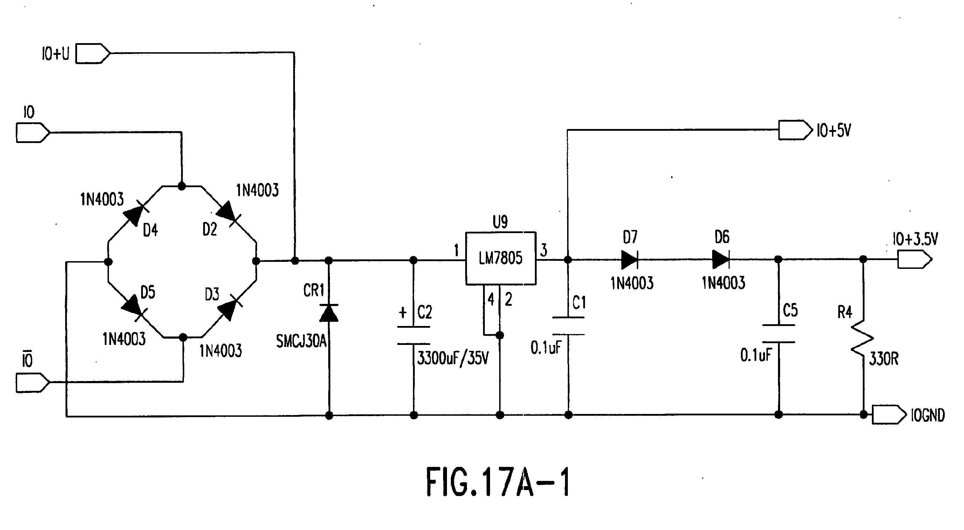

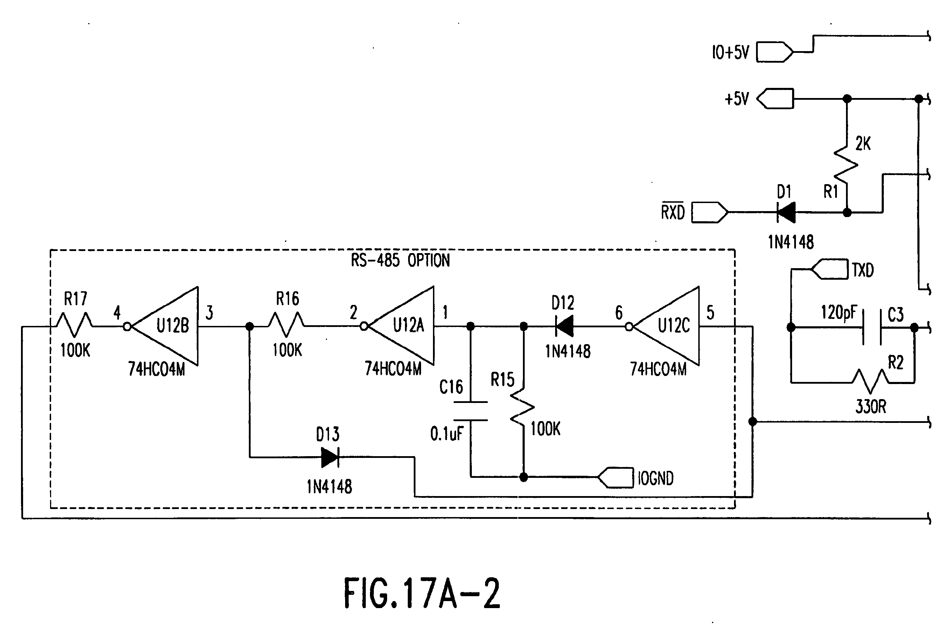

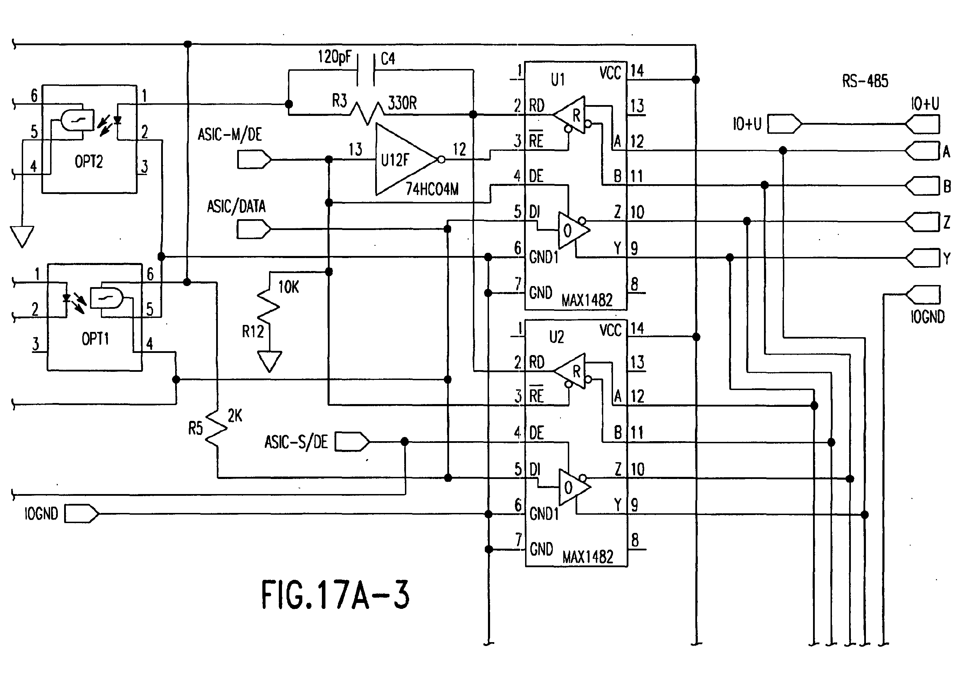

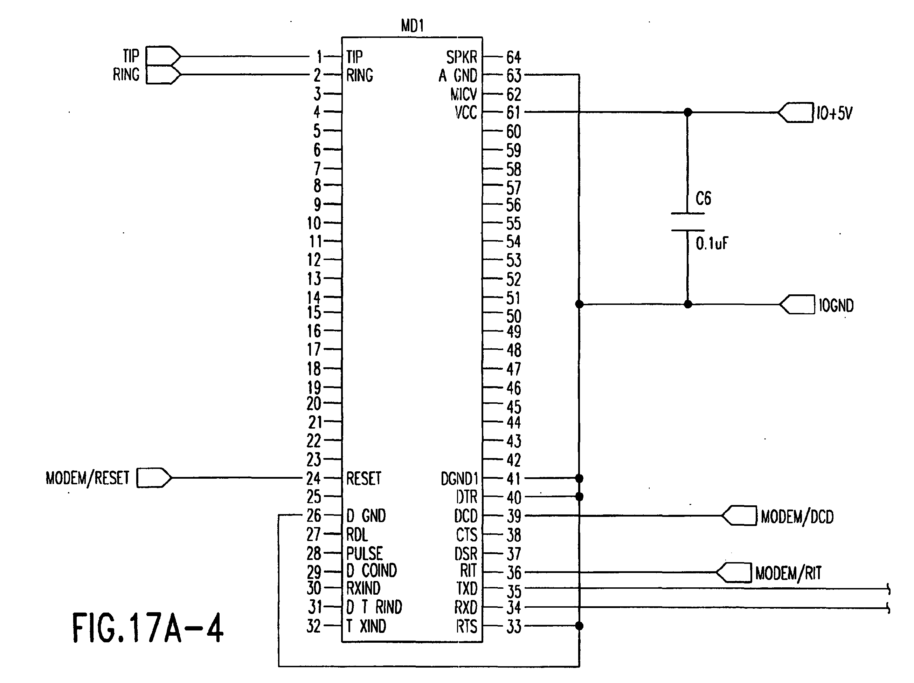

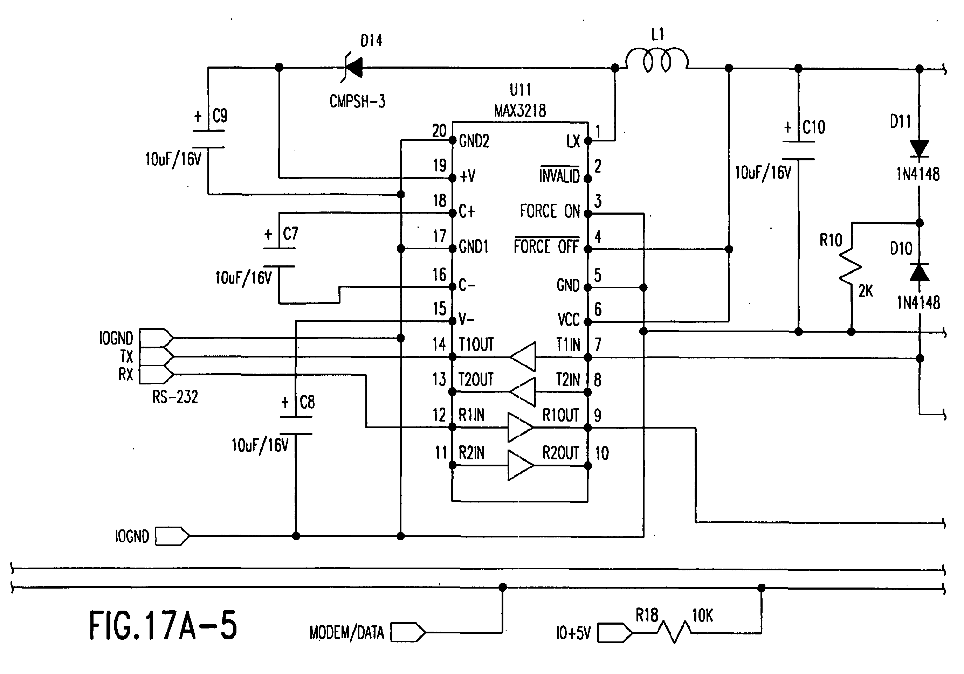

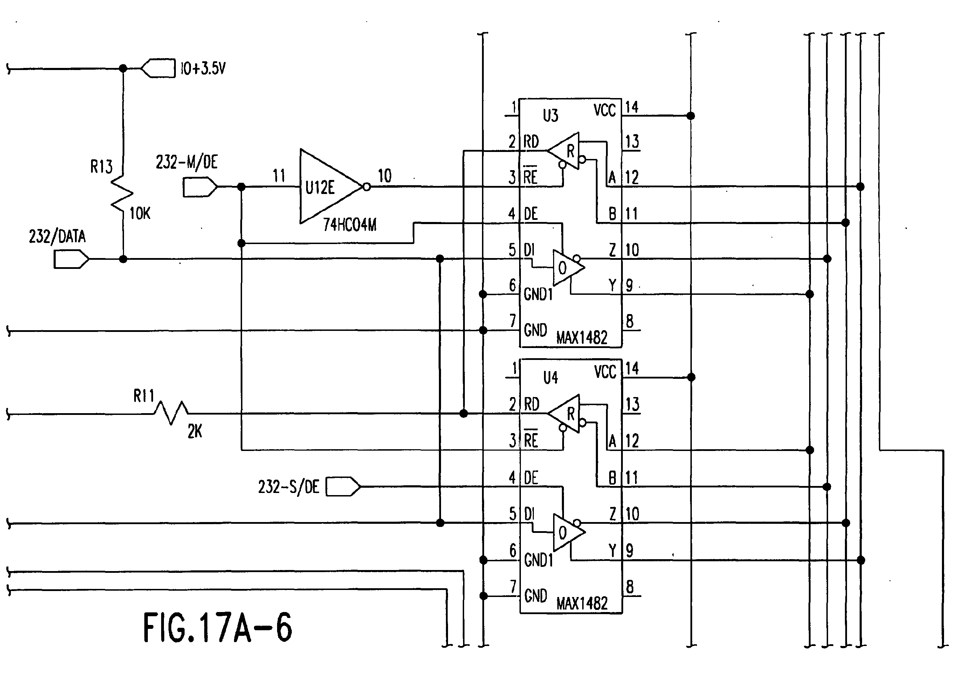

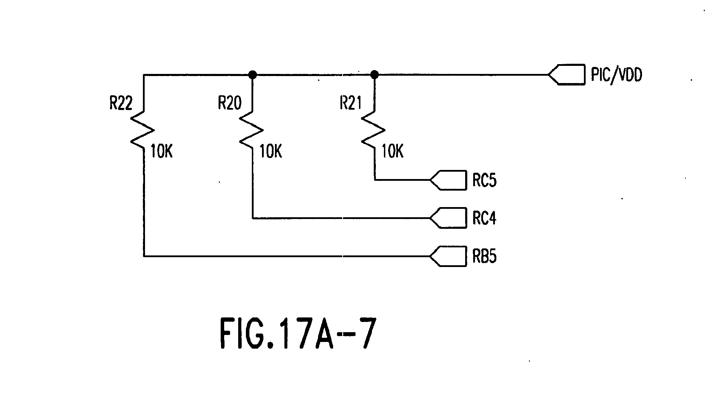

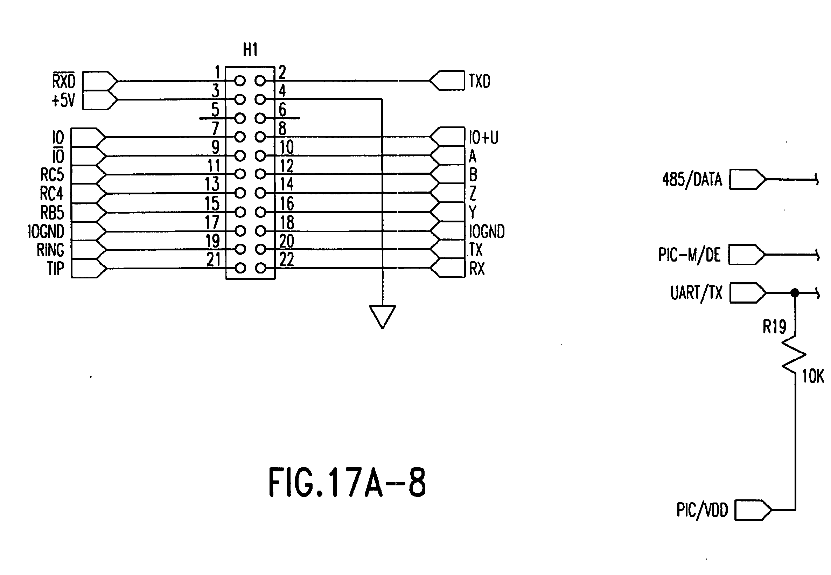

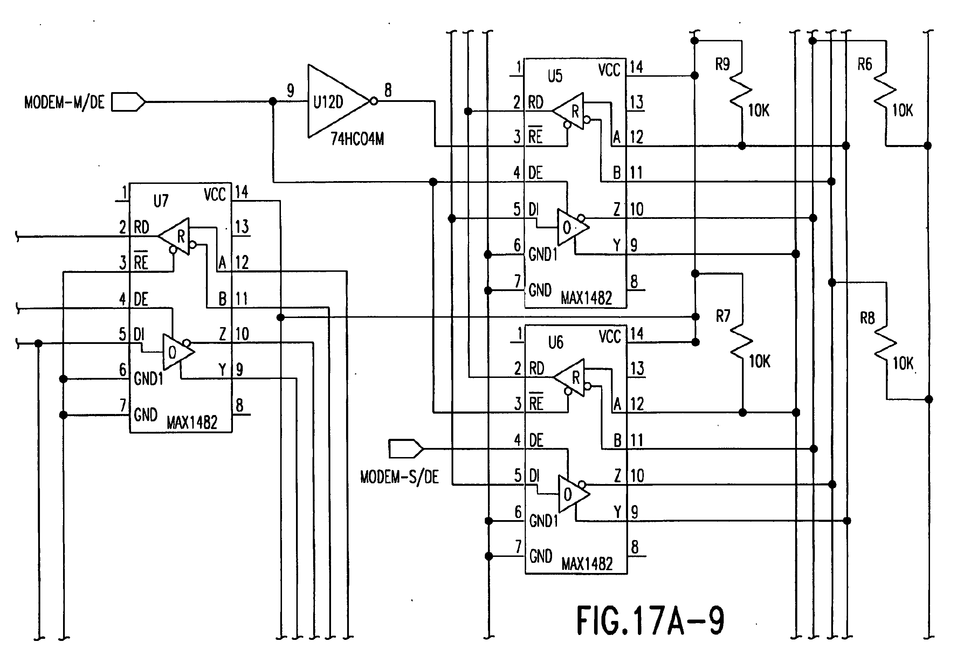

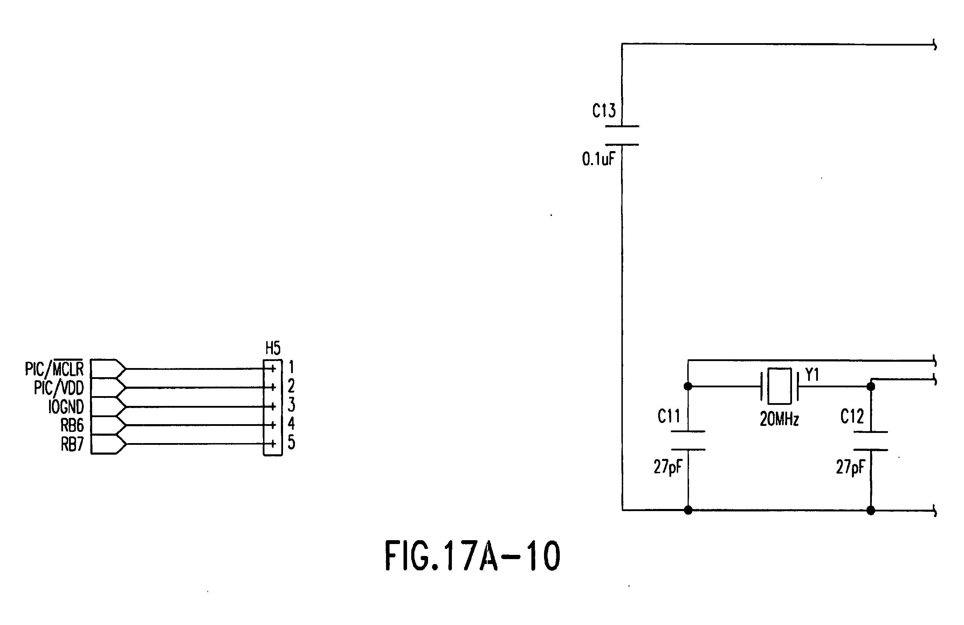

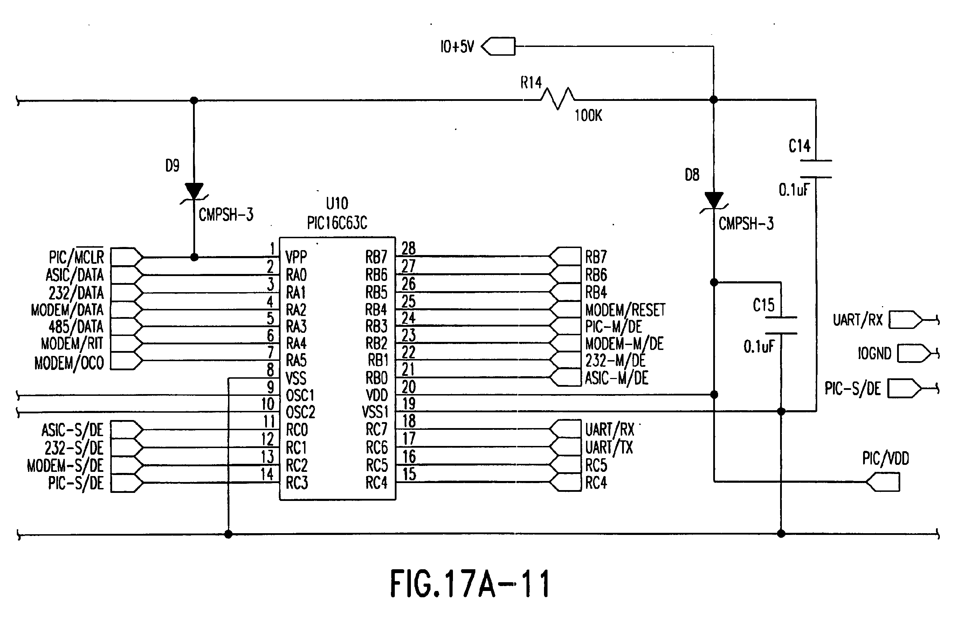

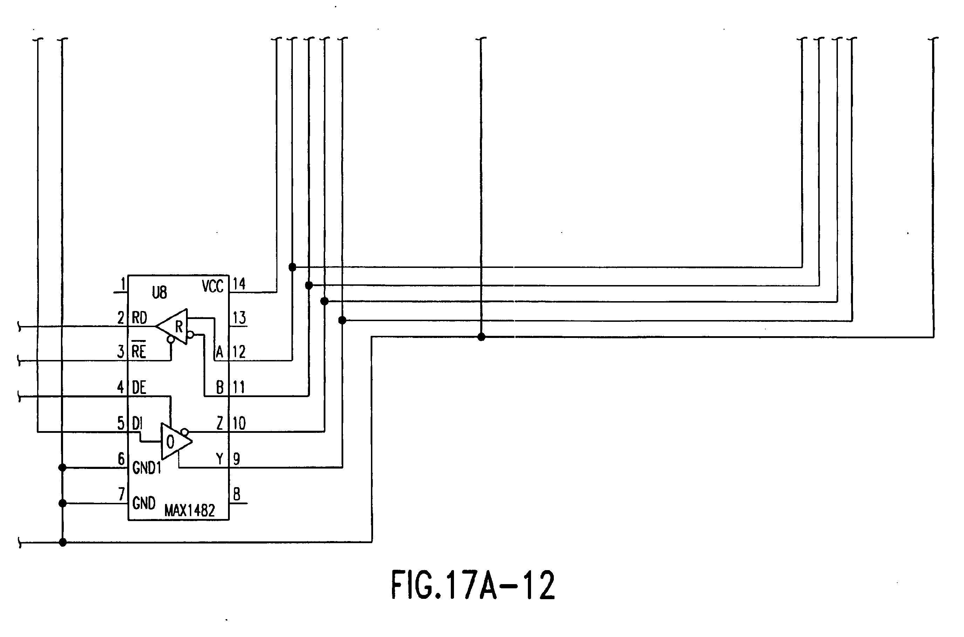

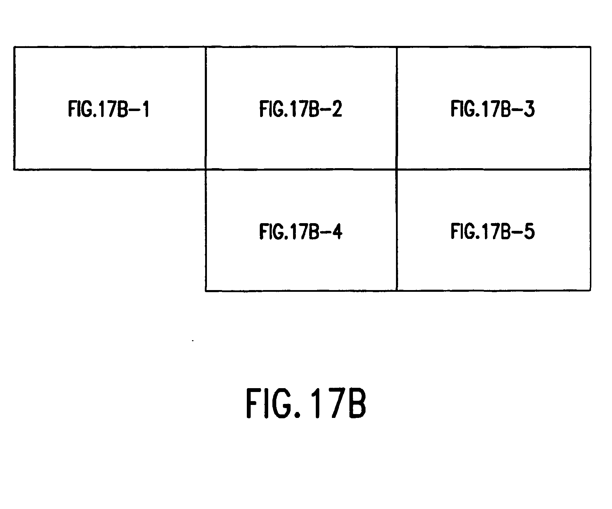

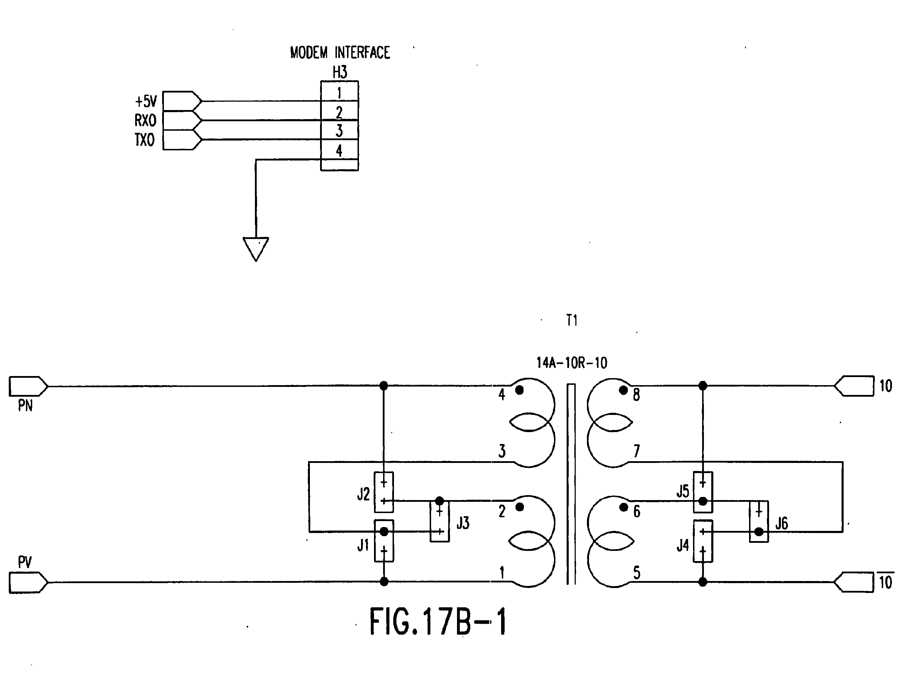

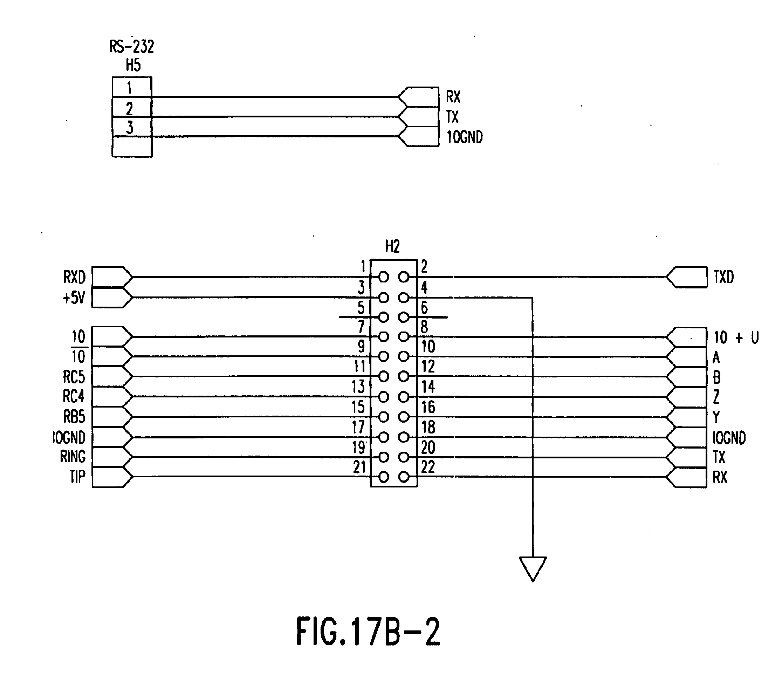

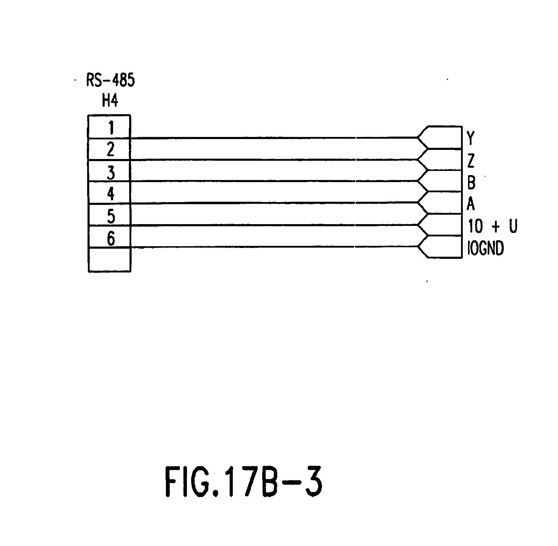

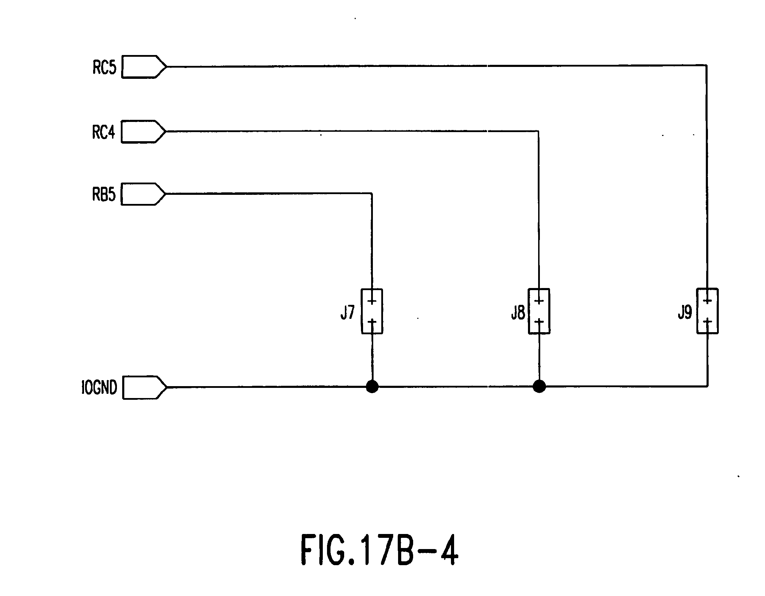

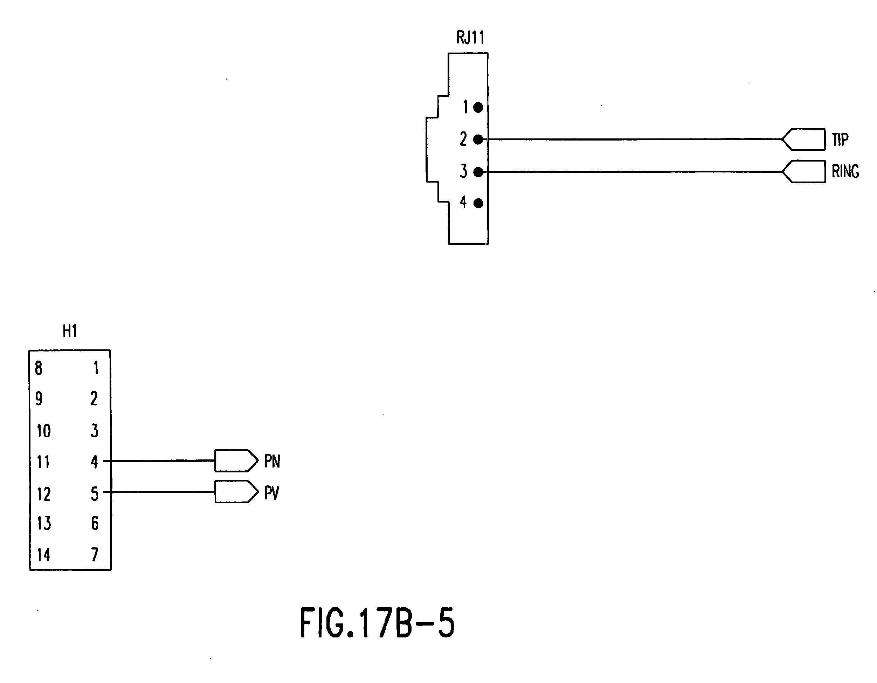

The Modem Board is so named because its on-board modem permits remote dial-in communication to other devices through different communication schemes. The Modem Board schematic diagram can be found in **FIGS.17A-B**. Each Modem Board is attached to a Mother Board containing an ASIC. Each Modem Board consists of a modem **MD1**, external RS232 (via **H4**), external RS485 (via **H1**), and an on-board microprocessor **U10**. The modem, RS232, the Mother Board, microprocessor, and external RS485 all communicate across the R5485 bus by means of TTL/RS485 converters (**U1- U8**). **U11** converts incoming RS232 to TTL levels. **U12** rectifies signal levels for RS485 converter controls. The phone line is connected to **RJ11**. Power into the rectifier and regulator come from **H2**. **H5** is the header that allows factory programming of **U10**.

To avoid bus conflicts, the on-board microprocessor arbitrates Master control and Slave control over these devices. The algorithms contained in the microprocessor are described by the HEX formatted file, MODEM.HEX, in the attached Appendix. The modem board's Auto Hunt feature seeks and adjusts to one of three appropriate baud rates 9600, 19200, and 38400.

**Calibrator**

The meter is calibrated automatically by a fully automatic calibrator. The calibrator: (1) can calibrate the meter at 20 points for both amplitude and phase; (2) calibrates each phase of the meter independently; (3) stores calibration constants in the non-volatile flash memory of the Transmeter; and (4) archives calibration records to the manufacturing database. The calibrator is described more fully below.

**The ASIC**

**Meter Component**

The ASIC of a preferred embodiment has an advanced electric meter with the following features:

(1) Automatic Autoranging Current and Voltage Amplifiers. The ASIC amplifiers sense the level of current and adjust to the level automatically in hardware. The ASIC voltage amplifiers are controlled by the external microprocessor.
(2) Automatic sample and hold timing logic. Allows for calibration of angle errors.
(3) Late voltage sampling logic and line frequency meter. Allows for generation of precise 90° phase shifted waveform for calculation of reactive power and energy.
(4) Offset DAC - allows for automatic firmware controlled amplifier offset correction.
(5) 12 BIT DAC with calibration points. A 12 BIT DAC with only 8 bits of accuracy is calibrated with digitally selected current sources to achieve 12-bit resolution and monotonicity.
(6) Auxiliary inputs to read battery voltage, power supply voltage, signal voltage from powerline modem and external analog quantities.
(7) Use of one of the analog inputs to compensated the temperature curve of the ADC to achieve better accuracy. Reads a fraction of the reference voltage generated with a voltage divider to maintain a constant scale factor over temperature.
(8) A digital potentiometer with 64 tap points used to digitally calibrate the voltage reference to within 0.1 % from an initial accuracy of 5%.

(9) Read the voltage on a common silicon diode to obtain an analog of temperature. Storing N pairs of calibration position from (8) above and temperature diode voltages can fit a curve of degree N-1 to the temperature variation, precisely controlling the temperature variation of the reference voltage. The diode is also used to correct the temperature variation of the real time clock crystal.

**Powerline Modem Component**

The ASIC of a preferred embodiment has a powerline modem with the following features:

(1) An adjustable gain, adjustable frequency analog bandpass filter with minimal external components.
(2) A circuit to allow continuous calibration of the gain and center frequency of the bandpass filter under microprocessor control.
(3) A bandpass delta-sigma modulator to convert the analog data to a digital stream.
(4) A digitally implemented demodulator unit capable of adjusting gains and demodulating either fsk or bpsk data.
(5) A digitally implemented fsk and psk modulator.
(6) A digitally and software implemented data clock that uses the line frequency or a multiple thereof as a common synchronous data clock throughout the system network.

**Digital Control and Memory**

The ASIC of a preferred embodiment contains many circuits that control the external devices on the Display Board: (1) a Motorola 68000 bus generator; (2) memory control logic; (3) a real-time clock (RTC); (4) a watchdog timer; (5) 4kBytes of CMOS battery backed RAM; (6) digital I/O; (7) tamper switch detection that continues to operate on battery; and (8) a bootstrap ROM for loading a secondary bootstrap program to internal RAM.

**Firmware**

Firmware controls many of the above-mentioned features of metering with advanced calibration algorithms, powerline communication protocols, liquid crystal displays, serial data interface. See 28130104.S in the attached Appendix.

The firmware provides an Advanced Data Integrity Method by providing a flash memory audit trail for added protection against data loss.

The firmware also provides a Data Log of Energy and Event Information, since the audit trail of energy information is commercially valuable under deregulation to ESCOs, utilities and end-users.

The firmware works with the Calibrator and (optionally) a Toaster (a test apparatus) to calibrate:

(1) The ADC. Realize 12 bits from an 8 bit limited CMOS process.
(2) The voltage reference. Obtain 0.1 % accuracy from a 5% device.
(3) The internal current transformers (both amplitude and phase - a complex plane calibration), at 20 separate logarithmically-spaced points throughout the load curve.
(5) All components in the metering circuit,
(6) The time clock's 32768 Hz crystal.

The firmware also provides Temperature Compensation Methods, since it: (1) uses a temperature diode to calibrate the voltage reference and time clock over temperature; and (2) uses a resistor divider on the voltage reference to calibrate the ADC over temperature.

The firmware also provides Self Calibration Methods, since it: (1) calibrates the bandpass filters periodically, and (2) adjusts the offsets in the meter circuits continually.

Also, the firmware provides Advanced Metering Parameters, since it:

(1) Uses a unique sample and control algorithm to provide all metering quantities. This method is fully determined by the program in the 68000, which controls the ASIC.
(2) Measures line frequency and create virtual 90 degree shifted voltage waveform for reactive power.
(3) Uses real, reactive and apparent power to calculate power factor, total harmonic distortion and phase angle.

The firmware can also automatically determine the proper range for: (1) Voltage; (2) Current; (3) Powerline signal; and (4) Demodulator parameters.

A more detailed description of the ASIC, its components, and its functionality are provided below.

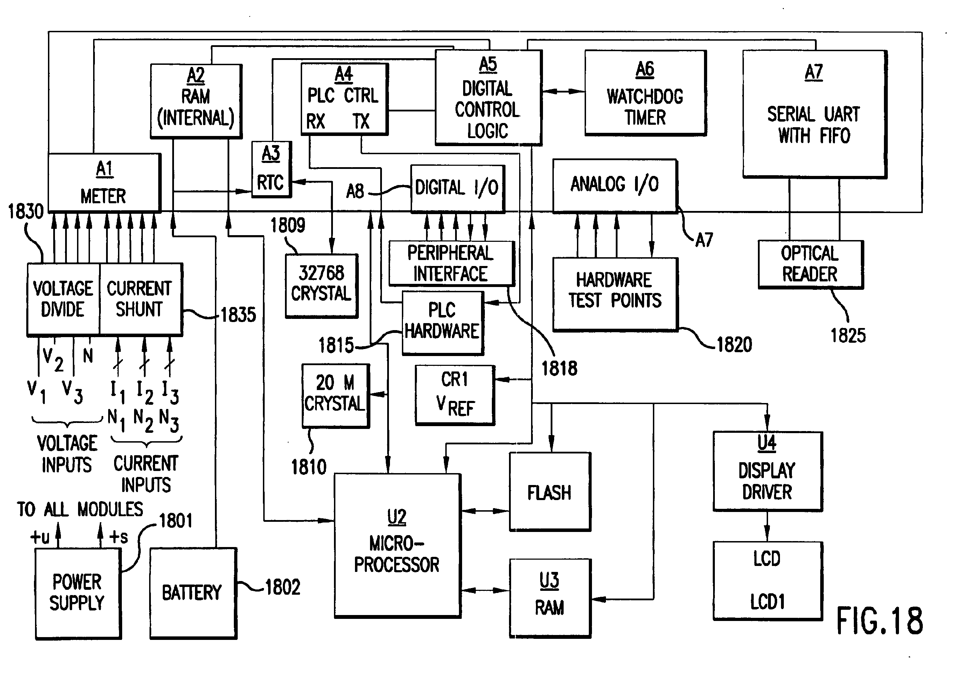

Configuration of a preferred submeter system is depicted in **FIG. 18**. The following is a description of principal modules in the system.

A Power Supply **1801** supplies unregulated DC voltage +U for high power functions such as PLC. A regulated +5VDC feeds each of the ICs and many other circuit blocks.

A Battery **1802** provides power for power-out operation of several functions in the ASIC including the Internal RAM **A2**, RTC **A3**, and 32768Hz crystal **1809**. It also powers the pulse reader when system power is unavailable.

Microprocessor **U2** performs all the intelligent computations from the raw meter data and the ASIC states. The main program memory resides in the FLASH **U5** but also run out of RAM and ASIC ROM in some cases.

FLASH **U5** is nonvolatile memory, the site of primary memory storage and program memory.

RAM **U3** is an IC that is external to the ASIC for microprocessor temporary storage of information.

Display Driver **U4** sends the control signals to the LCD **LCD1.**

The ASIC **U1** contains the bulk of the control hardware in the submeter system. The control blocks within the ASIC are discussed below.

32768 Crystal **1809** is used for time keeping.

20M Crystal **1810** is the system clock for both the ASIC and the microprocessor.

$V_{REF}$ **CR1** is a 2.5VDC reference voltage. This design utilizes an IC with an external voltage adjustment such as LM336- 2.5. The ASIC contains a 64 tap digital potentiometer that provides one of 64 voltage levels to the external control line. The ASIC control of $V_{REF}$ **CR1** saves the cost of a moving part and provides digital code accuracy. Furthermore, because this code can be software- controlled, $V_{REF}$ can be calibrated meter by meter and can be calibrated to fit a parabolic profile with temperature. $V_{REF}$ is calibrated to 2.49V, the voltage point of greatest temperature stability.

PLC Hardware **1815** is the power circuitry for the PLC transmit and receive.

Peripheral Interface **1818** is the connection point to external devices such as Pulse Relay, Relay Control, Minicloset interface, and transponder phase control circuits.

Hardware Test Points **1820** supply the ASIC with information that enables reading of +U, temperature, and ADC calibration. Various test points in the ASIC can be output as well.

Optical Reader **1825** is the hardware that translates the serial communication into optical transmission.

Voltage Divide **1830** is a 1000:1 voltage divide circuit that prepares measurement voltage for ASIC input.

Current Shunt **1835** is a resistor network used to convert current to voltage for ASIC input.

## Detailed ASIC description

A preferred ASIC system **U1** is depicted in **FIG. 18**. The following is an explanation of the different modules in the ASIC.

## The Meter

Meter **A1** reads the current and voltage channels from Voltage Divide **1830** and Current Shunt **1835**. Internal amplifiers and correction factors improve the accuracy of the meter reading.

RAM (Internal) **A2** is non-volatile RAM, backed up by the external battery **1802**. This is the storage site for temporary RAM accumulators and other critical RAM variables.

Real Time Clock (RTC) **A3** is the continuous time keeper for the system. The RTC is clocked by an accurate 32768Hz crystal **1809** and is the standard for time clocking. Battery power from battery **1802** keeps the RTC operational even when system power is removed.

PLC Control **A4** contains the control logic required to transmit and receive data that was sent through the PLC channels.

Digital Control Logic **A5** provides the interface bits that control the enable lines for each part, the address and data busses, system reset, and access to internal state registers.

Unless Watchdog Timer ("WDT") **A6** is refreshed, it will trigger a system reset.

Serial UART with FIFO **A7** functions much like the PC16550D from National Semiconductor.

Digital I/O **A8** is used for communicating to peripheral devices through the Peripheral Interface **1818**.

Analog I/O **A9** is used to gather system information from Hardware Test Points **1820**. This also outputs various analog points within the ASIC.

## Sampling

The following is an example of the sampling times of voltage and current.

Ideally the voltage and the current samples are performed exactly at the same time. However there are timing issues in the current and the voltage measurement hardware. Because time discrepancies are usually not equal, a constant timing adjustment, which we shall call "delay," is applied to the current sampling channel. The term "delay" is used loosely here because the actual numerical delay can be a positive or negative number. In Table 1, the delay is 0.056°. This number is obtained through calibration.

For each measurement, four voltage samples ($V_1$ $V_{L1}$ $V_2$ $V_{L1}$) and one current sample (I) are taken. $V_1/V_{L1}$ is used for phase-to-neutral reading and the $V_2/V_{L2}$ pair allows phase-to-phase reading. The difference between the two types will become more evident in the meter diagram discussion.

$V_1$ and $V_{L1}$ comprise a voltage sample pair. The two samples are placed approximately 2° apart. $V_1$ is called the Voltage Sample and $V_{L1}$ is called the Late Voltage Sample.

Each measurement phase takes turns utilizing the metering channel to read their sample pairs. For example, in a three-phase meter, phase 1 is read, then phase 2 is read, then phase 3 is read, then phase 1 is read again. Eventually all the phases are read and the cycle repeats.

The process requires two voltage samples to be 90° apart. The strategy is to set the cycle period so that $V_1$ from one sample pair and $V_{L1}$ from another sample pair will be exactly 90° apart. Table 1 lists example sampling degrees for a three-phase (3Φ) meter. Only phase 1 is shown.

Table 1

| Sample n | $V_1(n)$ | $V_{L1}(n)$ | I(n) |
|---|---|---|---|
| 1 | 0° | 2° | 0.056° |
| 2 | 44 | 46 | 44.056 |
| 3 | 88 | 90 | 88.056 |
| 4 | 132 | 134 | 132.056 |
| 5 | 176 | 178 | 176.056 |
| 6 | 220 | 222 | 220.056 |
| 7 | 264 | 266 | 264.056 |
| 8 | 308 | 310 | 308.056 |
| 9 | 352 | 354 | 352.056 |
| 10 | 36 | 38 | 36.056 |

Note the following:

(1) $V_1$ (1) and $V_{L1}$ (3) are 90° apart and therefore complete a measurement pair. $V_1$ (2) /$V_{L1}$ (4), $V_1$ (3) /$V_{L1}$ (5), and $V_1$ (4) /$V_{L1}$ (6) make up future measurement pairs.

(2) Note that the current is offset from the voltage by 0.056 degrees. This is the delay required to synchronize the reading of the two channels.

If Table 1 were extended, the sampling would sweep out the entire voltage waveform over a period of time. In a 3Φ meter every 4° would be sampled over 11 cycles. Table 2 shows the sequences of sampling degrees that would sweep the entire waveform:

Table 2

| $V_1(n)$ in degrees<br>$\Phi_1$ of a 3Φ meter |
|---|
| 0, 44, 88, 132, 176, 220, 264, 308, 352, 36, 80, 124, 168, 212, 256, 300, 344, 28, 72, 116, 160, 204, 248, 292, 336, 20, 64, 108, 152, 196, 240, 284, 328, 12, 56, 100, 144, 188, 232, 276, 320, 4, 48, 92, 136, 180, 224, 268, 312, 356, 40, 84, 128, 172, 216, 260, 304, 348, 32, 76, 120, 164, 208, 252, 296, 340, 24, 68, 112, 156, 200, 244, 288, 332, 16, 60, 104, 148, 192, 236, 280, 324, 8, 52, 96, 140, 184, 228, 272, 316, 0 |

Even better, since the 2° separation between $V_1$ and $V_{L1}$ is not exact, all of the degrees between will eventually be swept out over a longer period of time.

The other two phases in a three-phase meter fall evenly between the gaps of the sample pairs, as shown below in Table 3, $V_1$ degrees of a 3Φ Meter:

Table 3

| Phase 1 | Phase 2 | Phase 3 |
|---|---|---|
| 0.00° | 14.67° | 29.33° |
| 44.00 | 58.67 | 73.33 |
| 88.00 | 102.67 | 117.33 |
| 132.00 | 146.67 | 161.33 |
| 176.00 | 190.67 | 205.33 |
| 220.00 | 234.67 | 249.33 |
| 264.00 | 278.67 | 293.33 |
| 308.00 | 322.67 | 337.33 |
| 352.00 | 6.67 | 21.33 |

Two- phase (2Φ) meters are sampled analogously to a 3Φ meter except the third phase samples are discarded. Table 4, $V_1$ degrees of a 2Φ Meter, shows the sampling of a Two- Phase Meter:

Table 4

| Phase 1 | Phase 2 |
|---|---|
| 0.00° | 14.67° |
| 44.00 | 58.67 |
| 88.00 | 102.67 |
| 132.00 | 146.67 |
| 176.00 | 190.67 |
| 220.00 | 234.67 |
| 264.00 | 278.67 |
| 308.00 | 322.67 |
| 352.00 | 6.67 |

Mini- closets are sampled so that all 24 phases are sampled in about 630 degrees or seven quarter cycles of the line as shown below in Table 5, Sample Pair Degrees of a MiniCloset. This implies that each phase sweeps the entire sine wave in 67 line cycles.

Table 5

| Phase | V | $V_L$ |
|---|---|---|
| 1 | 0.00° | 2.00° |
| 2 | 26.17 | 28.17 |
| 3 | 52.33 | 54.33 |
| 4 | 78.50 | 80.50 |
| 5 | 104.67 | 106.67 |
| 6 | 130.83 | 132.83 |
| 7 | 157.00 | 159.00 |
| 8 | 183.17 | 185.17 |
| 9 | 209.33 | 211.33 |

(continued)

| Phase | V | $V_L$ |
|---|---|---|
| 10 | 235.50 | 237.50 |
| 11 | 261.67 | 263.67 |
| 12 | 287.83 | 289.83 |
| 13 | 314.00 | 316.00 |
| 14 | 340.17 | 342.17 |
| 15 | 6.33 | 8.33 |
| 16 | 32.50 | 34.50 |
| 17 | 58.67 | 60.67 |
| 18 | 84.83 | 86.83 |
| 19 | 111.00 | 113.00 |
| 20 | 137.17 | 139.17 |
| 21 | 163.33 | 165.33 |
| 22 | 189.50 | 191.50 |
| 23 | 215.67 | 217.67 |
| 24 | 241.83 | 243.83 |
| 1 | 268.00 | 270.00 |

Electrical quantities are computed from sampled voltage and current. The following are the mathematical formulas used:

Quantities calculated every sample:

Sample index: $n = n + 1$
Real Energy: $WHr_n = K_U V_1 (n) I (n) T_S + WHr_{n-1}$
Reactive Energy: $VARH_n = K_U V_{L1} (n+m) I (n) T_S + VARH_{n-1}$

Apparent Energy: $U_n = \sqrt{WHr_n^2 + VARH_n^2}$

Volts-square hour: $V^2 H = K_V^2 V_1(n)^2 T_S + V^2 H_{n-1}$

Current- square hour: $I^2H_n = (K_U / K_V)^2 I_1 (n)^2 T_S + I^2H_{n-1}$

Quantities calculated every frame of N samples:

Frame Index: $f = f + 1$

RMS voltage: $VRMS_f = \sqrt{(V^2 H_n) / T_N}$

RMS current: $IRMS_f = \sqrt{(I^2 H) / T_N}$

Volt-Amp hour: $VAH_f = VRMS_f \, IRMS_f \, T_N + VAH_{f-1}$

Where:

$K_U$ = KWH calibration constant for a particular range and metering phase.
$K_V$ = Voltage calibration constant.
$V_1(n)$ = Voltage sample point "n".
$V_{L1}(n + m)$ = Late voltage sample that is 90° displaced on the waveform from $V_1(n)$.
$I(n)$ = Current sample point.
$N$ = Total number of samples taken in a frame.
$T_S$ = Sample period.
$T_N$ = Frame period.

Notes:

1. $V_{RMS}$ and $I_{RMS}$ are non-accumulation quantities but require a frame of samples for calculation. A frame size is approximately 1 second's worth of samples. The $V_{RMS}$ calculation uses $V^2H$ that has accumulated between samples *0* and *N*. Similarly, the $I_{RMS}$ calculation uses $I^2H$ that has accumulated between samples *0* and *N*. Therefore *VAH* is only updated once per frame.
2. *VAH* contains power of harmonic content, whereas *WHr*, *U*, and *VARH,* do not.

**Calibration**

When the meters are produced, they are capable of measuring voltage, current, KWH, and other parameters. These measurements can have an error of up to plus or minus 15 percent, due to manufacturing tolerances in the electronic components. While the value of this error is not predictable, the error will be extremely stable for a given meter. In other words, a meter which has just been built will not be particularly accurate, but the error will be very repeatable.
The calibrator used in a preferred embodiment measures the inherent error of the meter, then instructs the meter's onboard processor to correct the measured error. The meter stores these correction factors in its non-volatile memory, resulting in readings that are both accurate and stable.
The calibrator comprises a computer and auxiliary equipment. The calibrator is preferably capable of supplying AC voltages between 0 and 600 volts, and AC currents between 0 and 210 amps. The phase angle theta (O) between the voltage and the current is adjustable from -90 to +90 degrees. The frequency of the AC power can be either 50 or 60 hertz.
The calibrator communicates with the meter using the meter's built-in optical communications port, and uses standard measurement devices to measure the actual correct value of the parameters being adjusted. For voltages, the calibrator uses a digital voltmeter (DVM) to obtain the actual values. For KWH, the calibrator uses a Radian KWH standard to measure the KWH to .05 percent accuracy.
There are several possible sources of errors in the meter's measurements: (1) voltage reference value and stability; (2) ADC linearity; (3) amplifier gain and delay; (4) sample rate; (5) system clock frequency; and (6) component tolerances for resistors and capacitors in measurement circuitry.

**Calibration Algorithm**

Voltage reference calibration: The output voltage of the voltage reference is adjusted by the calibrator to an initial value chosen to provide the most stable output voltage. This is accomplished by reading the actual value of the voltage reference using a DVM. The meter is then instructed to set the value of a digitally-controlled potentiometer (within the ASIC in the preferred embodiment) that adjusts the output voltage of the voltage reference. The calibrator then repeats this process until the voltage reference is set to the correct nominal output voltage (in a preferred embodiment, this is 2.490 Volts).
ADC linearity calibration: the meter uses an ADC inside the ASIC to read the voltage, current, and other analog values needed by the measurement algorithm of the meter. When the ASIC is manufactured, this ADC may be non-monotonic at high-order bit transitions. The ASIC provides for individual adjustment of the weight of the 5 high-order bits in the ADC, allowing calibration to guaranteed monotonicity. The calibrator uses a DVM to measure values just above and below these bit transitions, and adjusts the weight of each bit in order to get a monotonic response. These adjustments are performed by the meter's firmware, which writes correction values into registers in the ASIC. When the proper correction values have been found, the calibrator instructs the meter to store these values permanently in the non-volatile memory.

$V_{REF}$ and ADC temperature drift calibration: the voltage reference and the ADC are both affected by temperature changes experienced by the ASIC. This results in an error which varies with temperature. The calibrator measures the performance of the voltage reference and the ADC at 3 different temperatures (room temperature, 5°C, and 85° C) . The effect of temperature is then communicated to the meter's firmware. In operation, the meter reads its ambient temperature, then uses the temperature calibration information to correct for the effects of temperature on the ADC and voltage reference.

Voltage calibration: the meter must measure AC RMS voltage. The accuracy of the measurement is affected by the factors listed above (in "sources of error"). The meter has 4 different measurement ranges for voltage. In the present meter, these ranges are: (1) Range 3 - 0 to 75 volts; (2) Range 2 - 75 to 150 volts; (3) Range 1 - 150 to 300 volts; and (4) Range 0 - 300 to 600 volts.

The different ranges use different internal configurations of the ASIC, resulting in different gains in the signal presented to the ADC. Each of these gain settings may have a different error. For each voltage range, the calibrator supplies the meter with an AC voltage which is appropriate for that range. The calibrator then reads the voltage applied to the meter using a DVM, and also reads the voltage as measured by the meter. The difference in these readings is analyzed, and a correction factor is calculated and sent to the meter. For each range, this process is repeated until the meter and the DVM measurements agree. The value of the correction factor (the Voltage Calibration Constant) is then permanently stored in the non-volatile memory of the meter.

KWH calibration: the meter must measure energy in KWH. In order to do this accurately, the external quantities of voltage and current must be accurately measured so that KWH can be calculated. The KWH measurement depends on the value of the voltage and the current, and the timing relationship between the voltage and the current. The equation for KWH is Volts * Amps * Cos(Theta) * Hours, where Theta is the phase angle between the voltage and the current. The meter performs this measurement by sampling the voltage and the current simultaneously, then processing these instantaneous values.

Various errors can occur due to the reasons listed above. For this measurement, it is not only necessary to correct any errors in the values of the measured voltage and current, it is also necessary to correct for any error in the time relationship of these measurements. The meter has 20 ranges for current, from range 23 at 0.5 amps to range 4 at 100 amps. For each range, the internal configuration of the ASIC amplifiers is different, and the CT introduces current-dependent errors in both amplitude and delay. Therefore, the calibrator repeats the KWH calibration for each range.

Amplitude compensation: any error in the actual value measured for voltage and current is compensated for by using an "Amplitude" (A) calibration constant. This constant is a factor by which the readings are multiplied, to make the measured value correct.

Delay compensation: the time relationship between the voltage and the current signals may be incorrect due to amplifier characteristics in the ASIC, or due to the characteristics of the current transformers (CTs). In particular the CTs introduce a current-dependent phase shift which becomes greater and greater at low currents. This results in the current signal not being properly synchronized with the voltage signal. This error results in errors in the KWH measurement due to the change in theta caused by this time shift.

Any error in the time relationship between the voltage and the current measurement is compensated for by instructing the ASIC to sample the current either before or after the ASIC samples the voltage. This time-delay between the samples is adjusted to exactly cancel the time-delay caused by the measurement circuitry. This is referred to as the "Delay" (D) calibration constant.

KWH calibration algorithm: for each of the 20 current ranges, the calibrator sets up a specified voltage and current. This voltage and current are supplied to the meter being calibrated, and also to a KWH standard (Radian RM-10, +/-.05%). The calibrator cannot directly measure the quantities that it needs to communicate to the meter (amplitude and delay error). Instead, the calibrator measures the actual error in KWH registration. This error is caused by the combination of the amplitude error and the delay error. The calibrator does this measurement by supplying the specified current and voltage to the meter and to the standard, then measuring the accumulated KWH for a specified time interval. The difference between the standard and the meter measurements is the KWH error.

In order to separate the contributions of the amplitude error and the delay error to the total error, the calibrator performs the KWH test twice. In the first test, theta is set to 60 degrees, and the KWH error is measured and saved. Then, the test is repeated at 0 degrees.

Because the slope of the cosine is nearly flat around 0 degrees and quite steep at 60 degrees, the contribution of the delay (timing) error is very small at 0 degrees, and much larger at 60 degrees. The contribution of the amplitude (value) error is the same at either 0 or 60 degrees. Therefore, with these 2 measurements, the calibrator can solve for the 2 independent error sources (amplitude and delay).

After the calibrator does these measurements and makes these calculations, the calibrator instructs the meter to compensate for these errors.

This entire process is then repeated, until the measurements at both 0 and 60 degrees are within specification. The calibration constants are then stored in the meter's non-volatile memory.

**Interval Metering**

Interval metering stores independent records of metering data for future recall. Electrical parameters are continuously accumulated into battery-backed RAM and then periodically stored to non-volatile FLASH memory. For example, if the metering interval were set to 30 minutes, there would be 48 records of data in the day. Table 6 below, illustrating interval storage, is an example of data storage using Interval Metering. Interval Metering can be particularly useful in calculating billing demand.

Table 6

| Time at start of Interval | Consumption |
|---|---|
| 02/03/2001 05:00am | 0.122 kwh |
| 02/03/2001 05:30am | 0.128 kwh |
| 02/03/2001 06:00am | 0.115 kwh |
| 02/03/2001 06:30am | 0.858 kwh |
| 02/03/2001 07:00am | 0.778 kwh |
| 02/03/2001 07:30am | 0.353 kwh |
| 02/03/2001 08:00am | 0.247 kwh |
| 02/03/2001 08:30am | 0.137 kwh |

Interval Metering offers more frequent data records, which is useful in demand billing calculations and Theft Detection. But more important, Interval Metering in conjunction with FLASH memory provides protection from data corruption. In the past, switching a very high-current inductive load created an enormous transient on the line, destroying the RAM data. In other cases, RAM has also been found to corrupt in the presence of EMI sources such as toy transmitters.

Because RAM data is frequently dumped to FLASH memory, only a minimal amount of data in RAM is ever exposed to corruption. Reducing the storage intervals further increases data protection. FLASH is a far more reliable memory because, it requires a sequence of commands for any data modification and does not require a power source for data retention.

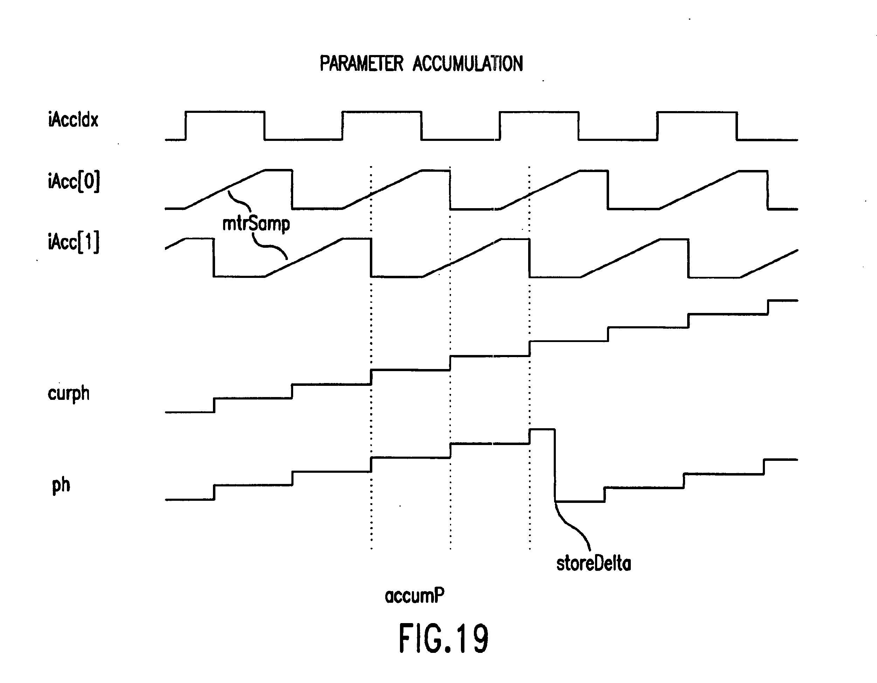

**FIG. 19** shows how electrical parameters are accumulated in preferred software. There are two data accumulation registers per parameter and phase. The first register iAcc[0] becomes active. After a short period of time, this register is available to be dumped into RAM register curph. While waiting for this transfer, iAcc[0] ceases to accumulate and iAcc[1] is cleared and begins active accumulation. When iAcc[1] is ready for transfer, iAcc[1] becomes inactive and iAcc[0] is cleared and begins to accumulate. This enables seamless accumulation and periodic dumping to curph in RAM.

At the end of a metering interval, the electrical parameters are then stored to FLASH. After successful storage to FLASH, the RAM register is cleared and begins to accumulate for the next interval.

**Meter Hardware**

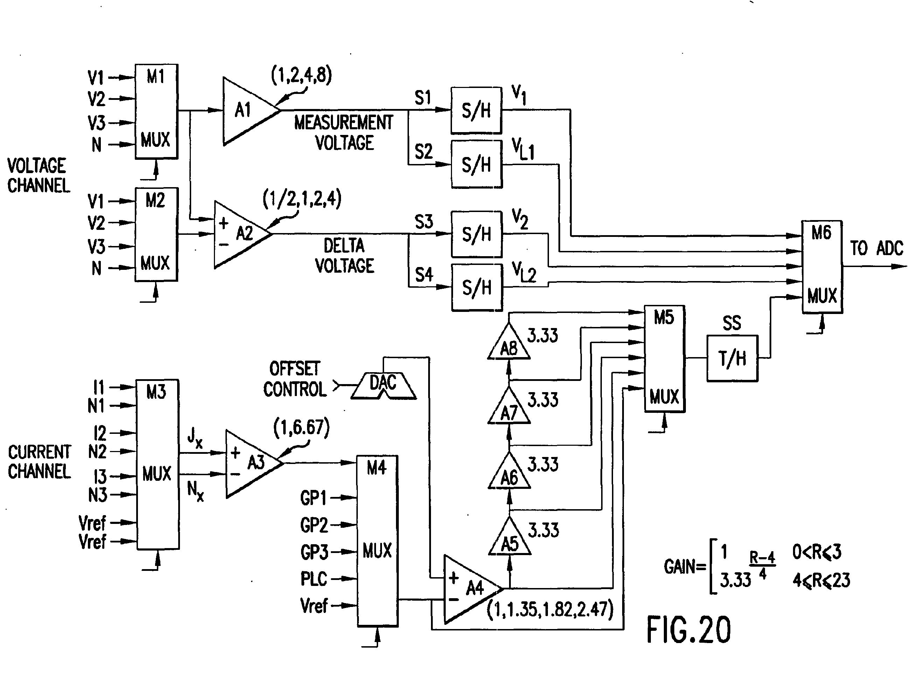

The overall Meter Hardware is depicted in **FIG. 20**. The upper portion shows the voltage channel and the lower portion the current channel. Both voltage and current are fed through their own gain stages and are selected through MUX **M6** for the ADC.

Voltage channel - MUX **M1** and MUX **M2** independently select between V1, V2, V3, and N. The signal through the amplifier **A1** is phase-to-neutral. The signal through the amplifier **A2** is a differential (or delta) voltage between the two signals that were selected from MUX **M1** and MUX **M2**, the delta voltage $V_2$. Each of these voltages pass through two sample and hold circuits, creating the late voltage $V_L$. From the four sample and holds emerge: $V_1$, $V_{L1}$, $V_2$, $V_{L2}$.

Amplifiers **A1** and **A2** have adjustable gains. Because **A2** is intended for higher delta voltage, its gains are half of **A1**. The gain setting corresponds to a particular range of voltage amplitudes that will obtain optimal readable scale after amplification. There are four voltage ranges, 0 through 3.

$V_1$: Gain = $2^R$

$V_2$: Gain = $2^{R-1}$

Current channel - MUX **M3** selects between 4 signal pairs: I1/N1, I2/N2, I3/N3, and $V_{REF}/V_{REF}$. The signal passes through amplifier **A3**, is selected by MUX **M4** and passes through a series of amplifiers **A4 - A8**. There are 23 current range settings selectable through MUX **M5** and amplifier **A4**.

I: Gain = 1.00 0 £ R £ 3
$3.33^{(R-4)/23}$ 4£ R £ 23:

Offset control - Small offset voltage in amplifier **A3** could saturate the current channel at higher ranges, making current unreadable. To null any offset, the output offset is dynamically monitored and adjusted in amplifier **A4**.

ADC Temperature Calibration - Because there is temperature variation with the ADC, the ADC is calibrated with temperature against the temperature sensing diode. The result is a best fit curve that can be applied to the final data in software.

**Power Line Communication**

A preferred implementation of Power Line Communication (PLC) is flexible enough to allow for faster data rates and successful data recovery.

Modulation schemes - Two modulation techniques are available: Frequency Shift Keying (FSK) and Phase Shift Keying (PSK).

Data Rates - The Baud Clock is synchronized to the line phase by means of a Phase-locked Loop (PLL). The PLL is jointly implemented in software and hardware. By knowing the zero phase crossings from the PLL, the actual data rate can be synchronized to fractions or multiples of the line frequency.

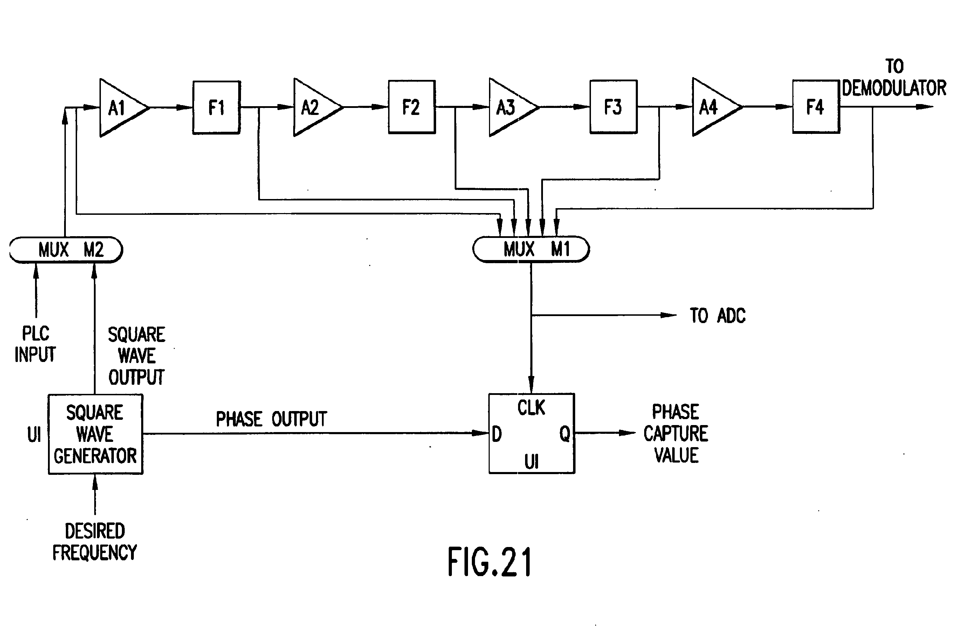

PLC Receiver - The PLC receive circuitry as found in the ASIC is shown in **FIG. 21.** In the normal mode, **M2** channels the PLC input into the filter. The filter rejects out-of-band noise and couples the signal into the demodulator.

The PLC filter is designed as a continuous time domain filter. Its advantage over switched capacitor filters is to achieve higher Q and lower internal noise level in the operating frequency band. The high Q is essential because a bandpass effect is created from a lowpass, high Q design with attenuation. The attenuation compensates for high gain at the peak frequency of the LPF. The attenuation provides the low frequency rejection. A true bandpass filter can also be used as well. The filter is tunable to frequencies from 20-90kHz. The filter also compensates for variation due to components and temperature variation.

The overall filter is frequency-tuned with the Coarse Adjustment Register. The proper setting places the filter in the vicinity of the desired value. The entire filter is comprised of four filter stages, with the attenuation control spread over the four stages. These four stages need to be aligned to the desired frequency. Fine Adjust registers **F1-F4** enable frequency tuning of each stage while Attenuation registers **A1-A4** enable amplitude tuning or each stage. Together, these adjustments calibrate out any discrepancies between stages.

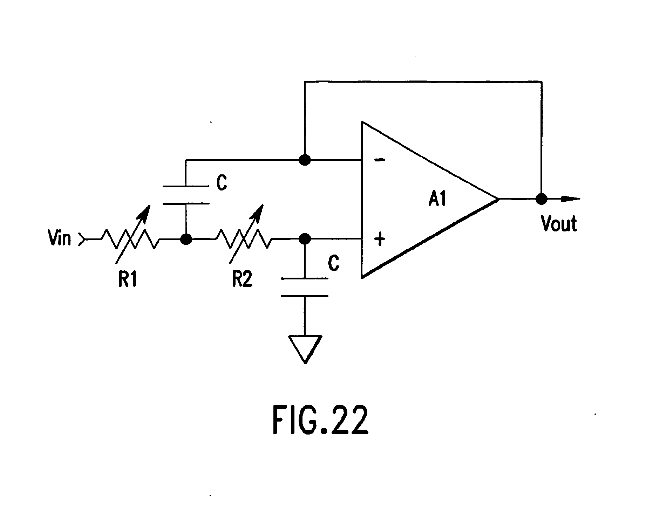

Each filter stage is preferably implemented as a two-pole lowpass filter with two external capacitors. A preferred filter is shown in **FIG. 22**.

Filter Alignment: Filter alignment is the process of tuning the corner frequencies of each of the four filter stages to the desired frequency by means of phase shift detection. The alignment process injects a test signal with a Square Wave Generator **U2**. **U2** also outputs the phase of the square wave to be latched in by a Phase Shift Detector **U1**.

The microprocessor selects the desired frequency for **U2** and routes the square wave through **M2** to the input to filter. This square wave signal passes into all four stages of the filter. The microprocessor selects the filter stage output to pass through **M1**. The signal undergoes phase shift in the filter stages and its rising edge becomes the latch clock for U1, latching across the phase difference between the filtered signal and the test signal. For the two-pole lowpass stage, the phase at the corner frequency is 90°.

The ADC monitors the signal strength of the PLC signal to adjust attenuators **A1 - A4** for adequate clocking of the phase capture latch. The following is the filter alignment process:

(1) Place Fine Adjust of Stage 1 at the midpoint value.

(2) Set the Coarse Adjust Register to the highest frequency setting and lowest attenuation. Observe signal strength with the ADC. Decrease Coarse Adjust until there is valid signal strength. Adjust attenuators so that filter input does not saturate. Check phase difference. Continue adjusting Coarse Adjust and Attenuator 1 until there is a 90° difference.

(3) Tune Stage 1: (A) start with Fine Adjust 1 at the midpoint; (B) modify Attenuator 1 for valid signal strength; (C) check filter phase; (D) change Fine Adjust in the direction that leads the filter phase to 90° (a binary search algorithm is suggested); and (E) repeat (B) to (D) until filter phase is 90°.

(4) Tune Stages 2 thru 4. Note that the Phase Capture value is the phase difference between the square wave input and the output of the filter stage. Therefore Stage 2 seeks a 180° difference, Stage 3 seeks a 270° difference, and Stage 4 seeks a 0° difference.

Similarly, if the filters were designed with true bandpass filters with the same roll- off, the phase difference across stages would be 180 degrees.

Digital Demodulator: The filtered signal enters the demodulator circuit. The digital demodulator uses a digital phase lock loop to identify the binary data stream.

**PLC Transmitter**

A preferred embodiment uses ASIC control circuitry to control the PLC transmitter. There are two outputs that can be driven in parallel or opposite, depending on whether the design is for a bridge circuit or for a single-ended circuit.

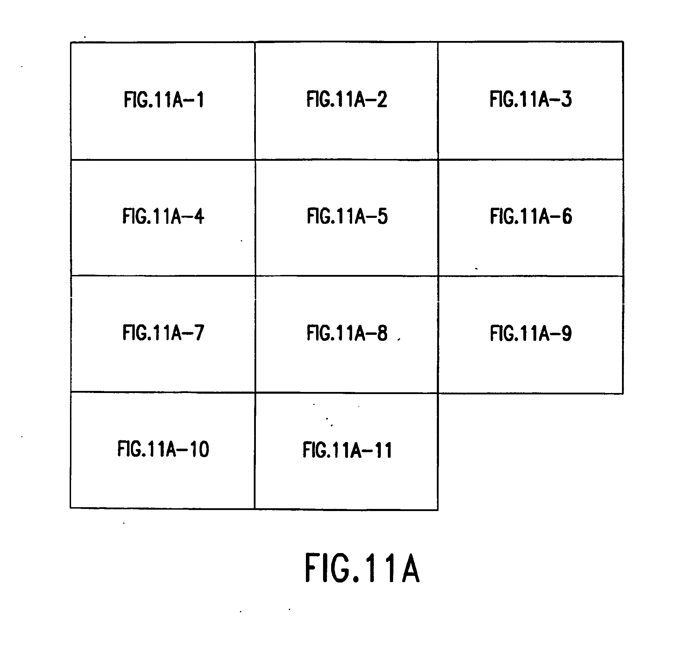

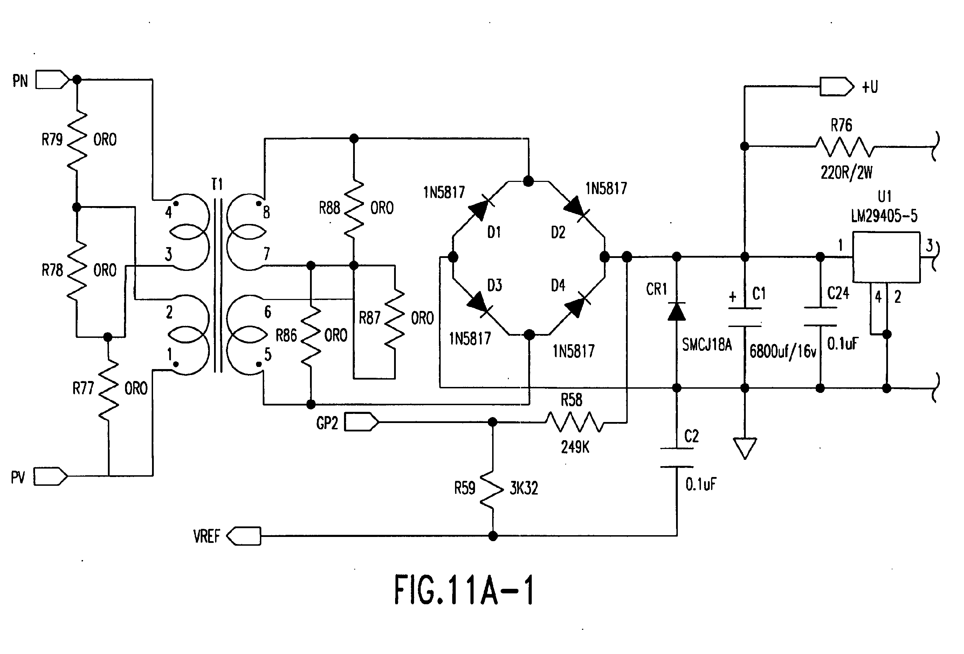

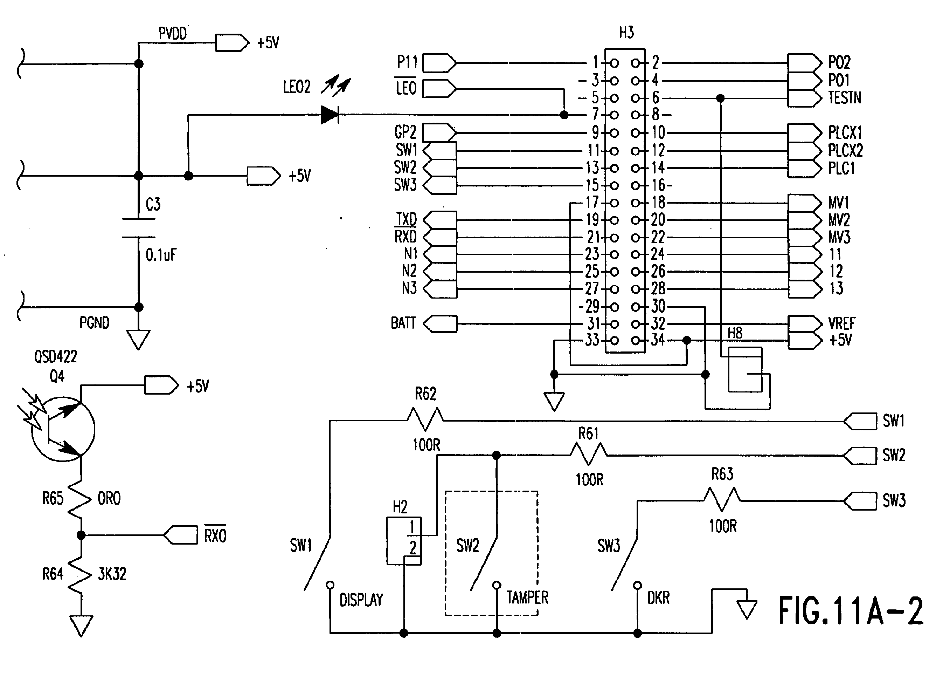

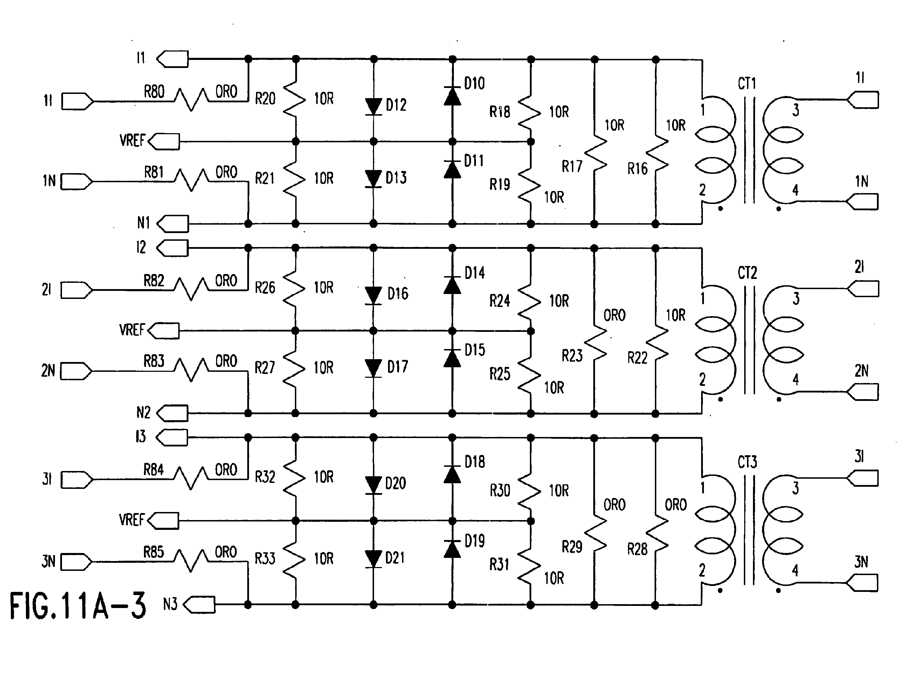

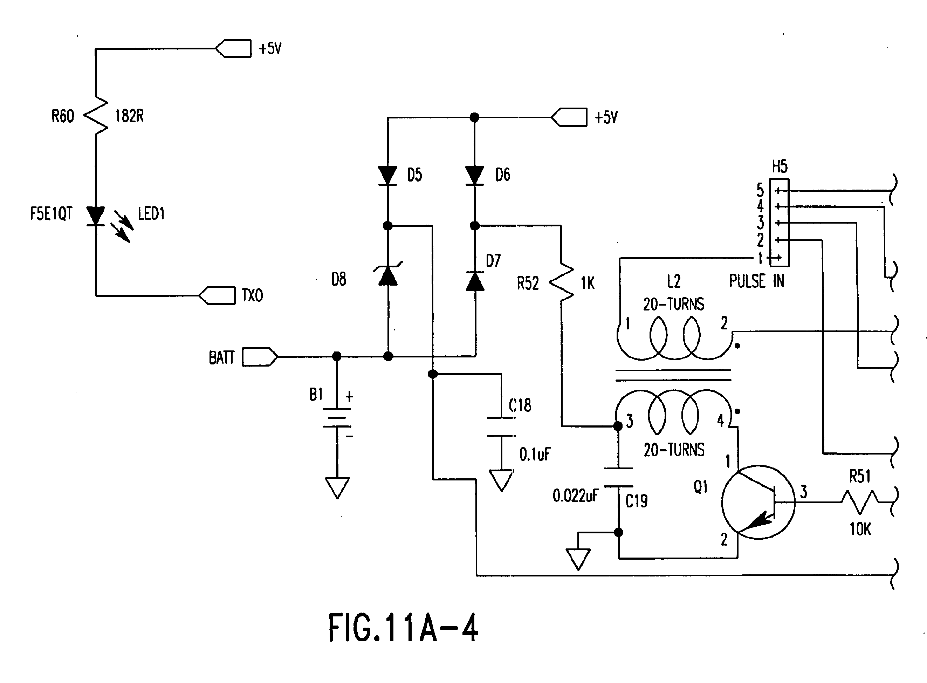

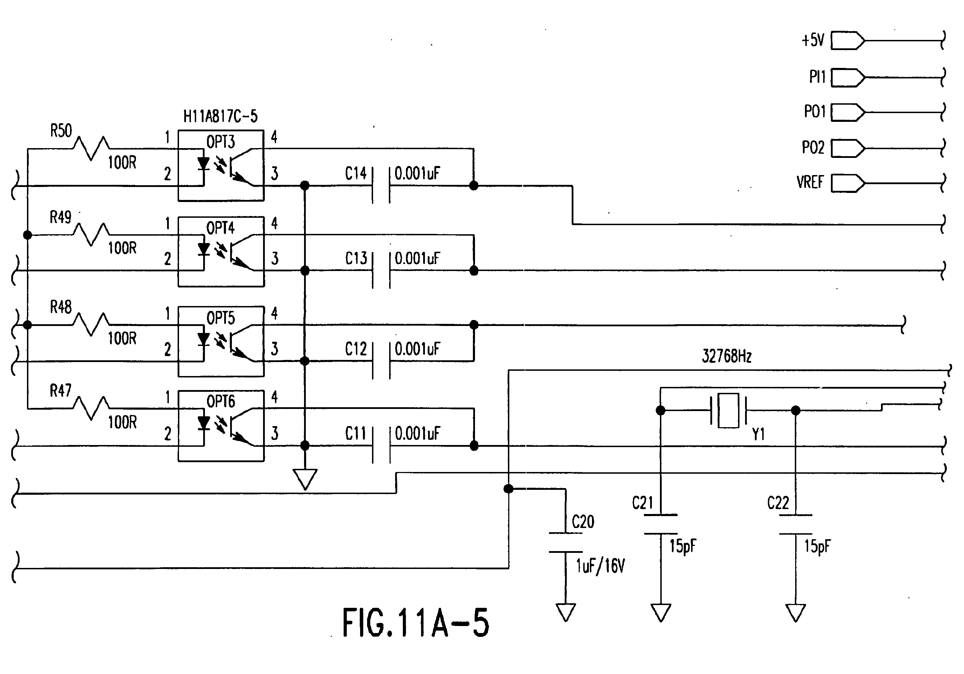

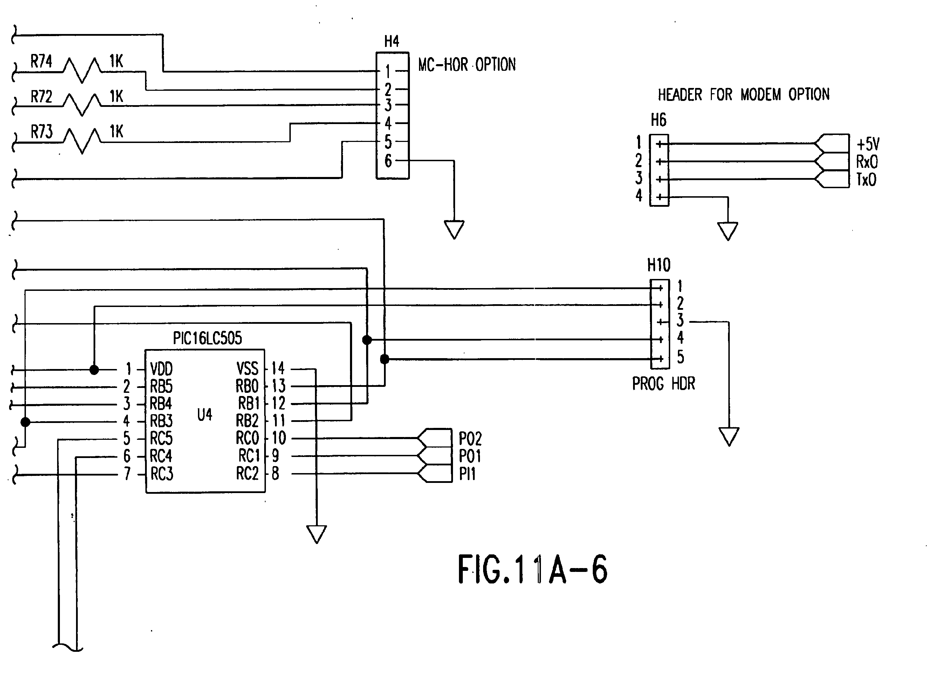

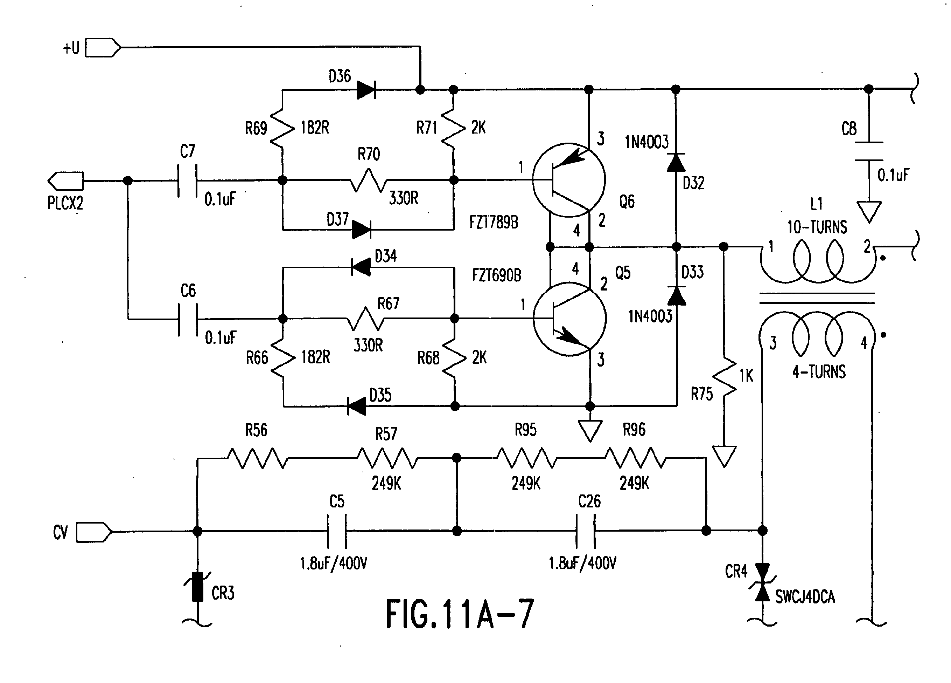

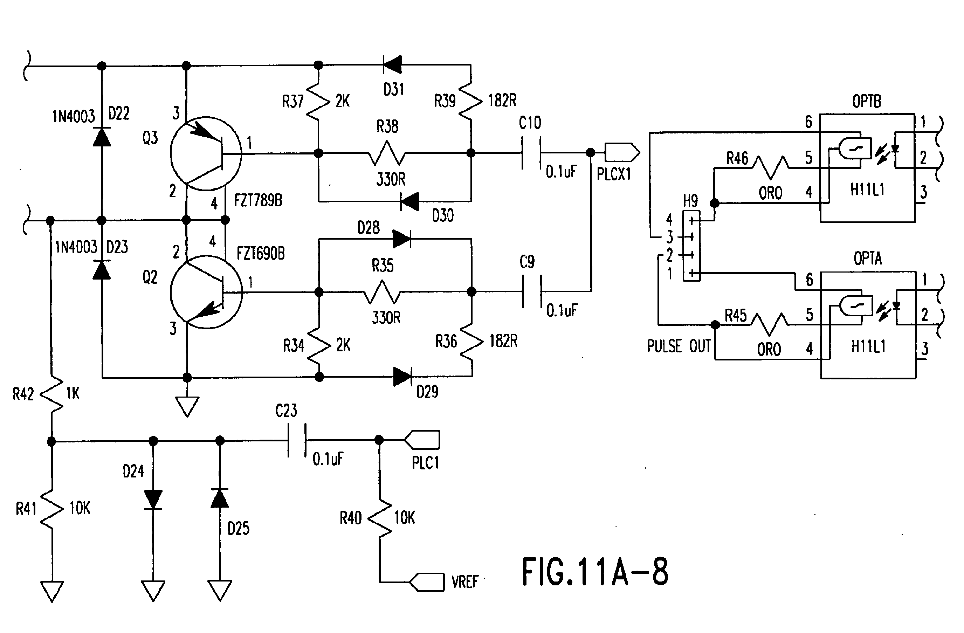

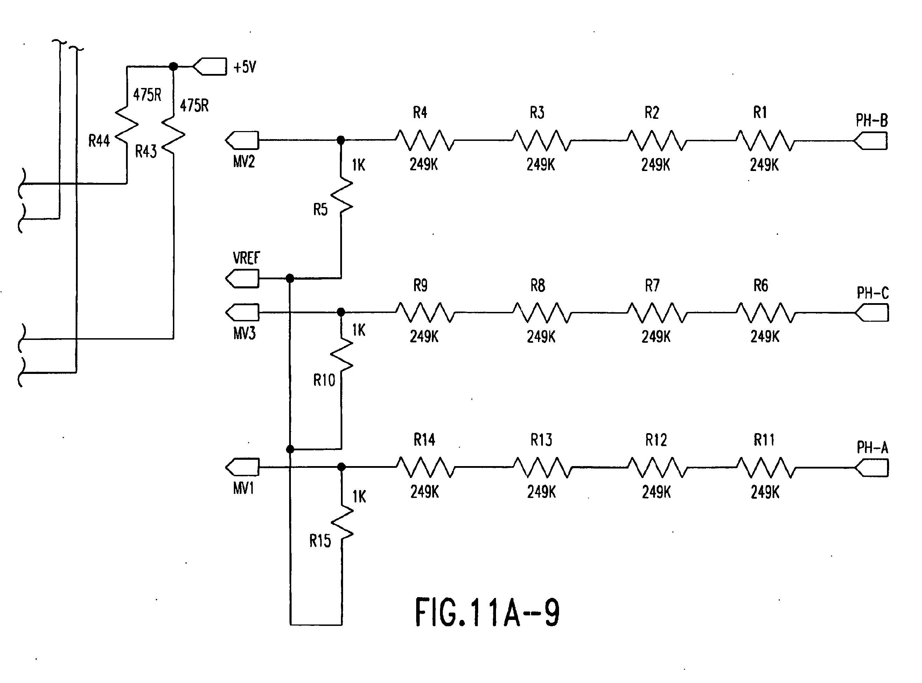

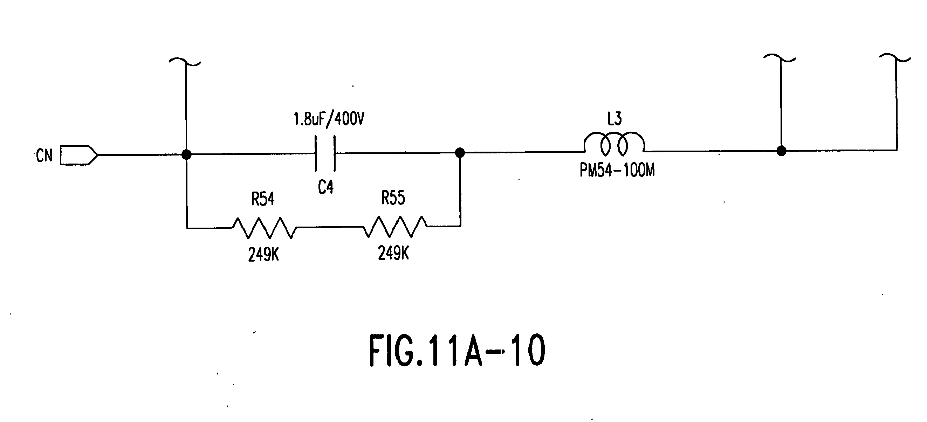

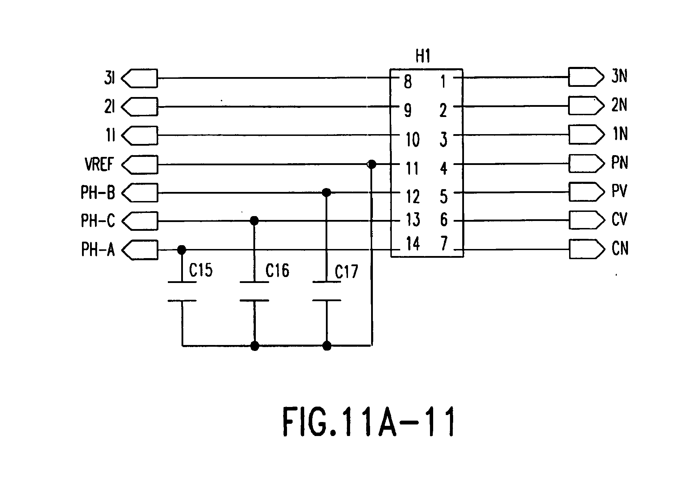

A preferred transmitter circuit is found in the 10 series schematic drawing in **FIG. 11A**. Because the switching time differs between off and on, there is some overlapping period of time when both **Q2** and **Q3** are both active. This overlap short-circuits the power supply through **Q2** and **Q3** for a brief moment creating transition heat. The hardware can be designed so that neither **Q2** nor **Q3** will be active at the same time. This is illustrated in Table 7, which lists a Transistor Switching Sequence. The interval when both **Q2** and **Q3** are off is called Dead Space. Here are some benefits: (1) transition heat of the **Q2** and **Q3** is reduced or eliminated; and (2) output transmitter wave shape becomes more sinusoidal, and therefore reduces harmonic injection to the line. The dead zone makes the transition step more gradual at the edges. And since the load is inductive, current continues to flow through the bridge through the bridge clamping diodes **(D22, D23, D32,** and **D33)** during the dead period, creating rounder edges and therefore more a sinusoid effect.

Table 7

| Duration | Q2 | Q3 |
|---|---|---|
| 12 us | **ON** | off |
| 3 us (dead space) | off | off |
| 12 us | off | **ON** |
| 3 us (dead space) | off | off |
| 12 us | **ON** | off |
| 3 us (dead space) | off | off |
| 12 us | off | **ON** |
| 3 us (dead space) | off | off |

Dead Space can be implemented in ASIC hardware or in discrete circuitry. The ASIC can use a binary counter and specify certain count states as "off" states. Discrete circuitry can be designed so that the base drive has a delayed turn on but synchronized turn-off.

The overall design of the transmitter circuit is to drive a toroid coil using a transistor bridge circuit using transistors **Q2**, **Q3**, **Q4**, and **Q5**. The control signals are PLCX1 and PLCX2.

The base drive design for **Q2** is explained below. Since the base drives of **Q2**, **Q3**, **Q4**, and **Q5** are identical or complementary, it is sufficient to discuss only the base drive of **Q2**. Capacitor **C9** provides AC coupling between the transistor base and the control signal.

This serves at least two functions:

(1) Transistor protection due to control signal failure. If PLCX1 was temporarily stuck in high impedance or at some intermediate voltage level (2.5V for example), **Q2** and **Q3** would turn on. This short-circuits the power supply through these devices and quickly damages these devices. The AC coupling deactivates the circuit under any situation where PLCX or PLCX2 gets locked into any static state.

(2) The AC coupling also reduces transition heat. In the absence of Dead Space hardware, the AC coupling reduces transition heat by forcing a faster switch off time for **Q2** and **Q3**. When PLCX1 transitions from high to low, the opposite side of **C9** transitions below ground. This negative voltage is impressed upon the base of **Q2** through **D28**. Charge is pulled out of the base of **Q2** making the switch off far more rapid.

**PLC Line Injection**

PLC is injected into the line through series capacitors **C4**, **C5**, and **C6** (see **FIG. 11A**). These capacitors block the generated PLC signal from high voltage. But unless **C4/C5/C6** is very large, the impedance of the series capacitance weakens the signal substantially. Unfortunately, capacitors of large values, high AC voltage blocking, and board mount size are rare and expensive. Therefore, an inductor **L3** is placed in series with the capacitor to cancel some of its impedance. For lower voltage applications (e.g., 120V), only one capacitor is required for line blockage allowing for a smaller inductance to be used. For medium level voltages (e.g., 220V, 347V), **C4** and **C5** must be used. For the highest level of voltages (e.g., 480V, 600V), all three capacitors must be used. Therefore, by building the PLC injection circuit to match the line voltage requirement, signal strength can be maximized while costs are minimized.

**C4, C5, C6,** and **L3** also act as an LC filter. For narrow band applications, a larger capacitance and smaller inductance is used. For broader band, smaller capacitance and larger inductance is used. Furthermore, another capacitor (not shown) can be placed at the CV/CN inputs. This offers yet another pole of filtering, if desired. This part can be mounted on the PCB or placed in the wiring harness.

**Pulse Circuit**

The Pulse Circuit controls external relays and counts contact closures. External relay control gives the utilities access to external events such as turning off power to the house or controlling other appliances. Contact closure reading enables other metering quantities such as gas and water to be monitored. The Pulse Circuit monitors these quantities in the absence of electric service. Normally, all services (such as gas, water and electricity) are active. Because of a battery-backed supply, gas and water are still accurately monitored in the absence of electric service. The circuit is shown in the central portion of **FIG. 11A**.

Contact Closure Read: The contact points are isolated from the main circuit through optical isolators and a pulse transformer. A remote microprocessor **U4** polls the contact closures through a pulse transformer. Any contacts that are closed will activate the corresponding optical isolator **(OPT3 - OPT6)** and shorts out the capacitors **(C11 - C14)**. The microprocessor reads the voltage on these capacitors to know which contacts were closed.

The pulse circuit is normally powered by +5VDC (through **D5**). But when +5VDC is not available, the battery supply (through **D8**) becomes the power supply of the pulse circuit. Because the minimum required voltage of the microprocessor is very close to the system battery voltage, care is preferably taken to maximize supply voltage. A schottky diode **(D8)** is used to minimize drop. A separate power feed (**D6** and **D7**) is used to power the pulse charger, whose voltage is held by **C19**. This capacitor is charged through a current limiting resistor **R52** to minimize voltage dips due to battery resistance. When the microprocessor activates **Q1**, **C19** dumps charge into the pulse transformer, thereby providing the interrogating voltage.

Relay Control Output: The Pulse Circuit also outputs relay control through **OPTA** and **OPTB**. An optical triac, optical dry contact output, or +5VDC output are optional output controllers.

Communication to Pulse Circuit: The microprocessor performs serial communication with the ASIC by means of the lines **PO2**, **PO1**, and **PI1**. The main processor therefore has access to each of the accumulator registers and has control of the output relay channels.

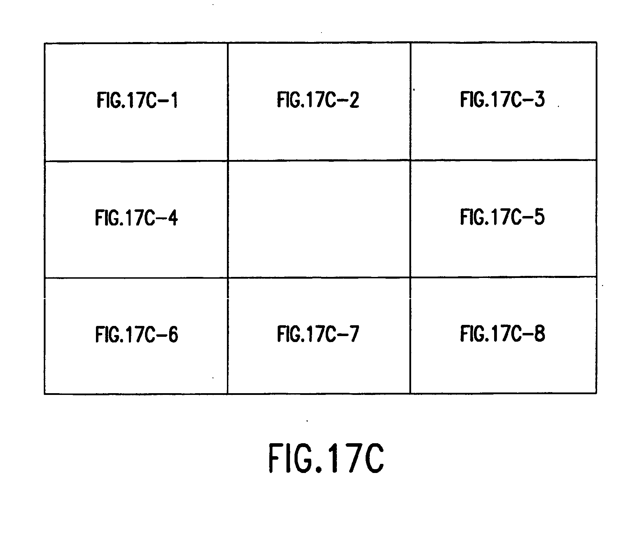

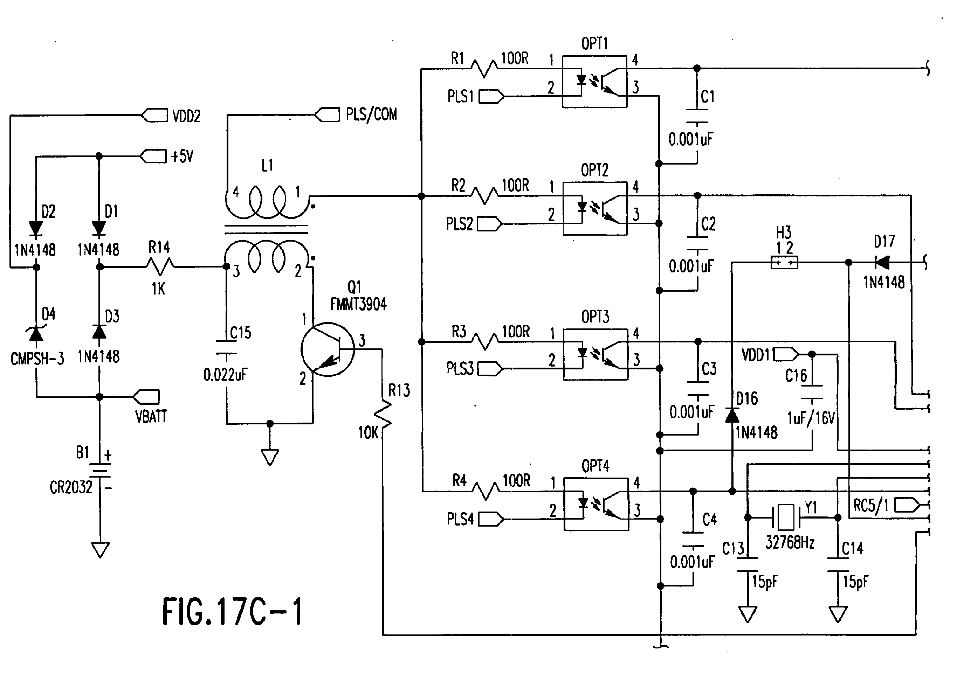

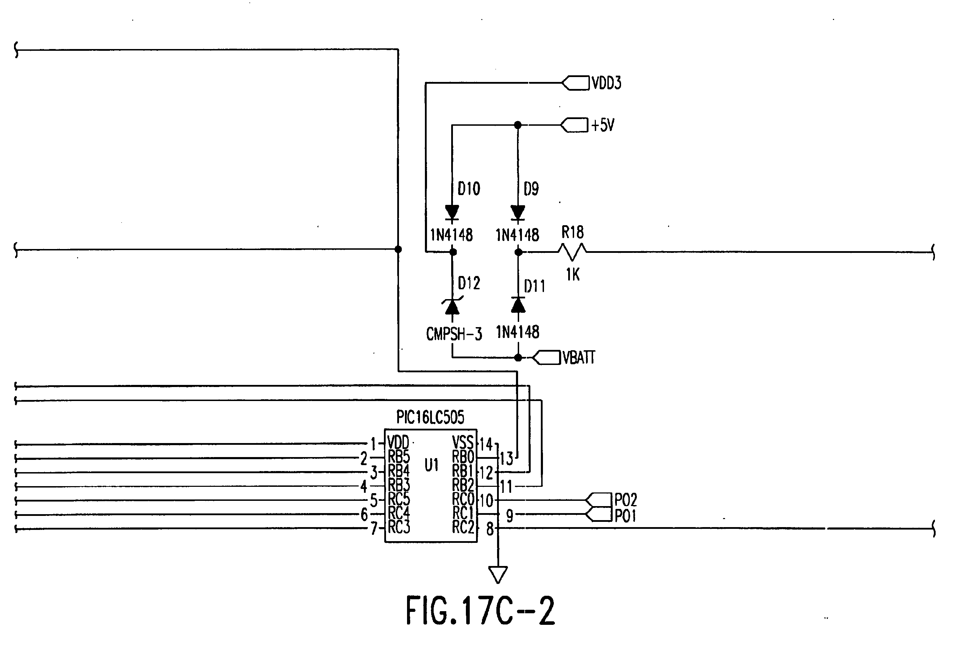

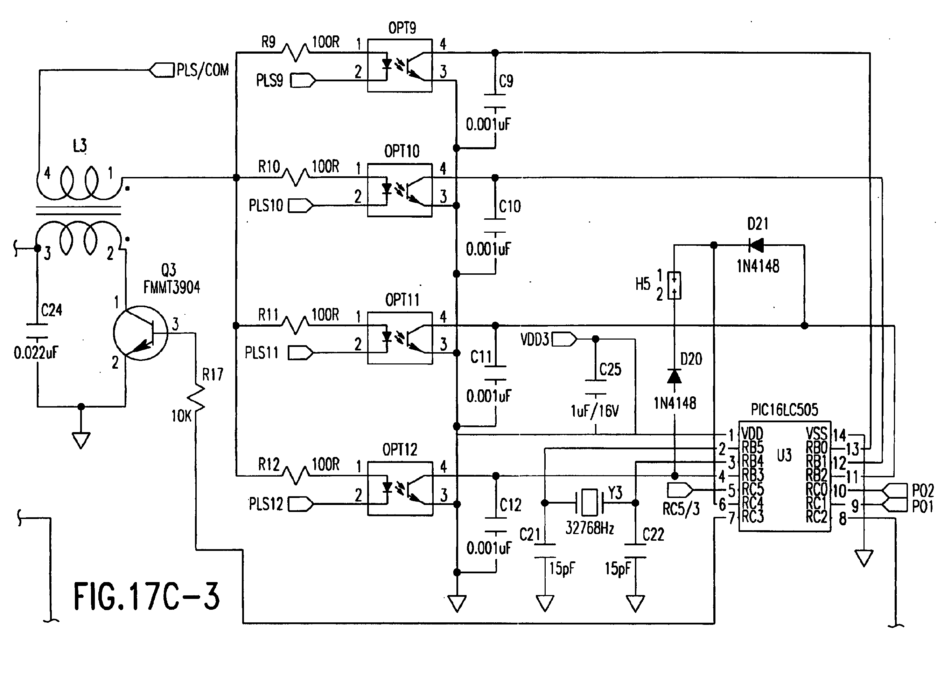

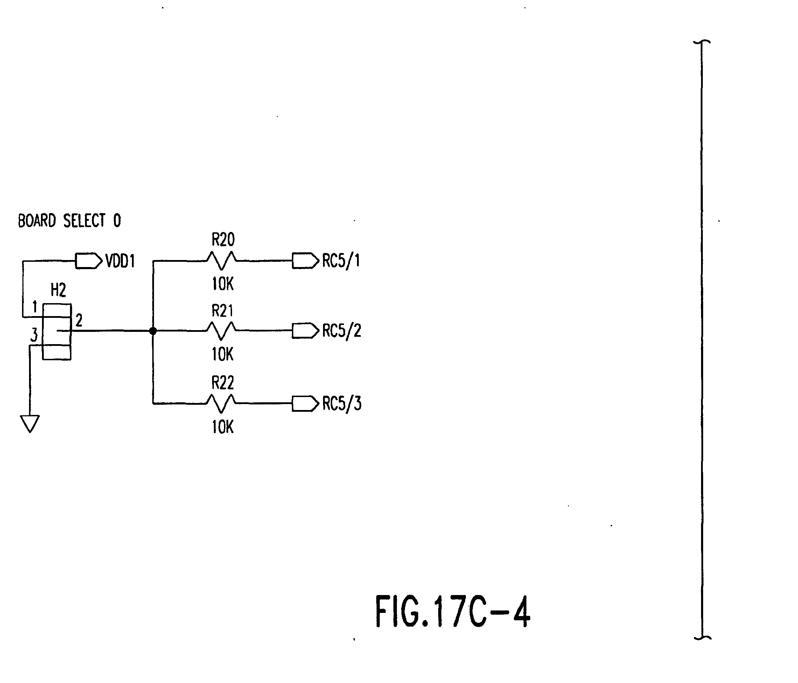

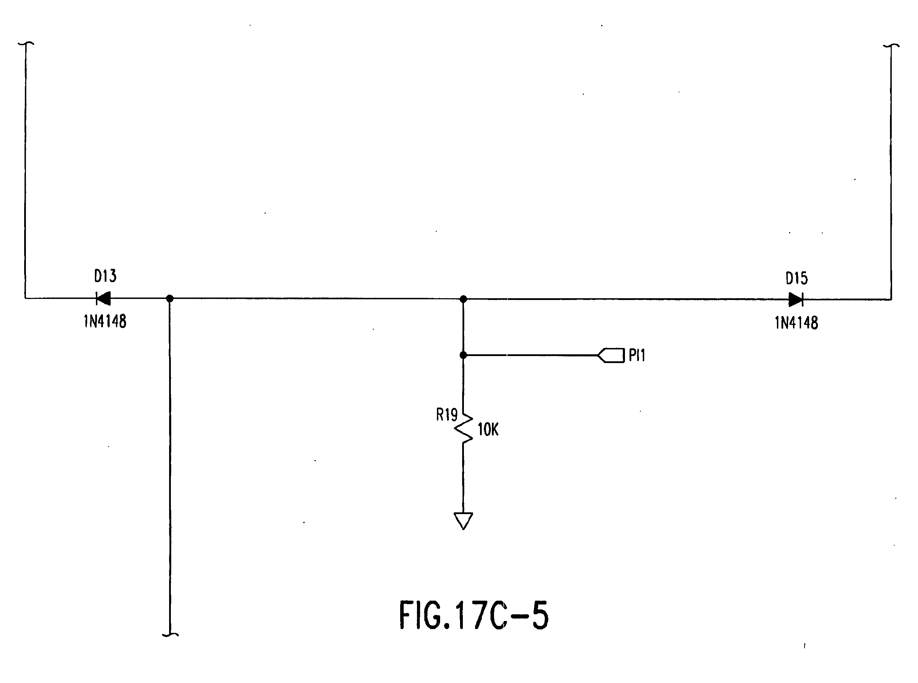

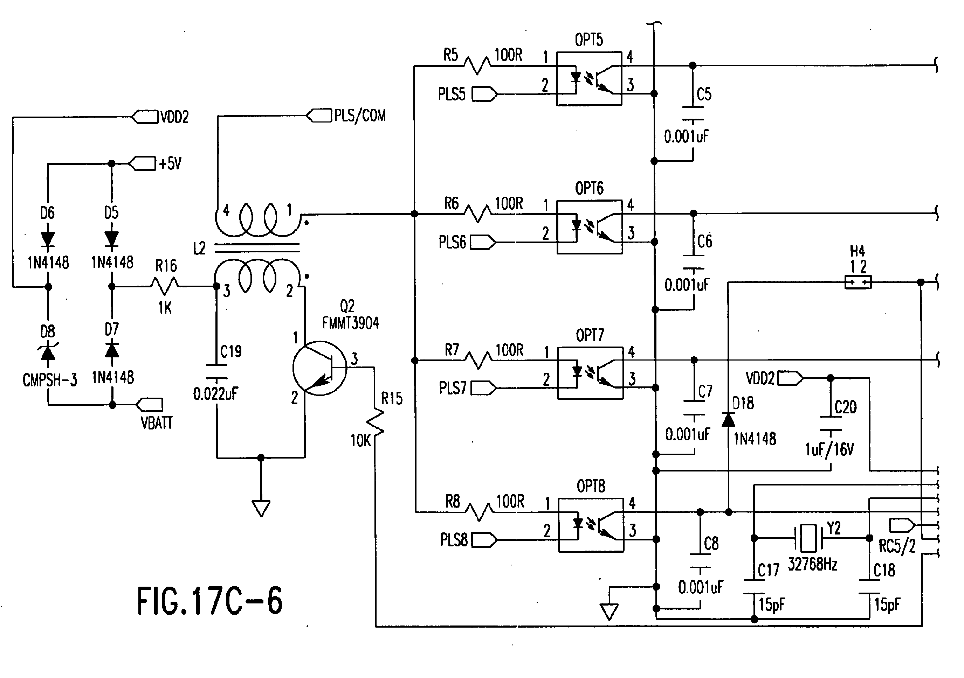

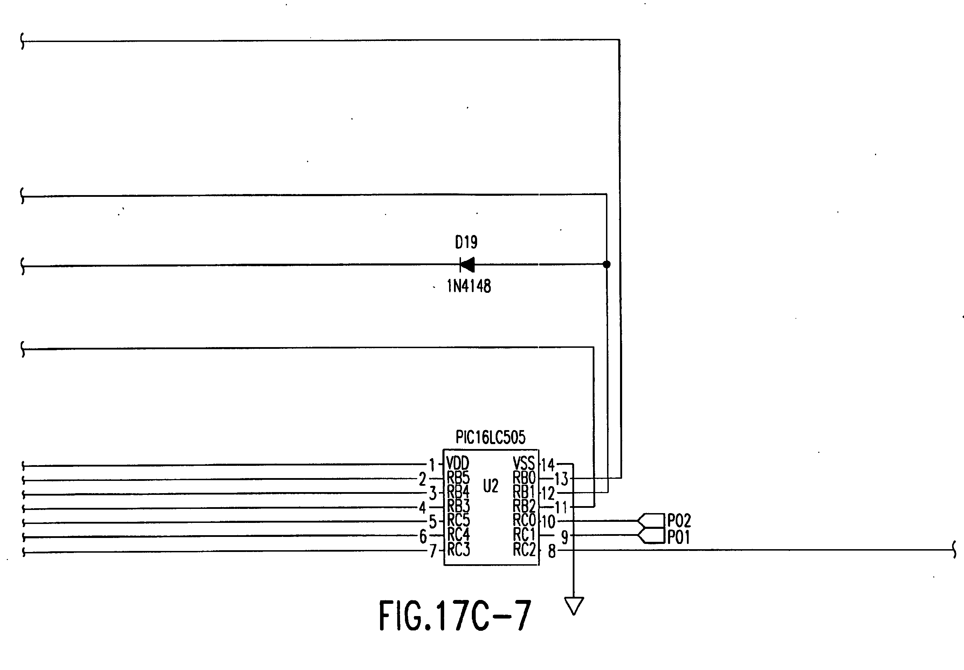

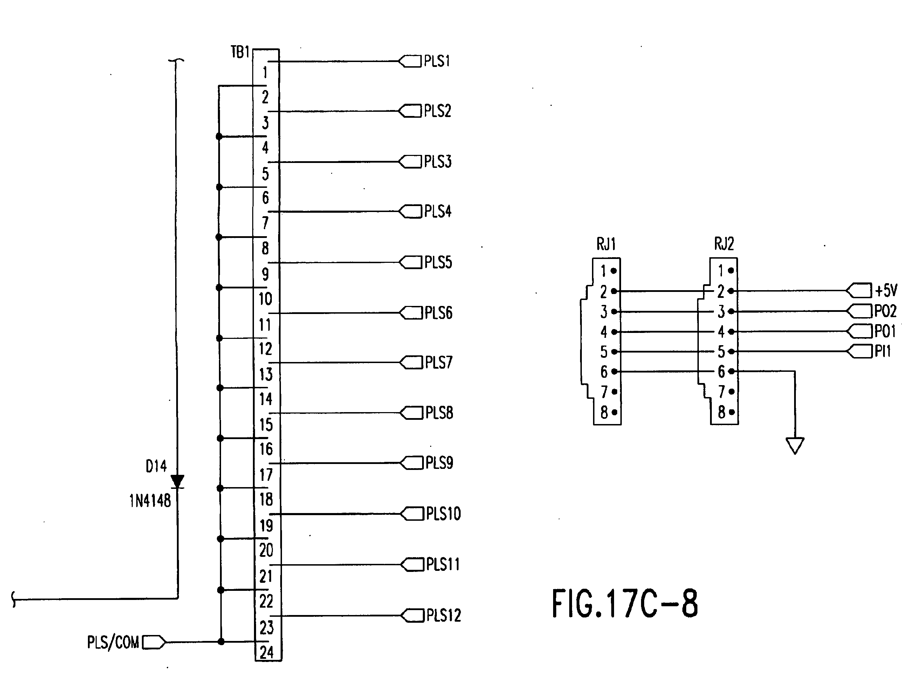

Expanded Pulse Readers: **FIG. 17C** shows a schematic of a preferred pulse expansion circuit. The input circuits are duplicated three times on the board for expanded metering capability. To distinguish one processor from the next, diodes **D17**, **D19**, and **D21** serve to uniquely identify position. This allows all 12 inputs to be unique. In addition, four pulse boards can be serially chained to create 48 independent inputs. To distinguish the four boards, jumpers are placed in **H2**, **H3**, **H4**, and **H5** for the processor to identify.

**KYZ circuit**

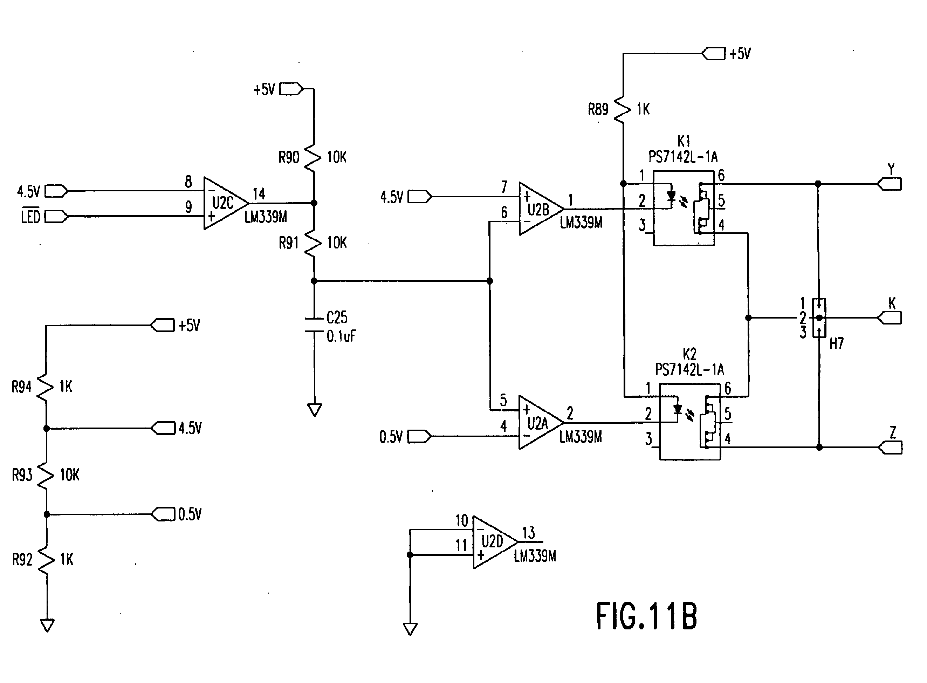

The KYZ circuit provides an equivalent dry contact closure that can handle 120VAC at the input. To prevent any momentary short circuits across the terminals Y and Z, circuitry enforces a dead period between transitions. **FIG. 11B** provides a KYZ schematic diagram.

The metering quantity is output through the LED signal and buffered through **U2C**. This waveform passes through an RC filter which slopes the edges of the square signal. This signal passes to comparators **U2A** and **U2B**. Only when the signal has traveled above 4.5V will **U2B** trigger causing **Y** to contact **K**. Only when the signal has traveled below 0.5V will **U2A** trigger causing **Z** to contact **K**. In the 0.5V to 4.5V zone, no contact is made, thereby enforcing the dead period and preventing momentary short circuits.

**Mini-closet (5A)**

The Minicloset(MC) monitors a mass number of electrical metering points, saving cost and space. The price per metering point is much cheaper. Also in high-rise installations, often entire rooms are required in order to hold all the electrical meters. Because of the compact design of the MC, only a small closet is required for all the metering points.

This frees up for building management extra rooms that would have otherwise been allocated for meter mounting.

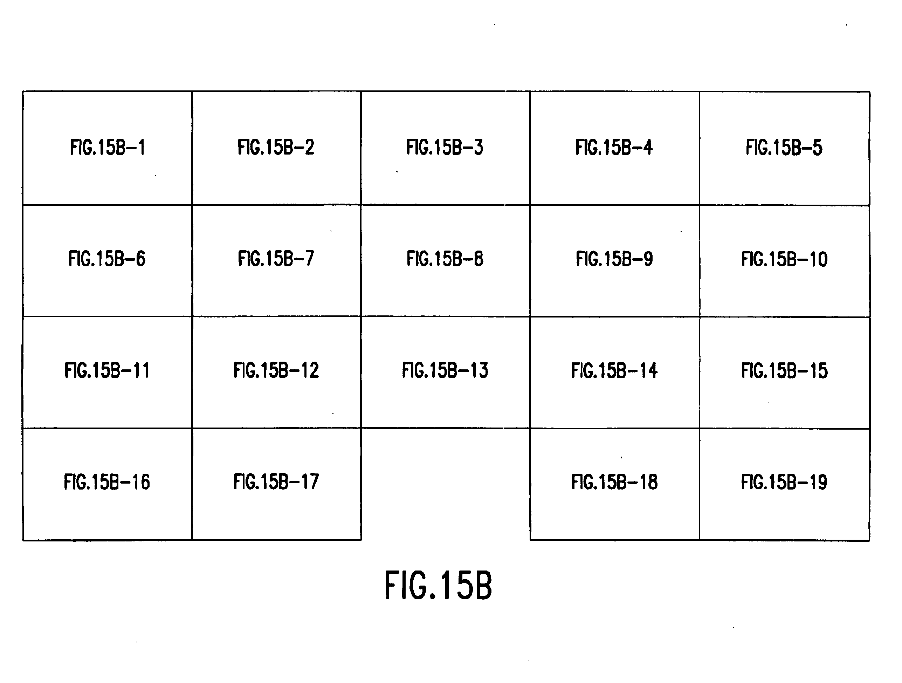

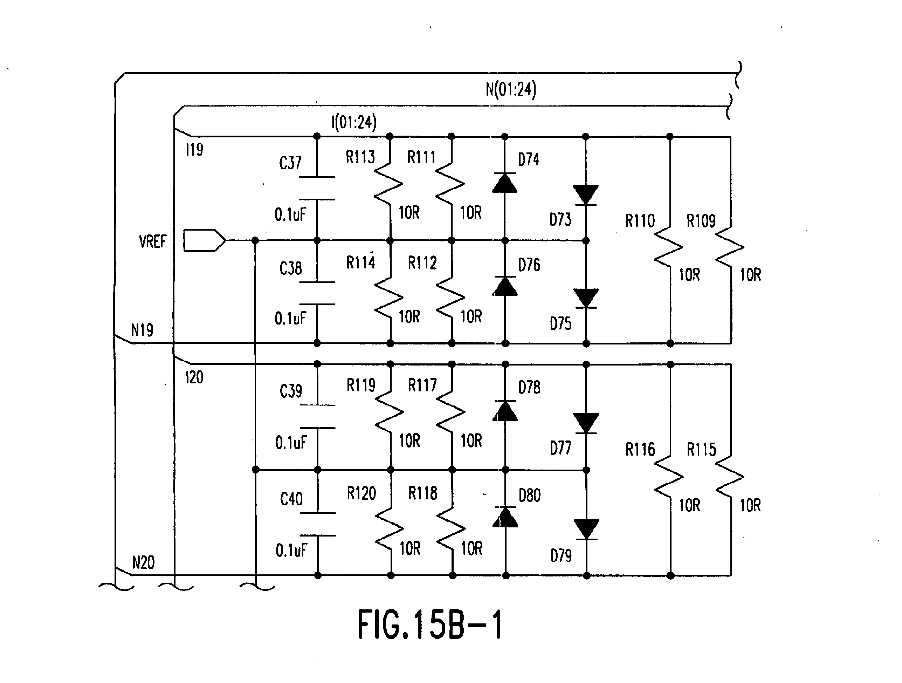

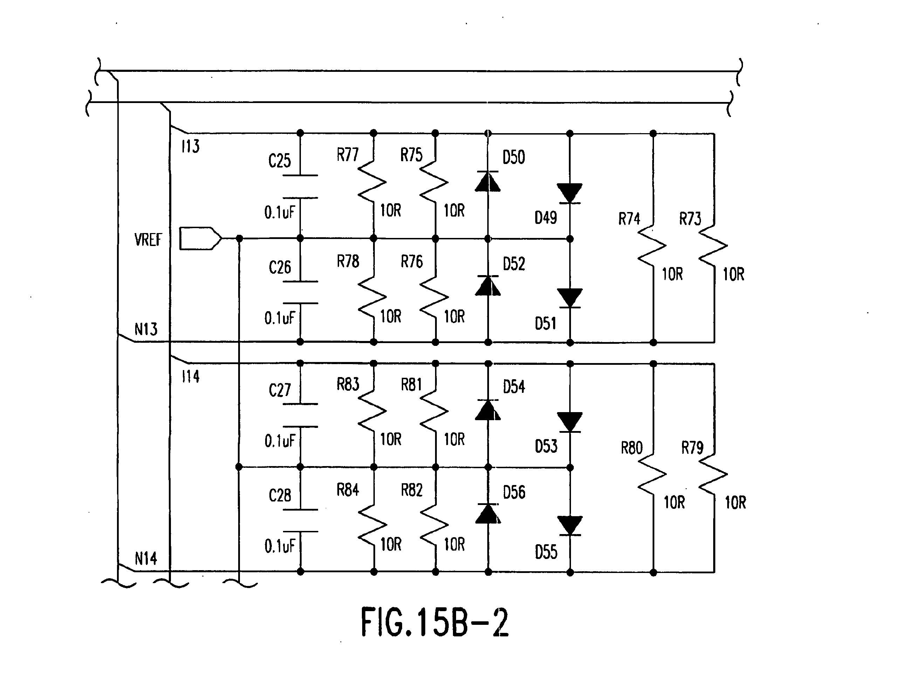

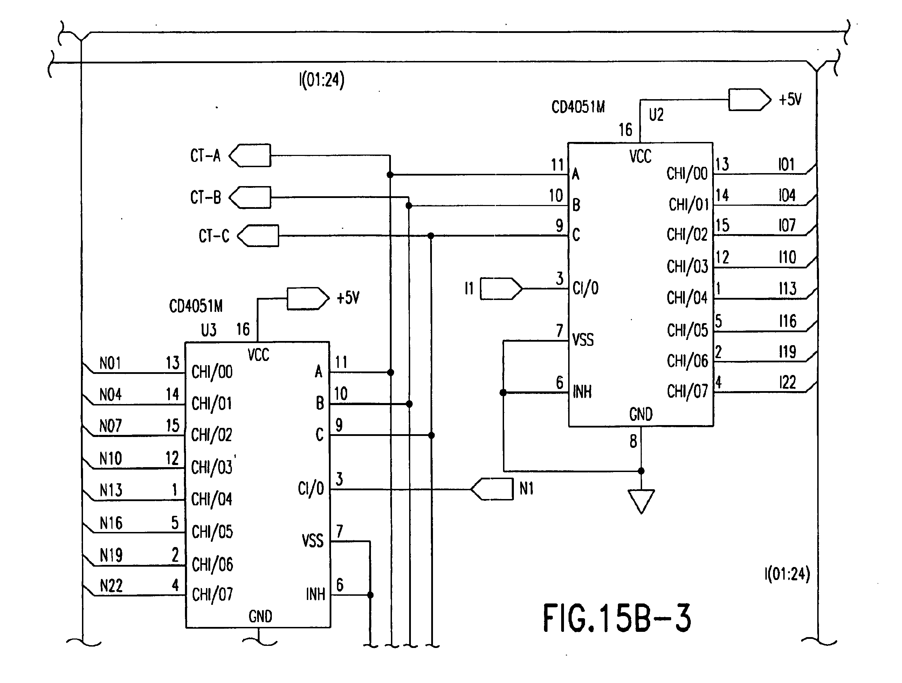

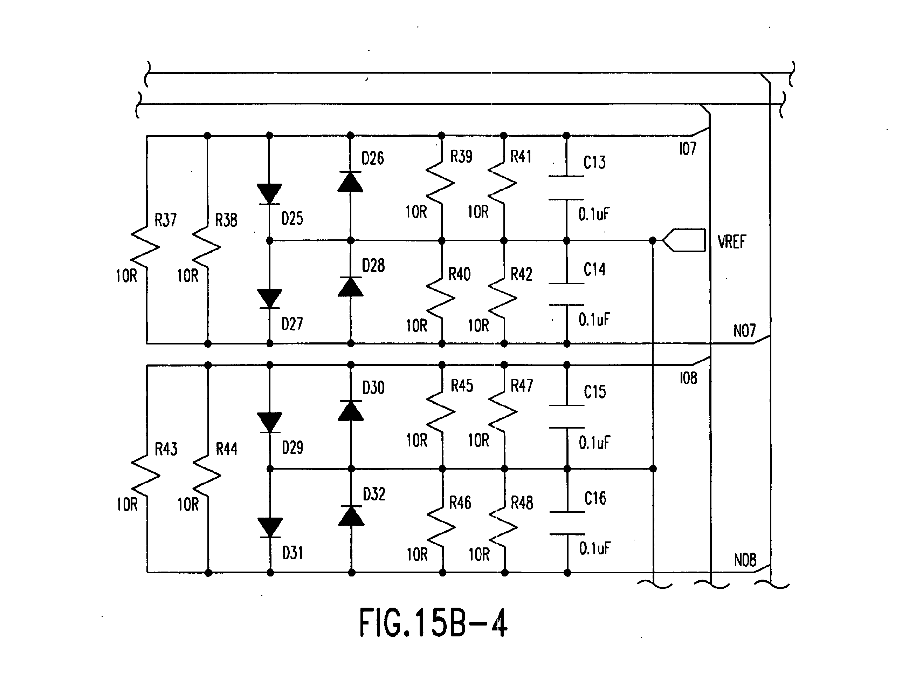

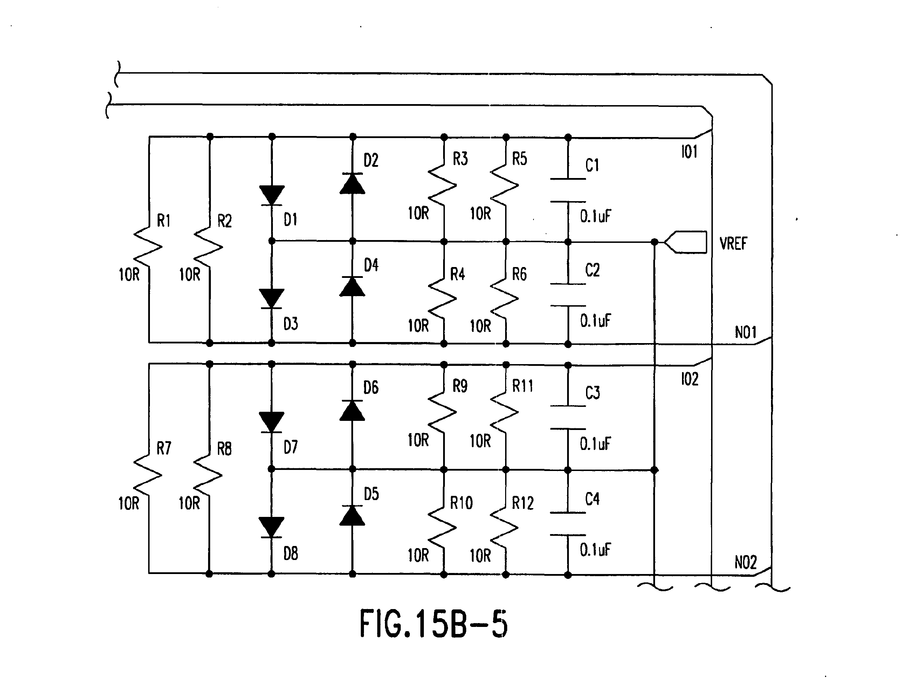

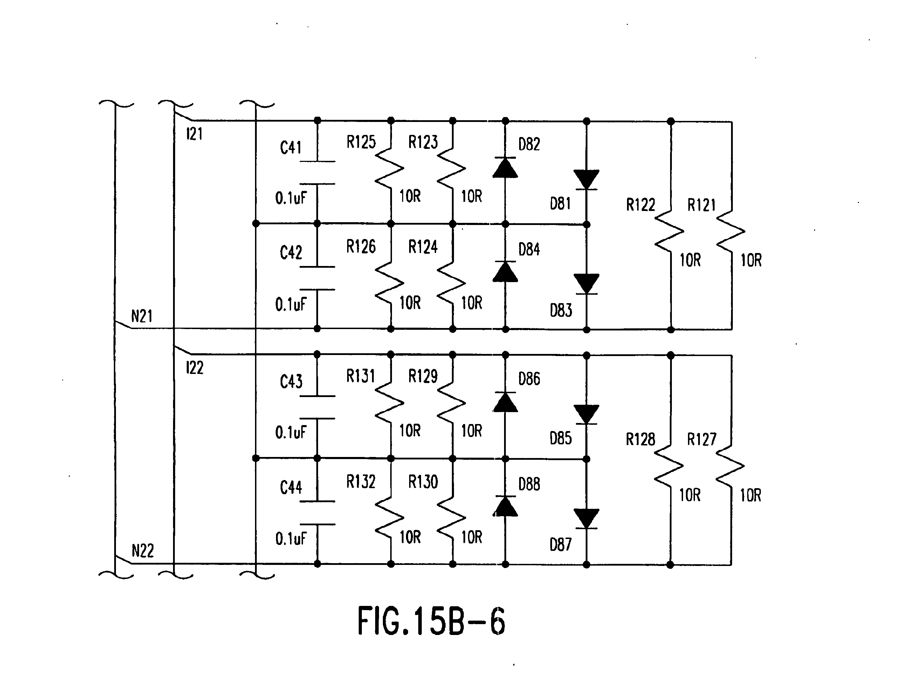

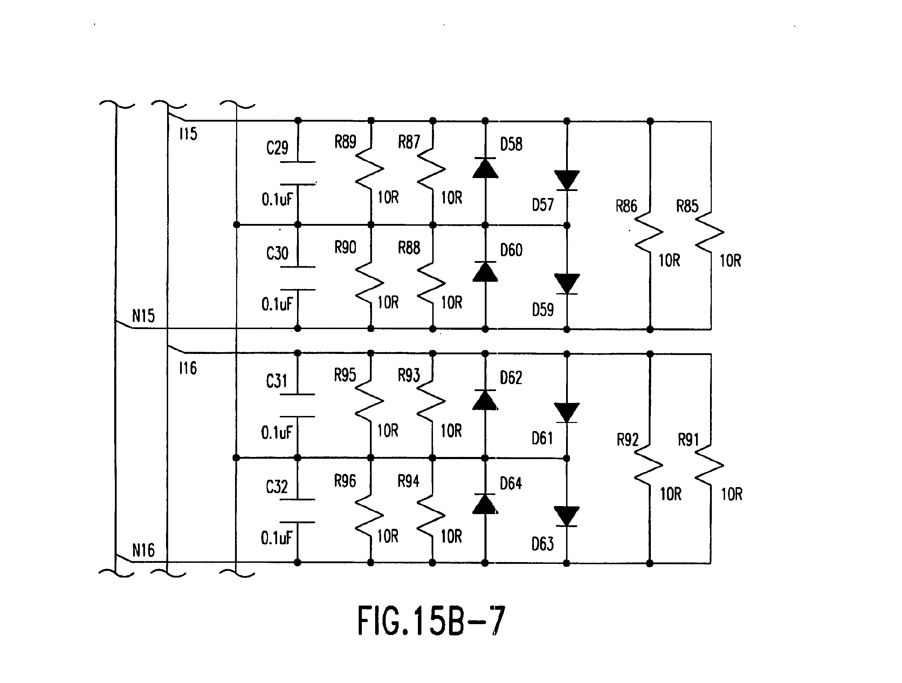

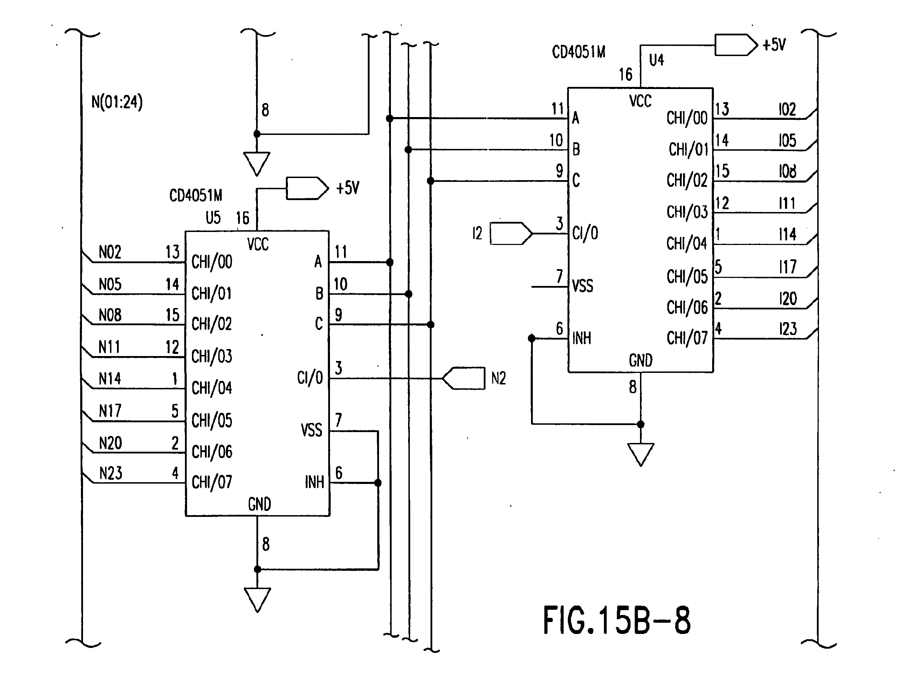

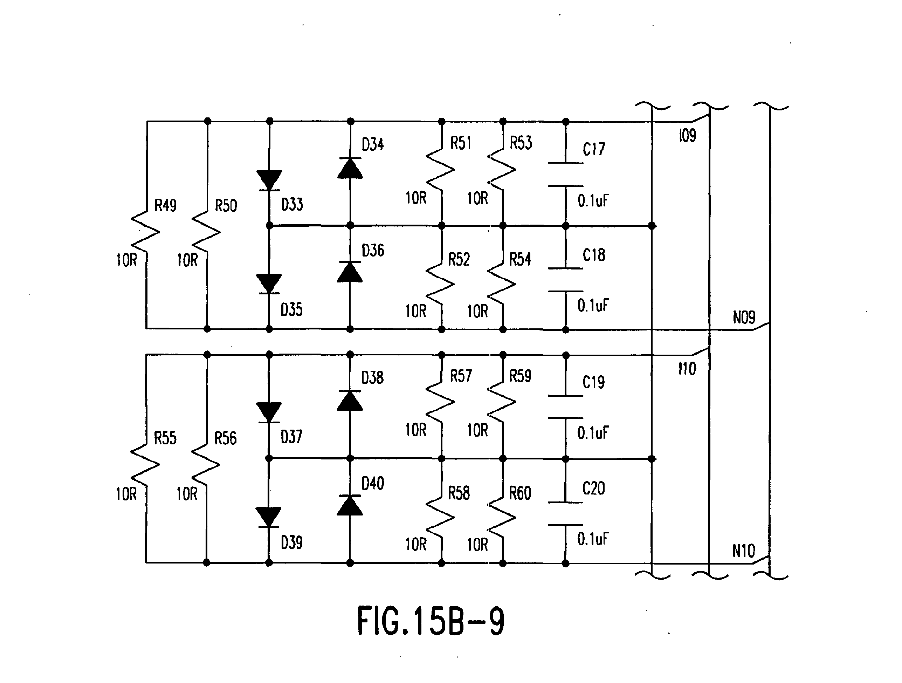

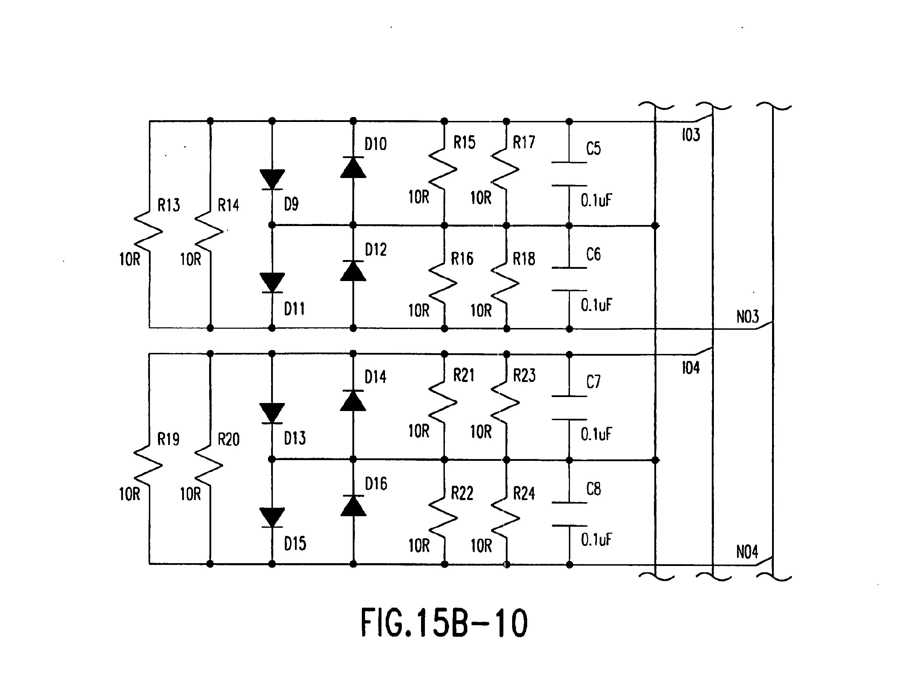

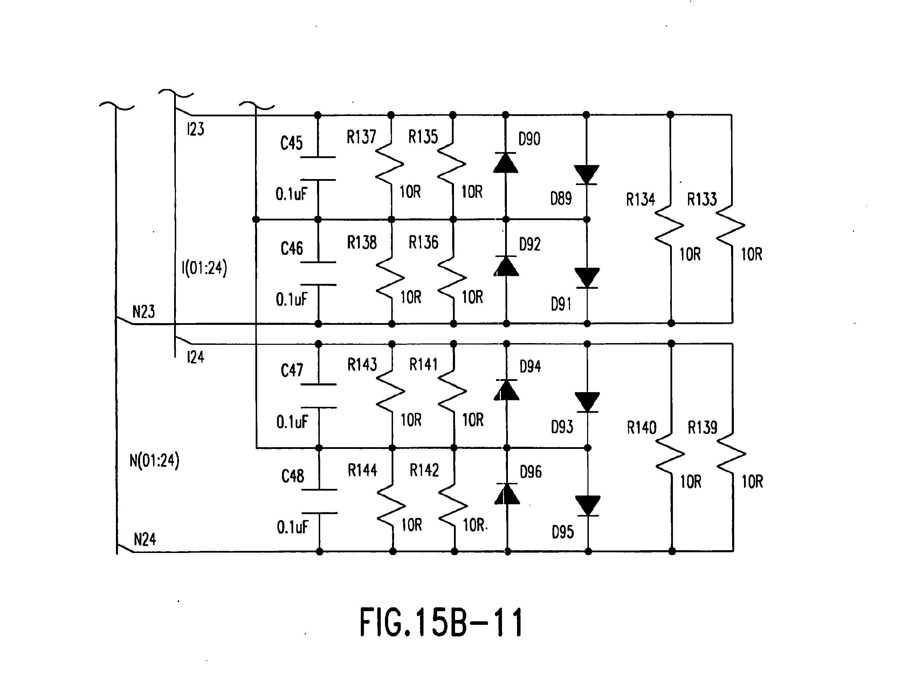

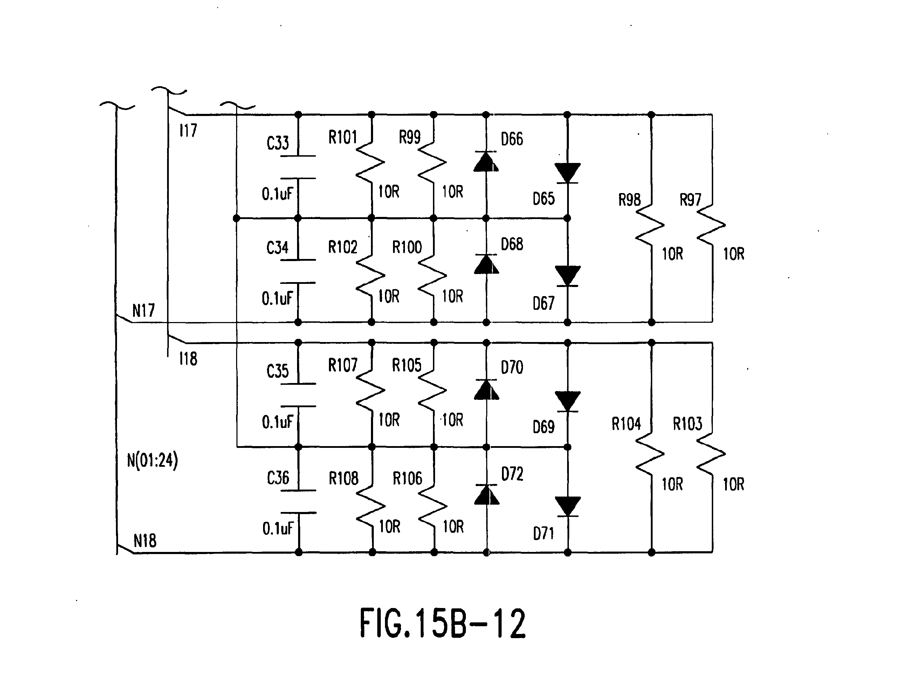

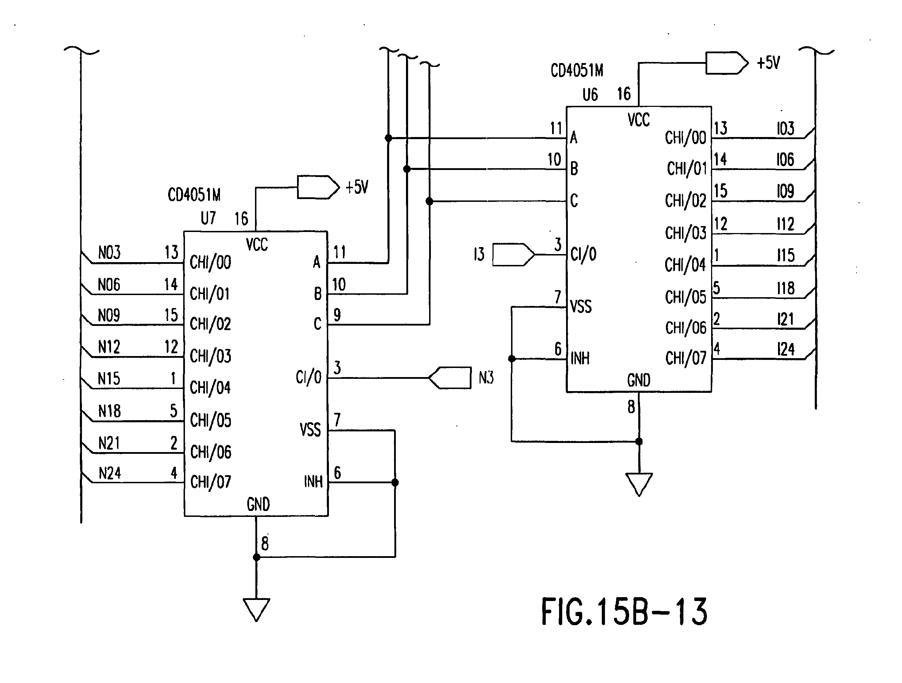

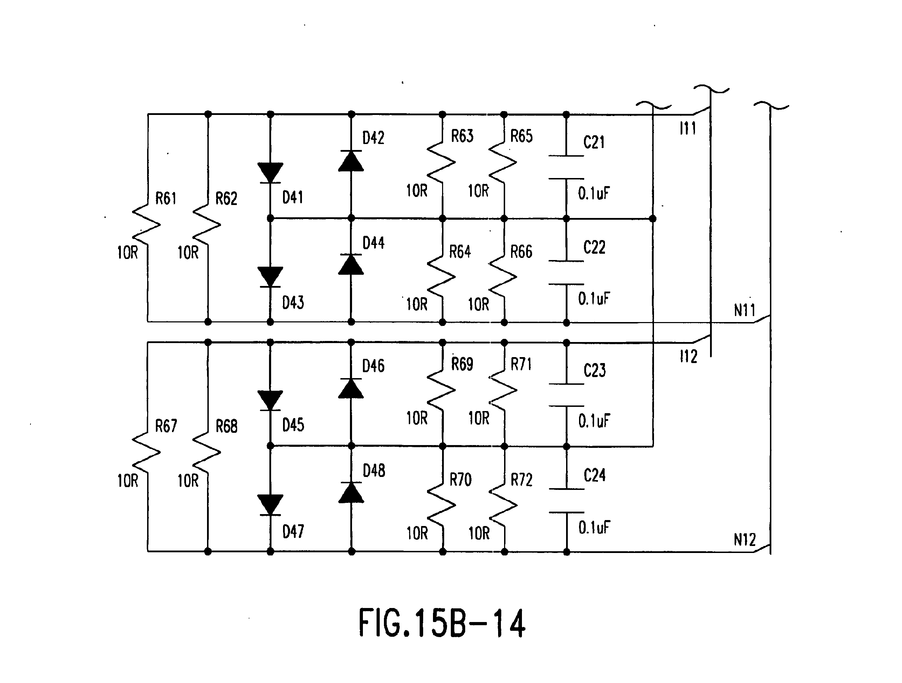

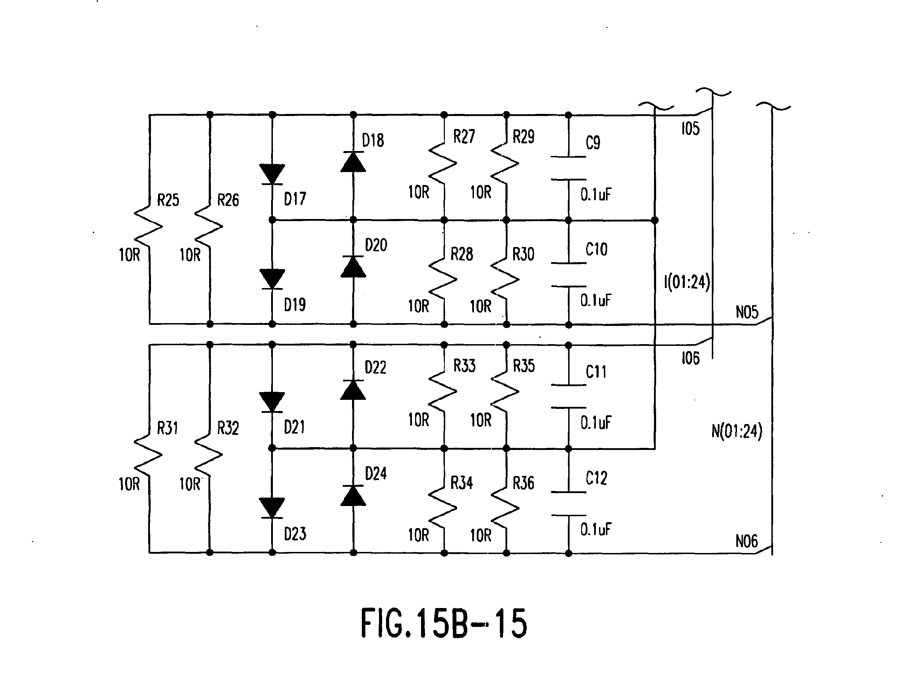

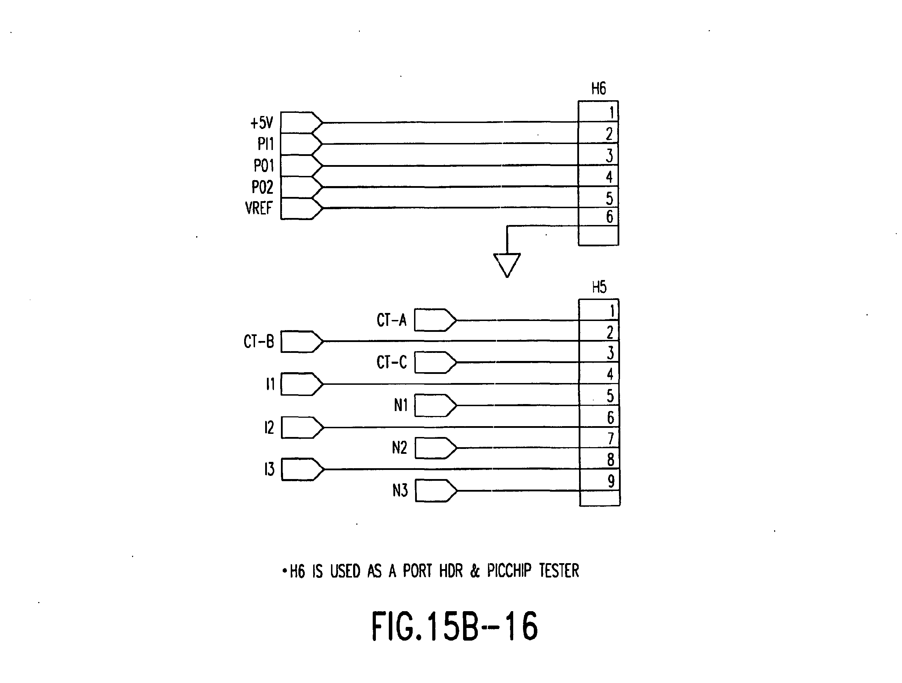

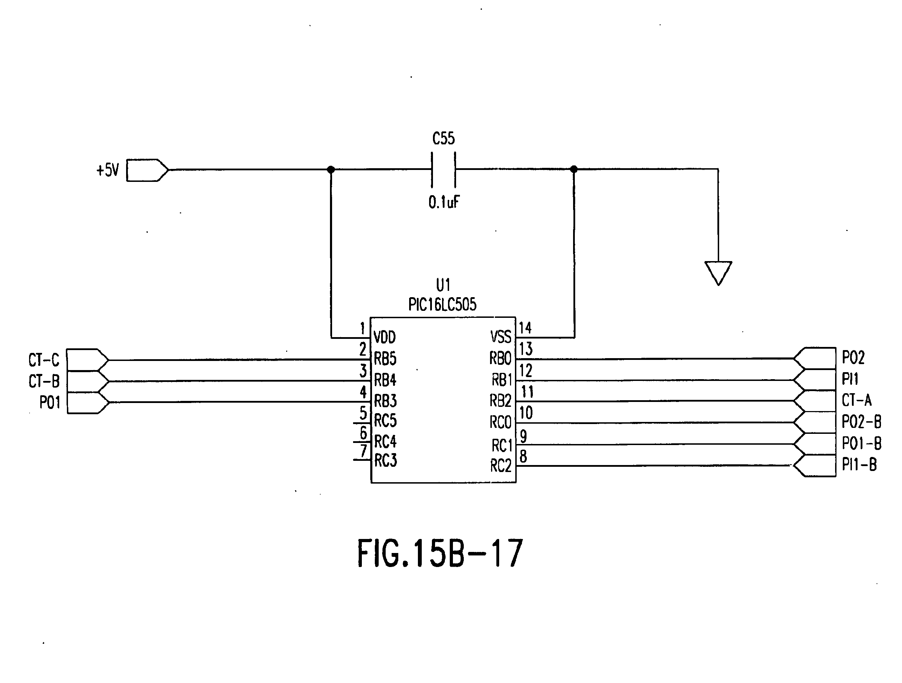

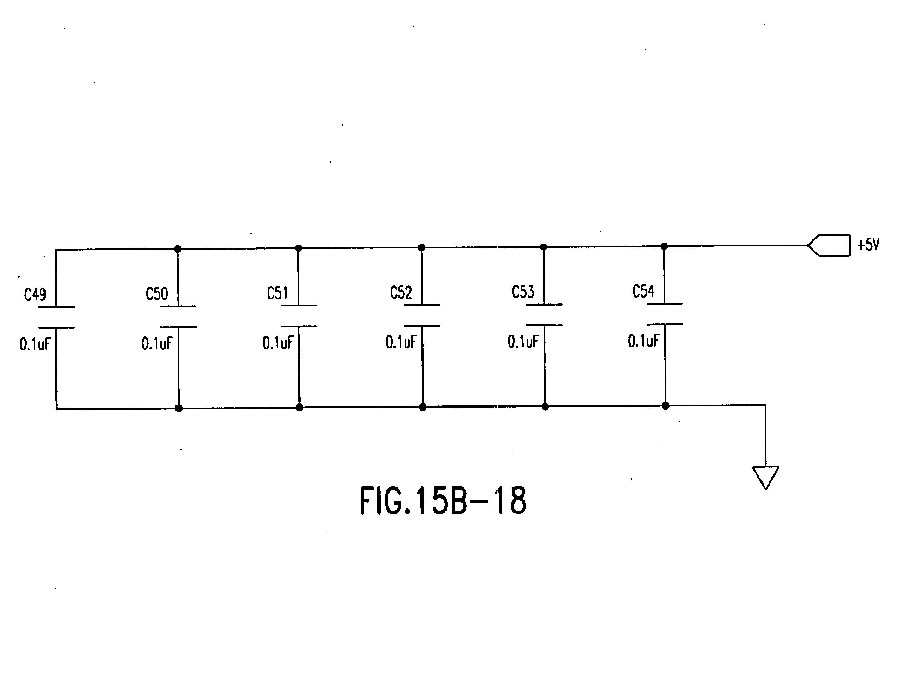

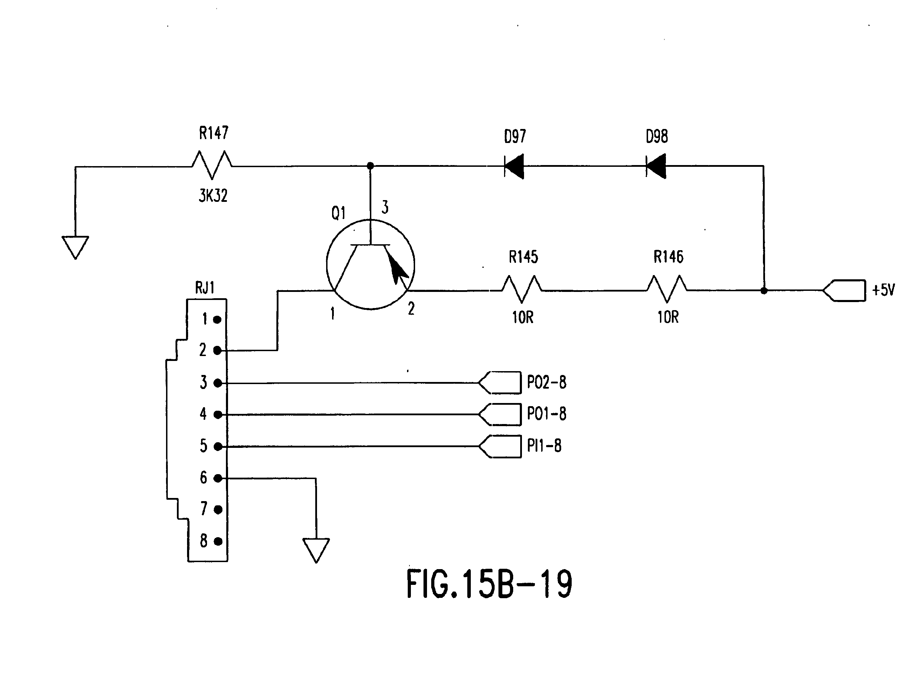

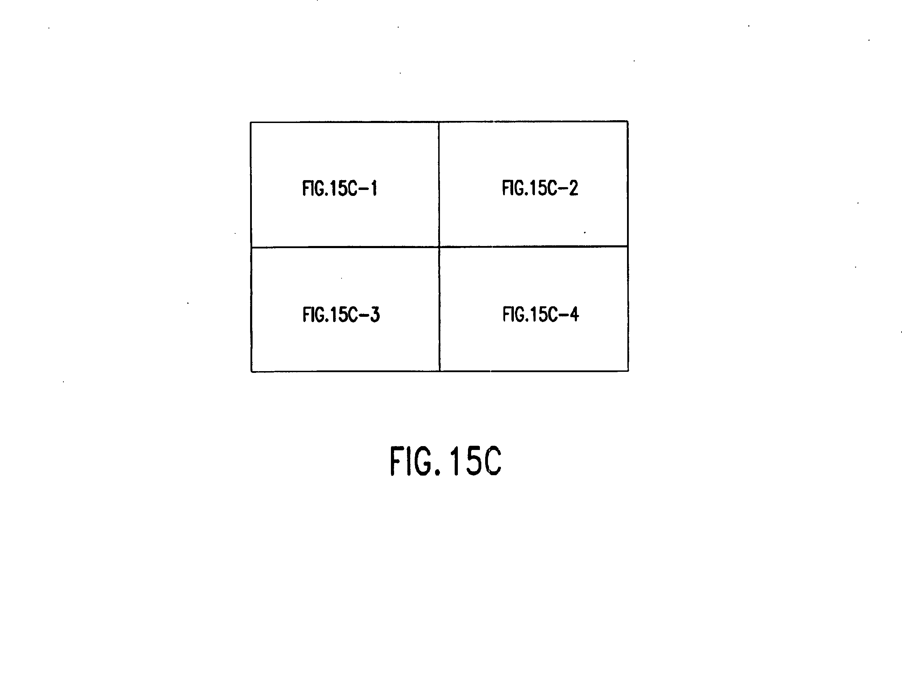

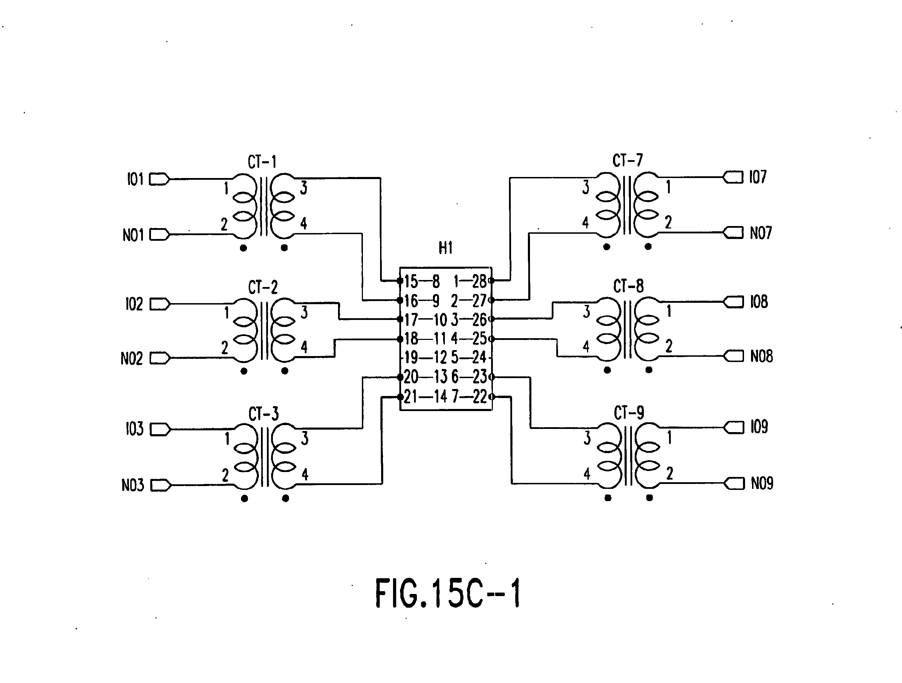

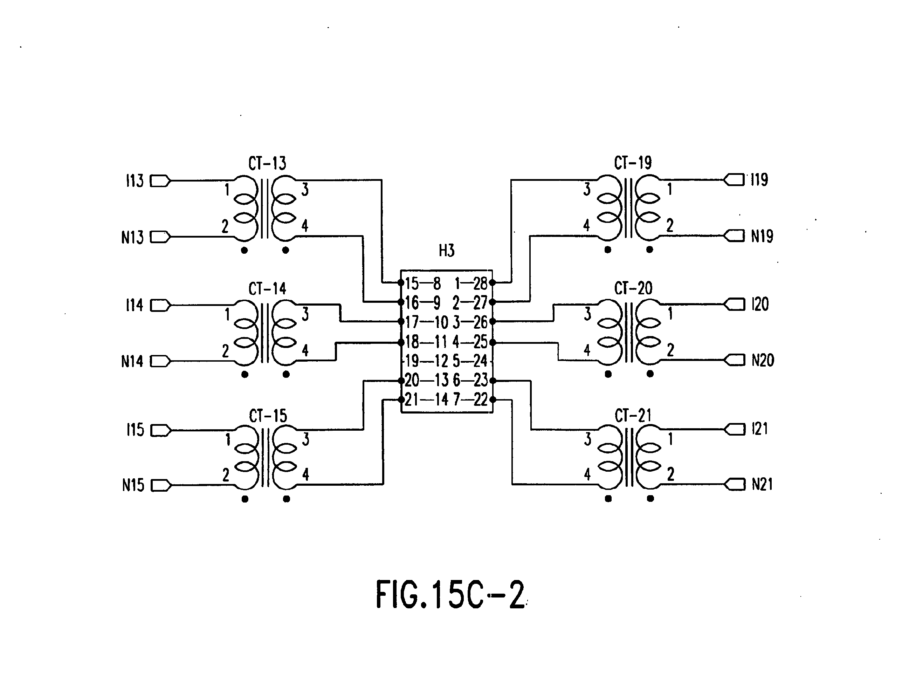

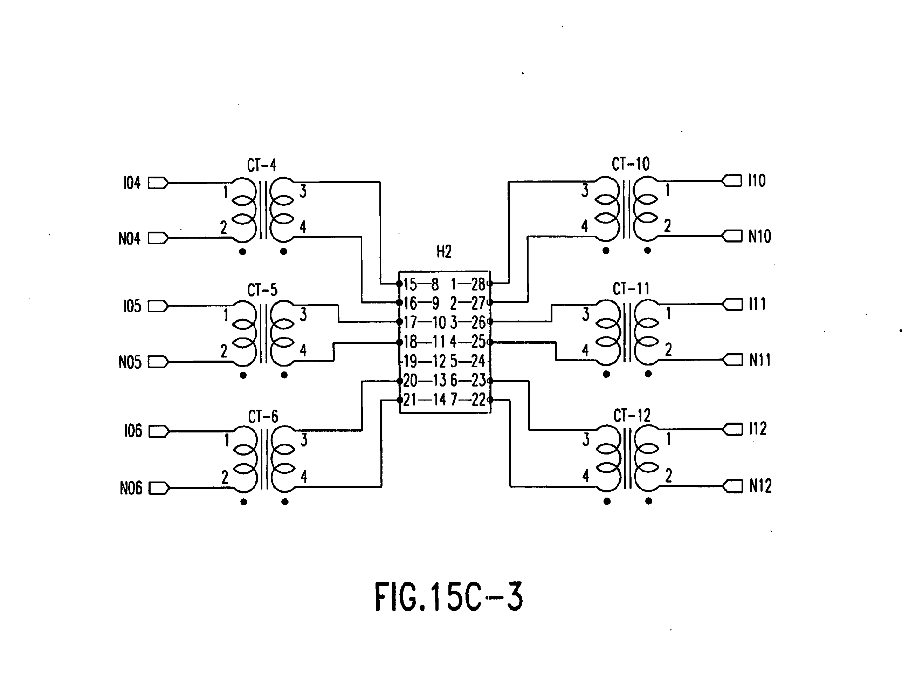

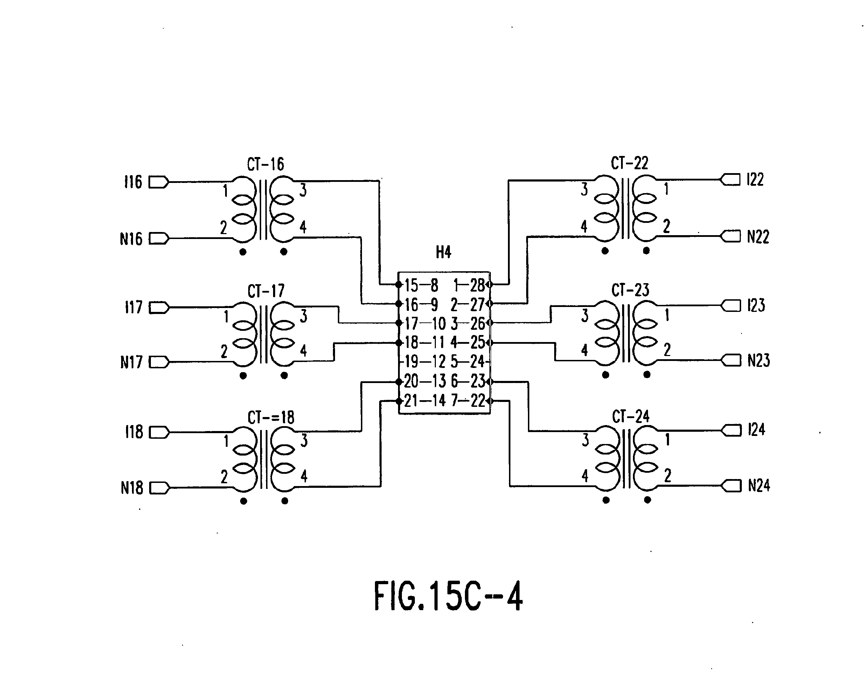

The 5A minicloset (MC) preferably monitors 24 metering points from one device. With internal 5A to 0.1A current transformers, the MC receives current as high as 5A. The MC also utilizes Internal Metering and stores its data in FLASH memory. The schematic diagram of the minicloset interface (MCI) board is shown in **FIGS. 15B** and **15C**.

The main processor communicates to a remote microprocessor **U1** and specifies which current channels to read. **U1** controls the analog multiplexer (**U2** - **U7**) and gates in the desired CT outputs to the current sensing circuit.

The MC can also monitor higher current levels if external CTs are used to step down the current.

## Scan Transponders

A Scan Transponder (ST) is used to communicate to each of the meters in a PLC system to collect data. The Transponder Power Board Circuit can be found in **FIG. 11A**. The transponder consists of four PLC communication channels: three channels to communicate along the three phases of the distribution transformer and a fourth phase to communicate along a medium tension line. The main processor communicates to the remote processor **U1** through **PO1**, **PO2**, and **PI1** to control the gating of the transmitters and the receivers.

The Scan Transponder collects data from the meters by sequentially polling each meter on a scheduled basis and copying the data to its memory. The ST can be optionally equipped with a large memory display board. The transponder can monitor electricity as well (i.e., function as an end user meter). The transponder has the ability to store additional data with an optional larger FLASH memory display board. The transponder can also periodically dump data to an even larger memory source such as a personal computer by means of a modem or a serial connection.

The ST requires that the serial numbers of each meter be cross referenced in its memory. This enables the ST to identify any meter in its cross reference table that is non-communicating. The ST also seeks optimal transfer by searching all phase, speed, and modulation combinations.

## Optical Reader

An Optical Reader circuit is shown in **FIG. 16**. This circuit is designed for a battery source. The design uses a two stage constant current source to provide increased communication rate with transistor circuitry (**Q1** and **Q2**).

## Theft Detection

Reports indicate energy theft of 10% to 30% in some areas. A theft detection embodiment of the present invention is based on the hypothesis that theft is not evenly spread among end users. Instead, there are probably some customers who steal 50% of their energy, some who steal 100%, and many who do not steal at all. Each distribution transformer in a power distribution network can easily supply energy to hundreds of customers. Theft detection meters are preferably placed at strategic points to narrow the theft detection zone in the following ways: (1) based on the population of end users - to pinpoint known customers who are stealing; and (2) geographical area - to narrow the search area for illegal tapping.

Furthermore, in a 300 customer service area, a non- paying customer with average usage represents only a 0.3% variation in the total energy. Narrowing the theft detection zone increases the detection sensitivity. If 20 equal zones are monitored, the 0.3% variation suddenly registers as a 6% variation in one theft detection zone.

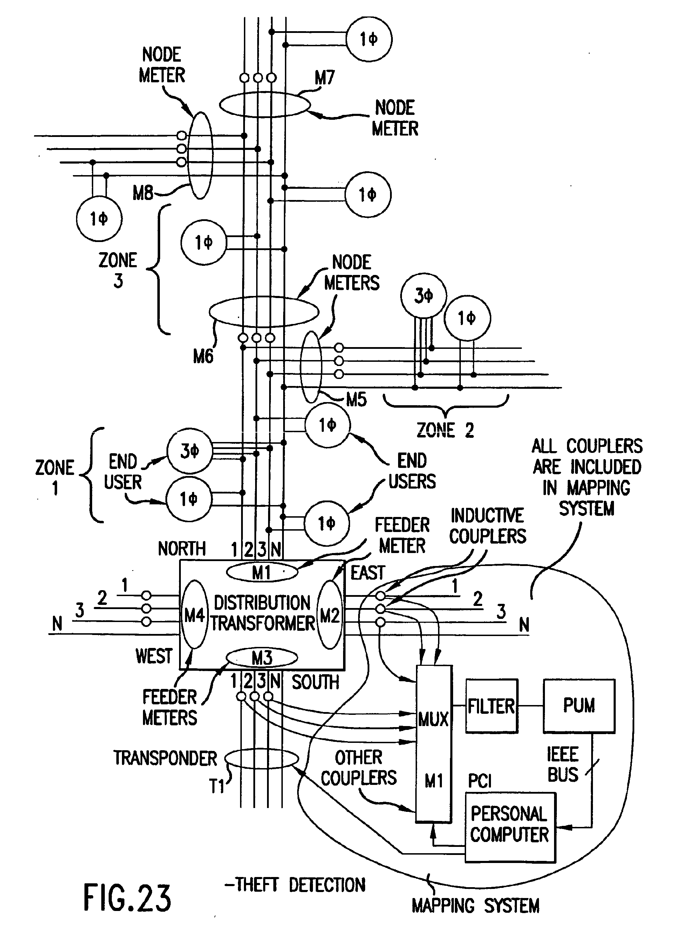

The distribution transformer in **FIG. 23** has twelve monitoring points coming from the four feeders and each of the three phases. The meters **M1** - **M4** that monitor these points and are called Feeder Meters. By metering these 12 points, the theft detection zone reduces to $^{1}/_{12}$ of the original metering points. In addition, Node Meters **M5, M6, M7,** and **M8** further section the North branch into more detection zones. If all four feeders were sectioned into just three zones, there would be 36 different detection regions, sectioning 300 customers into 8 or 9 customer portions. For example, theft is determined in Zone 1 if energy theft is detected in **M1** but not **M5** and **M6**.

For the purpose of theft detection, a three phase (3$\phi$) customer is treated as a customer with three 1$\phi$ services. This isolates the energy measurement cleanly between the phases. But for the sake of accurate demand billing, 3$\phi$ customers must be 3$\phi$ metered. If separate phases achieved equal peak demand but in non-coincident demand intervals, the customer who was billed as three 1$\phi$ could be overcharged for demand. Thus, a preferred 3$\phi$ meter is capable of being read either as three 1$\phi$ meters or one 3$\phi$ meter, thereby satisfying both conditions. Likewise a minicloset can be considered as twenty-four 1$\phi$ meters and a 2$\phi$ meter can be considered as two 1$\phi$ as well. This enables the Theft Detection system to work with customers of 1$\phi$, 2$\phi$, and 3$\phi$ meters and of 24$\phi$ Mini-closets, including any combination of such customers.

A transponder **T1**, located at the distribution transformer, gathers meter data from all Feeder Meters $P_F$, Node Meters $P_N$, and the End User Meters.

This system accomplishes the following: (1) isolation of theft location to a very small circuit branch; and (2) isolation of theft instance in time.

Isolation of theft location comprises the following steps:

(1) Check node meters that are furthest out, ones that have no other node meters in their branch. Here, **M7**, **M8**, and **M5**. A node meter consumption that registers higher than the sum of its end user meters indicates theft.

(2) Check node branches that are closer to the generator. Here, **M6**. Consumption in **M6** that registers higher than the sum of **M5**, **M6**, and any end users in this zone indicates theft.

(3) Keep checking node branches down until node branches are the feeder wires themselves from the generator.

Isolation of theft instance in time: Using interval metering, theft detection can be applied to each metering interval to isolate the theft instance. The precision of time identification is determined by the metering interval.

Theft network mapping: theft detection requires a network map of all meters interconnections. However since an accurate electrical routing diagram from the distribution transformer is not always available, there is need for a mapping scheme. A Theft Detection Mapping System of a preferred embodiment performs the following tasks: (1) stores data identifying all Feeder, Node, and End User Meters; (2) associates End User Meters to Node branch and Feeder Meters; and (3) identifies the phase arrangement of multi-phase meters. For example, in a three-phase meter, phase 1 of the distribution transformer output might not be connected to phase 1 of the meter. This too needs to be recorded in the network map.

The network mapping system does not have to be included in the permanent installation. After mapping is done, the transponder remembers the position of all of the meters, and the mapping system can be recycled to map other distribution transformers. A personal computer (**PC1**) is preferably the master controller of the mapping process. Inductive couplers are place on feeder wires and node wires to identify return PLC signal strength. The outputs of these inductors are multiplexed (under control of **PC1**) through a sharp bandpass filter and into a **DVM** (such as HP34401 A). **PC1** reads the signal level from the **DVM** through the IEEE bus.

Meter identification: **PC1** instructs the transponder to gather the serial numbers of all meters that exist on the network. The transponder sequentially requests an echo from the active meters on all three phases. When a meter receives the request from the transponder, it sends back its serial number to the transponder.

End user meter (phase) mapping: 1ϕ meter - The phase that the transponder reads with the greatest signal strength is metering phase of this meter. Alternatively, the phase can be determined in another way. The bit rate must be set equal to the line frequency. Because of phase lock, the bit transitions occur at the zero crossings of the line voltage. If the return signal from the meter has zero-crossings with the transponder metering phases, then the meter is said to be on transponder phase A (TϕA). If there is a +120° shift, it is said to be on transponder phase B (TϕB). And the remaining phase is transponder phase C (TϕC).

3ϕ meter - Because Phase 1 of the meter might not be connected to Phase 1 of its Node Meter, mapping is required to identify phase arrangement. Like the 1ϕ meter, the transponder sends out a PLC signal with the bit rate equaling the line frequency. But this time it is the 3ϕ meter that compares the PLC bit-transitions to the zero crossings of each of their metering phases. From these comparisons, the meter determines which metering phases are connected to TϕA, TϕB, and TϕC. The Node Meter repeats the process to identify the phase mapping relationship. These relationships are transmitted back to the transponder to correlate the phases of the Node meters with its 3ϕ meter.

Feeder mapping: **PC1** communicates to the transponder through its optical port to instruct a meter to send a 30-second message. The computer **PC1** polls each of the couplers for signal strength. The coupler with the strongest signal indicates feeder position.

Node mapping: Starting at the farthest node meters, couplers are placed at these meters and checked for signal strength returning from the meter. If a signal is not present, couplers are moved down one node at a time and are again tested for return signal strength. The process repeats until all nodes are mapped.

In a further embodiment, mapping the locations of meters is used to locate line breakages. This embodiment comprises a method of determining the location of a break in a powerline electricity distribution network that has microprocessor-controlled end user electricity meters operative to communicate with a remotely located computer. The method comprises the steps of: (1) mapping the location of each end user meter; (2) periodically receiving data from each end user meter in response to a query to that meter; (3) when a plurality of meters in the same branch of the network fail to report during a given period, querying meters in neighboring branches to pinpoint the location of a break. Such queries, used in conjunction with the network map, will locate the break (at least to the resolution provided by the locations of the query-able meters) in a few seconds, thus reducing the time typically required to find a break by having line repair personnel visually inspect the lines until the break is spotted.

In a further embodiment, a personal computer (PC) is connected to a Scan Transponder and issues commands to the ST to continuously sequentially poll each meter for an echo. When multiple meters fail to echo, the ST correlates the serial numbers of these meters on an electrical distribution map (obtained by the Theft Detection mapping scheme, for example). If the non-communicating meters lie on the same distribution path, the PC hypothesizes that there is power line breakage at the point on the map where the meters fail to communicate.

**Virtual Meter**

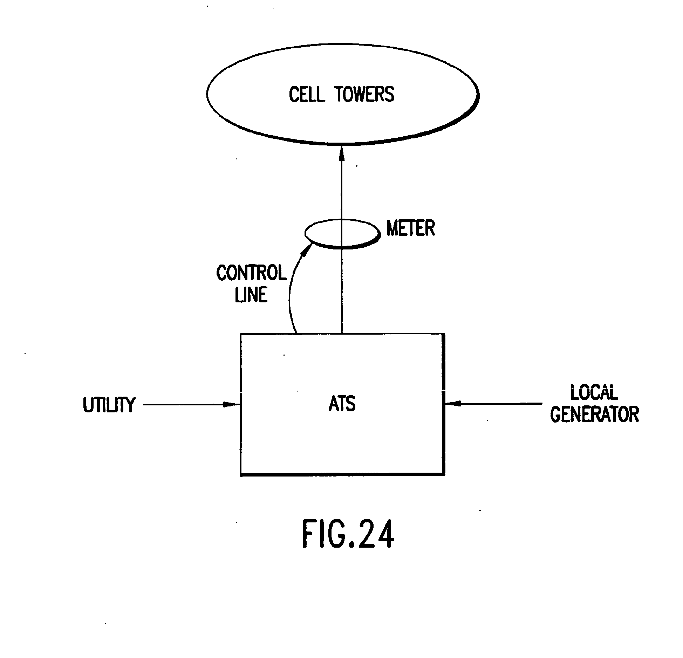

In a preferred embodiment (an example using an Automatic Transfer Switch (ATS) is depicted in **FIG. 24**), a single meter can monitor consumption from two or more sourcesfor example, a utility and a local generator -- and store the data into separate corresponding sets of data registers. In the example illustrated in **FIG. 24**, a logical control signal line from the ATS is connected to the meter. When power comes from the utility, the meter stores metering data into a first set of data registers. When utility power is interrupted and the ATS delivers power from the local generator, the control line from the ATS triggers the meter to store metering data into a second set of data registers. When utility service is restored, the ATS switches the power source back to the utility and releases the control line; metering data is once again stored in the first set of data registers. Those skilled in the art will recognize that this embodiment can be applied to more general situations wherein there are multiple power sources and the meter receives a signal indicating when to switch metering data storage to another set of data registers.

**Credit and Prepay Meters**

Credit and Prepay meters of a preferred embodiment address the problems with present credit and prepay systems. No operator is needed to enter the house since all transactions are performed by PLC. Fraud-prone swipe cards are not needed since a remote utility operator handles the energy purchase and deposits the amount to the meter by PLC.

Prepay Meters: In a prepay embodiment of a preferred system, energy is purchased by an end user customer from a system operator (typically, a utility operator) in advance. The operator deposits the purchased energy to the customer's meter by PLC. When the customer has reached his prepaid limit, the meter cuts power to the household. The LCD display preferably alternates (i.e., displays each for a pre-defined period, then displays another) between the following displays, for example: (1) "Deposit $50 01/23/01"; (2) "Remaining $23.45" (present amount remaining); and (3) "Estimated Cutoff 11:43 02/28/01" (based on present consumption).

Credit Meters: In a credit embodiment of a preferred system, energy is purchased on credit. When the customer fails to pay his bill, an operator can terminate power by instructing the meter through PLC. The LCD display alternates between displaying the following quantities, for example: (1) "Last Bill: $ 62.53 12/15/00"; (2) "Consumption: 45623.453 kWhr" (consumption on last bill); (3) "Projected Bill: $ 59.35 01/23/01" (1/23/01 is end of present billing cycle); and (4) "Cost per kWhr $0.15."

In a preferred embodiment, an operator also, when desired, remotely programs meters to cut off power when certain parameters are met or exceeded. For example, a customer with inferior credit may have his power temporarily discontinued when he uses 10 amps, when he uses 5 amps, or when his allotted consumption level is exceeded. The hardware and methodology for such remote programming are disclosed above.

**Printing Meter**

In a further embodiment, submeters are equipped with printers. In this embodiment, the utility still polls the meters for data through PLC and therefore has control over billing information. The utility calculates the bill and data is downloaded to the meter for local printing. Since the local printer is under utility control, the utility can initiate the printing of other messages through PLC as well. Such other messages may include billing receipts, rate changes, and usage profiles.

This is a useful feature in situations where it is inconvenient for a meter reader to enter the house to read the meter (for example, in countries or cultures where a male meter reader is not permitted to read the meter if the husband is not at home), or where local mail service is not reliable for sending invoices.

**Disabling customers using GFI**

This embodiment allows a utility to inexpensively disconnect a customer by taking advantage of an existing Ground Fault Interrupt (GFI) capable of interrupting power to the customer. For example, in Europe most residential customers are equipped with a whole-home GFI. The GFI is a protective circuit that shuts down power during anomalous current flow. In a preferred embodiment, when the utility wants to remove service to a customer, the utility sends a PLC signal to the meter. The meter then activates the GFI with onboard circuitry. The utility may want to deactivate customers for demand-side management applications or when customers fail to pay their bills.

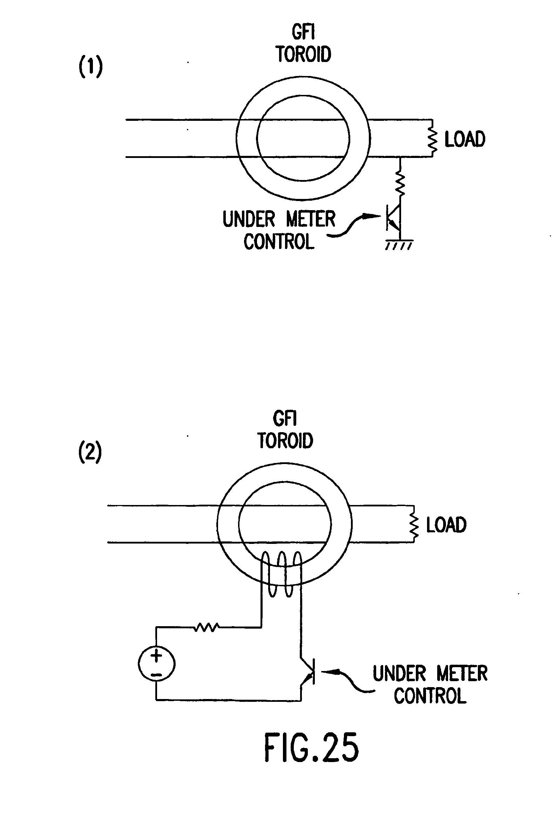

The meter preferably trips the GFI (see **FIG. 25**) either by (1) initiating a small leakage to earth ground, or (2) coupling a small amount of current into the GFI toroid.

## Claims

1. A system for monitoring energy usage on a power line comprising:

   (a) an electronic microprocessor-controlled digital electricity metering device (100) coupled to a power line and including a non-volatile non-battery-powered memory, wherein said metering device (100) is operable to perform interval metering for each of a plurality of intervals, is operable to store in said memory data acquired by said interval metering for each of said plurality of intervals, in a manner that enables recovery of measurements for individual intervals of said plurality of intervals and is operable to receive a data request and transmit data in response to said request over said power line; and
   (b) a data collector coupled to the metering device (100) via said power line, the data collector being operable to receive data from and transmit data to the metering device (100) over the power line; operable to store data received from the metering device (100) over the power line, and operable to receive data from and transmit data to a remotely located computer (140).

2. A system as in claim 1, wherein said data collector is a transponder (130).

3. A system as in claim 1, wherein said metering device (100) is coupled to an output device operable to control loads on said power line.

4. A system as in claim 1, wherein said metering device (100) is operable to meter reactive electric energy.

5. A system as in claim 1, wherein said data collector is operable to receive data from and transmit data to said remotely located computer (140) via a power line.

6. A system as in claim 1, wherein said data collector is operable to receive data from and transmit data to said remotely located computer (140) via a telephone line.

7. A system as in claim 1, wherein said data collector is coupled to and operable to store data in a non-volatile FLASH memory.

8. A system as in claim 1, wherein said metering device (100) comprises a microprocessor (U2) that is remotely programmable.

9. A system as in claim 8, wherein the microprocessor (U2) is operable to be remotely programmed to change what data are stored by the metering device (100) and in what time intervals.

10. A system as in claim 8, wherein the microprocessor (U2) is operable to be remotely programmed to change time-of-use profiles.

11. A system as in claim 8, wherein the microprocessor (U2) is operable to be remotely programmed to change whether the metering device (100) operates on a pre-paid or on a credit basis.

12. A system as in claim 8, wherein the metering device (100) is operable to retrieve local data.

13. A system as in claim 12, wherein said metering device (100) is coupled to a local display device (LCD1).

14. A system as in claim 13, wherein the microprocessor (U2) is operable to be remotely programmed to change what data are displayed on said display device (LCD1) .

15. A system as in claim 8, wherein said microprocessor (U2) is operable to be locally reprogrammed via a local data input device.

16. A system as claimed in any of the preceding claims wherein the non-volatile non-battery-powered memory is a FLASH memory.

**17.** A system as in claim 1, wherein said metering device (100) is coupled to and operable to receive data from other metering devices.

**18.** A system as in claim 1, wherein said metering device (100) is operable to adjust the frequency on which it transmits data over said power line.

**19.** A system as in claim 18, wherein said frequency is adjusted in response to instructions received from a remote computer.

**20.** A system as in claim 1, where said metering device (100) comprises a paper printing device.

**21.** A system as in claim 1, wherein said interval metering comprises periodically storing data into the non-volatile, non-battery-powered memory.

**22.** A system as in claim 21, wherein said metering device (100) is further operable to aggregate stored data upon request by said microprocessor.

**23.** A system as in claim 21, wherein said metering device (100) is further operable to report accumulated energy usage.

**24.** A system as in claim 23, wherein said energy usage is real, reactive, or apparent.

**25.** A system as in claim 24, wherein said aggregated data is aggregated according to intervals of said interval metering.

**26.** A system as in claim 1, wherein data acquired by said interval metering is stored such that data acquired during each interval is stored in a separate register.

**27.** A system as in claim 26 further comprising means for altering which register stores data for which interval.

**28.** A system as in claim 1, wherein data acquired by said interval metering is stored such that data acquired for each interval is separately recoverable for some time after the next interval.

**29.** A method of monitoring energy usage, comprising the steps of:

(a) measuring energy usage using a microprocessor-controlled digital electricity metering device (100) at regular intervals;
(b) storing data acquired by interval metering, said data representing measured energy usage for each of a plurality of said regular intervals, in a non-volatile, non-battery-operated memory of said metering device, wherein said data acquired by said interval metering is stored in a manner that enables recovery of measurements for individual intervals of said plurality of intervals;
(c) receiving a request for said stored data over a power line from a transponder (130), and
(d) in response to said request, transmitting said stored data over said power line to said transponder (130).

**30.** A method as in claim 29, wherein said metering device (100) comprises a remotely programmable microprocessor (U2).

**31.** A method as in claim 30, wherein said microprocessor (U2) can be remotely programmed and is operable to take a programmed action when a measured parameter reaches or exceeds a downloaded value.

**32.** A method as claimed in any of claims 29 to 31 wherein the non-volatile non-battery-powered memory is a FLASH memory.

**33.** A method as in any of claims 29 to 32, wherein for each interval of said plurality of said regular intervals, data representing measured energy usage for that interval is stored in a register separate from those used to store data for others of said intervals.

**34.** A method as in claim 33, wherein for each interval of said plurality of said regular intervals, data representing measured energy usage for that interval is separately recoverable for some time after a subsequent interval.

## Patentansprüche

**1.** System zum Überwachen der Energienutzung auf einer Netzleitung, umfassend:

(a) eine elektronische mikroprozessorgesteuerte digitale Elektrizitätsmessvorrichtung (100), die mit einer Netzleitung gekoppelt ist und einen nichtflüchtigen, nicht batteriegespeisten Speicher einschließt, worin die Messvorrichtung (100) betriebsfähig ist, Intervallmessung für jedes aus einer Vielzahl von Intervallen durchzuführen, betriebsfähig ist, durch die Intervallmessung erlangte Daten für jedes aus der Vielzahl von Intervallen auf eine Weise in dem Speicher zu speichern, welche die Wiederherstellung von Messwerten für einzelne Intervalle der Vielzahl von Intervallen ermöglicht, und betriebsfähig ist, eine Datenanforderung zu empfangen und als Antwort auf die Anforderung Daten über die Netzleitung zu übertragen; und
(b) einen Datensammler, der mittels der Netzleitung mit der Messvorrichtung (100) gekoppelt ist, wobei der Datensammler betriebsfähig ist, über die Netzleitung Daten von der Messvorrichtung (100) zu empfangen und zu ihr zu übertragen, betriebsfähig ist, von der Messvorrichtung (100) über die Netzleitung empfangene Daten zu speichern, und betriebsfähig ist, Daten von einem entfernt angeordneten Computer (140) zu empfangen und zu ihm zu übertragen.

**2.** System nach Anspruch 1, worin der Datensammler ein Transponder (130) ist.

**3.** System nach Anspruch 1, worin die Messvorrichtung (100) mit einer Ausgabevorrichtung gekoppelt ist, die betriebsfähig ist, Lasten auf der Netzleitung zu steuern.

**4.** System nach Anspruch 1, worin die Messvorrichtung (100) betriebsfähig ist, elektrische Blindenergie zu messen.

**5.** System nach Anspruch 1, worin der Datensammler betriebsfähig ist, mittels einer Netzleitung Daten von dem entfernt angeordneten Computer (140) zu empfangen und zu ihm zu übertragen.

**6.** System nach Anspruch 1, worin der Datensammler betriebsfähig ist, mittels einer Telefonleitung Daten von dem entfernt angeordneten Computer (140) zu empfangen und zu ihm zu übertragen.

**7.** System nach Anspruch 1, worin der Datensammler mit einem nichtflüchtigen Flash-Speicher gekoppelt ist und betriebsfähig ist, Daten darin zu speichern.

**8.** System nach Anspruch 1, worin die Messvorrichtung (100) einen Mikroprozessor (U2) umfasst, der fernprogrammierbar ist.

**9.** System nach Anspruch 8, worin der Mikroprozessor (U2) betriebsfähig ist, fernprogrammiert zu werden, um zu ändern, welche Daten durch die Messvorrichtung (100) in welchen Intervallen gespeichert werden.

**10.** System nach Anspruch 8, worin der Mikroprozessor (U2) betriebsfähig ist, fernprogrammiert zu werden, um Nutzungszeitprofile zu ändern.

**11.** System nach Anspruch 8, worin der Mikroprozessor (U2) betriebsfähig ist, fernprogrammiert zu werden, um zu ändern, ob die Messvorrichtung (100) auf einer vorausbezahlten oder auf einer Kreditbasis arbeitet.

**12.** System nach Anspruch 8, worin die Messvorrichtung (100) betriebsfähig ist, lokale Daten abzurufen.

**13.** System nach Anspruch 12, worin die Messvorrichtung (100) mit einer lokalen Anzeigevorrichtung (LCD1) gekoppelt ist.

**14.** System nach Anspruch 13, worin der Mikroprozessor (U2) betriebsfähig ist, fernprogrammiert zu werden, um zu ändern, welche Daten auf der Anzeigevorrichtung (LCD1) angezeigt werden.

**15.** System nach Anspruch 8, worin der Mikroprozessor (U2) betriebsfähig ist, mittels einer lokalen Dateneingabevorrichtung lokal umprogrammiert zu werden.

**16.** System nach einem der vorhergehenden Ansprüche, worin der nichtflüchtige, nicht batteriegespeiste Speicher ein Flash-Speicher ist.

**17.** System nach Anspruch 1, worin die Messvorrichtung (100) mit anderen Messvorrichtungen gekoppelt ist und betriebsfähig ist, Daten von ihnen zu empfangen.

**18.** System nach Anspruch 1, worin die Messvorrichtung (100) betriebsfähig ist, die Frequenz anzupassen, mit der sie Daten über die Netzleitung überträgt.

**19.** System nach Anspruch 18, worin die Frequenz als Antwort auf Anweisungen angepasst wird, die von einem entfernten Computer empfangen werden.

**20.** System nach Anspruch 1, worin die Messvorrichtung (100) eine Papierdruckvorrichtung umfasst.

**21.** System nach Anspruch 1, worin die Intervallmessung periodisches Speichern von Daten in den nichtflüchtigen, nicht batteriegespeisten Speicher umfasst.

**22.** System nach Anspruch 21, worin die Messvorrichtung (100) ferner betriebsfähig ist, gespeicherte Daten auf Anforderung durch den Mikroprozessor zusammenzufassen.

**23.** System nach Anspruch 21, worin die Messvorrichtung (100) ferner betriebsfähig ist, die aufgelaufene Energienutzung zu melden.

**24.** System nach Anspruch 23, worin die Energienutzung Wirk-, Blind- oder Scheinnutzung ist.

**25.** System nach Anspruch 24, worin die zusammengefassten Daten gemäß Intervallen der Intervallmessung zusammengefasst werden.

**26.** System nach Anspruch 1, worin durch die Intervallmessung erlangte Daten so gespeichert werden, dass während jedes Intervalls erlangte Daten in einem separaten Register gespeichert werden.

**27.** System nach Anspruch 26, ferner Mittel zum Verändern, welches Register Daten für welches Intervall speichert, umfassend.

**28.** System nach Anspruch 1, worin durch die Intervallmessung erlangte Daten so gespeichert werden, dass für jedes Intervalls erlangte Daten für eine gewisse Zeit nach dem nächsten Intervall getrennt wiederherstellbar sind.

**29.** Verfahren zum Überwachen von Energienutzung, die folgenden Schritte umfassend:

(a) Messen der Energienutzung unter Verwendung einer mikroprozessorgesteuerten digitalen Elektrizitätsmessvorrichtung (100) in regelmäßigen Intervallen;
(b) Speichern durch Intervallmessung erlangter Daten, wobei die Daten die gemessene Energienutzung für jedes aus einer Vielzahl der regelmäßigen Intervalle darstellen, in einem nichtflüchtigen, nicht batteriegespeisten Speicher der Messvorrichtung, worin die durch die Intervallmessung erlangten Daten auf eine Weise gespeichert werden, welche die Wiederherstellung von Messwerten für einzelne Intervalle der Vielzahl von Intervallen ermöglicht;
(c) Empfangen einer Anforderung für die gespeicherten Daten von einem Transponder (130) über eine Netzleitung; und
(d) als Antwort auf die Anforderung erfolgendes Übertragen der gespeicherten Daten über die Netzleitung zu dem Transponder (130).

**30.** Verfahren nach Anspruch 29, worin die Messvorrichtung (100) einen fernprogrammierbaren Mikroprozessor (U2) umfasst.

**31.** Verfahren nach Anspruch 30, worin der Mikroprozessor (U2) fernprogrammiert werden kann und betriebsfähig ist, eine programmierte Handlung vorzunehmen, wenn ein gemessener Parameter einen heruntergeladenen Wert erreicht oder überschreitet.

**32.** Verfahren nach einem der Ansprüche 29 bis 31, worin der nichtflüchtige, nicht batteriegespeiste Speicher ein Flash-Speicher ist.

**33.** Verfahren nach einem der Ansprüche 29 bis 32, worin für jedes Intervall der Vielzahl von regelmäßigen Intervallen Daten, welche die gemessene Energienutzung für dieses Intervall darstellen, in einem Register gespeichert werden, das von denen getrennt ist, die verwendet werden, um Daten für andere der Intervalle zu speichern.

**34.** Verfahren nach Anspruch 33, worin für jedes Intervall der Vielzahl von regelmäßigen Intervallen Daten, welche die gemessene Energienutzung für dieses Intervall darstellen, für eine gewisse Zeit nach dem anschließenden Intervall getrennt wiederherstellbar sind.

**Revendications**

**1.** Système de surveillance de la consommation d'énergie sur une ligne d'alimentation, comprenant :

(a) un dispositif numérique de mesure de l'électricité commandé par un microprocesseur électronique (100), couplé à une ligne d'alimentation, et comprenant une mémoire non volatile non alimentée par batterie, dans lequel ledit dispositif de mesure (100) est exploitable de manière à mettre en oeuvre une mesure d'intervalles pour chacun d'une pluralité d'intervalles, est exploitable de manière à stocker, dans ladite mémoire, les données acquises par ladite mesure d'intervalles pour chacun de ladite pluralité d'intervalles, d'une manière qui permet la récupération de mesures pour des intervalles individuels de ladite pluralité d'intervalles ; et est exploitable de manière à recevoir une demande de données et à transmettre des données en réponse à ladite demande sur ladite ligne d' alimentation ; et
(b) un collecteur de données couplé au dispositif de mesure (100) par l'intermédiaire de ladite ligne d'alimentation, le collecteur de données étant exploitable de manière à recevoir des données en provenance du dispositif de mesure (100), et à lui transmettre des données sur la ligne d'alimentation ; est exploitable de manière à stocker des données reçues à partir du dispositif de mesure (100) sur la ligne d'alimentation, et est exploitable de manière à recevoir des données en provenance d'un ordinateur situé à distance (140), et à lui transmettre des données.

**2.** Système selon la revendication 1, dans lequel ledit collecteur de données est un transpondeur (130).

**3.** Système selon la revendication 1, dans lequel ledit dispositif de mesure (100) est couplé à un dispositif de sortie exploitable de manière à commander des charges sur ladite ligne d'alimentation.

**4.** Système selon la revendication 1, dans lequel ledit dispositif de mesure (100) est exploitable de manière à mesurer de l'énergie électrique réactive.

**5.** Système selon la revendication 1, dans lequel ledit collecteur de données est exploitable de manière à recevoir des données en provenance dudit ordinateur situé à distance, et à transmettre des données audit ordinateur situé à distance (140), par l'intermédiaire d'une ligne d'alimentation.

**6.** Système selon la revendication 1, dans lequel ledit collecteur de données est exploitable de manière à recevoir des données en provenance dudit ordinateur situé à distance, et à transmettre des données audit ordinateur situé à distance (140), par l'intermédiaire d'une ligne téléphonique.

**7.** Système selon la revendication 1, dans lequel ledit collecteur de données est couplé à une mémoire FLASH non volatile, et est exploitable de manière à stocker des données dans la mémoire FLASH non volatile.

**8.** Système selon la revendication 1, dans lequel ledit dispositif de mesure (100) comprend un microprocesseur (U2) programmable à distance.

**9.** Système selon la revendication 8, dans lequel le microprocesseur (U2) est exploitable de manière à être programmé à distance en vue de modifier les données qui sont stockées par le dispositif de mesure (100) et les intervalles de temps concernés.

**10.** Système selon la revendication 8, dans lequel le microprocesseur (U2) est exploitable de manière à être programmé à distance en vue de modifier des profils de temps d'utilisation.

**11.** Système selon la revendication 8, dans lequel le microprocesseur (U2) est exploitable de manière à être programmé à distance en vue de modifier si le dispositif de mesure (100) opère sur une base de prépaiement ou sur une base de crédit.

**12.** Système selon la revendication 8, dans lequel le dispositif de mesure (100) est exploitable de manière à extraire des données locales.

**13.** Système selon la revendication 12, dans lequel ledit dispositif de mesure (100) est couplé à un dispositif d'affichage local (LCD1).

**14.** Système selon la revendication 13, dans lequel le microprocesseur (U2) est exploitable de manière à être programmé à distance en vue de modifier les données qui sont affichées sur ledit dispositif d'affichage (LCD1).

**15.** Système selon la revendication 8, dans lequel ledit microprocesseur (U2) est exploitable de manière à être reprogrammé localement par l'intermédiaire d'un dispositif de saisie de données local.

**16.** Système selon l'une quelconque des revendications précédentes, dans lequel la mémoire non volatile non alimentée par batterie est une mémoire FLASH.

**17.** Système selon la revendication 1, dans lequel ledit dispositif de mesure (100) est couplé à d'autres dispositifs de mesure et est exploitable de manière à recevoir des données provenant d'autres dispositifs de mesure.

**18.** Système selon la revendication 1, dans lequel ledit dispositif de mesure (100) est exploitable de manière à ajuster la fréquence à laquelle il transmet des données sur ladite ligne d'alimentation.

**19.** Système selon la revendication 18, dans lequel ladite fréquence est ajustée en réponse aux instructions reçues à partir d'un ordinateur distant.

**20.** Système selon la revendication 1, où ledit dispositif de mesure (100) comprend un dispositif d'impression de papier.

**21.** Système selon la revendication 1, dans lequel ladite mesure d'intervalles comprend le stockage périodique de données dans la mémoire non volatile non alimentée par batterie.

**22.** Système selon la revendication 21, dans lequel ledit dispositif de mesure (100) est en outre exploitable de manière à agréger des données stockées, sur demande dudit microprocesseur.

**23.** Système selon la revendication 21, dans lequel ledit dispositif de mesure (100) est en outre exploitable de manière à signaler la consommation d'énergie cumulée.

**24.** Système selon la revendication 23, dans lequel ladite consommation d'énergie est réelle, réactive ou apparente.

**25.** Système selon la revendication 24, dans lequel lesdites données agrégées sont agrégées selon des intervalles de ladite mesure d'intervalles.

**26.** Système selon la revendication 1, dans lequel les données acquises par ladite mesure d'intervalles sont stockées de sorte que les données acquises au cours de chaque intervalle sont stockées dans un registre individuel.

**27.** Système selon la revendication 26, comprenant en outre un moyen pour modifier le registre stockant les données et l'intervalle concerné.

**28.** Système selon la revendication 1, dans lequel les données acquises par ladite mesure d'intervalles sont stockées de sorte que les données acquises pour chaque intervalle sont récupérables séparément au cours d'un certain temps après l'intervalle successif.

**29.** Procédé de surveillance d'une consommation d'énergie, comprenant les étapes ci-dessous consistant à :

(a) mesurer une consommation d'énergie, en utilisant un dispositif numérique de mesure de l'électricité commandé par un microprocesseur (100), à des intervalles réguliers ;
(b) stocker les données acquises par les mesures d'intervalles, lesdites données représentant une consommation d'énergie mesurée pour chacun d'une pluralité desdits intervalles réguliers, dans une mémoire non volatile non alimentée par batterie dudit dispositif de mesure, dans lequel lesdites données acquises par lesdites mesures d'intervalles sont stockées d'une manière qui permet la récupération de mesures pour des intervalles individuels de ladite pluralité d'intervalles ;
(c) recevoir une demande pour lesdites données stockées, sur une ligne d'alimentation, en provenance d'un transpondeur (130) ; et
(d) en réponse à ladite demande, transmettre lesdites données stockées, sur ladite ligne d'alimentation, audit transpondeur (130).

**30.** Procédé selon la revendication 29, dans lequel ledit dispositif de mesure (100) comprend un microprocesseur programmable à distance (U2).

**31.** Procédé selon la revendication 30, dans lequel ledit microprocesseur (U2) peut être programmé à distance et est exploitable de manière à mettre en oeuvre une action programmée lorsqu'un paramètre mesuré atteint ou dépasse une valeur téléchargée.

**32.** Procédé selon l'une quelconque des revendications 29 à 31, dans lequel la mémoire non volatile non alimentée par batterie est une mémoire FLASH.

**33.** Procédé selon l'une quelconque des revendications 29 à 32, dans lequel, pour chaque intervalle de ladite pluralité desdits intervalles réguliers, des données représentant la consommation d'énergie mesurée pour cet intervalle sont stockées dans un registre séparé de ceux utilisés pour stocker des données pour d'autres desdits intervalles.

**34.** Procédé selon la revendication 33, dans lequel pour chaque intervalle de ladite pluralité desdits intervalles réguliers, des données représentant la consommation d'énergie mesurée pour cet intervalle sont récupérables séparément au cours d'un certain temps après un intervalle subséquent.

A1-QUADLOGIC SYSTEM INSTALLATION DIAGRAM
7.2/12.47 KV
60KV
12KV
ST-5
130
QLC
RS-232
FIBER OPTIC MUX
CAP/IND
COUPLERS
COUPLER
MT PLC
120
115
POWER TRANSFORMERS
LT PLC
120/208V
ST-5
QLC
110
RSM20
100
CUSTOMER READS OWN METER
VIA INTERNET
PC
FIBER
MT PLC
LT PLC
MT PLC=MEDIUM TENSION POWER LINE COMMUNICATION
LT PLC=LOW TENSION POWER LINE COMMUNICATION
FIBER LOOP
FIBER RSM20
SUBSTATION
RS232
22 SUBSTATIONS
OR FIBER LOOP
UTILITY BILLING CENTER READ METERS
VIA FIBER
MT PLC
LT PLC
140
FIBER MUX
RS-232
MODEM
INTERNET
FIG.1

A2-INSTALLATION DIAGRAM
SLAVE TRANSPONDER
3 PHASE 120/208V AERIAL TRANSFORMER
PHASE C
PHASE B
PHASE A
FUSE
DISCONNECT
120V
FIG.2
FERRITE
BEADS
N
03
02
01
FB-5B
120/208V
FERRITE
BEADS
POWER ADAPTER
BB-4
CN1
1
2
3
4
5
6
7
8
9
10
11
12
13
14
CV1
CAPACITOR#
RKS5704-0042
STRAP CAPACITOR TO POLE
INSULATED #6 AWG SOLID
SIGNAL TRANSFORMER
NEUTRAL COPPER CABLE
SIGNAL WIRES
ST-3
H1
POWER HEADER

A3-SUBSTATION INSTALLATION DIAGRAM MASTER TRANSPONDER ON UNUSED SWITCH CABINET
PHASE C
PHASE B
PHASE A
CAPACITOR #
RK5704-0042
INSULATED #8 AWG
SIGNAL TRANSFORMER
2x #12 AWG
TO FIG.3B
CAPACITOR #
RK5704-0042
INSULATED #8 AWG
SIGNAL TRANSFORMER
2x #12 AWG
TO FIG.3B
CAPACITOR #
RK5704-0042
INSULATED #8 AWG
SIGNAL TRANSFORMER
2x #12 AWG
CV1
CN1
TO FIG.3B

FIG.3A

TO FIG.3A
TO FIG.3A
TO FIG.3A
120V TO POWER SUPPLY
NEUTRAL
PHASE 1
FERRITE BEADS
CV2
CN2
CV3
CN3
POWER ADAPTER
1234567
10 12 14
89 11 13
FB-5B
Ø1 Ø2 Ø3 N
120/208V
FERRITE BEADS
BB-4
POWER ADAPTER
SIGNAL WIRES
ST-5
POWER HEADER

FIG.3B

A4-AERIAL TRANSFORMER (CAPACITIVE)
(3) SINGLE PHASE
VOLTAGE TAP W/PLUG 120V
CONCENTRATOR/
SIGNAL UNIT
STRAPUNIT TO POLE
ST-5C
120V/
NEUTRAL
QLC
NEUTRAL COPPER CABLE

FIG.4

A5-PHASE TO PHASE INDUCTIVE PAD MOUNT COUPLER
H2A
10 FEET #8
AWG (SOLID)
H1A
H2A
H3A
H1B
H2B
H3B
X1
X2
X3
X0
SIGNAL TRANSFORMER
SIGNAL WIRES

FIG.5

A6-SIGNAL TRANSFORMER ASSEMBLY
10 FEET #8 AWG (SOLID)
#8 AWG (SOLID) & #16 AWG 1015 (STRANDED) SPLICED
TOROIDS 10 x 46113-TC CUT
& GLUED FISHPAPER
2 x 5" x 0.5" x 0.018" THICK
14 TURNS #16 AWG 1015 (STRANDED)
#8 AWG (SOLID) & #16 AWG 1015 (STRANDED) SPLICED
SIGNAL WIRES 14 TURNS #12 AWG 1015-600V
INSULATION (STRANDED) EXTENDED 12 FEET
10 FEET #8 AWG (SOLID)

FIG.6

A7–CONCENTRATOR/SIGNAL UNIT DIAGRAM
7200 VOLTS
SIGNAL WIRES
GROUND LUG
OIL FILLED
15M–OHM
FUSE
0.1uF/
7200VAC

FIG.7

A8-MASTER TRANSPONDER POWER ADAPTER 120/208V

14 PIN RECEPTACLE

MN

9 PIN PLUG

CN1 (WHITE/BLACK)
CV1 (BLACK/WHITE)
CN2 (WHITE/RED)
CV2 (RED/WHITE)
CN3 (WHITE/BLUE)
CV3 (BLUE/WHITE)
MN (WHITE)
MV1 (BLACK)
MV2 (RED)
MV3 (BLUE)

PN (WHITE)
PV1 (BLACK)
PV2 (RED)
PV3 (BLUE)

PHASE 1
PHASE 2
PHASE 3

FIG.8A

SLAVE TRANSPONDER POWER ADAPTER 120/208V
14 PIN RECEPTACLE
MN
9 PIN PLUG
CN1 (WHITE/BLACK)
CV1 (BLACK/WHITE)
CV2 (RED/WHITE)
CV3 (BLUE/WHITE)
MN (WHITE)
MV1 (BLACK)
MV2 (RED)
MV3 (BLUE)
8 1
9 2
10 3
11 4
12 5
13 6
14 7
CN2 (WHITE/RED)
CN3 (WHITE/BLUE)
PN (WHITE)
PV1 (BLACK)
PV2 (RED)
PV3 (BLUE)
PHASE 1
PHASE 2
PHASE 3
1 2 3
4 5 6
7 8 9

FIG.8B

| | | |
|---|---|---|
| | FIG.9A-1 | FIG.9A-2 |
| FIG.9A-3 | FIG.9A-4 | FIG.9A-5 |
| FIG.9A-6 | FIG.9A-7 | FIG.9A-8 |
| FIG.9A-9 | FIG.9A-10 | FIG.9A-11 |

FIG. 9A

D=(00:15)
A=(00.23)
A-23
A-22
A-21
A-13
A-12
A-11
A-10
A-09
A-08
A-07
A-06
A-05
A-04
A-03
A-02
A-01
C17
+5v

FIG.9A–1

A-13
A-14
A-15
A-16
A-17
A-18
A-19
A-20
A-21
A-22
A-23
D-15
D-14
D-13
D-12
C3
+5v

FIG.9A–2

+5V
TESTN
SW1
SW2
SW3
R2
Q1
RXD
C1
D2
C51
C50
D1
C53
C52
R1
Y2
+5V
D6
R5
TXD
Q2
VREF
D7
D3
D4

FIG.9A-3

FIG.9A-4

U1
FS1004
LCDCS
DROMCSN
PROMCSN
WRN
LCDC
+5V
D-15
D-07
D-14
D-06
D-13
D-05
D-12
D-04
D-11
D-03
D-10
D-02
D-09
D-01
D-08
D-00

A-12
A-11
A-10
A-09
A-08
A-07
A-06
A-05
A-04
A-03
A-02
A-01
U2
WC68CC0001U12
C4
C2
C8
+5v
+5v
WE

FIG.9A-5

LED2
D5
C48
D8
C49
R3
VBATF
BATF
CR1
CM354W-2.5V
+V
ADJ
-V
1
2
3
4
5
6
7
8

FIG.9A-6

VRCF
C9
C10
C25
C24
C23
C22
C21
C20
C19
C18
H3
H2
R6
C14
GP1 GP2
R14
R15
R13
+5v
60
59
58
57
56
55
54
53
52
51
50
49
48
47
46
45
44
43
42
41
40
39
38
37
36
35
34
33
32
31
FIG.9A-7

A-16
A-15
A-14
A-13
A-12
A-11
A-10
A-09
A-18
A-08
A-07
A-06
A-05
A-04
A-03
A-02
A16 1
BYTEN 2
VSS 3
D15 4
D7 5
D14 6
D6 7
D13 8
D5 9
D12 10
D4 11
VCC 12
D11 13
D3 14
D10 15
D2 16
D9 17
D1 18
D8 19
D0 20
DEM 21
VSS1 22
CEM 23
A0 24
A15 48
A14 47
A13 46
A12 45
A11 44
A10 43
A9 42
A8 41
NC5 40
NC4 39
WEN 38
RESETN 37
NC3 36
NC2 35
RY/BY 34
NC1 33
A17 32
A7 31
A6 30
A5 29
A4 28
A3 27
A2 26
A1 25
D-15
D-07
D-14
D-06
D-13
D-10
D-12
D-17
D-11
D-03
D-10
D-02
D-09
D-01
D-08
D-00
A-17
C6
C7
V1
A1
A2
A3
A4

FIG.9A-8

H1
P11
P12
P13
GP1
GP2
SW1
SW2
SW3
+5v
TXD
RXD
H1
H2
H3
VBATT
BATT
C45
C46
C47
C32
C37
C36
C39
C34
C33
C31
C29
C27
C16
C30
C28
C26
C11
C12
C13
C42
C43
C40
C41

FIG.9A-9

P02
P01
TESTN
RESETN
PLC31
PLC32
PLC1
PLC2
WV1
WV2
WV3
11
12
13
VREF
+5v
C44
C38
C35
VRCF
WV1
WV2
WV3
11
M1
12
M2
13
M3
PLC1
PLC2
PLCX1
PLCX2

FIG.9A-10

U5
7C1020
A15 A13 A12 OC UB LB 1/015 1/014 1/013 1/012 VSS VCC1 1/011 1/010 1/09 1/08 A18 A11 A10 A09 A08 A17
A16 A0 A1 A2 A3 CC 1/00 1/01 1/02 1/03 VCC GHD 1/04 1/05 1/06 1/07 WE A4 A5 A6 A7 A16
A-15 A-14 A-13
D-15 D-14 D-13 D-12
D-11 D-10 D-09 D-08
A-19 A-12 A-11 A-10 A-16
A-16 A-01 A-02 A-03 A-04
D-00 D-01 D-02 D-03
D-04 D-05 D-06 D-07
A-05 A-06 A-07 A-08 A-17
P11 P12 P13 P01 P02

FIG.9A−11

| | | |
|---|---|---|
| | FIG.9B-1 | FIG.9B-2 |
| FIG.9B-3 | FIG.9B-4 | FIG.9B-5 |
| FIG.9B-6 | FIG.9B-7 | FIG.9B-8 |
| FIG.9B-9 | FIG.9B-10 | FIG.9B-11 |

FIG. 9B

D=(00:15)
A=(00.23)
A-23
A-22
A-21
A-13
A-12
A-11
A-10
A-09
A-08
A-07
A-06
A-05
A-04
A-03
A-02
A-01
+5v
C17
0.1uf

FIG.9B—1

A-13
A-14
A-15
A-16
A-17
A-18
A-19
A-20
A-21
A-22
A-23
D-15
D-14
D-13
D-12
0.1uf
C3
+5v

FIG.9B-2

+5V
TESTN
FMM3904
R2
475R
Q1
SW1
SW2
SW3
RXD
C1
0.1uf
D2
1H414B
C50
C51
0.1uf
2.2uf/16v
D1
1H414B
2.2uf/16v
C52
C53
0.1uf
R1
6K19
32768Hz
Y2
+5V
D8
1H414B
R5
8K19
TXD
Q2
D7
1H414B
D3
1H414B
D4
1H414B
VREF

FIG.9B–3

FIG.9B-4
U1
FS1004
TESTN
SW1
SW2
SW3
GN01
VDD1
LCDCS
EIOCSN
OROWC5N
PROWC5N
RAWC5N
WRK
RSET
HN
XTL11
XTL10
VBATT
VCC
V002
GND2
RXD
TXD
POTA
POTWPE
POTB
VRCF
LCDCONT
LED
AV001
LCDCS
DROMCSN
PROMCSN
WRN
LCDC
+5V
PDM
MASTER
ASN
UDSN
LDSN
PWN
PLN2
PLN1
PLND
POND2
PVND2
LOOK
DTACK
CLK
HALTN
RESETN
BERRN
P11
P12
P13
P01
P02
XTL21
XTL20
PVDD1
PGND1
RESETN
GPA11
GPA12
GPA13
PHIN
PHOUT
AGND1
PHA
PHB
PHC
PLCR1
PLCR2
AGND2
AVDD2
PLCX1
PLCX2

U2
C4
0.1uf
C2
0.1uf
C8
0.1uf
wE
+5v
+5v
A-12
A-11
A-10
A-09
A-08
A-07
A-06
A-05
A-04
A-03
A-02
A-01

FIG.9B-5

LED2
D5
1H4148
C48
0.1uf
D6
1H4148
C49
0.1uf
LED
R3
2K
VBATT
BATT
CM354W-2.5V
CR1
+V
ADJ
-V
1
2
3
4
5
6
7
8

FIG.9B-6

AW29F400ATF
U3
A-16
A-15
A-14
A-13
A-12
A-11
A-10
A-09
A-18
A-08
A-07
A-06
A-05
A-04
A-03
A-02
A15
A14
A13
A12
A11
A10
A9
A8
NC5
NC4
WEN
RESETN
NC3
NC2
RY/BY
NC1
A17
A7
A6
A5
A4
A3
A2
A1
A16
BYTEN
VSS
D15
D7
D14
D6
D13
D5
D12
D4
VCC
D11
D3
D10
D2
D9
D1
D8
D0
DEM
VSS1
CEM
A0
D-15
D-07
D-14
D-06
D-13
D-10
D-12
D-17
D-11
D-03
D-10
D-02
D-09
D-01
D-08
D-00
A-17
A-01
C6
0.1uf
C7
0.1uf
V1
12MHz

FIG.9B--8

1000uf
1000uf
1000uf
0.1uf
0.1uf
0.1uf
C45
C46
C47
C32
C37
C36
C39
1000pf
H1
PH2-224/100-34-1
P11
P12
P13
LED
GP2
SW1
SW2
SW3
+5v
TXD
RXD
H1
H2
H3
VBATT
BATT
C16
0.1uf
C34
C33
C31
C29
C27
0.1uf
0.1uf
0.1uf
0.1uf
0.1uf
C30
C28
C26
C11
C12
C13
0.1uf
0.1uf
0.1uf
1000uf
1000uf
1000uf
C42
C43
C40
C41
1000uf
1000uf
1000uf
1000uf

FIG.9B-9

P02
P01
TESTN
RESETN
PLCX1
PLCX2
PLC1
PLC2
WV1
WV2
WV3
I1
I2
I3
VREF
+5v
C44
C38
C35
0.1uf
1000uf
1000uf
VREF
WV1
WV2
WV3
I1
M1
I2
M2
I3
M3
PLC1
PLC2
PLCX1
PLCX2

FIG.9B-10

U5
7C1020
A15
A0
A1
A2
A3
CC
1/00
1/01
1/02
1/03
VCC
GND
1/04
1/05
1/06
1/07
wE
A4
A5
A6
A7
A16
A14
A13
A12
OC
UB
LB
1/015
1/014
1/013
1/012
VSS
VCC1
1/011
1/010
1/09
1/08
A18
A11
A10
A09
A08
A17
A-15
A-14
A-13
A-19
A-12
A-11
A-10
A-16
D-15
D-14
D-13
D-12
D-11
D-10
D-09
D-08
D-00
D-01
D-02
D-03
D-04
D-05
D-06
D-07
A-16
A-01
A-02
A-03
A-04
A-05
A-06
A-07
A-08
A-17
P11
P12
P13
P01
P02

FIG.9B-11

| FIG.10A | FIG.10B | FIG.10C |
|---|---|---|
| | FIG.10D | |

FIG. 10

FIG.10A

S101.801
C5
0.1uf
0v00
+5v
R7
2K
R8
2K
OPTIONAL

FIG.10B

U4
R6
90K9
R9
R10
R11
2K
2K
2K
LCDC
A-01
WC
LCDCS
D=(00.15)
D=(00.15)
C101.141

FIG.10C

U6
28F320JA
DROWC5N
+5v
PROWC5N
RESETN
A22
CE1
A21
A20
A19
A18
A17
A16
VCC
A15
A14
A13
A12
CEO
VPEN
HP#
A11
A10
A9
A8
GHO
A7
A6
A5
A4
A3
A2
A1
NCI
WE#
OE#
ST5
DQ15
DQ7
DQ14
DQ8
GHD2
DQ13
DQ5
DQ12
DQ4
VCCO
GNDI
DQ11
DQ3
DQ10
DQ2
VCC1
DQ9
DQ1
DQ8
DQ0
A0
BYTE#
NC
CE2
WC
WRK
R12
2K
+5v

FIG.10D

| FIG.11A-1 | FIG.11A-2 | FIG.11A-3 |
|---|---|---|
| FIG.11A-4 | FIG.11A-5 | FIG.11A-6 |
| FIG.11A-7 | FIG.11A-8 | FIG.11A-9 |
| FIG.11A-10 | FIG.11A-11 | |

FIG.11A

+U
R76
220R/2W
U1
LM29405-5
1
2
3
4
C24
0.1uF
C1
6800uf/16v
SMCJ18A
CR1
C2
0.1uF
1N5817
D1
D2
D3
D4
R58
249K
R59
3K32
ORO
R88
R87
R86
GP2
T1
VREF
R79
R78
R77
PN
PV

FIG.11A-1

PVDD
+5V
LE02
+5V
C3
0.1uF
PGND
QSD422
Q4
+5V
R65
ORO
RXO
R64
3K32
H3
P11
LEO
GP2
SW1
SW2
SW3
TXD
RXD
N1
N2
N3
BATT
P02
P01
TESTN
PLCX1
PLCX2
PLC1
MV1
MV2
MV3
11
12
13
VREF
+5V
H8
R62
100R
R61
100R
R63
100R
SW1
SW2
SW3
H2
SW1
DISPLAY
SW2
TAMPER
SW3
DKR
FIG.11A-2

CT1
CT2
CT3
1I
1N
2I
2N
3I
3N
I1
I2
I3
N1
N2
N3
VREF
R16
R17
R18
R19
R20
R21
R22
R23
R24
R25
R26
R27
R28
R29
R30
R31
R32
R33
R80
R81
R82
R83
R84
R85
D10
D11
D12
D13
D14
D15
D16
D17
D18
D19
D20
D21
10R
0R0

FIG.11A-3

H5
5
4
3
2
1
PULSE IN
R51
10K
L2
20-TURNS
20-TURNS
Q1
C19
0.022uF
+5V
1K
R52
D6
D7
C18
0.1uF
D5
D8
B1
BATT
+5V
TXO
182R
R60
LED1
F5E1QT

FIG.11A-4

+5V
PI1
PO1
PO2
VREF
H11A817C-5
R50
100R
OPT3
C14
0.001uF
R49
100R
OPT4
C13
0.001uF
R48
100R
OPT5
C12
0.001uF
R47
100R
OPT6
C11
0.001uF
32768Hz
Y1
C20
1uF/16V
C21
15pF
C22
15pF

FIG.11A-5

H4
MC-HOR OPTION
R74
R72
R73
1K
1K
1K
HEADER FOR MODEM OPTION
H6
+5V
RxO
TxO
H10
PROG HDR
PIC16LC505
U4
VDD
RB5
RB4
RB3
RC5
RC4
RC3
VSS
RB0
RB1
RB2
RC0
RC1
RC2
PO2
PO1
PI1

FIG.11A-6

C8
0.1uF
L1
10-TURNS
4-TURNS
SWCJ4DCA
CR4
1K
R75
D32
D33
1N4003
1N4003
Q6
Q5
R96
249K
C26
1.8uF/400V
FZT789B
FZT690B
2K
2K
R71
R68
R95
249K
330R
R70
D37
D34
R67
330R
D35
R57
249K
D36
182R
182R
C5
1.8uF/400V
R69
R66
R56
0.1uF
0.1uF
C7
C6
CR3
+U
PLCX2
CV

FIG.11A-7

OPTB
H11L1
OPTA
H11L1
R46
ORO
R45
ORO
H9
PULSE OUT
PLCX1
C10
0.1uF
C9
0.1uF
R39
182R
R36
182R
D30
D31
R38
330R
D28
R35
330R
D29
R37
2K
R34
2K
FZT789B
FZT690B
Q3
Q2
D22
1N4003
D23
1N4003
R42
1K
R41
10K
C23
0.1uF
D24
D25
PLC1
R40
10K
VREF

FIG.11A-8

PH-B
PH-C
PH-A
R1
R2
R3
R4
R5
R6
R7
R8
R9
R10
R11
R12
R13
R14
R15
249K
1K
MV2
VREF
MV3
MV1
+5V
475R
R43
R44

FIG.11A-9

L3
PM54-100M
R55
249K
1.8uF/400V
C4
R54
249K
CN

FIG.11A-10

H1
1
2
3
4
5
6
7
8
9
10
11
12
13
14
3N
2N
1N
PN
PV
CV
CN
3I
2I
1I
VREF
PH-B
PH-C
PH-A
C15
C16
C17

FIG.11A-11

Y
K
Z
H7
+5V
R89
1K
K1
PS7142L-1A
K2
PS7142L-1A
U2B
LM339M
U2A
LM339M
U2D
LM339M
U2C
LM339M
4.5V
0.5V
R90
10K
R91
10K
C25
0.1uF
+5V
LED
R94
1K
R93
10K
R92
1K

FIG.11B

| | | | |
|---|---|---|---|
| FIG.11C-1 | FIG.11C-2 | FIG.11C-3 | FIG.11C-4 |
| FIG.11C-5 | FIG.11C-6 | FIG.11C-7 | FIG.11C-8 |
| FIG.11C-9 | FIG.11C-10 | FIG.11C-11 | FIG.11C-12 |
| FIG.11C-13 | | | |

FIG.11C

+U
C8
0.1uF
C1
3300uF/35v
C2
0.1uF
CR1
SMCJ30A
1N4003
D1
D2
D3
D4
R58
249K
R59
3K32
GP2
VREF
10
R77
R76
R75
R92
ORO
T1
14 A 10R10
T2
R74
R73
R72
R80
PN
PV
PN1
H9
FIG.11C-1

PVDD
R81
220R/2W
U1
LM340S-5
+5V
C6
0.1uF
PGND
QSD422
Q4
R65
0R0
R64
3K32
RXO
H3
P02
P01
TESTN
PLCX1
PLCX2
PLC1
MV1
MV2
MV3
I1
I2
I3
VREF
P11
LED
GP2
SW1
SW2
SW3
TXD
RXD
N1
N2
N3
BATT
H2
SW5
TEST
R62
100R
R61
100R
R63
100R
H1
TAMPER
DISPLAY
DKR


FIG.11C-2

TXD
H7
2
4
6
8
10
1
3
5
7
9
RXD
+5V
IO
IO

FIG.11C-3

CT1
CT2
CT3
2
1
R16
R17
R18
R19
R20
R21
R22
R23
R24
R25
R26
R27
R28
R29
R30
R31
R32
R33
10R
D10
D11
D12
D13
D14
D15
D16
D17
D18
D19
D20
D21
1N414B
I1
VREF
N1
I2
N2
I3
N3

FIG.11C-4

R79
ORO
R78
ORO
PV1
2
1
6
5
R91
ORO
R90
ORO
IO
H5
5
4
3
2
1
PULSE IN
20T
L3
20T
+5V
1N4148
1N4148
D5
D7
R60
182R
D8
1N4148
R50
1K
F5E1QT
LED1
D6
BATT
CMPSH-3
C3
0.1uF
0.022uF
C20
Q1
TXD
CR2032
B1

FIG.11C--5

R46
100R
OPT3
R47
100R
OPT4
R48
100R
OPT5
R49
100R
OPT6
R43
10K
C11
1000pF
C12
1000pF
C13
1000pF
1000pF
C14
32768Hz
Y1
C18
15pF
C19
15pF
C21
1uF/16V

FIG.11C-6

H10
U2
PIC16LC505
VDD
RB5
RB4
RB3
RC5
RC4
RC3
VSS
RB0
RB1
RB2
RC0
RC1
RC2
PO2
PO1
PI1
+5V
475R
R43
475R
R44

FIG.11C-7

U3D
LM339M
13
10
11
Y
K
Z
H6
PS7142L-1A
K1
K2
1K
R87
U3B
U3A
LM339M
LM339M
4.5V
0.5V
10K
R85
10K
R86
C25
0.1uF
U3C
LM339M
14
4.5V
LED
0.5V
1K
R82
10K
R83
1K
R84
+5V

FIG.11C-8

+U
1N4148
D34
R66
182R
D35
1N4148
R68
2K
R70
330R
FZT789B
Q6
FZT690B
Q5
1N4003
D37
D36
1N4003
C7
0.1uF
L1
6T
4T
D22
1N4003
D23
1N4003
PLCX2
C24
0.1uF
C23
0.1uF
R71
330R
R67
182R
1N4148
D32
D33
1N4148
R69
2K
R51
1K
R40
1K
R41
10K
R56
249K
R57
249K
R88
249K
R89
249K
C5
1.8uF/400V
C26
1.8uF/400V
CV
471KD14
CR3
CR4
SWCJ4DCA

FIG.11C-9

PLC1
0.1uF
0.1uF
C10
C9
D31
182R
182R
1N4148
1N4148
R39
R36
D29
PLC1
VREF
10K
R42
1N4148
D30
R38
R35
D28
1N4148
0.1uF
C22
2K
330R
330R
2K
R37
R34
D27
FZT789B
FZT690B
1N4148
Q3
Q2
D26
1N4148

FIG.11C-10

H11L1
OPTB
H11L
OPTA
R52
ORO
R53
ORO
PULSE OUT
H8
PV
PH-A
PH-B
PH-C
PN
CV
CN
VREF

FIG.11C-11

PH-A
C15
2700pF/1KV
PH-B
C16
2700pF/1KV
PH-C
C17
2700pF/1KV
R1
249K
R2
249K
R3
249K
R4
249K
R5
1K
R6
249K
R7
249K
R8
249K
R9
249K
R10
1K
R11
249K
R12
249K
R13
249K
R14
249K
R15
1K
MV1
MV2
VREF
MV3

FIG.11C-12

L2
1
2
PM54-100M
R55
249K
1.8uF/400V
C4
R54
249K
CN

FIG.11C-13

| | | |
|---|---|---|
| FIG.12A-1 | FIG.12A-2 | FIG.12A-3 |
| FIG.12A-4 | FIG.12A-5 | FIG.12A-6 |
| FIG.12A-7 | FIG.12A-8 | FIG.12A-9 |

FIG.12A

R16
VREF
D12
D10
D11
D9
D8
D6
D7
D5
DRD
PV3
PV2
R39
R38
R37
R36
R35
T4
T3
H8

FIG. 12A-1

D22
D21
D25
L2
PLC1A
PLC1B
CX7
+U
+U
L1
4
3
5
6
2
7
1
RX4
RX3
CX2
CR2
CX1
RX2
RX1
CR1
L7
CV1
CN1
CP2
+U
C5
R17
C4
+
CR7

FIG. 12A-2

TX1
INVR1
PLCX1
PLCX2
TX2
INVR2
U12B
U12A
U13A
74HC86
U10B
U10A
U11B
74HC02
CX8
CX9
CX12
RX13
RX14
RX15
RX16
RX17
RX18
RX19
RX20
RX21
D17
D18
D19
D20
D23
D26
Q1
Q2
Q3

FIG. 12A-3

C6
D4
D2
D3
D1
R37
PV1
R33
R32
R31
8
7
6
5
T2
4
3
2
1

FIG. 12A-4

RX7
RX8
L3
CX11
L4
D24
L8
CX4
CV2
2
4
3
CR3
CR4
7
PLC2A
CN2
CX3
5
U1
+U
1
3
+5V
RX5
RX6
1
6
PLC2B
4
2
C7
D28
RX11
RX12
L5
CX15
L6
L9
CX6
CV3
2
4
D27
3
CR5
CR6
7
PLC3A
CX5
5
CN3
RX9
RX10
1
6
PLC3B

FIG. 12A-5

Q4
D29
RX23
RX24
RX22
D30
CX13
U11A
74HC02
U13B
74HC86
D60
RX25
RX27
Q5
RX26
D61
CX16
U11C
74HC02
U13C
74HC86
TX3
INVR3
Q6
D62
RX29
RX30
RX30
D63
CX17
U11D
74HC02
U13D
74HC86
U10C
74HC02
U12C
74HC86

FIG. 12A-6

H6
R30
R29
R28
PV1
T1
PN
+U
C14
C15
H7
+5V
RX10
TX10
CH1
CH2
CH3
PV2
PV3
CV1
CV2
CV3
VREF
MV1
MV2
MV3

FIG. 12A-7

D46
D47
D50
D51
D54
D55
RR1
RR3
RR4
RR6
RR7
RR9
RR2
RR5
RR8
PLC1A
PLC1B
PLC2A
PLC2B
PLC3A
PLC3B

FIG. 12A-8

D44
D45
D48
D49
D52
D53
13
U10D
12
11
74HC02
U12D
13
74HC86
U14
CD4052M
+5V
YOVCC
Y1
Y2
Y3
X0
X1
X2
X3
GND
B
A
YOUT
XOUT
INH
VEE
8
A
VREF
PLC1

FIG. 12A-9

| FIG.12B-1 | FIG.12B-2 | FIG.12B-3 |
|---|---|---|
| FIG.12B-4 | FIG.12B-5 | FIG.12B-6 |
| FIG.12B-7 | FIG.12B-8 | FIG.12B-9 |

FIG.12B

R70
1K
R1
249K
CR1
R3
249K
R72
1K
R5
249K
CV1
CN1
10K
R69
R71
10K
VREF
D54
D56
D53
D55
C37
0.1uF
R77
10K
C38
0.1UF
C10
0.1uF
U2
VDD
RB5
RB4
RB3
RC5
RC4
RC3
VSS
RB0
RB1
RB2
RC0
RC1
RC2
PO2
P11
TX4
TX1
TX2
TX3
+5V
B
A
PO1
INVR3
INVR2
INVR1

FIG. 12B-1

C21
0.1uF
C22
0.1uF
R18
182R
R22
182R
R30
182R
R19
330R
R21
330R
D23
D21
D22
D24
D31
R20
2K
R17
2K
R32
2K
Q1
Q2
Q5
D5
D6
D9
+U
+U
R65
1K
L1
CR2
R2
249K
R4
249K
R6
249K
C13
C14

FIG. 12B-2

INVR1
PLCX1
TX1
PLCX2
INVR2
TX2
U6B
74HC86M
U6A
74HC86M
U6D
74HC86M
U4B
74HC02M
U4A
74HC02M
U4D
74HC02M
C23
0.1uF
C24
0.1uF
R24
182R
R28
182R
R36
182R
D27
D25
D26
D28
D35
R25
330R
R27
330R
R26
2K
R23
2K
R38
2K
Q3
Q4
Q7
D7
D8
D11
+U
+U

FIG. 12B-3

+5V
U3
CD4052M
16
9 B
10 A
3 YOUT
VCC
Y0 1
Y1 5
Y2 2
Y3 4
X0 12
X1 14
X2 15
X3 11
13 XOUT
6 INH
7 VEE
GND
8
B
A
PLC1
R78
10K
VREF
CV2
CR3
CN2
R7
249K
C39
0.1uF
R74
1K
D57
D58
R73
10K
R9
249K
CV3
CR5
CN3
R11
249K
R79
10K
VREF

FIG. 12B-4

C25
0.1uF
C26
0.1uF
R31
330R
D29
D30
R33
330R
R34
182R
D32
R29
2K
Q6
D10
R66
1K
L2
CR4
C15
C16
R8
249K
+U
D39
R42
182R
C29
0.1uF
R43
330R
D37
R44
2K
Q9
D13
D38
C30
0.1uF
R45
330R
R46
182R
R41
2K
Q10
D14
R67
1K
L3
CR6
R10
249K
C17
C18
R12
249K

FIG.12B-5

R37
330R
C27
D33
0.1uF
Q8
D34
C28
330R
R39
0.1uF
D12
R35
2K
R40
182R
D36
U4C
74HC02M
U6C
74HC86M
U5B
74HC02M
U7B
74HC86M
INVR3
+U
D43
R50
2K
R48
182R
C31
Q11
R49
330R
D15
0.1uF
D41
D42
Q12
330R
C32
D16
R51
182R
0.1uF
R47
2K
R52
U5B
74HC02M
U7A
74HC86M
TX3

FIG. 12B-6

C40
0.1uF
R76
1K
R13
249K
D59
D60
R75
10K
CV4
CR7
R80
10K
VREF
CN4
R15
249K
H1
VREF
MV1
CV1
CV2
CV3
CV4
8
9
10
11
12
13
14
1
2
3
4
5
6
7
PV
PN
CN1
CN2
CN3
CN4
+U

FIG. 12B-7

D40
+U
D47
R14
249K
R56
2K
R54
182R
Q13
C33
C19
D17
R55
330R
0.1uF
CR8
D45
C20
Q14
D46
R57
330R
C34
D18
0.1uF
R16
249K
R68
1K
R53
2K
R58
182R
D48
C5
10uF
/35V
C6
0.1uF
45V
C7
0.1uF
C8
0.1uF
C9
0.1uF

FIG. 12B-8

TX4
U5D
74HC02M
U5C
74HC02M
C35
0.1uF
C36
0.1uF
R60
182R
R64
182R
R61
330R
R63
330R
D51
D49
D50
D52
D44
R62
2K
R59
2K
Q15
Q16
D19
D20
+U
U7C
74HC86M
U7D
74HC86M

FIG. 12B-9

| FIG.12C-1 | FIG.12C-2 | FIG.12C-3 |
|---|---|---|
| FIG.12C-4 | | |

FIG.12C

D1
D2
D3
D4
GP2
R01
ORO
R02
ORO
R03
ORO
T1
8
7
6
5
4
3
2
1
R05
ORO
R06
ORO
R04
ORO
PN
PV

FIG.12C-1

+5V
C3
0.1uF
U1
LM340S-5
3
+5V
2
4
1
C2
0.1uF
C1
+
+U
CR9
C4
0.1uF
VREF
R81
249K
R82
3K32

FIG.12C-2

PO2
PO1
TESTN
PLCX1
PLCX2
PLC1
V1
VREF
+5V
H3
H4
B1
PI1
GP2
+5V
TXD
RXD
BATT

FIG.12C-3

H5
+5V
RXD
TXD
1
2
3
4
R83
182R
LED1
TXD
+5V
Q17
3
2
1
R84
0R0
RXD
R85
3K32
MV1
R86
249K
R87
249K
R88
249K
R89
249K
V1
C41
2700pF/1KV
R90
1K
VREF

FIG.12C-4

| FIG.13A | FIG.13B | FIG.13C |
| --- | --- | --- |
| | FIG.13D | FIG.13E |

FIG.13

N(01:24)
N(01:24)
I(01:24)
I(01:24)
107
CT-19
RA9
RA10
RA11
RA12
RA7
RA8
VREF
N07
105
CT-13
RA3
RA4
RA5
RA6
RA1
RA2
VREF
N05
115
CT-20
RB9
RB10
RB11
RB12
RB7
RB8
N15
113
CT-14
RB3
RB4
RB5
RB6
RB1
RB2
N13
123
CT-21
RC9
RC10
RC11
RC12
RC7
RC8
N23
121
CT-15
RC3
RC4
RC5
RC6
RC1
RC2
N21
108
CT-22
RA21
RA22
RA23
RA24
RA19
RA20
N08
106
CT-16
RA15
RA16
RA17
RA18
RA13
RA14
N06
116
CT-23
RB21
RB22
RB23
RB24
RB19
RB20
N16
114
CT-17
RB15
RB16
RB17
RB18
RB13
RB14
N14
124
CT-24
RC21
RC22
RC23
RC24
RC19
RC20
N24
122
CT-18
RC15
RC16
RC17
RC18
RC13
RC14
N22

FIG.13A

N(01:24)
N(01:24)
I(01:24)
I(01:24)
CT-A
CT-B
CT-C
+5V
U2
U3
U4
U5
U6
U7
VCC
GND
CHI/00
CHI/01
CHI/02
CHI/03
CHI/04
CHI/05
CHI/06
CHI/07
A
B
C
CI/0
VSS
INH
IX1
NX1
I2
N2
I3
N3
N01
N02
N03
N04
N05
N06
N07
N08
N09
N10
N11
N12
N13
N14
N15
N16
N17
N18
N19
N20
N21
N22
N23
N24
I01
I02
I03
I04
I05
I06
I07
I08
I09
I10
I11
I12
I13
I14
I15
I16
I17
I18
I19
I20
I21
I22
I23
I24

FIG.13B

N(01:24)
I(01:24)
103
CT-7
RA36
RA35
RA34
RA33
RA32
RA31
VREF
N03
111
CT-8
RB36
RB35
RB34
RB33
RB32
RB31
N11
119
CT-9
RC36
RC35
RC34
RC33
RC32
RC31
N19
104
CT-10
RA48
RA47
RA46
RA45
RA44
RA43
N04
112
CT-11
RB48
RB47
RB46
RB45
RB44
RB43
N12
120
CT-12
RC48
RC47
RC46
RC45
RC44
RC43
N20
101
CT-1
RA30
RA29
RA28
RA27
RA26
RA25
VREF
N01
109
CT-2
RB30
RB29
RB28
RB27
RB26
RB25
N09
117
CT-3
RC30
RC29
RC28
RC27
RC26
RC25
N17
108
CT-4
RA42
RA41
RA40
RA39
RA38
RA37
N02
110
CT-5
RB42
RB41
RB40
RB39
RB38
RB37
N10
118
CT-6
RC42
RC41
RC40
RC39
RC38
RC37
N18

FIG.13C

C17
C16
C13
C12
C11
C10

FIG.13D

R18
R19
R20
SW1
SW2
SW3
TESTN
DISPLAY SW
TAMPER SW
DKR SW
TESR SW
S1
S2
S3
S4

FIG.13E

| | | |
|---|---|---|
| FIG.14A | FIG.14B | FIG.14C |
| FIG.14D | FIG.14E | FIG.14F |
| FIG.14G | FIG.14H | |

FIG. 14

I01
N01
I09
N09
I17
N17
I02
N02
CT1
CT2
CT3
CT4
I-1
N-1
I-2
N-2
I-3
N-3
I-4
N-4

FIG.14A

FIG.14B

I-13
N-13
I-14
N-14
I-15
N-15
I-16
N-16
CT13
CT14
CT15
CT16
I03
N03
I13
N13
I21
N21
I06
N06

H2
N-2
I-2
N-4
I-4
N-6
I-6
N-8
I-8
N-10
I-10
N-12
I-12
1
2
3
4
5
6
7
8
9
10
11
12
13
14
15
16
17
18
19
20
21
22
23
24
N-1
I-1
N-3
I-3
N-5
I-5
N-7
I-7
N-9
I-9
N-11
I-11

FIG.14C

I10
N10
I18
N18
I03
N03
I11
N11
CT5
CT6
CT7
CT8
1
2
3
4
I-5
N-5
I-6
N-6
I-7
N-7
I-8
N-8

FIG.14D

FIG.14E

I-17
N-17
I-18
N-18
I-19
N-19
I-20
N-20
CT17
CT18
CT19
CT20
I14
N14
I22
N22
I07
N07
I15
N15

H3
N-14
I-14
N-16
I-16
N-18
I-18
N-20
I-20
N-22
I-22
N-24
I-24
1
2
3
4
5
6
7
8
9
10
11
12
13
14
15
16
17
18
19
20
21
22
23
24
N-13
I-13
N-15
I-15
N-17
I-17
N-19
I-19
N-21
I-21
N-23
I-23

FIG.14F

FIG.14G

I13
N13
I04
N04
I12
N12
I20
N20
CT9
CT10
CT11
CT12
1
2
3
4
I-9
N-9
I-10
N-10
I-11
N-11
I-12
N-12

FIG.14H

I-21
N-21
I-22
N-22
I-23
N-23
I-24
N-24
CT21
CT22
CT23
CT24
3
4
1
2
I23
N23
I08
N08
I18
N18
I24
N24

| FIG.15A-1 | FIG.15A-2 | FIG.15A-3 |
|---|---|---|
| | FIG.15A-4 | FIG.15A-5 |
| FIG.15A-6 | FIG.15A-7 | |

FIG.15A

MV1
R1
R2
R3
R4
V1
C1
R5
MV2
R6
R7
R8
R9
V2
C2
R10
MV3
R11
R12
R13
R14
V3
C3
R15
VREF

FIG.15A–1

VREF
+5V
H4
MC24-HDR
CT-A
CT-C
MC-B
CT-B
MC-A
MC-C
VREF
J2
J1
I1
IX1
N1
NX1


FIG.15A-2

P02
P01
TESTN
PLCX1
PLCX2
PLC1
V1
V2
V3
I1
I2
I3
GND
VREF
+5V
H5
PI1
CP2
SW1
SW2
SW3
+5V
RXD
TXD
N1
N2
N3
BATT
B1
+
-

FIG.15A-3

+5V
RXD
Q7
3
1
2
R23
R22
TXD
R21
LED1

FIG.15A-4

+5V
D13
D14
R26
R25
Q8
3
2
1
PO2-8
PO1-8
PI1-8
R24
J3
1
2
3
4
5
6
7
8
RJ45/8

FIG.15A-5

C9
U9
PIC16LC505
VDD
RB5
RB4
RB3
RC5
RC4
RC3
VSS
RB0
RB1
RB2
RC0
RC1
RC2
1
2
3
4
5
6
7
14
13
12
11
10
9
8
PO2
PI1
TX1
TX2
TX3
B
A
PO1
NVR3
INVR2
INVR1


FIG.15A-6

+5V
PO2
PI1
CT-A
PO2-B
PI1-B
MC-A
C8
U8
PIC16LC505
VSS
RB0
RB1
RB2
RC0
RC1
RC2
VDD
RB5
RB4
RB3
RC5
RC4
RC3
1
2
3
4
5
6
7
8
9
10
11
12
13
14
CT-C
CT-B
PO1
MC-C
MC-B
PO1-B

FIG.15A-7

| | | | | |
|---|---|---|---|---|
| FIG.15B-1 | FIG.15B-2 | FIG.15B-3 | FIG.15B-4 | FIG.15B-5 |
| FIG.15B-6 | FIG.15B-7 | FIG.15B-8 | FIG.15B-9 | FIG.15B-10 |
| FIG.15B-11 | FIG.15B-12 | FIG.15B-13 | FIG.15B-14 | FIG.15B-15 |
| FIG.15B-16 | FIG.15B-17 | | FIG.15B-18 | FIG.15B-19 |

FIG.15B

N(01:24)
I(01:24)
R109
10R
R110
10R
R111
10R
R112
10R
R113
10R
R114
10R
R115
10R
R116
10R
R117
10R
R118
10R
R119
10R
R120
10R
D73
D74
D75
D76
D77
D78
D79
D80
C37
0.1uF
C38
0.1uF
C39
0.1uF
C40
0.1uF
I19
I20
VREF
N19
N20

FIG.15B-1

R73
10R
R74
10R
D49
D50
D51
D52
R75
10R
R76
10R
R77
10R
R78
10R
C25
0.1uF
C26
0.1uF
I13
VREF
N13
R79
10R
R80
10R
D53
D54
D55
D56
R81
10R
R82
10R
R83
10R
R84
10R
C27
0.1uF
C28
0.1uF
I14
N14

FIG.15B-2

+5V
I01
I04
I07
I10
I13
I16
I19
I22
I(01:24)
U2
CD4051M
VCC
CHI/00
CHI/01
CHI/02
CHI/03
CHI/04
CHI/05
CHI/06
CHI/07
GND
A
B
C
CI/O
VSS
INH
I1
N1
I(01:24)
CT-A
CT-B
CT-C
+5V
CD4051M
U3
VCC
A
B
C
CI/O
VSS
INH
GND
CHI/00
CHI/01
CHI/02
CHI/03
CHI/04
CHI/05
CHI/06
CHI/07
N01
N04
N07
N10
N13
N16
N19
N22

FIG.15B-3

VREF
N07
N08
I07
I08
C13
0.1uF
C14
0.1uF
C15
0.1uF
C16
0.1uF
R41
10R
R42
10R
R47
10R
R48
10R
R39
10R
R40
10R
R45
10R
R46
10R
D26
D28
D30
D32
D25
D27
D29
D31
R38
10R
R44
10R
R37
10R
R43
10R


FIG.15B-4

VREF
NO1
NO2
IO1
IO2
C1
0.1uF
C2
0.1uF
C3
0.1uF
C4
0.1uF
R5
10R
R6
10R
R11
10R
R12
10R
R3
10R
R4
10R
R9
10R
R10
10R
D2
D4
D6
D5
D1
D3
D7
D8
R2
10R
R8
10R
R1
10R
R7
10R

FIG.15B–5

R121
10R
R122
10R
R127
10R
R128
10R
D81
D82
D83
D84
D85
D86
D87
D88
R123
10R
R124
10R
R125
10R
R126
10R
R129
10R
R130
10R
R131
10R
R132
10R
C41
0.1uF
C42
0.1uF
C43
0.1uF
C44
0.1uF
I21
I22
N21
N22

FIG.15B-6

R85
10R
R86
10R
D57
D59
D58
D60
R87
10R
R88
10R
R89
10R
R90
10R
C29
0.1uF
C30
0.1uF
I15
N15
R91
10R
R92
10R
D61
D63
D62
D64
R93
10R
R94
10R
R95
10R
R96
10R
C31
0.1uF
C32
0.1uF
I16
N16

FIG.15B–7

+5V
U4
16
VCC
CD4051M
CHI/00
CHI/01
CHI/02
CHI/03
CHI/04
CHI/05
CHI/06
CHI/07
I02
I05
I08
I11
I14
I17
I20
I23
GND
A
B
C
CI/O
VSS
INH
I2
N2
U5
N(01:24)
N02
N05
N08
N11
N14
N17
N20
N23

FIG.15B-8

N09
N10
I09
I10
C17
0.1uF
C18
0.1uF
C19
0.1uF
C20
0.1uF
R53
10R
R54
10R
R59
10R
R60
10R
R51
10R
R52
10R
R57
10R
R58
10R
D34
D36
D38
D40
D33
D35
D37
D39
R50
10R
R56
10R
R49
10R
R55
10R

FIG.15B–9

NO3
NO4
IO3
IO4
C5
0.1uF
C6
0.1uF
C7
0.1uF
C8
0.1uF
R17
10R
R18
10R
R23
10R
R24
10R
R15
10R
R16
10R
R21
10R
R22
10R
D10
D12
D14
D16
D9
D11
D13
D15
R14
10R
R20
10R
R13
10R
R19
10R

FIG.15B-10

R133
10R
R134
10R
R139
10R
R140
10R
D89
D90
D91
D92
D93
D94
D95
D96
R135
10R
R136
10R
R137
10R
R138
10R
R141
10R
R142
10R.
R143
10R
R144
10R
C45
0.1uF
C46
0.1uF
C47
0.1uF
C48
0.1uF
I23
I(01:24)
I24
N23
N(01:24)
N24

FIG.15B-11

R97
10R
R98
10R
R103
10R
R104
10R
D65
D66
D67
D68
D69
D70
D71
D72
R99
10R
R100
10R
R101
10R
R102
10R
R105
10R
R106
10R
R107
10R
R108
10R
C33
0.1uF
C34
0.1uF
C35
0.1uF
C36
0.1uF
I17
I18
N17
N18
N(01:24)

FIG.15B-12

+5V
CD4051M
U6
VCC
16
CHI/00
CHI/01
CHI/02
CHI/03
CHI/04
CHI/05
CHI/06
CHI/07
13
14
15
12
1
5
2
4
I03
I06
I09
I12
I15
I18
I21
I24
A
B
C
CI/0
VSS
INH
GND
11
10
3
7
6
8
I3
N3
CD4051M
U7
9
N03
N06
N09
N12
N15
N18
N21
N24


FIG.15B–13

N11
N12
I11
I12
C21
0.1uF
C22
0.1uF
C23
0.1uF
C24
0.1uF
R65
10R
R66
10R
R71
10R
R72
10R
R63
10R
R64
10R
R69
10R
R70
10R
D42
D44
D46
D48
D41
D43
D45
D47
R62
10R
R68
10R
R61
10R
R67
10R

FIG.15B-14

N05
N(01:24)
N06
I05
I(01:24)
I06
C9
0.1uF
C10
0.1uF
C11
0.1uF
C12
0.1uF
R29
10R
R30
10R
R35
10R
R36
10R
R27
10R
R28
10R
R33
10R
R34
10R
D18
D20
D22
D24
D17
D19
D21
D23
R26
10R
R32
10R
R25
10R
R31
10R

FIG.15B–15

H6
1
2
3
4
5
6
+5V
PI1
P01
P02
VREF
H5
1
2
3
4
5
6
7
8
9
CT-A
CT-B
CT-C
I1
N1
I2
N2
I3
N3

•H6 IS USED AS A PORT HDR & PICCHIP TESTER

FIG.15B--16

PO2
PI1
CT-A
PO2-B
PO1-B
PI1-B
14
13
12
11
10
9
8
VSS
RB0
RB1
RB2
RC0
RC1
RC2
U1
PIC16LC505
VDD
RB5
RB4
RB3
RC5
RC4
RC3
1
2
3
4
5
6
7
C55
0.1uF
+5V
CT-C
CT-B
PO1

FIG.15B-17

+5V
C54
0.1uF
C53
0.1uF
C52
0.1uF
C51
0.1uF
C50
0.1uF
C49
0.1uF

FIG.15B-18

+5V
D98
D97
R146
10R
R145
10R
PO2-8
PO1-8
PI1-8
Q1
R147
3K32
RJ1

FIG.15B-19

| FIG.15C-1 | FIG.15C-2 |
| --- | --- |
| FIG.15C-3 | FIG.15C-4 |

FIG. 15C

I07
N07
I08
N08
I09
N09
CT-7
CT-8
CT-9
H1
CT-1
CT-2
CT-3
I01
N01
I02
N02
I03
N03

FIG. 15C-1

I19
N19
I20
N20
I21
N21
CT-19
CT-20
CT-21
H3
15—8 1—28
16—9 2—27
17—10 3—26
18—11 4—25
19—12 5—24
20—13 6—23
21—14 7—22
CT-13
CT-14
CT-15
I13
N13
I14
N14
I15
N15

FIG.15C-2

I10
N10
I11
N11
I12
N12
CT-10
CT-11
CT-12
H2
CT-4
CT-5
CT-6
I04
N04
I05
N05
I06
N06

FIG.15C-3

I22
N22
I23
N23
I24
N24
CT-22
CT-23
CT-24
H4
CT-16
CT-17
CT-=18
I16
N16
I17
N17
I18
N18

FIG.15C--4

QSD422
Q5
R7
10K
Q4
R6
3K32
Q3
R5
10K
L1
15uH
D4
CMPSH-3
U1
MAX3218
LX
INVALID
FORCEON
FORCEOFF
GND
VCC
T1IN
T2IN
R1OUT
R2OUT
GND2
+V
C+
GND1
C-
V-
T1OUT
T2OUT
R1IN
R2IN
+3V
H1
LED1
F5E1QT
R2
220R
D1
D2
D5
CMPSH-3
C4
10uF/16V
C1
10uF/16V
C2
10uF/16V
C3
10uF/16V
Q1
R1
1K5
Q2
R4
6R0
D3
R3
100R
J1
TXD
RXD
+3V
+U
-U

FIG. 16

| | | |
|---|---|---|
| FIG.17A-1 | FIG.17A-2 | FIG.17A-3 |
| FIG.17A-4 | FIG.17A-5 | FIG.17A-6 |
| FIG.17A-7 | FIG.17A-8 | FIG.17A-9 |
| FIG.17A-10 | FIG.17A-11 | FIG.17A-12 |

FIG.17A

IO+3.5V
IOGND
R4
330R
IO+5V
C5
0.1uF
D6
1N4003
D7
1N4003
C1
0.1uF
U9
LM7805
1
2
3
4
C2
3300uF/35V
+
CR1
SMCJ30A
1N4003
D2
D3
1N4003
D4
D5
1N4003
1N4003
IO+U
IO
$\overline{IO}$

FIG.17A–1

IO+5V
+5V
2K
R1
D1
1N4148
RXD
TXD
C3
120pF
R2
330R
RS-485 OPTION
5
U12C
74HC04M
6
D12
1N4148
R15
100K
IOGND
C16
0.1uF
1
U12A
74HC04M
2
D13
1N4148
R16
100K
3
U12B
74HC04M
4
R17
100K

FIG.17A-2

RS-485
IO+U
A
B
Z
Y
IOGND
120pF
C4
R3
330R
ASIC-M/DE
U12F
74HC04M
ASIC/DATA
10K
R12
R5
2K
ASIC-S/DE
OPT2
OPT1
U1
U2
VCC
RD
RE
DE
DI
GND1
GND
MAX1482
R
0

FIG.17A-3

MD1
TIP
RING
TIP
RING
SPKR
A GND
MICV
VCC
IO+5V
C6
0.1uF
IOGND
MODEM/RESET
RESET
D GND
RDL
PULSE
D COIND
RXIND
D T RIND
T XIND
DGND1
DTR
DCD
CTS
DSR
RIT
TXD
RXD
RTS
MODEM/DCD
MODEM/RIT

FIG.17A-4

D14
CMPSH-3
L1
U11
MAX3218
C9
10uF/16V
C7
10uF/16V
C8
10uF/16V
C10
10uF/16V
D11
1N4148
R10
2K
D10
1N4148
GND2
+V
C+
GND1
C-
V-
T1OUT
T2OUT
R1IN
R2IN
LX
INVALID
FORCE ON
FORCE OFF
GND
VCC
T1IN
T2IN
R1OUT
R2OUT
IOGND
TX
RX
RS-232
IOGND
MODEM/DATA
IO+5V
R18
10K

FIG.17A-5

IO+3.5V
R13
10K
232/DATA
232-M/DE
11
U12E
10
74HC04M
U3
VCC
RD
RE
DE
DI
Z
Y
GND1
GND
A
B
MAX1482
U4
VCC
RD
RE
DE
DI
GND1
GND
A
B
Z
Y
MAX1482
R11
2K
232-S/DE


FIG.17A-6

PIC/VDD
RC5
RC4
RB5
R21
10K
R20
10K
R22
10K

FIG.17A-7

485/DATA
PIC-M/DE
UART/TX
R19
10K
PIC/VDD

H1
TXD
IO+U
A
B
Z
Y
IOGND
TX
RX
1
2
3
4
5
6
7
8
9
10
11
12
13
14
15
16
17
18
19
20
21
22
RXD
+5V
IO
IO
RC5
RC4
RB5
IOGND
RING
TIP

FIG.17A-8

MODEM-M/DE
U12D
74HC04M
U7
U5
U6
MAX1482
MAX1482
MAX1482
VCC
RD
RE
DE
DI
GND1
GND
A
B
Z
Y
R9
10K
R6
10K
R7
10K
R8
10K
MODEM-S/DE

FIG.17A-9

C13
0.1uF
C11
27pF
C12
27pF
Y1
20MHz

FIG.17A-10

H5
1
2
3
4
5
PIC/MCLR
PIC/VDD
IOGND
RB6
RB7

UART/RX
IOGND
PIC-S/DE
PIC/VDD
C14
0.1uF
C15
0.1uF
CMPSH-3
D8
IO+5V
R14
100K
RB7
RB6
RB4
MODEM/RESET
PIC-M/DE
MODEM-M/DE
232-M/DE
ASIC-M/DE
UART/RX
UART/TX
RC5
RC4
U10
PIC16C63C
VPP
RA0
RA1
RA2
RA3
RA4
RA5
VSS
OSC1
OSC2
RC0
RC1
RC2
RC3
RB7
RB6
RB5
RB4
RB3
RB2
RB1
RB0
VDD
VSS1
RC7
RC6
RC5
RC4
CMPSH-3
D9
PIC/MCLR
ASIC/DATA
232/DATA
MODEM/DATA
485/DATA
MODEM/RIT
MODEM/OCO
ASIC-S/DE
232-S/DE
MODEM-S/DE
PIC-S/DE

FIG.17A-11

FIG.17A-12
U8
MAX1482
VCC
RD
RE
DE
DI
GND1
GND
A
B
Z
Y
R
D
1
2
3
4
5
6
7
8
9
10
11
12
13
14

| FIG.17B-1 | FIG.17B-2 | FIG.17B-3 |
| --- | --- | --- |
| | FIG.17B-4 | FIG.17B-5 |

FIG. 17B

MODEM INTERFACE
H3
1
2
3
4
+5V
RXO
TXO
T1
14A-10R-10
10
$\overline{10}$
J1
J2
J3
J4
J5
J6
1
2
3
4
5
6
7
8
PN
PV

FIG.17B-1

RS-232
H5
RX
TX
1OGND
TXD
10 + U
A
B
Z
Y
IOGND
TX
RX
H2
RXD
+5V
10
RC5
RC4
RB5
IOGND
RING
TIP

FIG.17B-2

Y
Z
B
A
10 + U
IOGND
RS-485
H4
1
2
3
4
5
6

FIG.17B-3

J9
J8
J7
RC5
RC4
RB5
IOGND

FIG.17B-4

TIP
RING
RJ11
1
2
3
4

FIG.17B-5

PN
PV
H1
1
2
3
4
5
6
7
8
9
10
11
12
13
14

| | | |
|---|---|---|
| FIG.17C-1 | FIG.17C-2 | FIG.17C-3 |
| FIG.17C-4 | | FIG.17C-5 |
| FIG.17C-6 | FIG.17C-7 | FIG.17C-8 |

FIG.17C

VDD2
+5V
PLS/COM
L1
D2
1N4148
D1
1N4148
R14
1K
D4
CMPSH-3
D3
1N4148
VBATT
B1
CR2032
C15
0.022uF
Q1
FMMT3904
R13
10K
R1
100R
PLS1
OPT1
C1
0.001uF
R2
100R
PLS2
OPT2
C2
0.001uF
H3
1 2
D17
1N4148
R3
100R
PLS3
OPT3
C3
0.001uF
VDD1
C16
1uF/16V
D16
1N4148
R4
100R
PLS4
OPT4
C4
0.001uF
Y1
32768Hz
RC5/1
C13
15pF
C14
15pF

FIG.17C-1

VDD3
+5V
D10
D9
1N4148
1N4148
R18
1K
D12
D11
CMPSH-3
1N4148
VBATT
PIC16LC505
U1
VDD
RB5
RB4
RB3
RC5
RC4
RC3
VSS
RB0
RB1
RB2
RC0
RC1
RC2
P02
P01

FIG.17C--2

PLS/COM
L3
Q3
FMMT3904
C24
0.022uF
R17
10K
R9
100R
PLS9
OPT9
C9
0.001uF
R10
100R
PLS10
OPT10
C10
0.001uF
R11
100R
PLS11
OPT11
C11
0.001uF
R12
100R
PLS12
OPT12
C12
0.001uF
D21
1N4148
H5
D20
1N4148
VDD3
C25
1uF/16V
PIC16LC505
U3
VDD
RB5
RB4
RB3
RC5
RC4
RC3
VSS
RB0
RB1
RB2
RC0
RC1
RC2
PO2
PO1
RC5/3
Y3
32768Hz
C21
15pF
C22
15pF

FIG.17C-3

BOARD SELECT 0
VDD1
H2
1
2
3
R20
10K
R21
10K
R22
10K
RC5/1
RC5/2
RC5/3

FIG.17C-4

D15
1N4148
PI1
10K
R19
D13
1N4148
FIG.17C-5

VDD2
+5V
PLS/COM
D6
D5
1N4148
1N4148
R16
1K
L2
D8
CMPSH-3
D7
1N4148
VBATT
C19
0.022uF
Q2
FMMT3904
R15
10K
R5
100R
OPT5
PLS5
C5
0.001uF
R6
100R
OPT6
PLS6
C6
0.001uF
H4
1 2
R7
100R
OPT7
PLS7
C7
0.001uF
VDD2
C20
1uF/16V
D18
1N4148
R8
100R
OPT8
PLS8
C8
0.001uF
C17
15pF
Y2
32768Hz
C18
15pF
RC5/2

FIG.17C-6

P02
P01
14
13
12
11
10
9
8
VSS
RB0
RB1
RB2
RC0
RC1
RC2
PIC16LC505
U2
VDD
RB5
RB4
RB3
RC5
RC4
RC3
1
2
3
4
5
6
7
D19
1N4148

FIG.17C-7

+5V
PO2
PO1
PI1
RJ2
RJ1
1
2
3
4
5
6
7
8

FIG.17C-8

PLS1
PLS2
PLS3
PLS4
PLS5
PLS6
PLS7
PLS8
PLS9
PLS10
PLS11
PLS12
TB1
D14
1N4148
PLS/COM

A2
RAM
(INTERNAL)
A4
PLC CTRL
RX
TX
A5
DIGITAL
CONTROL
LOGIC
A6
WATCHDOG
TIMER
A7
SERIAL UART
WITH FIFO
A1
METER
A3
RTC
A8
DIGITAL I/O
ANALOG I/O
1830
1809
A7
PERIPHERAL
INTERFACE
HARDWARE
TEST POINTS
OPTICAL
READER
VOLTAGE
DIVIDE
CURRENT
SHUNT
1835
32768
CRYSTAL
PLC
HARDWARE
1815
1820
1825
1818
V2
N
V1
V3
I1
I2
I3
N1
N2
N3
20 M
CRYSTAL
CR1
VREF
VOLTAGE
INPUTS
CURRENT
INPUTS
1810
U4
DISPLAY
DRIVER
FLASH
TO ALL MODULES
+u
+s
1801
U2
MICRO-
PROCESSOR
POWER
SUPPLY
BATTERY
1802
U3
RAM
LCD
LCD1
FIG.18

PARAMETER ACCUMULATION
iAccIdx
iAcc[0]
iAcc[1]
curph
ph
mtrSamp
storeDelta
accumP

FIG.19

TO ADC
M6
MUX
SS
T/H
M5
MUX
S/H
S/H
S/H
S/H
$V_1$
$V_{L1}$
$V_2$
$V_{L2}$
S1
S2
S3
S4
MEASUREMENT VOLTAGE
DELTA VOLTAGE
(1,2,4,8)
(1/2,1,2,4)
A1
A2
M1
MUX
M2
MUX
V1
V2
V3
N
VOLTAGE CHANNEL
A8
A7
A6
A5
3.33
A4
(1,1.35,1.82,2.47)
DAC
OFFSET CONTROL
M4
MUX
GP1
GP2
GP3
PLC
Vref
(1,6.67)
A3
$J_x$
$N_x$
M3
MUX
I1
N1
I2
N2
I3
N3
Vref
CURRENT CHANNEL
GAIN= 1 0<R≤3
$3.33^{\frac{R-4}{4}}$ 4≤R≤23
FIG.20

TO DEMODULATOR
F4
A4
F3
A3
F2
A2
F1
A1
MUX M1
TO ADC
PHASE CAPTURE VALUE
CLK
D
Q
UI
PHASE OUTPUT
MUX M2
SQUARE WAVE OUTPUT
SQUARE WAVE GENERATOR
UI
PLC INPUT
DESIRED FREQUENCY

FIG.21

C
A1
Vin
Vout
R1
R2
C

FIG.22

1φ
NODE
METER
M7
NODE
METER
M8
1φ
1φ
ZONE
3
1φ
NODE
METERS
3φ
1φ
M6
M5
ZONE 2
1φ
ZONE
1
END
USER
3φ
1φ
END
USERS
1φ
ALL COUPLERS
ARE INCLUDED
IN MAPPING
SYSTEM
FEEDER
METER
INDUCTIVE
COUPLERS
NORTH
1 2 3 N
M1
EAST
DISTRIBUTION
TRANSFORMER
M4
M2
1
2
3
N
WEST
M3
1 2 3 N
SOUTH
FEEDER
METERS
MUX
FILTER
PUM
TRANSPONDER
T1
OTHER
COUPLERS
M1
PCI
IEEE
BUS
PERSONAL
COMPUTER
MAPPING SYSTEM


FIG.23 -THEFT DETECTION

CELL TOWERS
METER
CONTROL LINE
UTILITY
ATS
LOCAL GENERATOR

FIG.24

(1)
GFI
TOROID
LOAD
UNDER METER
CONTROL

(2)
GFI
TOROID
LOAD
+
-
UNDER METER
CONTROL

FIG.25

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 4783748 A, Swarztrauber
- US 5986574 A, Colton
- WO 9946746 A
- WO 9957697 A
- US 5764739 A, Patton
- GB 2306852 A
- US 5897607 A
- CA 2279802 A
- CA 2279802